# EUROPEAN PATENT SPECIFICATION

(11) **EP 2 055 746 B1**
(45) Date of publication and mention of the grant of the patent: **28.09.2011**
(21) Application number: 08168088.6
(22) Date of filing: 31.10.2008
(51) Int. Cl.: C08L 101/00, H01L 27/146, B41M 3/00, B41C 1/10, H05K 3/28, H05K 3/00, G03B 33/16, C08L 33/08, C08F 2/50, C08F 22/10

(54) **Colored curable composition, color filter, method of producing the same, and solid state image pickup device.**
Farbige härtbare Zusammensetzung, Farbfilter, Herstellungsverfahren dafür und Festzustand-Bildaufnahmevorrichtung
Composition durcissable colorée, filtre de couleur, son procédé de production et dispositif semi-conducteur de capture d'images

(30) Priority: 31.10.2007 JP 2007284474
(43) Date of publication of application: 06.05.2009
(73) Proprietor: FUJIFILM Corporation, Tokyo 106-0031 (JP)
(72) Inventor: Tsuchimura, Tomotaka c/o Fujifilm Corporation, Haibara-gun Shizuoka-ken 421-0302 (JP); Shimada, Kazuto c/o Fujifilm Corporation, Haibara-gun Shizuoka-ken 421-0302 (JP)
(74) Representative: Brookes Batchellor LLP

(56) References cited:
- EP-A2- 1 505 441
- EP-A2- 1 826 200
- EP-A2- 2 028 544
- WO-A1-02/100903
- WO-A1-2006/018405
- JP-A- 2007 148 371
- US-A1- 2007 099 096
- US-A1- 2007 166 631

## Description

### BACKGROUND

### Field of the Invention

The present invention relates to a colored curable composition, a color filter, a method of producing the same, and a solid state image pickup device.

### Description of Related Art

As a method of producing a color filter for use in a liquid crystal display element or a solid state image pickup device, a staining method, a printing method, an electrodeposition method, and a pigment dispersion method are known.

Among the above, the pigment dispersion method refers to a method of producing a color filter by a photolithography method using a colored curable composition in which a pigment has been dispersed in various photosensitive compositions. By the use of a pigment, the pigment dispersion method has an advantage of being stable against light, heat, etc. Since patterning is performed by the photolithography method, the accuracy of position is high. Thus, the pigment dispersion method has been widely used as a method suitable for producing a color filter for high-definition color displays having a big screen.

A color filter is produced by the pigment dispersion method as follows: a photosensitive composition is applied to a glass substrate by a spin coater, a roll coater, or the like, and dried to form a coating film; the coating film is subjected to pattern exposure and developed to form a colored pixel; and then the process is repeated for every color to obtain a color filter. As the pigment dispersion method, a negative photosensitive composition has been described in which a photopolymerizable monomer and a photoinitiator are used in combination with an alkali-soluble resin (e.g., Japanese Patent Application Laid-Open (JP-A) No. 2-199403).

In contrast, recently, the color filter for use in a solid state image pickup device has been desired to have a higher definition and a further reduced thickness. For example, as a technique for forming a thin film in which spectral properties are maintained, a technique is disclosed (e.g., JP-A No. 2006-276878 or Japanese Patent No. 3823579) which involves increasing the content of a colorant with respect to the total solid content of a colored curable composition and improving pattern formation properties by a resin.

However, when the content of a colorant is further increased while maintaining the formulation disclosed in JP-A No. 2006-276878 or Japanese Patent No. 3823579, there are problems in that the sensitivity is remarkably reduced and a pattern in a low exposure region peels off. Furthermore, since a color material (colorant) is contained at a high concentration, a residue is likely to remain between pixels. In particular, the color filter for a solid state image pickup device has been desired to have a higher color concentration and a further reduced thickness so as to achieve high light gathering properties and improvement in image quality due to high color separation properties in a solid state image pickup device, such as CCD. Thus, it has been desired to prevent the decrease in the sensitivity and the formation of a residue.

In order when a large amount of colorant is added to a photocurable composition for use in pixel pattern formation in order to achieve a high color concentration of a color filter, the sensitivity becomes insufficient for faithfully reproducing the shape of a fine pixel pattern of, for example, 2.5 µm or lower, whereby pattern missing frequently occurs as a whole.

Thus, under the present circumstances, the photocurable composition mainly for use in a color filter has been desired to have a high curing sensitivity even when a colorant is contained at a high concentration, in view of the necessity to obtain favorable pattern formation properties. From the viewpoint of improvement in curing sensitivity, an embodiment is mentioned in which the addition amount of a polymerization initiator contained in a photocurable composition is increased. However, when the addition amount of a polymerization initiator increases, removability of an uncured portion decreases. In particular, when a Bayer pattern having a pattern size of 1.5 µm or lower is formed, a problem arises in that considerable residues are formed in a region where no colored pattern is formed. As a countermeasure to the problem of the residue formation, for example, an embodiment may be mentioned in which a photocurable compound having a hydrophilic group is applied. In such an embodiment, however, there has been a problem of reduction in sensitivity.

### SUMMARY

The present invention has been made in view of the above-described circumstances, and provides the following.
More specifically, an object of the present invention is to provide a colored curable composition which is cured with high sensitivity, which has favorable pattern formation properties, and which is excellent in properties of removing an uncured portion, even when a colorant is contained at a high concentration.
Another object of the present invention is to provide a color filter having a colored pattern with a favorable shape in which the formation of a residue in a region where no colored pattern is formed is suppressed; a method capable of producing the color filter at high productivity; and a solid state image pickup device equipped with the color filter.

The present inventors have conducted extensive researches. As a result, the present inventors has found that it is possible to obtain a colored curable composition can be obtained which is cured with high sensitivity and which has favorable pattern formation properties and excellent removability of an uncured portion by using a specific oxime photopolymerization initiator having a high absorption efficiency at a wavelength of 365 nm, even when a colorant is contained at a high concentration.
The present invention provides a colored curable composition, containing:
(A) a photopolymerization initiator represented by Formula (II) and having a molar extinction coefficient at a wavelength of 365 nm of from 12,000 to 500,000;
(B) a polymerizable compound; and
(C) a colorant.

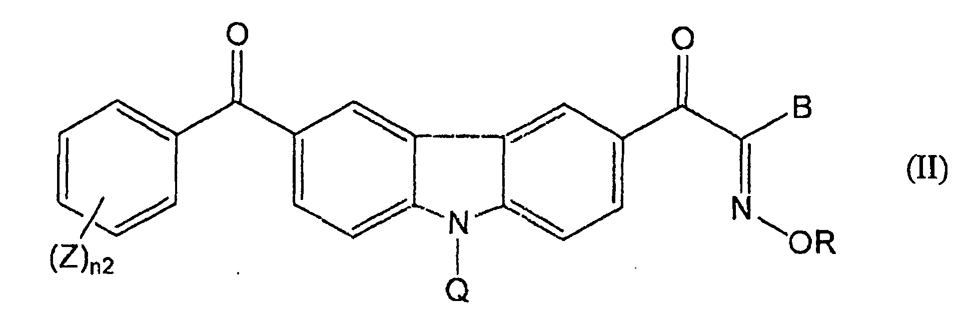

In Formulae (II), R, B, and Q each independently represent a monovalent organic group; Z represents a monovalent substituent; and n₂ represents an integer of from 0 to 5.

A third aspect of the invention provides colored curable composition according to the first or second aspect, further containing (D) an alkali-soluble resin having at least one unsaturated double bond.

The composition also comprises an alkali-soluble resin includes at least one structural unit represented by any one of the following Formulae (1) to (3) and a structural unit represented by the following Formula (4).

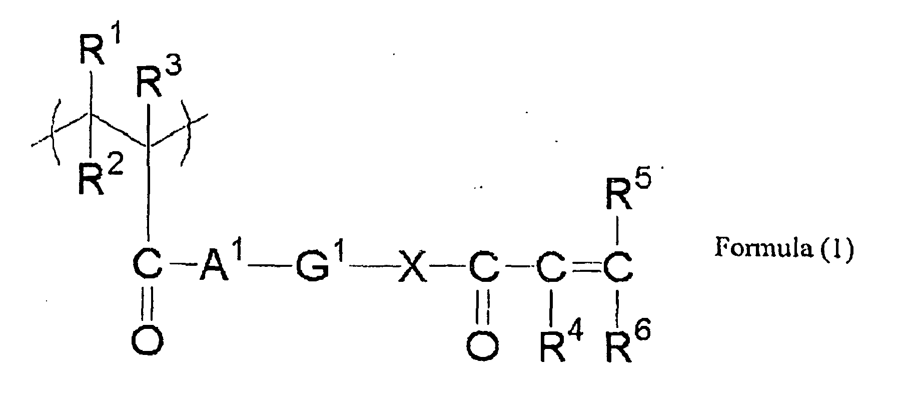

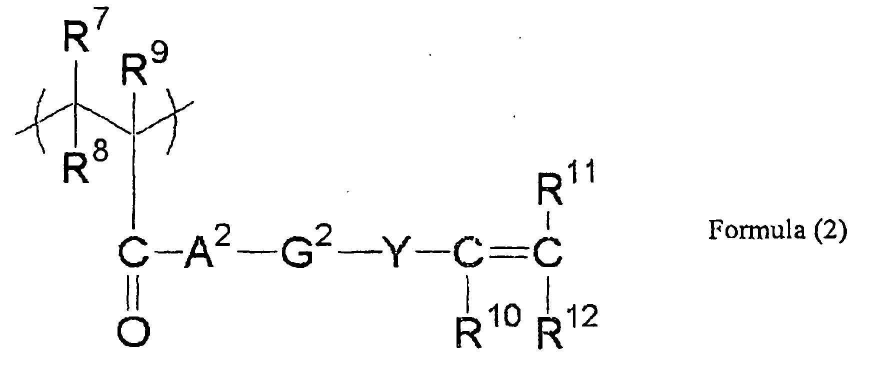

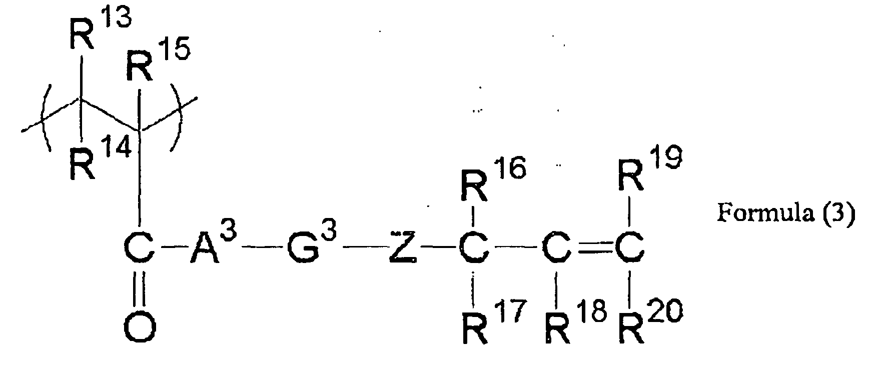

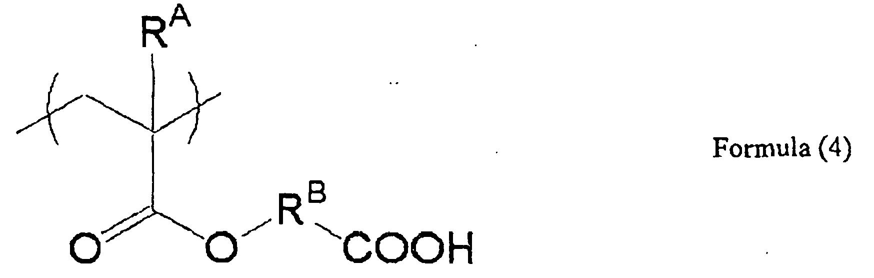

In Formulae (1) to (3), A¹, A² and A³ each independently represent an oxygen atom, a sulfur atom, or -N(R²¹)-; R²¹ represents an alkyl group which may have a substituent; G¹, G² and G³ each independently represent a divalent organic group; X and Z each independently represent an oxygen atom, a sulfur atom, or -N(R²²)-; R²² represents an alkyl group which may have a substituent; Y represents an oxygen atom, a sulfur atom, a phenylene group which may have a substituent, or -N(R²³)-; R²³ represents an alkyl group which may have a substituent; and R¹ to R²⁰ each independently represent a hydrogen atom or a monovalent substituent. In Formula (4), R^{A} represents hydrogen or an alkyl group having 1 to 6 carbon atoms; and R^{B} represents a divalent connecting group.

A second aspect of the invention provides a colored curable composition according to the first aspect, wherein the content of the colorant is from 50 mass% to 90 mass% with respect to the total solid content of the colored curable composition.

A third aspect of the invention provides a color filter, containing a colored pattern formed from the colored curable composition according to the first or second aspect.

A fourth aspect of the invention provides a method of producing a color filter, including:
applying the colored curable composition according to any one of the first to third aspects onto a support to form a colored curable composition layer;
exposing the colored curable composition layer through a mask; and
developing the colored curable composition layer after exposure to form a colored pattern.
An fifth aspect of the invention provides a solid state image pickup device, containing the color filter according to the third aspect.

According to the present invention, a colored curable composition may be provided which is cured with high sensitivity and which has favorable pattern formation properties and excellent removability of an uncured portion even when a colorant is contained at a high concentration. Moreover, a color filter may be provided which has a colored pattern with a favorable shape wherein, in the color filter, a residue in a region where no colored pattern is formed is reduced. Further a method capable of producing the color filter at a high productivity and a solid state image pickup device equipped with the color filter are also provided.

### BRIEF DESCRIPTION OF THE DRAWINGS

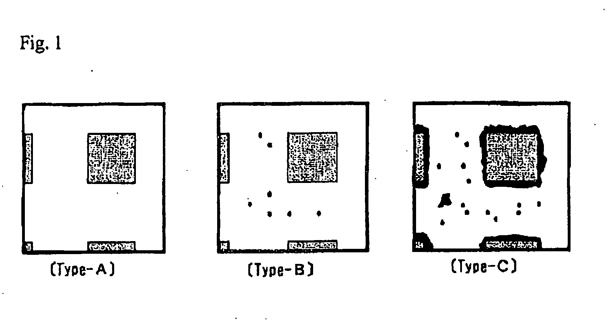

Fig. 1 is a view illustrating a classification of the degree of development residue generation.

### DETAILED DESCRIPTION OF THE INVENTION

### [Colored curable composition]

A colored curable composition of the invention contains at least a (A) photopolymerization initiator represented by Formula (II) and having a molar extinction coefficient at a wavelength of 365 nm of from 12,000 to 500,000 (hereinafter, also referred to as a "specific photopolymerization initiator"), (B) a polymerizable compound; (C) a colorant, and a resin according to claim 1.

### <(A) Specific Photopolymerization Initiator>

The specific photopolymerization initiator is a compound that has a molar extinction coefficient at a wavelength of 365 nm of from 12,000 to 500,000 and that is represented by Formula (I). When the molar extinction coefficient at a wavelength of 365 nm is from 12,000 to 500,000, the polymerizable compound can be polymerized with high sensitivity even when a colorant is contained at a high concentration in a coloring composition.
From the viewpoint of sensitivity, the molar extinction coefficient at a wavelength of 365 nm is preferably from 12,000 to 300,000, more preferably from 13,000 to 300,000, and particularly preferably from 14,000 to 200,000.
The molar extinction coefficient mentioned herein refers to a value measured at a concentration of 0.01 g/L in an ethyl acetate solvent for spectral analysis with an UV-Vis spectrophotometer (Carry-5 (trade name) spectrophotometer manufactured by Varian).

The specific photopolymerization initiator is represented by Formula (II).

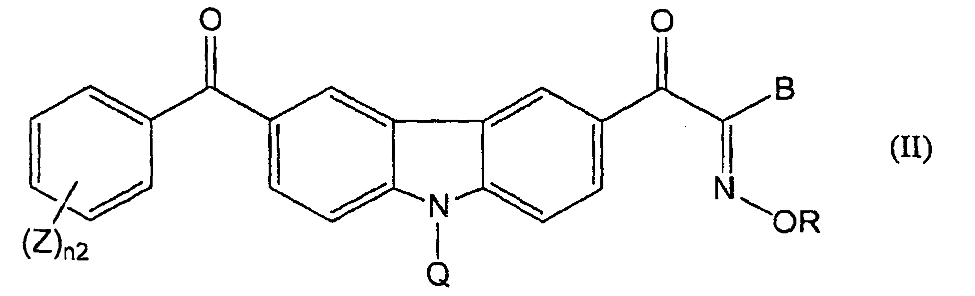

In Formula (II) represents a monovalent substituent; and n₂ represents an integer of from 0 to 5.

Examples of the group represented by Q include those described as examples of B. The group represented by Q is preferably an alkyl group having 1 to 20 carbon atoms, and is most preferably an ethyl group.

The specific photopolymerization initiator represented by Formula (II) will be described in detail.

Examples of the monovalent organic group represented by R include an alkyl group which may have a substituent, an aryl group which may have a substituent, an alkenyl group which may have a substituent, an alkynyl group which may have a substituent, an alkylsulfinyl group which may have a substituent, an arylsulfinyl group which may have a substituent, an alkylsulfonyl group which may have a substituent, an arylsulfonyl group which may have a substituent, an acyl group which may have a substituent, an alkoxycarbonyl group which may have a substituent, an aryloxycarbonyl group which may have a substituent, a phosphinoyl group which may have a substituent, a heterocyclic group which may have a substituent, an alkylthiocarbonyl group which may have a substituent, an arylthiocarbonyl group which may have a substituent, a dialkylaminocarbonyl group which may have a substituent, and a dialkylaminothiocarbonyl group which may have a substituent.

The alkyl which may have a substituent is preferably an alkyl group having 1 to 30 carbon atoms, and examples include a methyl group, an ethyl group, a propyl group, a butyl group, a hexyl group, an octyl group, a decyl group, a dodecyl group, an octadecyl grouop, an isopropyl group, an isobutyl group, a sec-butyl group, a tert-butyl group, a 1-ethylpentyl group, a cyclopentyl group, a cyclohexyl group, a trifluoromethyl grouop, a 2-ethylhexyl group, a phenacyl group, a 1-naphthoylmethyl group, a 2-naphthoylmethyl group, a 4-methylsulfanylphenacyl group, a 4-phenylsulfanylphenacyl group, a 4-dimethylaminophenacyl group, a 4-cyanophenacyl group, a 4-methylphenacyl group, a 2-methylphenacyl group, a 3-fluorophenacyl group, a 3-trifluoromethylphenacyl group, and a 3-nitrophenacyl group.

The aryl group which may have a substituent is preferably an aryl group having 6 to 30 carbon atoms, and examples include a phenyl group, a biphenyl group, a 1-naphthyl group, a 2-naphthyl group, a 9-anthryl group, a 9-phenanthryl group, a 1-pyrenyl group, a 5-naphthacenyl group, a 1-indenyl group, a 2-azulenyl group, a 9-fluorenyl group, a terphenyl group, a quarterphenyl group, an o-tolyl group, a m-tolyl group, a p-tolyl group, a xylyl group, an o-cumenyl group, a m-cumenyl group, a p-cumenyl group, a mesityl group, a pentalenyl group, a binaphthalenyl group, a temaphthalenyl group, a quarternaphthalenyl group, a heptalenyl group, a biphenylenyl group, an indacenyl group, a fluoranthenyl group, an acenaphthylenyl group, an aceanthrylenyl group, a phenalenyl group, a fluorenyl group, an anthryl group, a bianthracenyl group, a teranthracenyl group, a quarteranthracenyl group, an anthraquinonyl group, a phenanthryl group, a triphenylenyl group, a pyrenyl group, a chrysenyl group, a naphthacenyl group, a pleiadenyl group, a picenyl group, a perylenyl group, a pentaphenyl group, a pentacenyl group, a tetraphenylenyl group, a hexaphenyl group, a hexacenyl group, a rubicenyl group, a coronenyl group, a trinaphthylenyl group, a heptaphenyl group, a heptacenyl group, a pyranthrenyl group, and an ovalenyl group. The alkenyl group which may have a substituent is preferably an alkenyl group having 2 to 10 carbon atoms, and examples include a vinyl group, an allyl group and a styryl group.

The alkynyl group which may have a substituent is preferably an alkynyl group having 2 to 10 carbon atoms, and examples include an ethynyl group, a propynyl group and a propargyl group.

The alkylsulfinyl group which may have a substituent is preferably an alkylsulfinyl group having 1 to 20 carbon atoms, and examples include a methylsulfinyl group, an ethylsulfinyl group, a propylsulfinyl group, an isopropylsulfinyl group, a butylsulfinyl group, a hexylsulfinyl group, a cyclohexylsulfinyl group, an octylsulfinyl group, a 2-ethylhexylsulfinyl group, a decanoylsulfinyl group, a dodecanoylsulfinyl group, an octadecanoylsulfinyl group, a cyanomethylsulfinyl group, and a methoxymethylsulfinyl group.

The arylsulfinyl group which may have a substituent is preferably an arylsulfinyl group having 6 to 30 carbon atoms, and examples include a phenylsulfinyl group, a 1-naphthylsulfinyl group, a 2-naphthylsulfinyl group, a 2-chlorophenylsulfinyl group, a 2-methylphenylsulfinyl group, a 2-methoxyplienylsulfinyl group, a 2-butoxyphenylsulfinyl group, a 3-chlorophenylsulfinyl group, a 3-trifluoromethylphenylsulfinyl group, a 3-cyanophenylsulfinyl group, a 3-nitrophenylsulfinyl group, a 4-fluorophenylsulfinyl group, a 4-cyanophenylsulfinyl group, a 4-methoxyphenylsulfinyl group, a 4-methylsulfanylphenylsulfinyl group, a 4-phenylsulfanylphenylsulfinyl group, and a 4-dimethylaminophenylsulfinyl group.

The alkylsulfonyl group which may have a substituent is preferably an alkylsulfonyl group having 1 to 20 carbon atoms, and examples include a methylsulfonyl group, an ethylsulfonyl group, a propylsulfonyl group, an isopropylsulfonyl group, a butylsulfonyl group, a hexylsulfonyl group, a cyclohexylsulfonyl group, an octylsulfonyl group, a 2-ethylhexylsulfonyl group, a decanoylsulfonyl group, a dodecanoylsulfonyl group, an octadecanoylsulfonyl group, a cyanomethylsulfonyl group, a methoxymethylsulfonyl group, and a perfluoroalkylsulfonyl group.

The arylsulfonyl group which may have a substituent is preferably an arylsulfonyl group having 6 to 30 carbon atoms, and examples include a phenylsulfonyl group, a 1-naphthylsulfonyl group, a 2-naphthylsulfonyl group, a 2-chlorophenylsulfonyl group, a 2-naethylphenylsulfonyl group, a 2-methoxyphenylsulfonyl group, a 2-butoxyphenylsulfonyl group, a 3-chlorophenylsulfonyl group, a 3-trifluoromethylphenylsulfonyl group, a 3-cyanophenylsulfonyl group, a 3-nitrophenylsulfouyl group, a 4-fluorophenylsulfonyl group, a 4-cyanophenylsulfonyl group, a 4-methoxypheuylsulfonyl group, a 4-methylsulfanylphenylsulfonyl group, a 4-phonylsulfanylphenylsulfonyl group, and a 4-dimethylaminophenylsulfonyl group.

The acyl group which may have a substituent is preferably an acyl group having 2 to 20 carbon atoms, and examples include an acetyl group, a propanoyl group, a butanoyl group, a trifluoromethylcarbonyl group, a pentanoyl group, a benzoyl group, a 1-naphthoyl group, a 2-naphthoyl group, a 4-methylsulfanylbenzoyl group, a 4-phenylsulfanylbenzoyl group, a 4-dimethylaminobenzoyl group, a 4-diethylaminobenzoyl group, a 2-chlorobenzoyl group, a 2-methylbenzoyl group, a 2-methoxybenzoyl group, a 2-butoxybenzoyl group, a 3-chlorobenzoyl group, a 3-trifluoromethylbenzoyl group, a 3-cyanobenzoyl group, a 3-nitrobenzoyl group, a 4-fluorobenzoyl group, a 4-cyanobenzoyl group, and a 4-methoxybenzoyl group.

The alkoxycarbonyl group which may have a substituent is preferably an alkoxycarbonyl group having 2 to 20 carbon atoms, and examples include a methoxycarbonyl group, an ethoxycarbonyl group, a propoxycarbonyl group, a butoxycarbonyl group, a hexyloxycarbonyl group, an octyloxycarbonyl group, a decyloxycarbonyl group, an octadecyloxycarbonyl group, and a trifluoromethyloxycarbonyl group.

Examples of the aryloxycarbonyl group which may have a substituent include a phenoxycarbonyl group, a 1-naphthyloxycarbonyl group, a 2-naphthyloxycarbonyl group, a 4-methylsulfanylphenyloxycarbonyl group, a 4-phenylsulfanylphenyloxycarbonyl group, a 4-dimethylaminophenyloxycarbonyl group, a 4-diethylaminophenyloxycarbonyl group, a 2-chlorophenyloxycarbonyl group, a 2-methylphenyloxycarbonyl group, a 2-methoxyphenyloxycarbonyl group, a 2-butoxyphenyloxycarbonyl group, a 3-chlorophenyloxycarbonyl group, a 3-trifluoromethylphenyloxycarbonyl group, a 3-cyanophenyloxycarbonyl group, a 3-nitrophenyloxycarbonyl group, a 4-fluorophenyloxycarbonyl group, a 4-cyanophenyloxycarbonyl group, and a 4-methoxyphenyloxycarbonyl group

The phosphinoyl group which may have a substituent is preferably a phosphinoyl group having 2 to 50 carbon atoms in total, and examples include a dimethylphosphinoyl group, a diethylphosphinoyl group, a dipropylphosphinoyl group, a diphenylphosphinoyl group, a dimethoxyphosphinoyl group, a diethoxyphosphinoyl group, a dibenzoylphosphinoyl group, and a bis(2,4,6-trimethylphenyl)phosphinoyl group.

The heterocyclic group which may have a substituent is preferably an aromatic or aliphatic heterocyclic group containing at least one heteroatom selected from nitrogen, oxygen, sulfur, and phosphorus atoms. Examples include a thienyl group, a benzo[b]thienyl group, a naphtho[2,3-b]thienyl group, a thianthrenyl group, a furyl group, a pyranyl group, an isobenzofuranyl group, a chromenyl group, a xanthenyl group, a phenoxathiinyl group, a 2H-pyrrolyl group, a pyrrolyl group, an imidazolyl group, a pyrazolyl group, a pyridyl group, a pyrazinyl group, a pyrimidinyl group, a pyridazinyl group, an indolizinyl group, an isoindolyl group, a 3H-indolyl group, an indolyl group, a 1H-indazolyl group, a purinyl group, a 4H-quinolizinyl group, an isoquinolyl group, a quinolyl group, a phthalazinyl group, a naphthyridinyl group, a quinoxalinyl group, a quinazolinyl group, a cinnolinyl group, a pteridinyl group, a 4aH-carbazolyl group, a carbazolyl group, a β-carbolinyl group, a phenanthridinyl group, an acrindinyl group, a perimidinyl group, a phenanthrolinyl group, a phenazinyl group, a phenarsazinyl group, an isothiazolyl group, a phenothiazinyl group, an isoxazolyl group, a furazanyl group, a phenoxazinyl group, an isochromanyl group, a chromanyl group, a pyrrolidinyl group, a pyrrolinyl group, an imidazolidinyl group, an imidazolinyl group, a pyrazolidinyl group, a pyrazolinyl group, a piperidyl group, a piperazinyl group, an indolinyl group, an isoindolinyl group, a quinuclidinyl group, a morpholinyl group, and a thioxanthonyl group.

Examples of the alkylthiocarbonyl group which may have a substituent include a methylthiocarbonyl group, a propylthiocarbonyl group, a butylthiocarbonyl group, a hexylthiocarbonyl group, an octylthiocarbonyl group, a decylthiocarbonyl group, an octadecylthiocarbonyl group, and a trifluoromethylthiocarbonyl group.

Examples of the aryl thiocarbonyl group which may have a substituent include a 1-naphthylthiocarbonyl group, a 2-naphthylthiocarbonyl group, a 4-methylsulfanylphenylthiocarbonyl group, a 4-phenylsulfanylphenylthiocarbonyl group, a 4-dimethylaminophenylthiocarbonyl group, a 4-diethylaminophenylthiocarbonyl group, a 2-chlorophenylthiocarbonyl group, a 2-methylphenylthiocarbonyl group, a 2-methoxyphenythiocarbonyl group, a 2-butoxyphenylthiocarbonyl group, a 3-chlorophenylthiocarbonyl group, a 3-trifluoromethylphenylthiocarbonyl group, a 3-cyanophenylthiocarbonyl group, a 3-nitrophenylthiocarbonyl group, a 4-fluorophenylthiocarbonyl group, a 4-cyanophenylthiocarbonyl group, and a 4-methoxyphenylthiocarbonyl group.

Examples of the dialkylaminocarbonyl group which may have a substituent include a dimethylaminocarbonyl group, a diethylaminocarbonyl group, a dipropylaminocarbonyl group, and a dibutylaminocarbonyl group.

Examples of the dialkylaminothiocarbonyl group which may have a substituent include a dimethylaminothiocarbonyl group, a dipropylaminothiocarbonyl group, and a dibutylaminothiocarbonyl group.

Among the above, from the viewpoint of increasing the sensitivity, the acyl group is more preferable as the monovalent organic group of represented by R. Specifically, an acetyl group, a propionyl group, a benzoyl, and a toluyl group are preferable.

As to specific examples of the monovalent organic group represented by R in Formula (I), the following are preferable from the viewpoint of obtaining higher sensitivity.

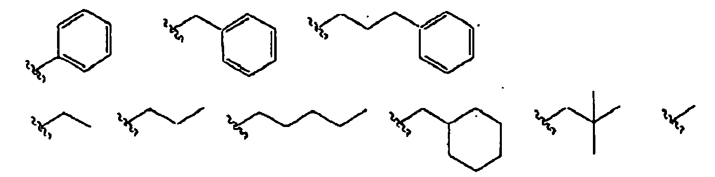

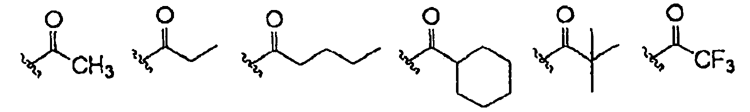

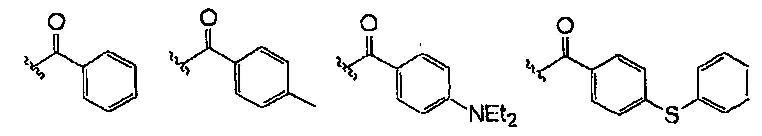

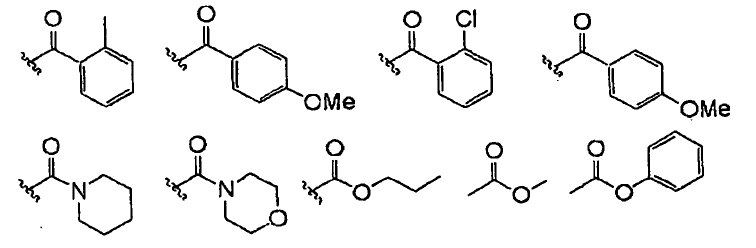

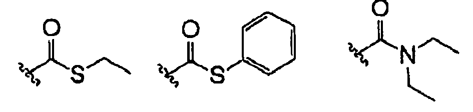

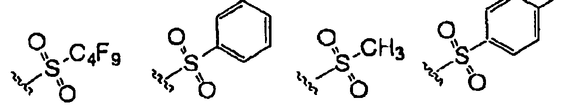

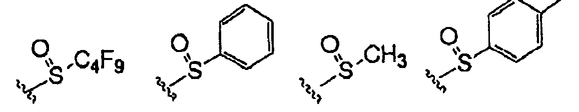

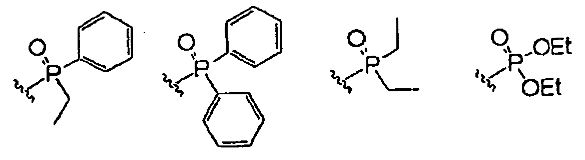

Examples of the monovalent organic group represented by B include a phenyl group (which may be substituted by at least one of an alkyl group having 1 to 6 carbon atoms, a phenyl group, a halogen atom, -OR⁸; -SR⁹, or -N (R¹⁰) (R¹¹)); an alkyl group having 1 to 20 carbon atoms (wherein, when the number of the carbon atoms of the alkyl group is from 2 to 20, the alkyl group may have at least one oxygen atom and/or at least one S atom between carbon atoms in the main chain, and the alkyl group may be substituted by at least one hydroxy group); an alkenyl group having 1 to 20 carbon atoms (wherein, when the number of the carbon atoms of the alkenyl group is from 2 to 20, the alkenyl group may have at least one oxygen atom and/or at least one S atom between carbon atoms in the main chain, and the alkenyl group may be substituted by at least one hydroxy group); an alkynyl group having 1 to 20 carbon atoms (wherein, when the number of carbon atoms of an alkynyl group is from 2 to 20, the alkynyl group may have at least one oxygen atom and/or at least one S atom between carbon atoms in the main chain, and the alkynyl group may be substituted by at least one hydroxy group); a cycloalkyl group having 5 to 8 carbon atoms; an alkanoyl group having 2 to 20 carbon atoms; a benzoyl group (which may be substituted by at least one of an alkyl group having 1 to 6 carbon atoms, a phenyl group, -OR⁸, -SR⁹; or -N (R¹⁰) (R¹¹)); an alkoxycarbonyl group having 2 to 12 carbon atoms (wherein, when the number of carbon atoms of the alkoxyl group is from 2 to 11, the alkoxyl group may have at least one oxygen atom between carbon atoms in the main chain, and the alkoxyl group may be substituted by at least one hydroxy group); a phenoxy carbonyl group (which may be substituted by at least one of an alkyl group having 1 to 6 carbon atoms, a phenyl group, halogen atom, -OR⁸, or -N (R¹⁰) (R¹¹)); a cyano group; a nitro group; -CON (R¹⁰) (R¹¹); a haloalkyl group having 1 to 4 carbon atoms; - S (O) m-R¹² (wherein R¹² represents an alkyl group having 1 to 6 carbon atoms and m is an integer of from 0 to 2); -S (O) m-R¹³ (wherein R¹³ represents an aryl group having 6 to 12 carbon atoms and may be substituted by an alkyl group having 1 to 12 carbon atoms, and m is an integer of from 0 to 2); an alkoxysulfonyl group having 1 to 6 carbon atoms; an aryloxysulfonyl group having 6 to 10 carbon atoms; or a diphenylphosphinoyl group.

R⁸ represents a hydrogen atom, an alkyl group having 1 to 12 carbon atoms, a substituted alkyl group having 2 to 6 carbon atoms {wherein the substituent contains at least one of a hydroxy group, a mercapto group, a cyano group, an alkoxyl group having 1 to 4 carbon atoms, an alkenyloxy group having 3 to 6 carbon atoms, a 2-cyanoethoxy group, or a 2-(alkoxycarbonyl)ethoxy group having 4 to 7 carbon atoms, an alkylcarbonyloxy group having 2 to 5 carbon atoms, a phenyl carbonyloxy group, a carboxyl group, or an alkoxycarbonyl group having 2 to 5 carbon atoms}, an alkyl group having 2 to 6 carbon atoms which has at least one oxygen atom between carbon atoms in the main chain, an alkanoyl group having 2 to 8 carbon atoms, -(CH₂CH₂O) nH (wherein, n is an integer of from 1 to 20); an alkenyl group having 3 to 12 carbon atoms, an alkenoyl group having 3 to 6 carbon atoms, a cyclohexyl group, a phenyl group (which may be substituted by a halogen atom, an alkyl group having 1 to 12 carbon atoms, or an alkoxyl group having 1 to 4 carbon atoms), a phenylalkyl group having 7 to 9 carbon atoms, or -Si(R¹⁴) r (R¹⁵)₃-r (wherein R¹⁴ represents an alkyl group having 1 to 8 carbon atoms, R¹⁵ represents a phenyl group, and r is an integer of from 1 to 3).

R⁹ represents a hydrogen atom, an alkyl group having 1 to 12 carbon atoms, an alkenyl group having 3 to 12 carbon atoms, a cyclohexyl group, a substituted alkyl group having 2 to 6 carbon atoms {wherein the substituent contains at least one of a hydroxy group, a mercapto group, a cyano group, an alkoxyl group having 1 to 4 carbon atoms, an alkenyloxy group having 3 to 6 carbon atoms, a 2-cyanoethoxy group, a 2-(alkoxycarbonyl) ethoxy group having 4 to 7 carbon atoms, an alkylcarbonyloxy group having 2 to 5 carbon atoms, a phenyl carbonyloxy group, a carboxyl group, or an alkoxycarbonyl group having 2 to 5 carbon atoms}, an alkyl group having 2 to 12 carbon atoms having at least one oxygen atom and/or at least one sulfur atom between carbon atoms in the main chain, a phenyl group (which may be substituted by a halogen atom, an alkyl group having 1 to 12 carbon atoms, or an alkoxyl group having 1 to 4 carbon atoms), or a phenylalkyl group having 7 to 9 carbon atoms.

Examples of the monovalent substituent represented by X, Y¹, or Y² include an alkyl group which may have a substituent, an aryl group which may have a substituent, an alkenyl group which may have a substituent, an alkynyl group which may have a substituent, an alkylsulfinyl group which may have a substituent, an arylsulfinyl group which may have a substituent, an alkylsulfonyl group which may have a substituent, an arylsulfonyl group which may have a substituent, an acyl group which may have a substituent, an alkoxycarbonyl group which may have a substituent, an aryloxycarbonyl group which may have a substituent, a phosphinoyl group which may have a substituent, a heterocyclic group which may have a substituent, an alkylthioxy group which may have a substituent, an arylthioxy group which may have a substituent, an alkyloxy group which may have a substituent, an aryloxy group which may have a substituent, an alkylthiocarbonyl group which may have a substituent, an arylthiocarbonyl group which may have a substituent, a dialkylamino carbonyl group which may have a substituent, a dialkylaminothiocarbonyl group which may have a substituent, a carboxylic acid group, a sulfonic acid group, a cyano group, a halogen atom, an amino group which may have a substituent, and a substituent obtained by combining two or more of the above-described monovalent substituents.

Among the above, as the monovalent substituent represented by X, Y¹, or Y², a hydrogen atom, an alkoxycarbonyl group, a cyano group, and a phenyl group are preferable from the viewpoint of the improvement in the sensitivity and stability over time of the composition. Y¹ and Y² each preferably represent independently a hydrogen atom, an alkoxycarbonyl group, a cyano group, or a phenyl group from the viewpoint of the improvement in the sensitivity and stability over time of the composition.

Two substituents selected from the monovalent substituents represented by X, Y¹, and Y² may be combined to each other to form a ring structure.

n₁ represents an integer of from 0 to 4, preferably an integer of from 0 to 2, and more preferably 1. When n₁ represents an integer of from 2 to 4, there are plural Xs, which may represent the same substituent as each other or different substituents from each other.

Examples of the monovalent substituent represented by Z include a halogen group, such as a fluorine atom, a chloride atom, a bromine atom, or an iodine atom; an alkoxy group, such as a methoxy group, an ethoxy group, or a tert-butoxy group; an aryloxy group, such as a phenoxy group or a p-tolyloxy group; an alkoxycarbonyl group, such a methoxycarbonyl group, a butoxycarbonyl group, or a phenoxycarbonyl group; an acyloxy group, such as an acetoxy group, a propionyloxy group, or a benzoyloxy group; an acyl group, such as an acetyl group, a benzoyl group, an isobutyryl group, an acryloyl group, a methacryloyl group, or a methoxalyl group; an alkylsulfanyl group, such as a methylsulfanyl group or a tert-butylsulfanyl group; an arylsulfanyl group, such as a phenylsulfanyl group or a p-tolylsulfanyl group; an alkylamino group, such as a methylamino group or a cyclohexylamino group; a dialkylamino group, such as a dimethylamino group, a diethylamino group, a morpholino group, a piperidino group, or a julolidine group; an arylamino group, such as a phenylamino group or a p-tolylamino group; an alkyl group, such as a methyl group, an ethyl group, a tert-butyl group, or a dodecyl group; an aryl group, such as a phenyl group, a p-tolyl group, a xylyl group, a cumenyl group, a naphthyl group, an anthryl group, or a phenanthryl group; a hydroxy group; a carboxy group; a formyl group; a mercapto group; a sulfo group; a mesyl group; a p-toluenesulfonyl group; an amino group; a nitro group; a cyano group; a trifluoromethyl group; a trichloromethyl group; a trimethylsilyl group; a phosphinico group; a phosphono group; a trimethylammoniumyl group; a dimethylsulfoniumyl group; a triphenylphenacylphosphoniumyl group; and a cyano group.

n₂ represents an integer of from 0 to 5, preferably an integer of from 0 to 3, and more preferably 0 or 1.
When n₂ represents an integer of from 2 to 5, there are plural Zs, which may represent the same substituent as each other or different substituents from each other.

The following partial structure (IV), which is a partial structure to be connected to the carbonyl carbon in Formula (11), is a more preferable embodiment of the partial structure (III). Examples thereof include structures included in the scope of the partial structure (IV) among the structures mentioned above as examples of the partial structure (III). More specifically, examples of the following partial structure (IV) include, but are not limited to, the following structures among the structures mentioned above as examples of the partial structure (III).

.

It should be noted that the details of Z and n₂ in the following partial structure (IV) are as described above in the description of Formula (II).

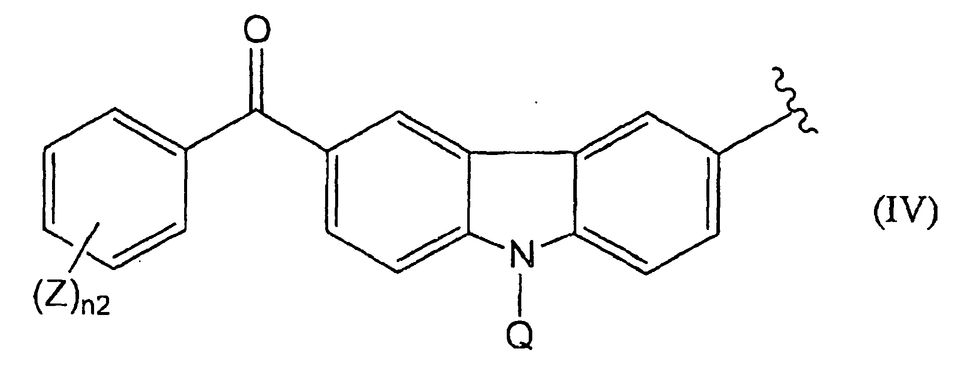

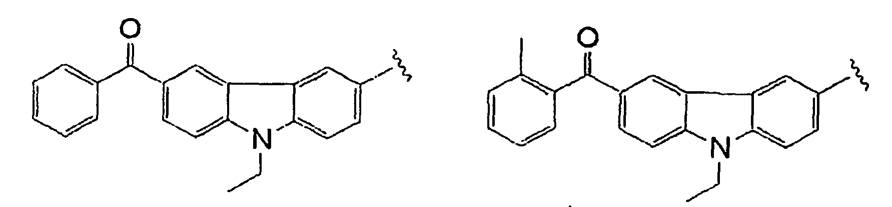

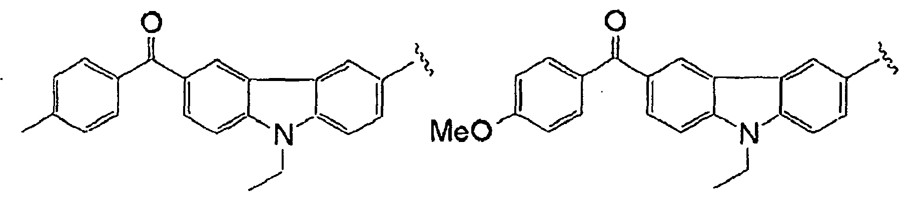

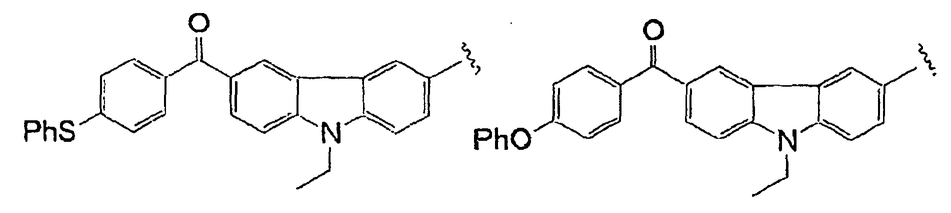

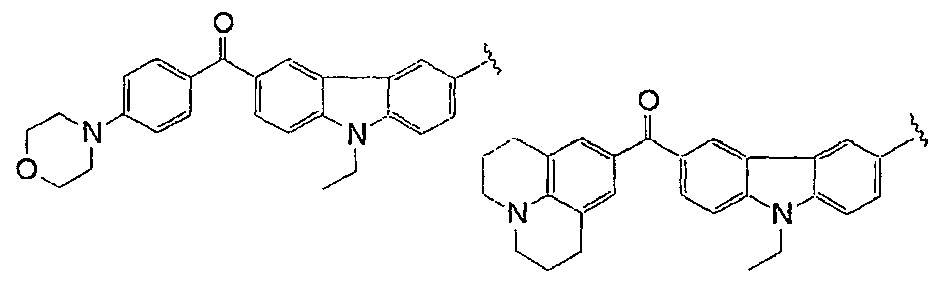

Specific examples of the compound (specific photopolymerization initiator) represented by Formula (I) include, but are not limited to, those shown below.
The compound represented by Formula (I) has a molar extinction coefficient at 365 nm of from 12,000 to 500,000. In particular, when the structure represented by Formula (II) is employed, the molar extinction coefficient tends to be higher. Each specific example shown below has a molar extinction coefficient in the range of from 12,000 to 500,000.

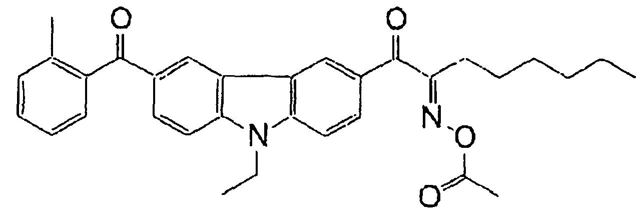

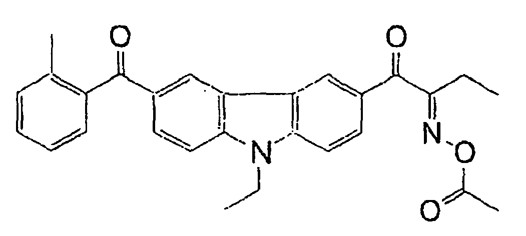

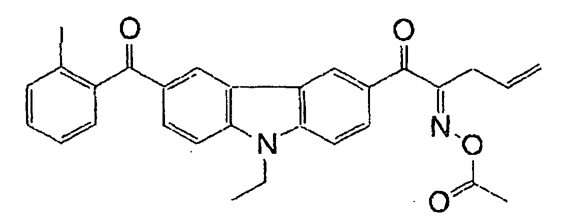

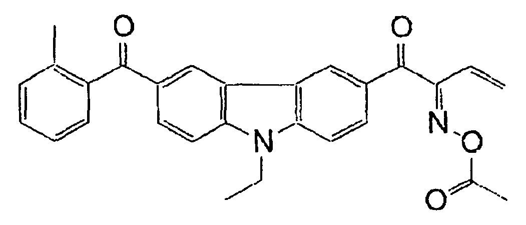

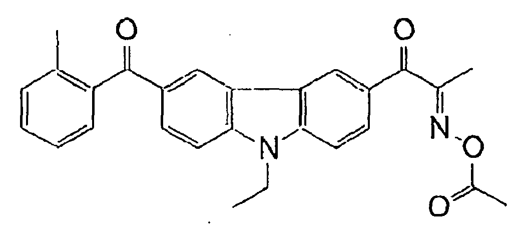

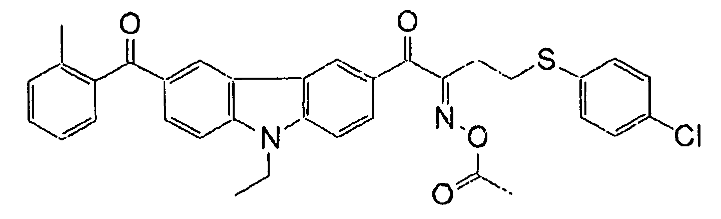

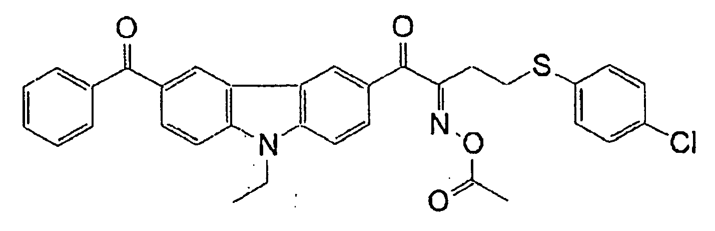

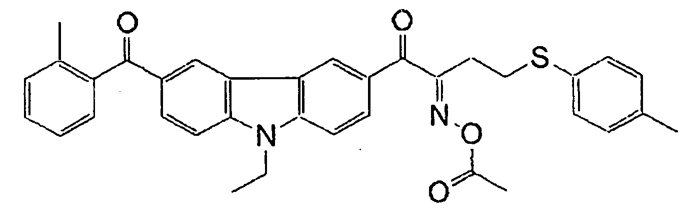

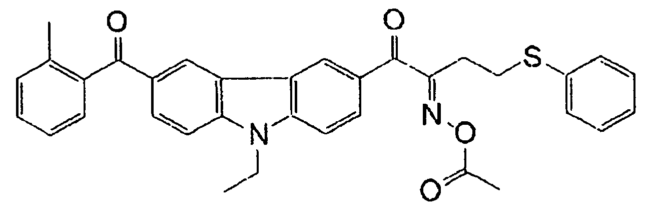

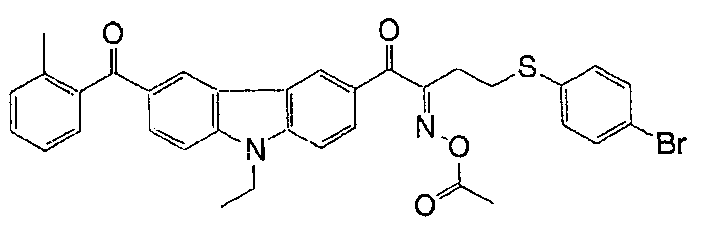

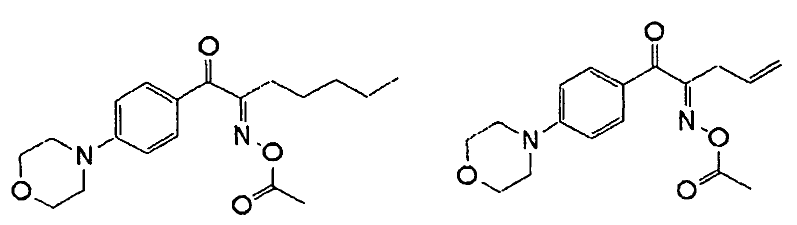

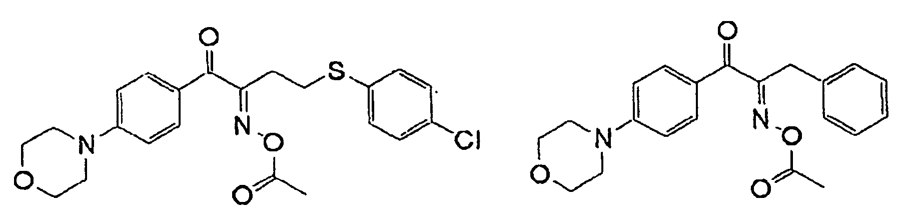

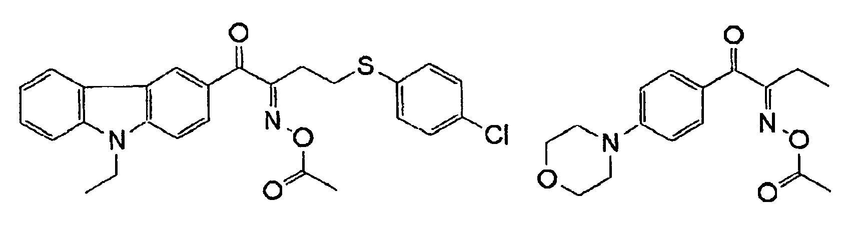

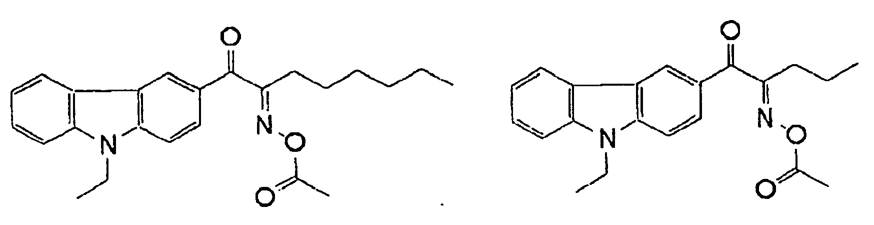

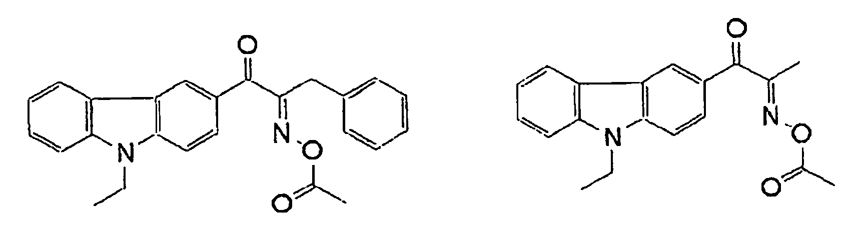

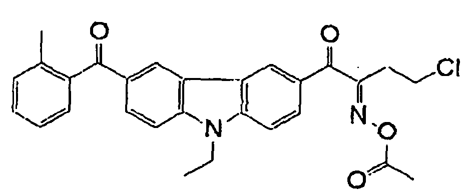

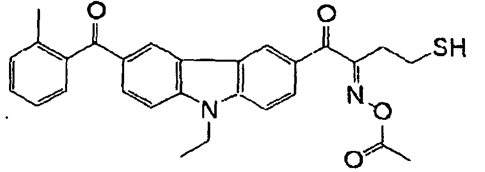

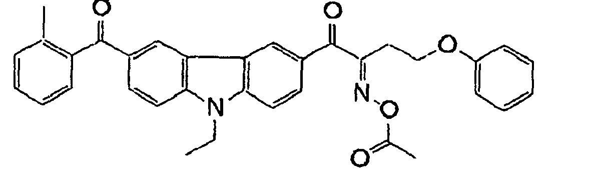

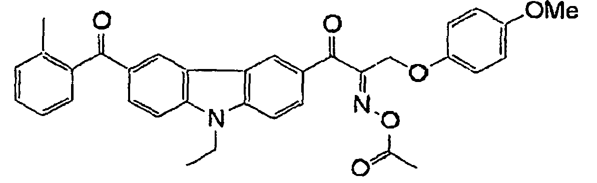

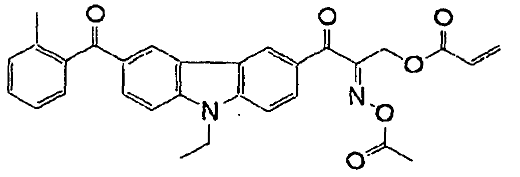

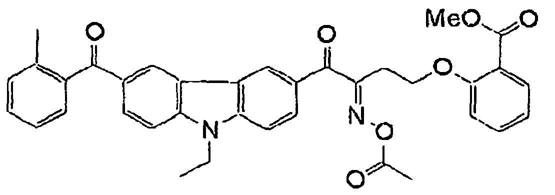

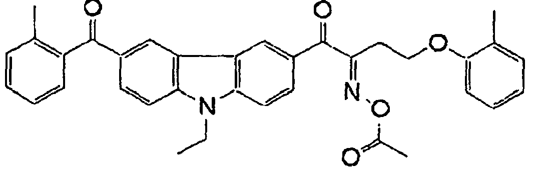

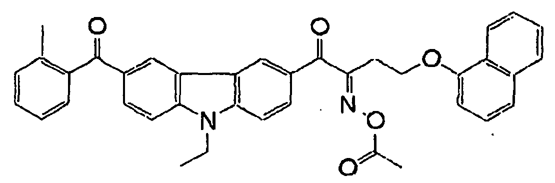

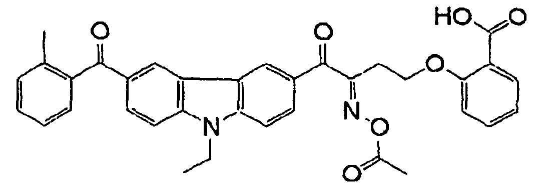

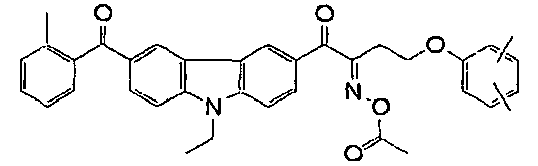

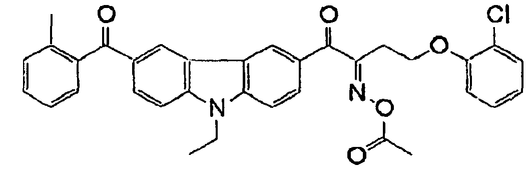

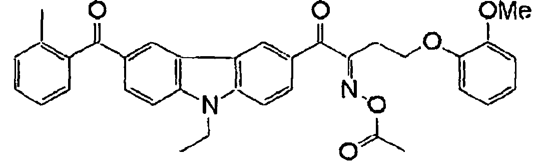

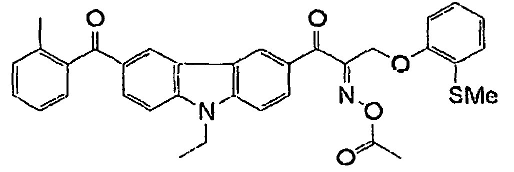

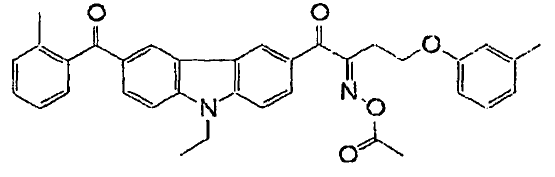

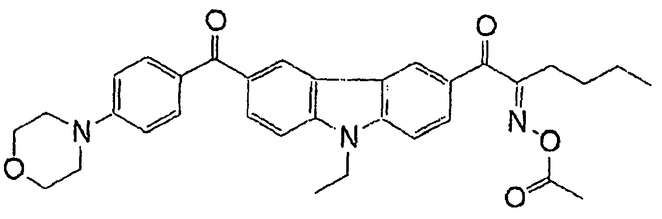

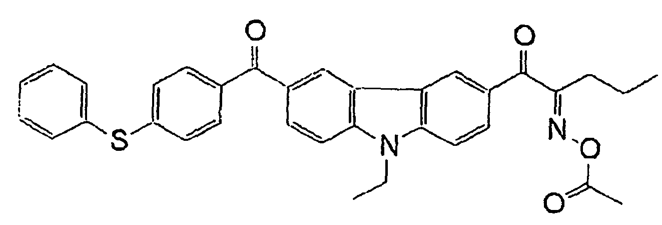

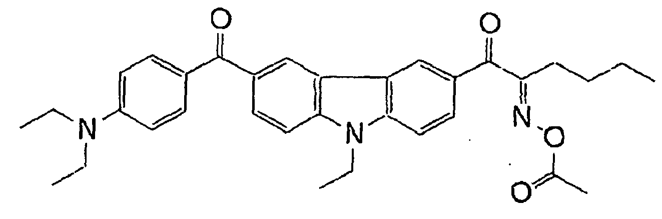

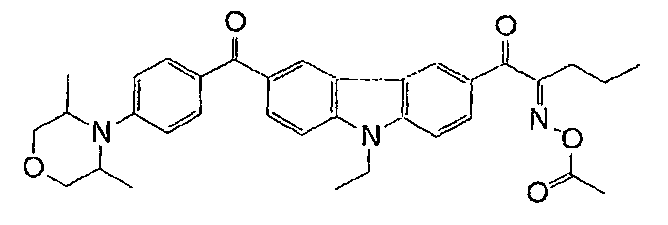

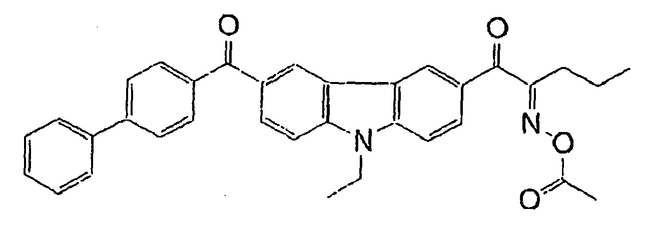

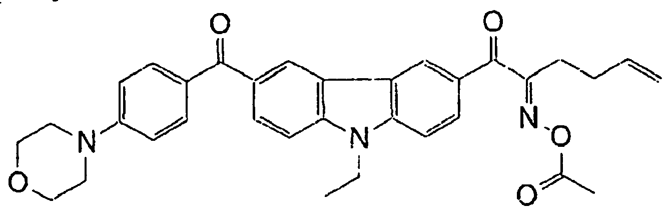

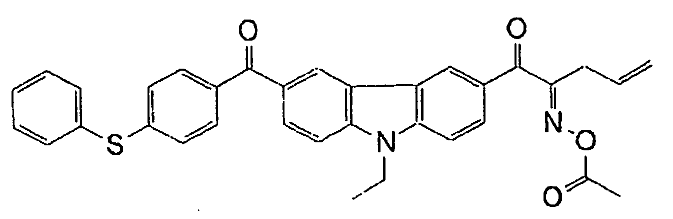

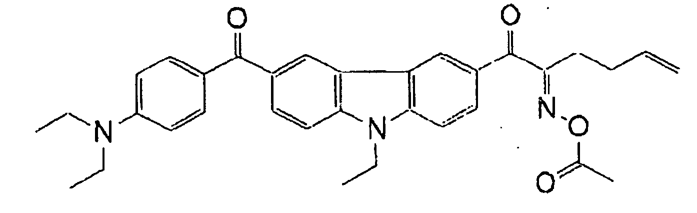

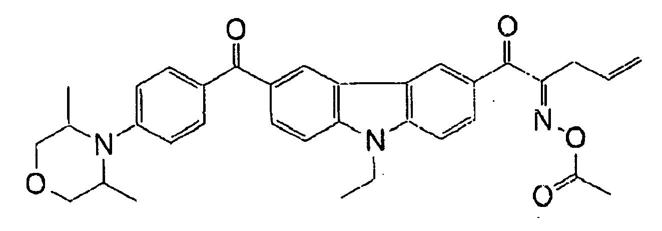

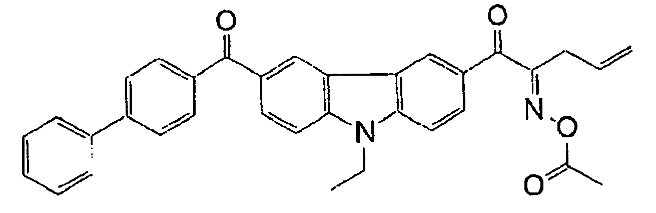

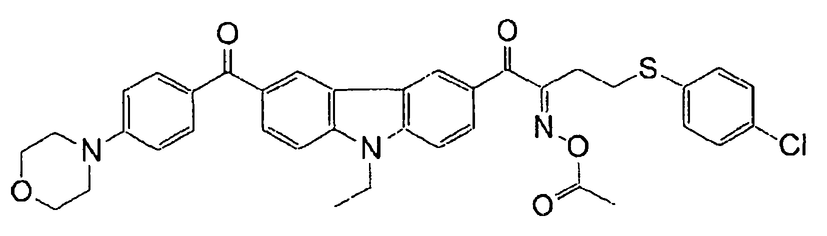

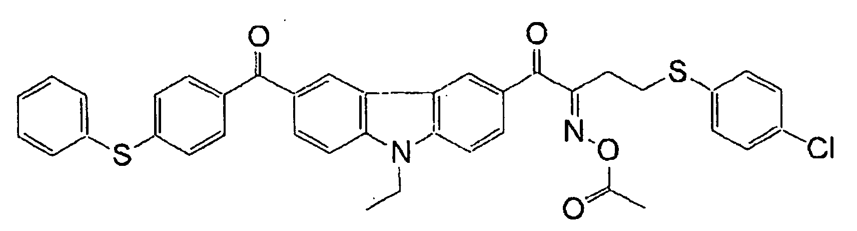

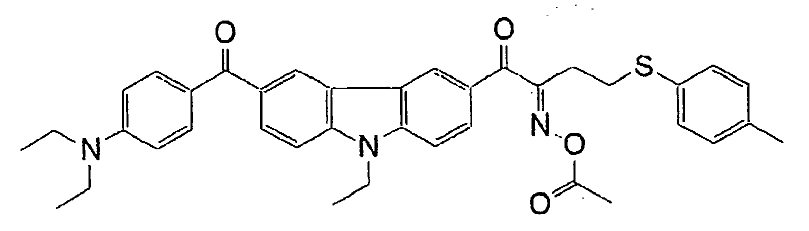

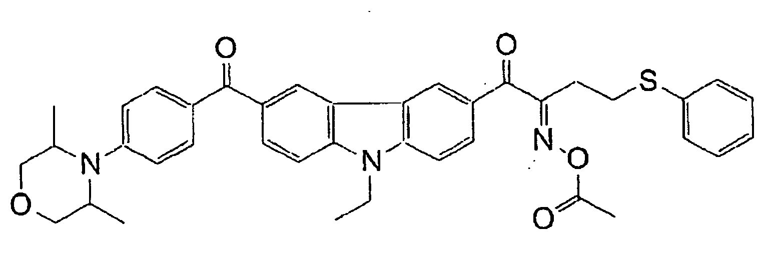

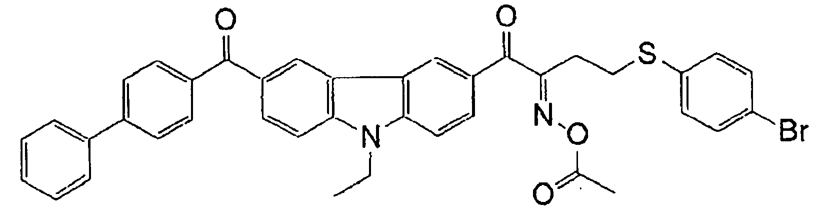

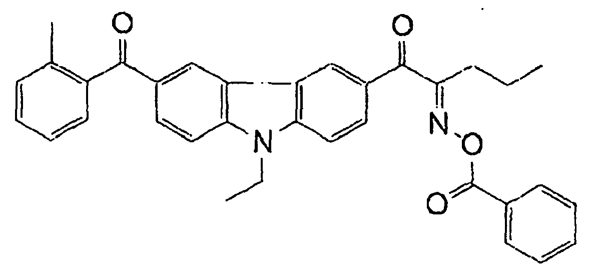

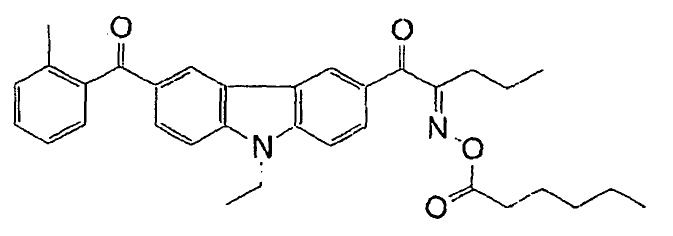

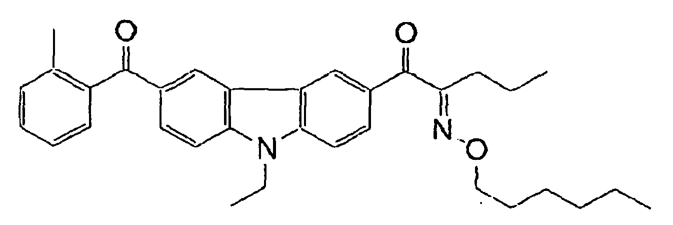

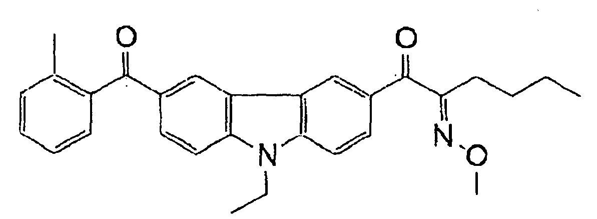

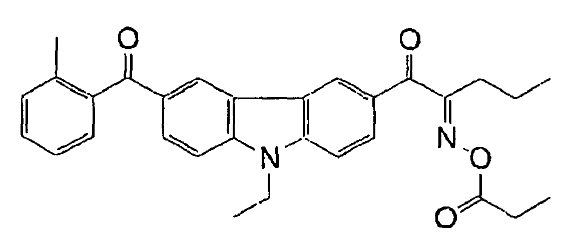

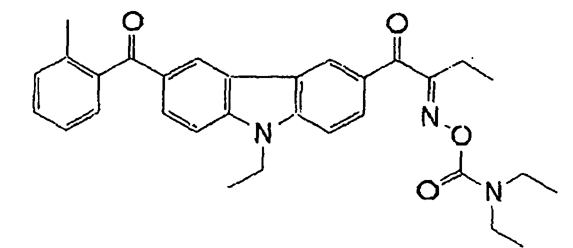

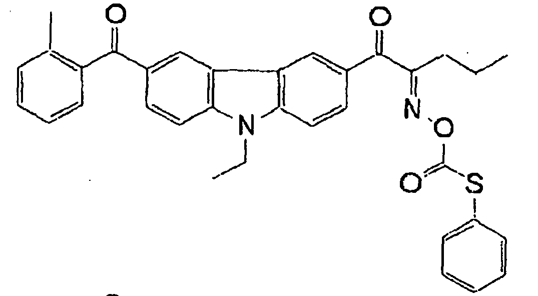

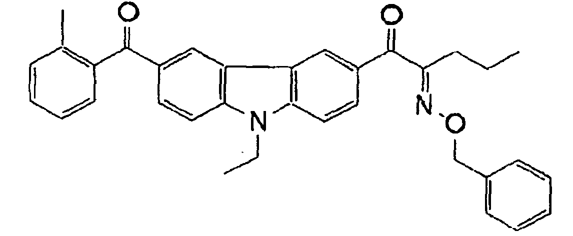

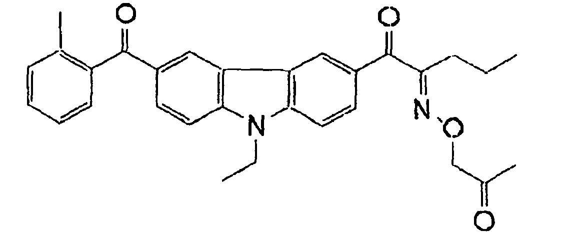

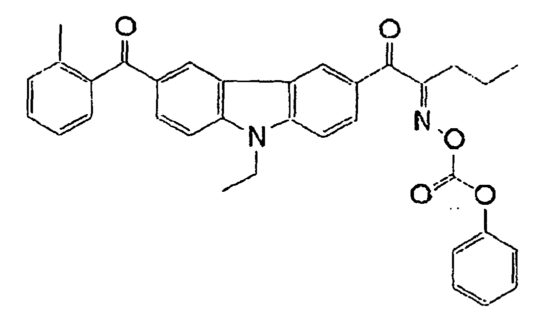

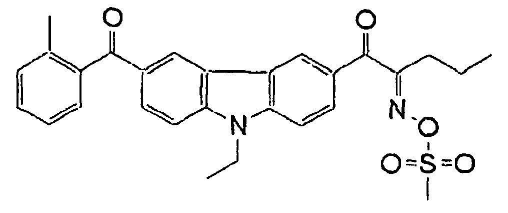

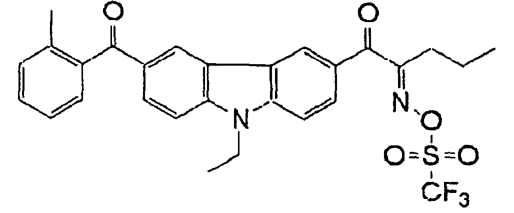

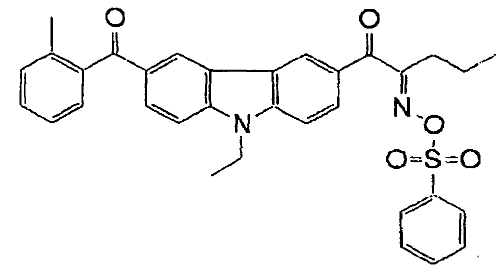

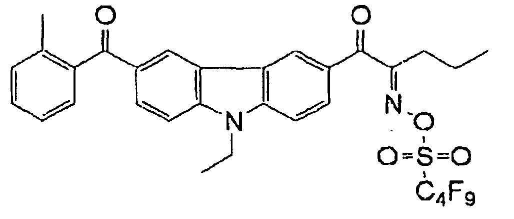

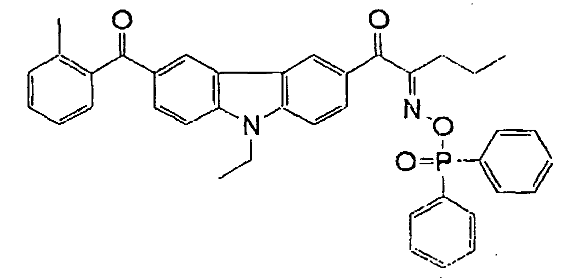

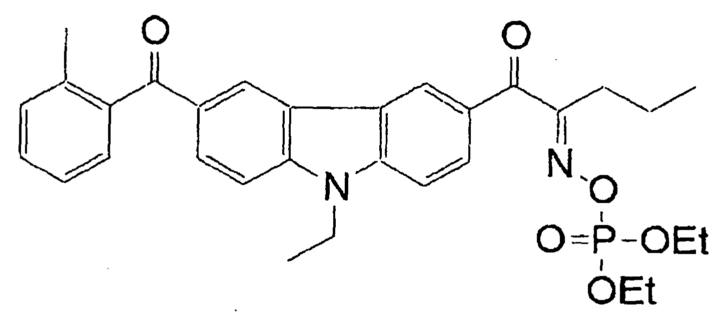

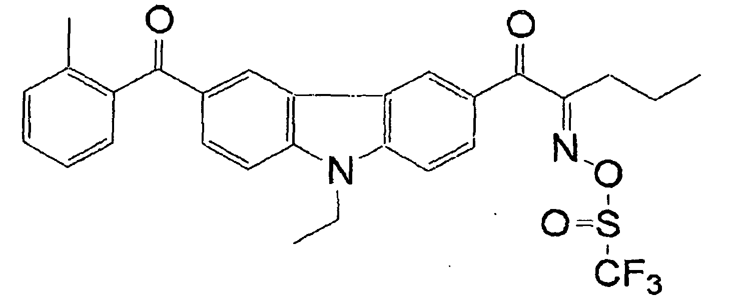

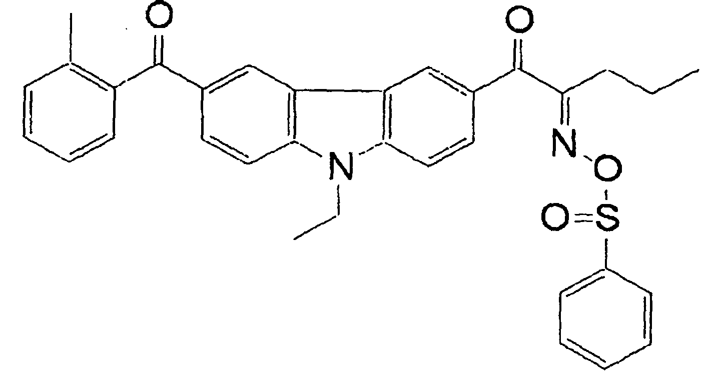

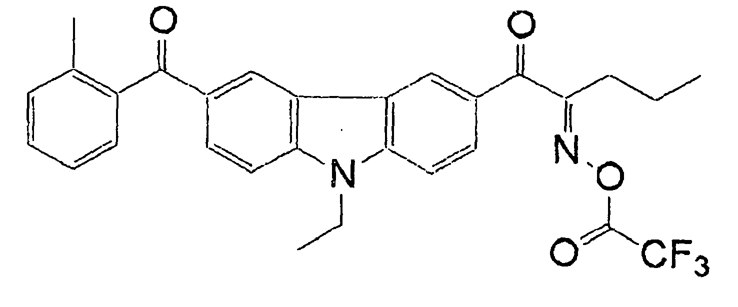

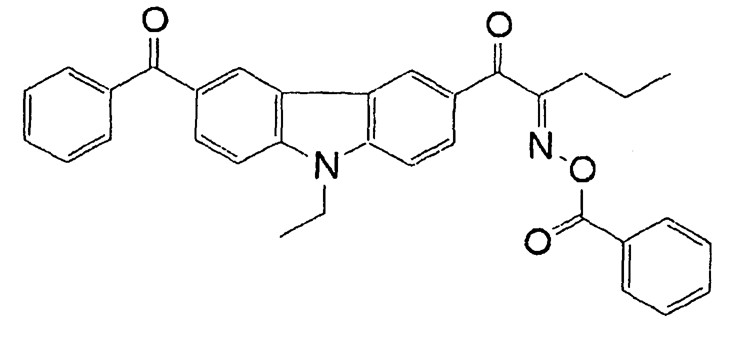

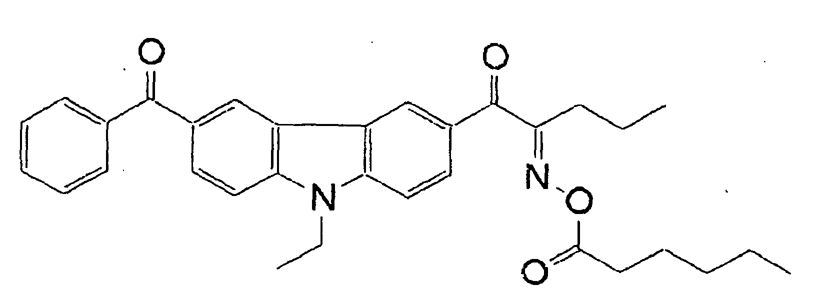

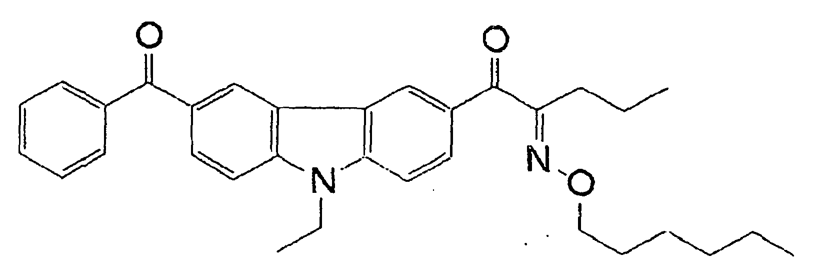

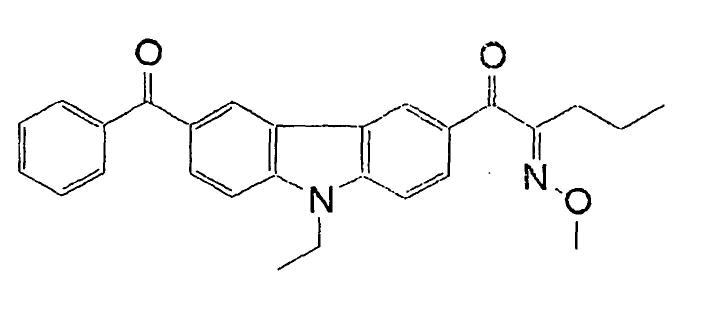

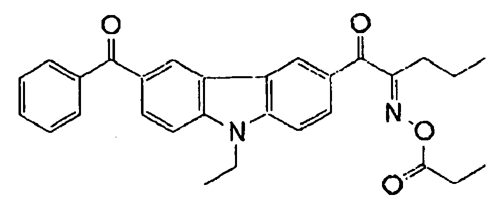

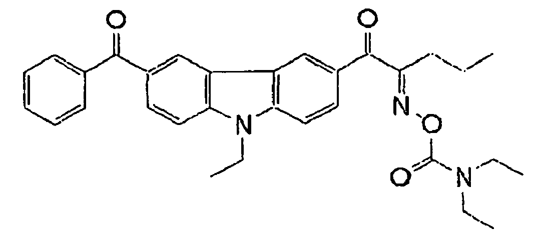

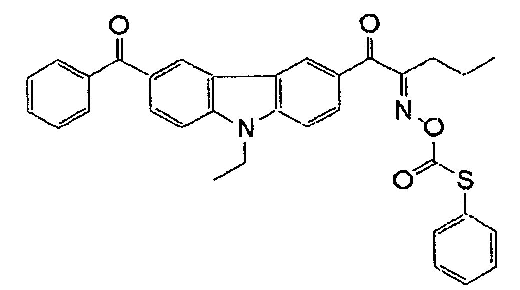

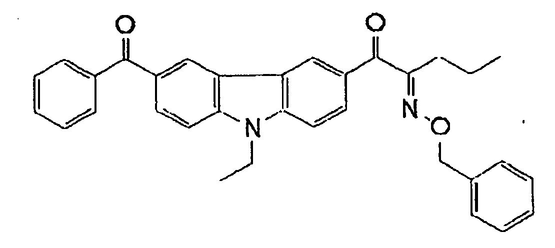

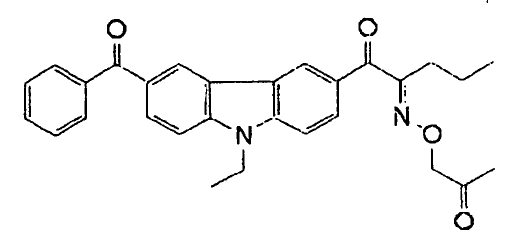

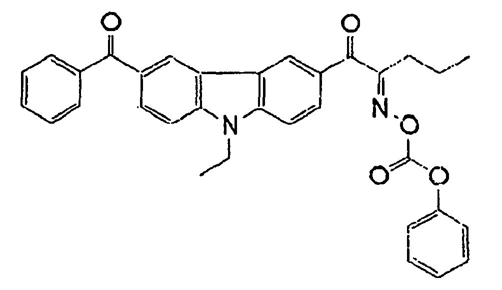

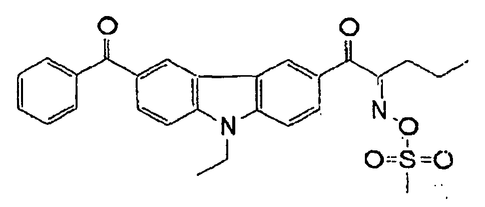

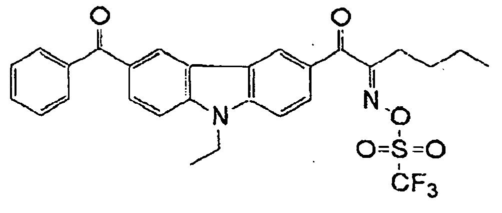

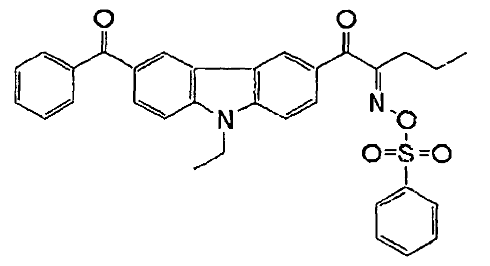

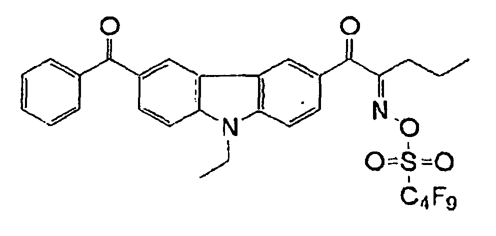

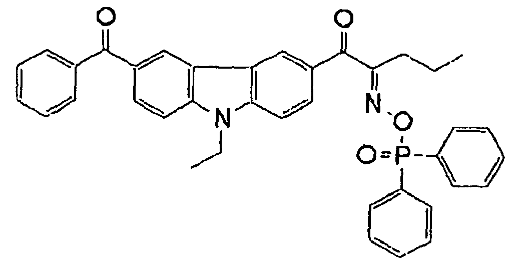

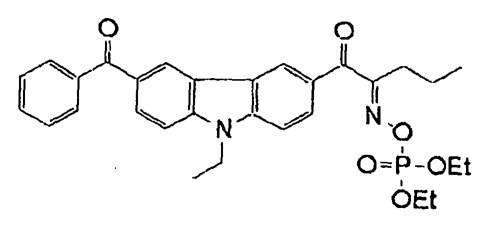

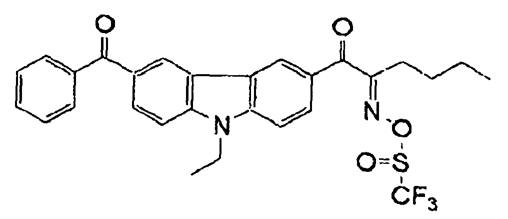

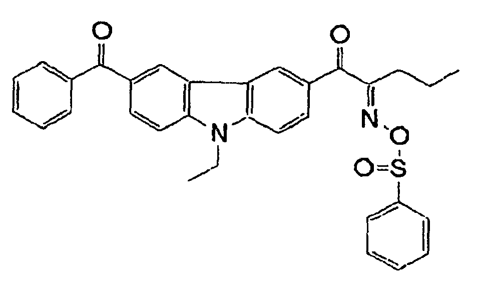

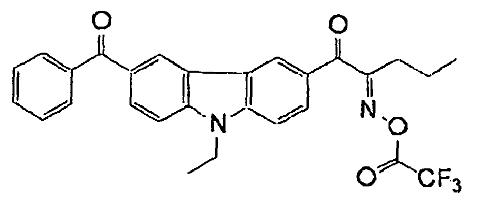

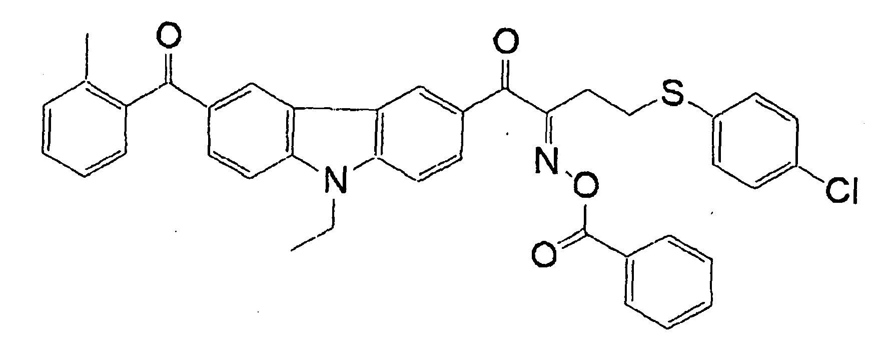

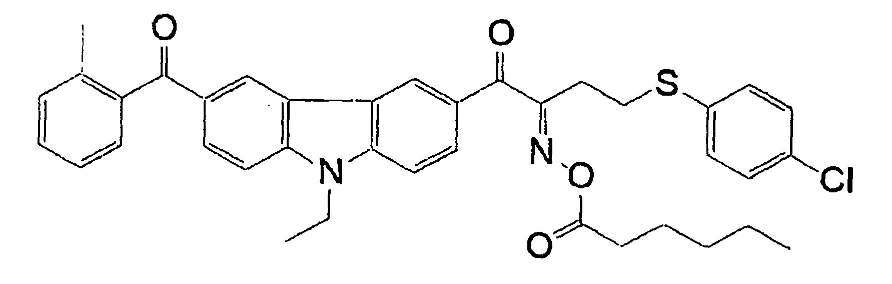

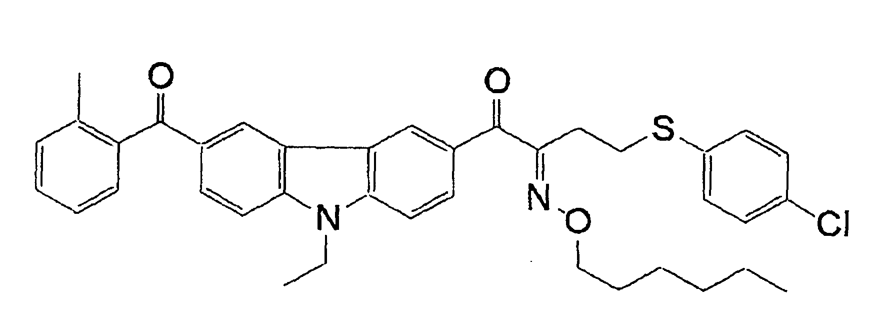

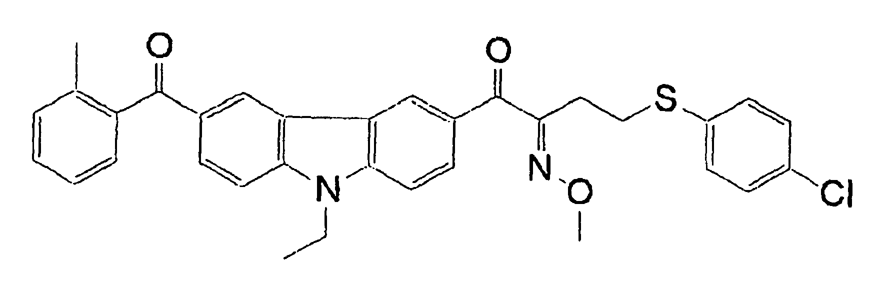

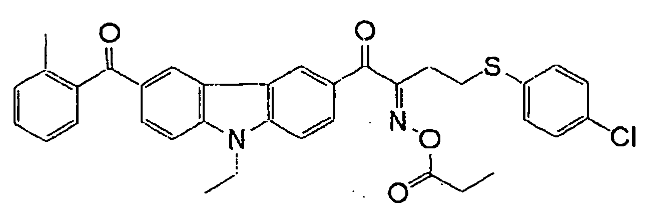

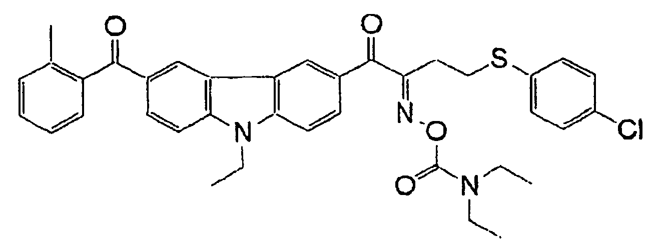

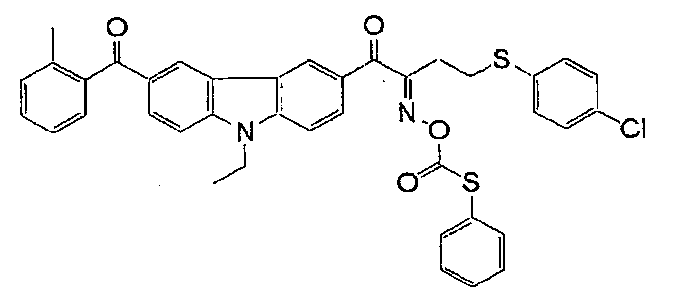

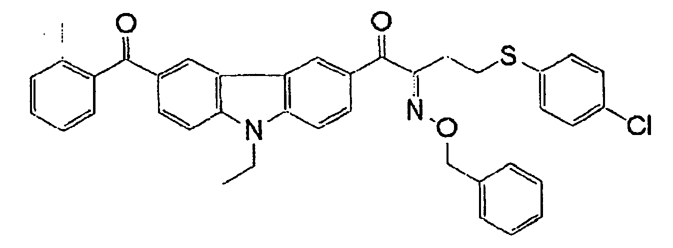

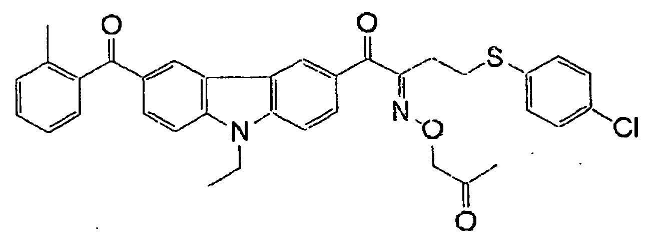

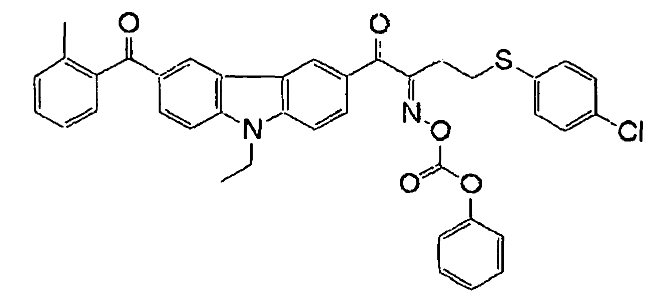

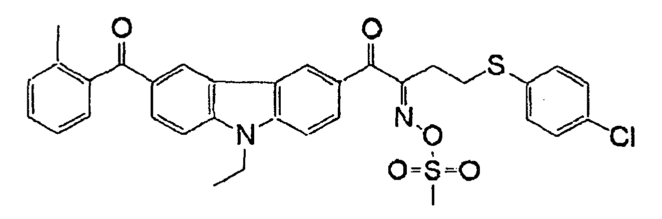

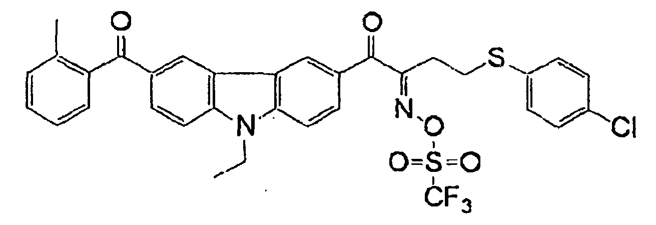

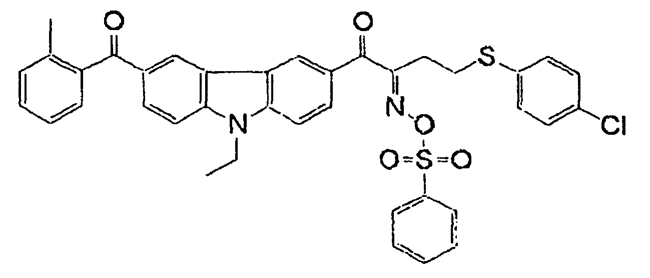

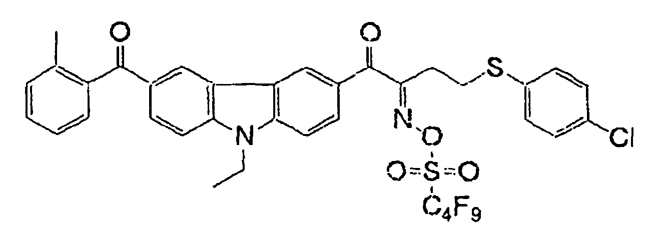

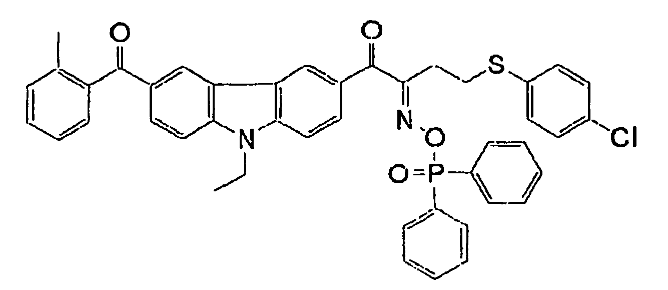

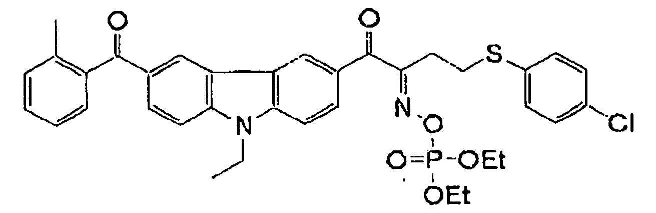

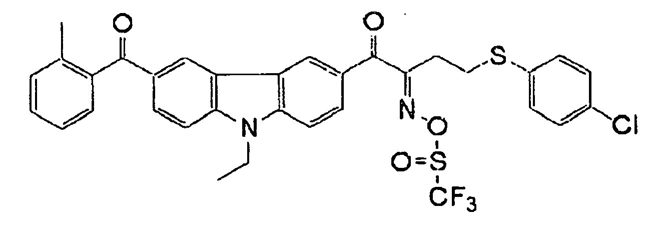

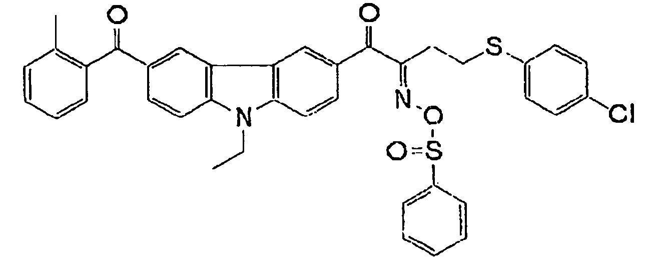

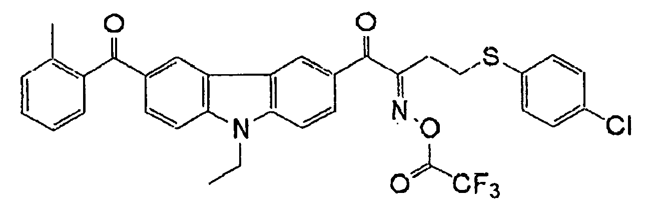

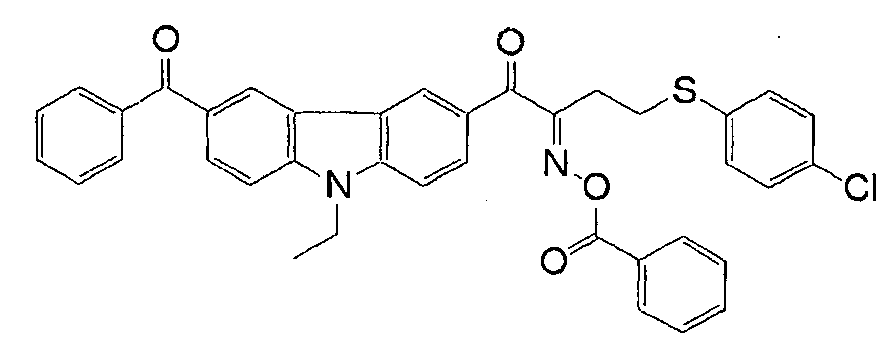

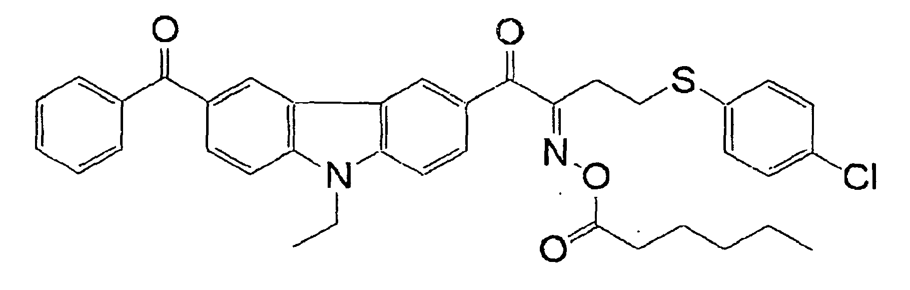

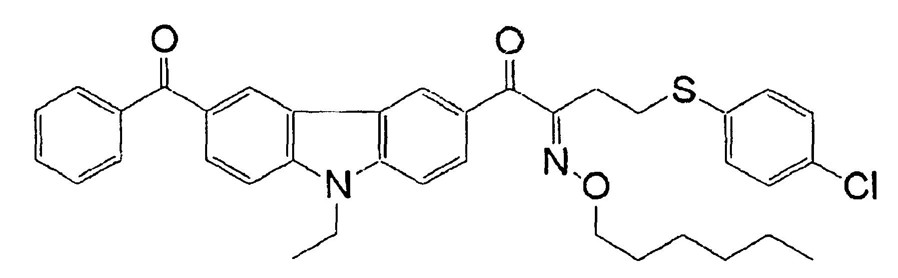

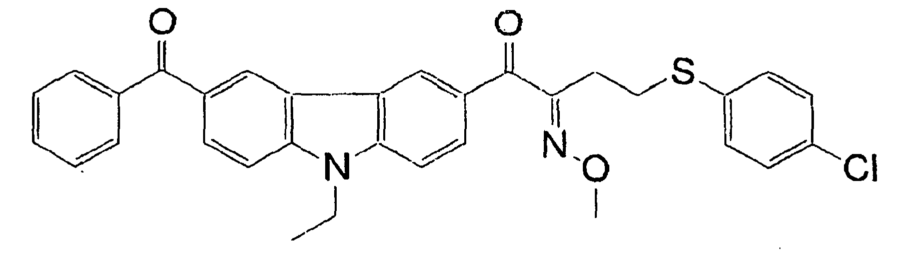

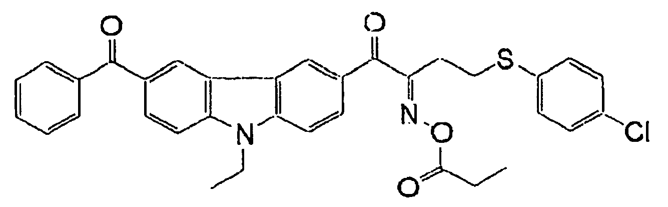

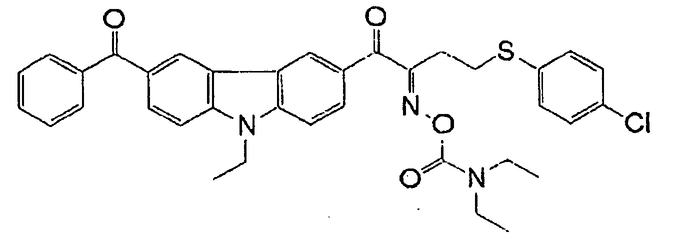

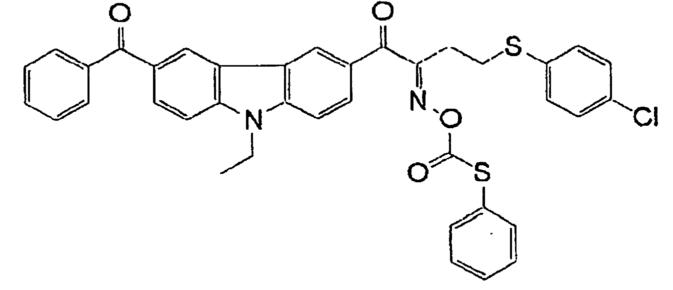

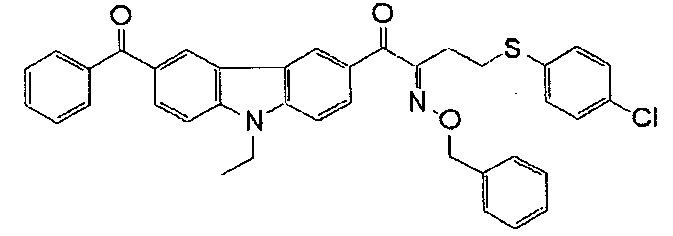

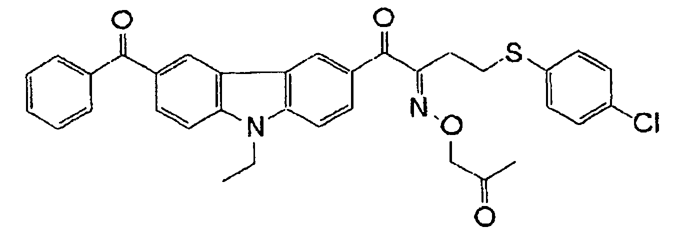

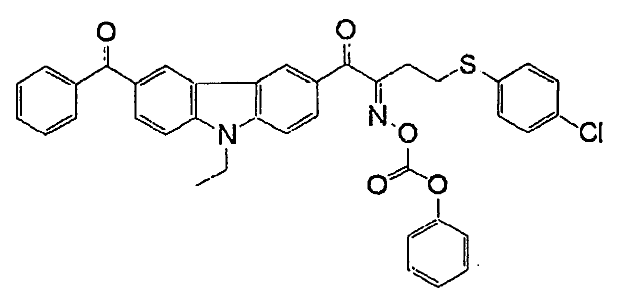

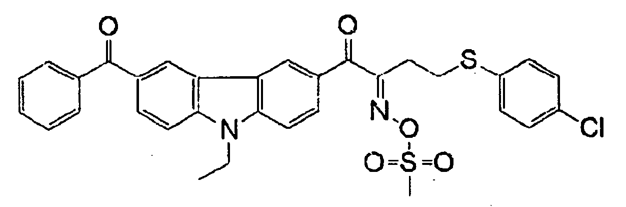

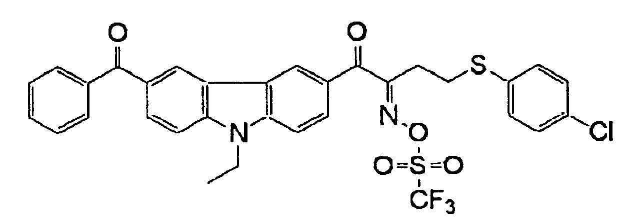

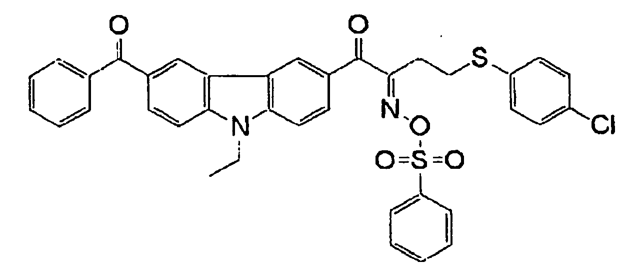

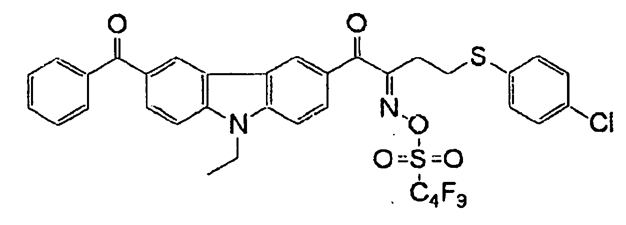

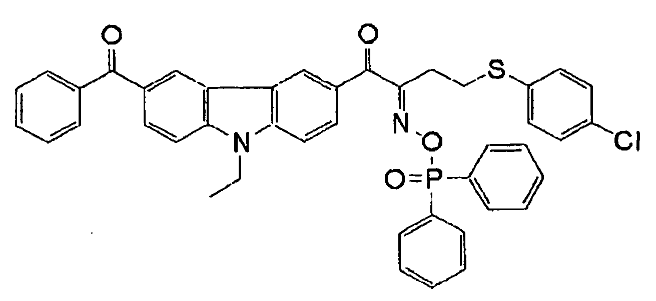

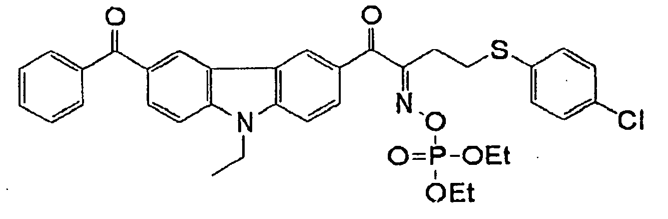

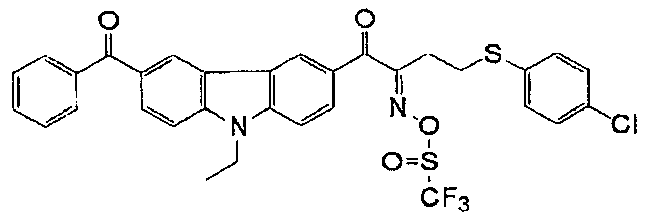

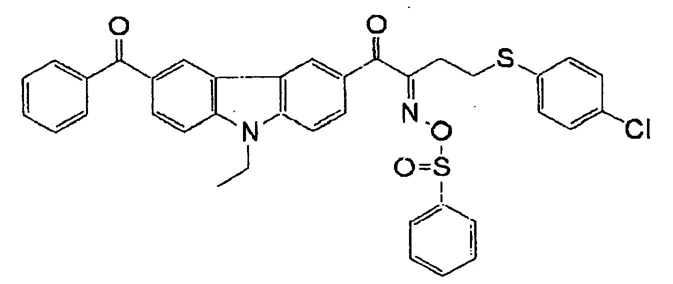

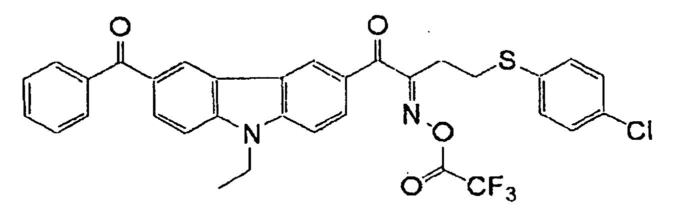

The specific photopolymerization initiator represented by Formula (II) can be synthesized by a method shown below, for example, but a method of synthesizing the specific photopolymerization initiator represented by Formula (II) is not limited thereto.

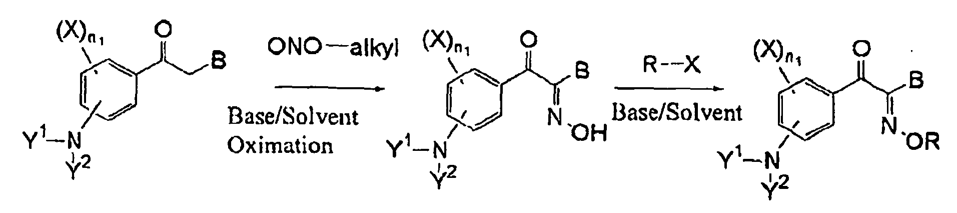

In the method of synthesizing the specific photopolymerization initiator represented by Formula (II), the details of B, R, X, Y¹, Y², and n₁ are as described above in the description of Formula (II).
More specifically, the specific photopolymerization initiator represented by Formula (I) can be synthesized by a method described below, for example.
- Synthesis Example of specific photopolymerization initiator-Ethylcarbazole is dissolved in chlorobenzene. After the solution is cooled to 0°C, aluminum chloride is added thereto. Subsequently o-tolylchloride is added dropwise thereto over 40 minutes. The temperature of the reaction solution is increased to room temperature, and then the reaction solution is stirred for 3 hours. After the reaction solution is cooled to 0°C, aluminum chloride is added thereto. Then 4-chlorobutyrylchloride is added thereto dropwise over 40 minutes, the temperature of the reaction solution is increased to room temperature, and then the reaction solution is stirred for 3 hours. A mixed solution of an aqueous 35 wt% hydrochloric acid solution and distilled water is cooled to 0°C, and the reaction solution is added dropwise to the mixed solution. The precipitated solid is collected by suction filtration, washed with distilled water and methanol, and recrystallized from acetonitrile to obtain Compound A having the following structure.

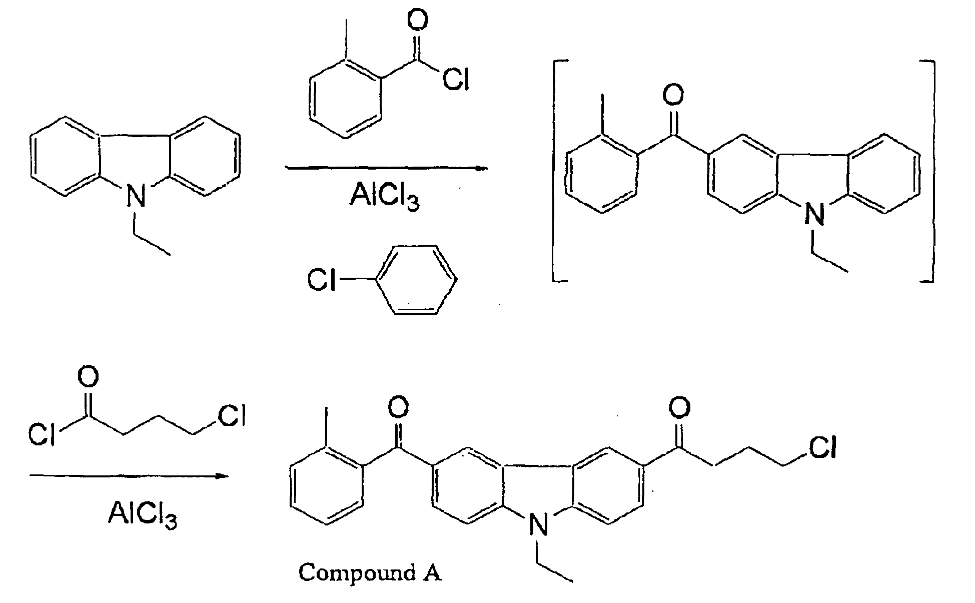

Next, Compound A is dissolved in THF, and 4-chlorobenzenethiol and sodium iodide are added thereto. Subsequently, sodium hydroxide is added to the reaction solution, and the reaction solution is refluxed for 2 hours. Furthermore, after the reaction solution is cooled to 0°C, SM-28 is added dropwise over 20 minutes. The temperature of the reaction solution is increased to room temperature, and then the reaction solution is stirred for 2 hours. Next, after the reaction solution is cooled to 0°C, isopentyl nitrite is added dropwise over 20 minutes. The temperature of the reaction solution is increased to room temperature, and then the reaction solution is stirred for 3 hours. The reaction solution is diluted with acetone, and then an aqueous 0.1N hydrochloric acid solution that has been cooled to 0°C is added dropwise. The precipitated solid is collected by suction filtration, washed with distilled water, and recrystallized from acetonitrile to obtain Compound B having the following structure.

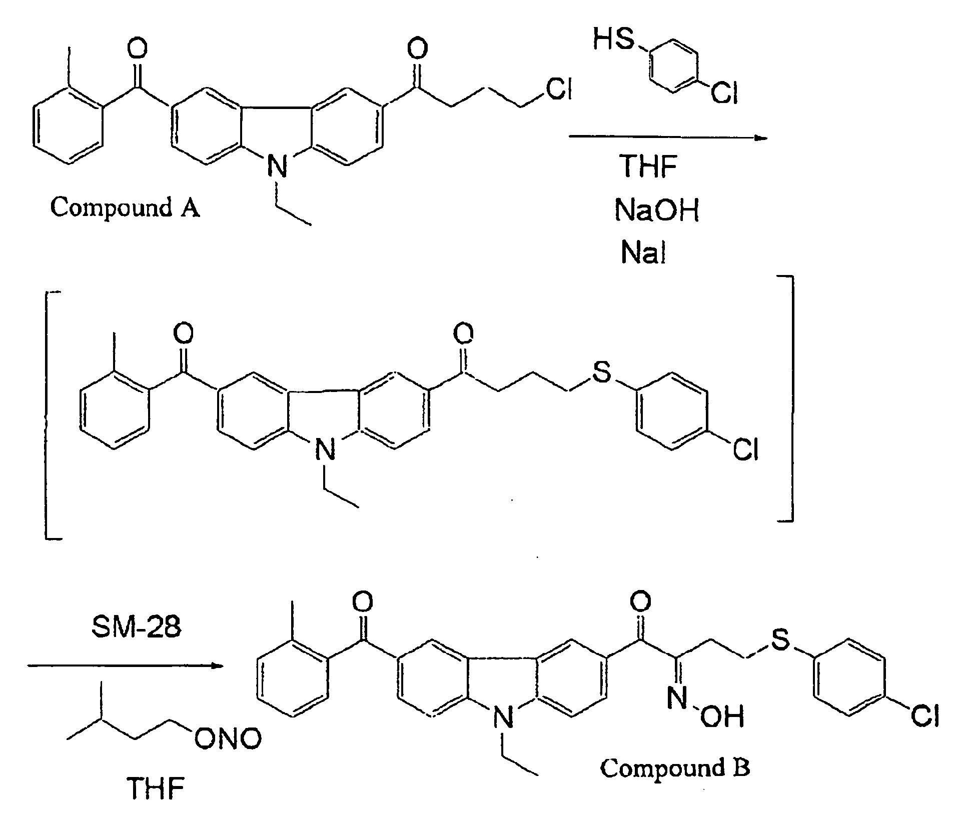

The compound B is dissolved in N-methylpyrrolidone, and then triethylamine is added thereto. Next, after the reaction solution is cooled to 0°C, acetyl chloride is added dropwise over 20 minutes. The temperature of the reaction solution is increased to room temperature, and the reaction solution is stirred for 2 hours. The reaction solution is added dropwise to distilled water that has been cooled to 0°C. The precipitated solid is collected by suction filtration, washed with isopropyl alcohol that has been cooled to 0°C, and then dried to obtain the specific photopolymerization initiator.

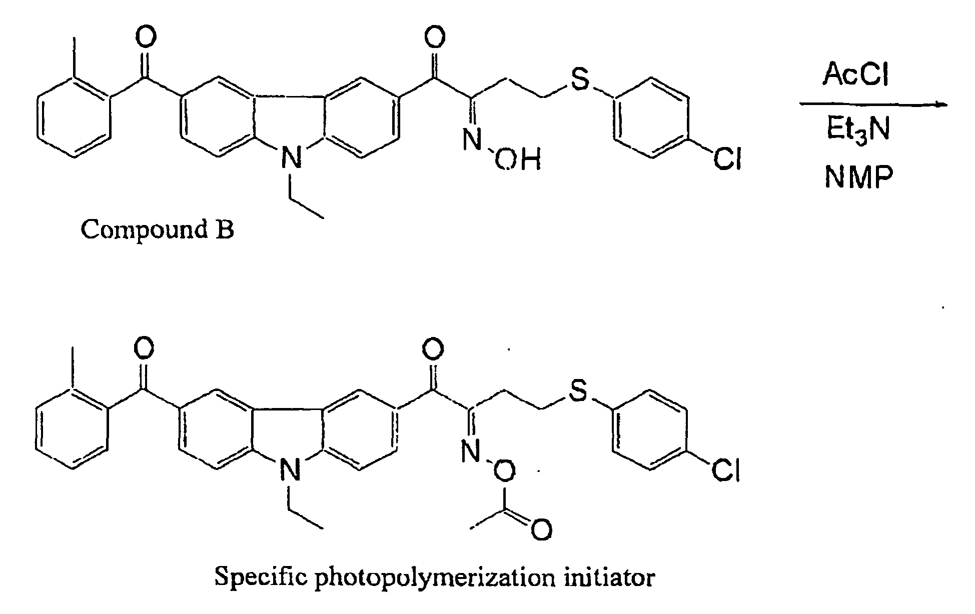

A desired specific photopolymerization initiator represented by Formula (I) can be obtained in a similar manner to the synthesis example described above, by changing, as necessary, ethylcarbazole, o-tolylchloride, and 4-chlorobutyrylchloride to other compounds such that the structure of the desired specific photopolymerization initiator can be obtained.
The structure of the obtained specific photopolymerization initiator can be identified by NMR.

The specific photopolymerization initiator represented by Formula (II) has a maximum absorption wavelength in a wavelength region at or around 365 nm, and is a compound that shows high absorption efficiency for light having a wavelength of 365 nm.

The specific photopolymerization initiator represented by Formula (II) may be used singly or in combination of two or more thereof.

The colored curable composition of the present invention may additionally contain a known photopolymerization initiator other than the specific photopolymerization initiator insofar as the effects of the present invention are not impaired,
The photopolymerization initiator which can be used additionally is a compound which is decomposed by light to thereby initiate and promote the polymerization of the polymerizable compound described later. The additional photopolymerization initiator preferably has absorption in a wavelength region of from 300 to 500 nm. Specific examples thereof include an organic halide compound, an oxydiazole compound, a carbonyl compound, a ketal compound, a benzoin compound, an acridine compound, an organic peroxide compound, an azo compound, a coumarin compound, an azide compound, a metallocene compound, a biimidazole compound, an organic boric acid compound, a disulfonic acid compound, an oxime ester compound, an onium salt compound, and an acylphosphine (oxide) compound.
When a known photopolymerization initiator is used as the additional photopolymerization initiator, the content ratio of the specific photopolymerization initiator to the known photopolymerization initiator (the specific photopolymerization initiator : known photopolymerization initiator) is preferably in the range of from 80:20 to 20:80, more preferably from 75:25 to 30:70, and still more preferably from 70:30 to 40:60 in terms of increasing the sensitivity.

The content of the specific photopolymerization initiator represented by Formula (II) is preferably from 1 to 40 mass%, more preferably from 1.5 to 30 mass%, and particularly preferably from 2.0 to 25 mass%, with respect to the total solid content of the colored curable composition from the viewpoint of increasing the sensitivity and reducing the amount of a residue that remains after development.

### (B) Polymerizable Compound

The colored curable composition of the invention contains (B) a polymerizable compound. The polymerizable compound that can be used in the colored curable composition of the invention may be an addition-polymerizable compound having at least one ethylenic unsaturated double bond and may be selected from compounds each having at least one ethylenic unsaturated terminal bond, preferably two or more ethylenic unsaturated terminal bonds. Such a class of compounds is widely known in the relevant industrial field, and such compounds may be used in the invention without particular limitations. Such compounds may be in the chemical form of a monomer or a prepolymer, specifically a dimer, a trimer or an oligomer, or any mixture thereof or any copolymer thereof. Examples of monomers and copolymers thereof include unsaturated carboxylic acids (such as acrylic acid, methacrylic acid, itaconic acid, crotonic acid, isocrotonic acid, and maleic acid), esters thereof, and amides thereof. Esters of unsaturated carboxylic acids and aliphatic polyhydric alcohol compounds, or amides of unsaturated carboxylic acids and aliphatic polyamines, are preferably used. Also preferably used are addition reaction products of unsaturated carboxylic acid esters or amides having a nucleophilic substituent such as a hydroxyl group, an amino group or a mercapto group, with monofunctional or polyfunctional isocyanates or epoxy compounds, and dehydration condensation reaction products of such esters or amides with monofunctional or polyfunctional carboxylic acids. Also preferred are addition reaction products of unsaturated carboxylic acid esters or amides having an electrophilic substituent such as an isocyanate group or an epoxy group, with monofunctional or polyfunctional alcohols, amines or thiols, and substitution reaction products of unsaturated carboxylic acid esters or amides having a halogen group or a leaving substituent such as a tosyloxy group, with monofunctional or polyfunctional alcohols, amines, or thiols. Other examples include compounds obtained by replacing the unsaturated carboxylic acid in the above examples by an unsaturated phosphonic acid, styrene, vinyl ether, or the like.

Examples of the monomer of the ester of an aliphatic polyhydric alcohol compound and an unsaturated carboxylic acid include acrylic esters such as ethyleneglycol diacrylate, triethyleneglycol diacrylate, 1,3-butanediol diacrylate, tetramethyleneglycol diacrylate, propyleneglycol diacrylate, neopentylglycol diacrylate, trimethylolpropane triacrylate, trimethylolpropane tri(acryloyloxypropyl)ether, trimethylolethane triacrylate, hexanediol diacrylate, 1,4-cyclohexanediol diacrylate, tetraethyleneglycol diacrylate, pentaerythritol diacrylate, pentaerythritol triacrylate, pentaerythritol tetraacrylate, dipentaerythritol diacrylate, dipentaerythritol hexaacrylate, sorbitol triacrylate, sorbitol tetraacrylate, sorbitol pentaacrylate, sorbitol hexaacrylate, tri(acryloyloxyethyl)isocyanurate, polyester acrylate oligomers, and isocyanuric acid EO-modified triacrylate.

Examples of the monomer of the ester also include methacrylic esters such as tetramethyleneglycol dimethacrylate, triethyleneglycol dimethacrylate, neopentylglycol dimethacrylate, trimethylolpropane trimethacrylate, trimethylolethane trimethacrylate, ethyleneglycol dimethacrylate, 1,3-butanediol dimethacrylate, hexanediol dimethacrylate, pentaerythritol dimethacrylate, pentaerythritol trimethacrylate, pentaerythritol tetramethacrylate, dipentaerythritol dimethacrylate, dipentaerythritol hexamethacrylate, sorbitol trimethacrylate, sorbitol tetramethacrylate, bis[p-(3-methacryloxy-2-hydroxypropoxy)phenyl]dimethylmethane, and bis[p-(methacryloxyethoxy)phenyl]dimethylmethane.

Examples of the monomer of the ester also include itaconic esters such as ethyleneglycol diitaconate, propyleneglycol diitaconate, 1,3-butanediol diitaconate, 1,4-butanediol diitaconate, tetramethylene glycol diitaconate, pentaerythritol diitaconate, and sorbitol tetraitaconate; crotonic esters such as ethyleneglycol dicrotonate, tetramethylene glycol dicrotonate, pentaerythritol dicrotonate, and sorbitol tetradicrotonate; isocrotonic esters such as ethyleneglycol diisocrotonate, pentaerythritol diisocrotonate, and sorbitol tetraisocrotonate; and maleic esters such as ethyleneglycol dimaleate, triethyleneglycol dimaleate, pentaerythritol dimaleate, and sorbitol tetramaleate.

Examples of other esters include the aliphatic alcohol esters described in Japanese Patent Publication (JP-B) No. 51-47334 and JP-A No. 57-196231, the aromatic skeleton-containing compounds described in JP-A Nos. 59-5240, 59-5241 and 02-226149, and the amino group-containing compounds described in JP-A No. 01-165613. A mixtures of monomers selected from the ester monomers described above may also be used.

Examples of the monomer of the amide of an aliphatic polyamine compound and an unsaturated carboxylic acid include methylenebis-acrylamide, methylenebis-methacrylamide, 1,6-hexamethylenebis-acrylamide, 1,6-hexamethylenebis-methacrylamide, diethylenetriaminetrisacrylamide, xylylenebisacrylamide, and xylylenebismethacrylamide.
Examples of other preferred amide monomers include the cyclohexylene structure-containing compounds described in JP-B No. 54-21726.

Addition-polymerizable urethane compounds produced by an addition reaction of isocyanate with a hydroxyl group are also preferred, examples of which include the vinyl urethane compounds described in JP-B No. 48-41708, which have two or more polymerizable vinyl groups within a molecule and are produced by adding a hydroxyl group-containing vinyl monomer represented by Formula (α) below to a polyisocyanate compound having two or more isocyanate groups within a molecule.

CH₂ = C(R⁴) COOCH₂CH (R⁵) OH (α)

In Formula (α) R⁴ and R⁵ each represent H or CH₃.

Moreover, urethane acrylates disclosed in JP-A No. 51-37193 and JP-B Nos. 2-32293 and 2-16765 and urethane compounds having an ethylene oxide skeleton disclosed in JP-B Nos. 58-49860, 56-17654, 62-39417, and 62-39418 are preferable. Furthermore, when addition-polymerizable compounds having an amino structure and/or a sulfide structure in the molecule, which are disclosed in JP-A Nos. 63-277653, 63-260909, and 1-105238, are used, a colored curable composition that is remarkably excellent in photoreactive speed can be obtained.

Other examples include polyfunctional acrylates and methacrylates, such as polyester acrylates and methacrylates and epoxy (meth)acrylates obtained by reacting an epoxy resin and (meth)acrylic acid, such as those disclosed in JP-A No. 48-64183 and JP-B Nos. 49-43191 and 52-30490; specific unsaturated compounds disclosed in JP-B Nos. 46-43946, 1-40337, and 1-40336, and vinyl phosphonic acid compounds disclosed in JP-A No. 2-25493. Moreover, in a certain case, a structure containing a perfluoroalkyl group disclosed in JP-A No. 61-22048 is suitably used. Furthermore, substances that are introduced, as photocurable monomers and photocurable oligomers, in Nihon Secchaku Kyoukai-Shi (Journal of the Adhesion Society of Japan) Vol.20, No.7, pp. 300-308 (1984) are also usable.

Details of how to use the addition-polymerizable compounds, such as what structure should be used, whether they should be used alone or in combination, or what amount should be added, may be freely determined depending on the final performance design of the colored curable composition. For example, they may be selected from the following viewpoints.
In view of sensitivity, a structure having a higher content of the unsaturated groups per molecule is preferable, and difunctional or higher functional structures are preferred in many cases. In order to increase the strength of the cured film, tri- or higher-functional structures are preferred. A method of using a combination of compounds having different numbers of functional groups and/or different types of polymerizable groups (for example, compounds selected from an acrylic ester, a methacrylic ester, a styrene compound, a vinyl ether compound) is also effective for controlling both of sensitivity and strength.
How to select and use the addition-polymerizable compound is also an important factor for the compatibility with or dispersibility to the specific photopolymerization initiator, the colorant (pigment and/or dye), and other components contained in the colored curable composition of the invention (such as a binder polymer). For example, in some cases, the compatibility may be improved by using a low-purity compound or by using a combination of two or more compounds. A particular structure may also be selected in order to improve adhesion to a hard surface of a support or the like.

From the viewpoint of the balance between the curing sensitivity and the formation of a residue, the content of the polymerizable compound is preferably from 50 to 5 mass%, more preferably from 45 to 10 mass%, and still more preferably from 40 to 15 mass% with respect to the total solid content of the colored curable composition of the present invention.

### <(C) Colorant>

The colored curable composition of the present invention contains (C) a colorant.
Since the colored curable composition of the present invention contains the specific photopolymerization initiator having excellent sensitivity to a 365 nm light source, which is a short wavelength light source, the colored curable composition of the present invention can be cured with high sensitivity even when a colorant is contained at a high concentration.

The colorant used in the colored curable composition of the present invention is not limited. Conventional various dyes and pigments can be used singly or as a mixture of two or more thereof, and can be suitably selected according to the application of the colored curable composition. When the colored curable composition of the present invention is used for producing a color filter, the colorant may be either a chromatic color colorants, such as R, G, or B, which form a color pixel of a color filter or a black colorant generally used for forming a black matrix.

Hereinafter, a colorant that can be used in the colored curable composition of the present invention will be described in detail, taking a colorant suitable for a color filter as an example.
As a chromatic color pigment, conventional various inorganic pigments or organic pigments can be used. Considering that a pigment having a high transmittance are preferable irrespective of whether the pigment is an inorganic pigment or an organic pigment, the pigment to be used preferably has a particle diameter that is as small as possible. Also considering handling properties, the average particle diameter of the pigment is preferably from 0.01 µm to 0.1 µm, and more preferably from 0.01 µm to 0.05 µm.

Examples of the inorganic pigment include metallic compounds, such as metal oxides and metal complexes. Specific examples thereof include metal oxides, such as an oxide of iron, cobalt, aluminum, cadmium, lead, copper, titanium, magnesium, chromium, zinc, or antimony, and complex oxides of the above-mentioned metals.

Examples of the organic pigment include C. I. Pigment Yellow 11, 24, 31, 53, 83, 93, 99, 108, 109, 110, 138, 139, 147, 150, 151, 154, 155, 167, 180, 185, 199; C. I. Pigment Orange 36, 38, 43, 71; C. I. Pigment Red 81, 105, 122, 149, 150, 155, 171, 175, 176, 177, 209, 220, 224, 242, 254, 255, 264, 270; C. I. Pigment Violet 19,23, 32, 39; C. I. Pigment Blue 1, 2, 15, 15:1, 15:3, 15:6, 16, 22, 60, 66; C. I. Pigment Green 7, 36, 37; C. I. Pigment Brown 25, 28; C. I. Pigment Black 1, 7; and carbon black.

In particular, in the present invention, pigments having a basic N atom in the structural formula thereof can be preferably used. The pigments having a basic N atom exhibit favorable dispersibility in a colored curable composition. Although the reason therefor is not fully understood, excellent affinity between a photosensitive polymerization component and a pigment is presumed to exert some influence.

Pigments which can be preferably used in the present invention include, but are not limited to, the following.

Examples of the pigments include C. I. Pigment Yellow 11, 24, 108, 109, 110, 138, 139, 150, 151, 154, 167, 180, 185; C.I. Pigment Orange 36, 71; C. I. Pigment Red 122, 150, 171, 175, 177, 209, 224, 242, 254, 255, 264; C.I. Pigment Violet 19, 23, 32; C. I. Pigment Blue 15:1, 15:3, 15:6, 16, 22, 60, 66; and C. I. Pigment Black 1.

The organic pigment can be used singly or in combination of two or more thereof so as to increase color purity. Specific examples of the combination will be described below. For example, a red pigment may be an anthraquinone pigment, a perylene pigment, or a diketopyrrolopyrrole pigment, or a mixture of at least one thereof and a disazo yellow pigment, isoindoline yellow pigment, quinophthalone yellow pigment, or perylene red pigment. Examples of the anthraquinone pigment include C.I. Pigment Red 177.
Examples of the perylene pigment include C.I. Pigment Red 155 and C.I. Pigment Red 224. Examples of the diketopyrrolopyrrole pigment include C.I. Pigment Red 254. In terms of color reproduction properties, it is preferable to mix such a pigment with C.I. Pigment Yellow 139. The mass ratio of the yellow pigment to the red pigment (yellow pigment/red pigment) is preferably in the range of from 5/100 to 50/100. When the mass ratio is 4/100 or lower, it may be difficult to reduce transmittance to light having a wavelength of from 400 to 500 nm, and the color purity may not be increased. When the mass ratio is 51/100 or higher, the main absorption wavelength shifts to a shorter wavelength, and the deviation from the NTSC target color may be large. In particular, the mass ratio in the range of from 10/100 to 30/100 is most preferable. In the case of a combination of red pigments, the mass ratio thereof may be adjusted in accordance with the chromaticity.

Moreover, as a green pigment, a phthalocyanine halide pigment can be used singly, or a mixture of a phthalocyanine halide pigment and a disazo yellow pigment, a quinophthalone yellow pigment, an azomethine yellow pigment, or an isoindoline yellow pigment can be used. As an example of the combination, a mixture of C. I. Pigment Green 7, 36, or 37 and C.I. Pigment Yellow 83, C.I. Pigment Yellow 138, C.I. Pigment Yellow 139, C.I. Pigment Yellow 150, C.I. Pigment Yellow 180, or C.I. Pigment Yellow 185 is preferable. The mass ratio of the yellow pigment to the green pigment (yellow pigment/green pigment) is preferably from 5/100 to 150/100. When the mass ratio is lower than 5/100, it is difficult to reduce the transmittance to light having a wavelength of from 400 to 450 nm, and the color purity may not be increased. When the mass ratio is higher than 150/100, the main absorption wavelength shifts to a longer wavelength, and the deviation from the NTSC target color may be large. The mass ratio in the range of from 30/100 to 120/100 is particularly preferable.

As a blue pigment, a phthalocyamine pigment can be used singly, or a mixture of a phthalocyanine pigment and a dioxazine violet pigment can be used. For example, a mixture of C.I. Pigment Blue 15:6 and C.I. Pigment Violet 23 is preferable. The mass ratio of the violet pigment to the blue pigment (violet pigment/blue pigment) is preferably from 0/100 to 30/100, and more preferably 10/100 or lower.

As a pigment for a black matrix, carbon, titanium carbon, an iron oxide, a titanium oxide can be used singly, or a mixture thereof can be used. A combination of carbon and titanium carbon is preferable. The mass ratio of titanium carbon to carbon (titanium carbon/carbon) is preferably in the range of from 0/100 to 60/100. When the mass ratio is 60/100 or higher, the dispersion stability may decrease.

In the colored curable composition of the present invention, when the colorant is a dye, a colored composition in which the dye is uniformly dissolved can be obtained.
There is no limitation on the dyes which can be used as the colorant to be contained in the colored curable composition of the present invention, and conventional dyes for color filters can be used. For example, coloring materials disclosed in the following documents may be used, for example: JP-A Nos. 64-90403, 64-91102, 1-94301, and 6-11614, Japanese Patent No. 2592207, U.S. Pat, No. 4,808,501, U.S. Pat. No. 5,667,920, U.S. Pat. No. 5,059,500, JP-A Nos. 5-333207, 6-35183, 6-51115, 6-194828, 8-211599, 4-249549, 10-123316, 11-302283, 7-286107, 2001-4823, 8-15522, 8-29771, 8-146215, 11-343437, 8-62416, 2002-14220, 2002-14221, 2002-14222, 2002-14223, 8-302224, 8-73758, 8-179120, and 8-151531.

In terms of a chemical structure, for example, the following dyes may be used: a pyrazole azo dye, an anilino azo dye, a triphenylmethane dye, an anthraquinone dye, an anthrapyridone dye, a benzylidene dye, an oxonol dye, a pyrazolotriazole azo dye, a pyridone azo dye, a cyanine dye, a phenothiazine dye, a pyrrolopyrazole azomethine dye, a xanthene dye, a phthalocyanine dye, a benzopyrane dye, and an indigo dye.

Moreover, in the case of resists to be developed with water or alkali, there are cases in which an acid dye and/or a derivative thereof can be preferably used from the viewpoint of thoroughly removing a binder and/or dye in a non-irradiated region by development.
Further, a direct dye, a basic dye, a mordant dye, an acid mordant dye, an azoic dye, a disperse dye, an oil-soluble dye, a food dye and/or derivatives thereof, for example, are also usable.

There is no limitation on the acid dye insofar as the dye has an acidic group such as a sulfonic acid group or a carboxylic acid group. The acid dye may be selected in consideration of all of the required properties, such as solubility in an organic solvent or a developer, salt-forming properties with a basic compound, absorbance, interaction with other components in a composition, light-fastness, and heat resistance.
Specific examples of the acid dye include, but are not limited to, the following: acid alizarin violet N; acid black 1, 2, 24, 48; acid blue 1,7,9,15,18,23,25,27,29,40,45, 62, 70, 74, 80, 83, 86, 87, 90, 92, 103, 112, 113, 120, 129, 138, 147, 158, 171, 182, 192, 243, 324:1; acid chrome violet K; acid Fuchsin; acid green 1, 3, 5, 9, 16, 25, 27, 50; acid orange 6, 7, 8, 10, 12, 50, 51, 52, 56, 63, 74, 95; acid red 1, 4, 8, 14, 17, 18, 26, 27, 29, 31, 34, 35, 37, 42, 44, 50, 51, 52, 57, 66, 73, 80, 87, 88, 91, 92, 94, 97, 103, 111, 114, 129, 133, 134, 138, 143, 145, 150, 151, 158, 176, 183, 198, 211, 215, 216, 217, 249, 252, 257, 260, 266, 274; acid violet 6B, 7, 9, 17, 19; acid yellow 1, 3, 7, 9, 11, 17, 23, 25, 29, 34, 36, 42, 54, 72, 73, 76, 79, 98, 99, 111, 112, 114, 116, 184, 243; Food Yellow 3; and derivatives of these dyes.

Among the above, the following dyes and derivatives thereof are preferable as the acid dye: acid black 24; acid blue 23, 25, 29, 62, 80, 86, 87, 92, 138, 158, 182, 243, 324:1; acid orange 8, 51, 56, 63, 74; acid red 1, 4, 8, 34, 37, 42, 52, 57, 80, 97, 114, 143, 145, 151, 183, 217; acid violet 7; acid yellow 17, 25, 29, 34, 42, 72, 76, 99, 111, 112, 114, 116, 184, 243; acid green 25; and derivatives of these dyes.
Moreover, an azo acid dye, a xanthene acid dye, and a phthalocyanine acid dye are also preferable besides the above dyes. Acid dyes, such as C.I. Solvent Blue 44, 38; C.I. Solvent Orange 45; Rhodamine B; and Rhodamine 110, and derivatives of these dyes are also used preferably.

In particular, the colorant is preferably selected from a triallyl methane colorant, an anthraquinone colorant, an azomethine colorant, a benzylidene colorant, an oxonol colorant, a cyanine colorant, a phenothiazine colorant, a pyrrolopyrazole azomethine colorant, a xanthene colorant, a phthalocyanine colorant, a benzopyran colorant, an indigo colorant, a pyrazole azo colorant, an anilino azo colorant, a pyrazolotriazole azo colorant, a pyridone azo colorant, and an anthrapyridone colorant.

The colorant that can be used in the colored curable composition of the present invention is preferably a dye or a pigment whose average particle diameter r (unit: nm) satisfies the relationship, 20 ≤ r ≤ 300, more preferably, 125 ≤ r ≤ 250, and particularly preferably, 30 ≤ r ≤ 200. By the use of a pigment having such an average particle diameter r, red pixels and green pixels that have a high contrast ratio and a high light transmittance can be obtained. The "average particle diameter" as used herein refers to an average particle diameter of secondary particles in which primary particles (single microcrystals) of a pigment are aggregated.
With respect to the particle diameter distribution of the secondary particles of the pigment that can be used in the present invention (hereinafter simply referred to as a "particle diameter distribution"), it is preferable that the secondary particles having a diameter within the range of (average particle diameter - 100 nm) to (average particle diameter + 100 nm) be more than 70 mass%, and preferably 80 mass%, with respect to all the secondary particles.

The pigment having the above-mentioned average particle diameter and particle diameter distribution can be prepared by grinding, mixing and dispersing a commercially-available pigment and one or more other optional pigments, which are preferably in the form of a pigment mixed liquid in which the pigment(s) are mixed with a dispersant and a solvent, using a grinder such as a bead mill and a roll mill. The average particle diameter of the optional pigments generally exceeds 300 nm. The pigment thus obtained generally takes a form of a pigment dispersion liquid.

The content of the colorant contained in the colored curable composition of the present invention is preferably from 50 mass% to 90 mass%, more preferably from 55 mass% to 85 mass%, and still more preferably from 60 mass% to 80 mass%, with respect to the total solid content of the colored curable composition, from the viewpoint of improving the color valency and reducing a residue formed at the time of development.
An excessively low content of the colorant may prevent a color filter produced using the colored curable composition of the present invention from having an adequate chromaticity. In contrast, an excessively high content of the colorant may lead to reduction in the film strength due to insufficient progression of the photo-curing reaction, and may narrow the development latitude at the time of alkaline development. However, the specific photopolymerization initiator used in the present invention shows remarkable effect in improving the sensitivity due to its high light absorption efficiency, even when the colorant is contained at a high concentration in the colored curable composition.
- Pigment dispersant-
   When the colored curable composition of the present invention contains a pigment as the colorant, it is preferable to add a pigment dispersant from the viewpoint of increasing the dispersibility of the pigment.

Examples of the pigment dispersant that can be used in the present invention include high-molecular-weight dispersants [e.g., polyamideamine and salts thereof, polycarboxylic acid and salts thereof, high-molecular-weight unsaturated acid esters, modified polyurethanes, modified polyesters, modified poly(meth)acrylates, (meth)acrylic copolymers, naphthalene sulfonic acid formalin condensates], polyoxyethylene alkyl phosphate, polyoxyethylene alkylamine, alkanolamine, and pigment derivatives.
The high-molecular-weight dispersants can be further classified into straight-chain polymers, terminal-modified polymers, graft polymers, and block polymers according to their structures.

The high molecular weight dispersant adsorbs to the surface of a pigment and functions to prevent re-aggregation. Therefore, a terminal-modified polymer, a graft polymer, and a block polymer that have an anchor moiety to a pigment surface can be mentioned as a preferable structure.
On the other hand, a pigment derivative has a property to promote adsorption of a high-molecular-weight dispersant, which is imparted by modification on the pigment surface.

Specific examples of the pigment dispersant usable in the present invention include Disperbyk-101 (tradename: polyamideamine phosphate), 107 (carboxylic ester), 110 (copolymer containing an acid group), 130 (polyamide),161, 162, 163, 164, 165, 166, 170 (high molecular weight copolymer) and BYK-P104, P105 (tradename: high-molecular-weight unsaturated polycarboxylic acid) manufactured by BYK Chemie; EFKA 4047, 4050, 4010, 4165 (tradename: polyurethane type), EFKA 4330, 4340 (tradename: block copolymer), 4400, 4402 (modified polyacrylate), 5010 (polyester amide), 5765 (high-molecular-weight polycarboxylic acid salt), 6220 (fatty acid polyester), 6745 (phthalocyanine derivative), and 6750 (azo pigment derivative) manufactured by by EFKA; Ajisper PB821, PB822 (tradename) manufactured by Ajinomoto Fine-Techno Co., Ltd.; FLOWLEN TG-710 (tradename: urethane oligomer) and POLYFLOW No. 50E, No. 300 (tradename: acrylic copolymer) manufactured by Kyoeisha Chemical Co., Ltd.; DISPARLON KS-860, 873SN, 874, #2150 (tradename: aliphatic polycarboxylic acid), #7004 (polyether ester), DA-703-50, DA-705, DA-725 manufactured by Kusumoto Chemicals, Ltd.; Demol RN, N (tradename: naphthalenesulfonic acid formalin polycondensate), MS, C, SN-B (tradename: aromatic sulfonic acid formalin polycondensate), HOMOGENOL L-18 (tradename: high molecular weight polycarboxylic acid), Emulgen 920, 930, 935, 985 (tradename: polyoxyethylene nonylphenyl ether), and ACETAMIN 86 (tradename: stearylamine acetate) manufactured by Kao K.K.; Solsperse 5000 (tradename: phthalocyanine derivative), 22000 (azo pigment derivative), 13240 (polyesteramine), 3000, 17000, 27000 (polymer having a function part at a terminal part), 24000, 28000, 32000, 38500 (graft polymer) manufactured by Lubrizol Corporation; and NIKKOL T 106 (tradename: polyoxyethylene sorbitan monooleate), and MYS-IEX (tradename: polyoxyethylene monostearate) manufactured by Nikko Chemicals.

The dispersant may be used singly or in combination of two or more thereof. In the present invention, it is preferable to use a pigment derivative and a high molecular weight dispersant in combination.

The content of the dispersant in the colored curable composition of the present invention is preferably from 1 to 80 mass%, more preferably from 5 to 70 mass%, and still more preferably from 10 to 60 mass%, with respect to the mass of the pigment.
Specifically, when a high-molecular-weight dispersant is used, the amount thereof is preferably in the range of from 5 to 100 mass%, and more preferably in the range of from 10 to 80 mass%, with respect to the mass of the pigment.
When a pigment derivative is used, the amount thereof is preferably in the range of from 1 to 30 mass%, more preferably in the range of from 3 to 20 mass%, and particularly preferably in the range of from 5 to 15 mass%, with respect to the mass of the pigment.

When a pigment as a colorant and a dispersant are used in the colored curable composition of the present invention, the total content of the colorant and dispersant is preferably from 30 mass% to 90 mass%, more preferably from 40 mass% to 85 mass%, and still more preferably from 50 mass% to 80 mass%, with respect to the total solid content of the colored curable composition from the viewpoint of curing sensitivity and color density.

<(D) Alkali-soluble resin having at least one unsaturated double bond>
The composition of the present invention further contains (D) an alkali-soluble resin having at least one unsaturated double bond (hereinafter, also referred to as a "specific alkali-soluble resin"). The alkali-soluble resin functions as a binder component. When the specific alkali-soluble resin is contained, both curability of an exposed portion and alkali-developability of an unexposed portion can be increased, in particular.

In order to improve various properties such as removability of a non-image portion, the specific alkali-soluble resin used in the present invention may have, in its structure, an acid group for imparting alkali-solublility to the resin and at least one unsaturated double bond. Preferable examples of the structure having an unsaturated double bond include a structure having, at a side chain or side chains, at least one selected from the groups represented by the following partial structures (a) to (c). The specific alkali-soluble resin, which is soluble in an aqueous alkaline solution and usable as a binder resin of a negative image recording material, may have, at a side chain or side chains, at least one of a group represented by partial structure (a), a group represented by partial structure (b), and a group represented by partial structure (c). It is a matter of course that the specific alkali-soluble resin may have two or more of a group represented by partial structure (a), a group represented by partial structure (b), and a group represented by partial structure (c), and the specific alkali-soluble resin may have all of a group represented by partial structure (a), a group represented by partial structure (b), and a group represented by partial structure (c) in the same resin.
Hereinafter, side chains represented by the partial structures (a) to (c) will be described in detail.

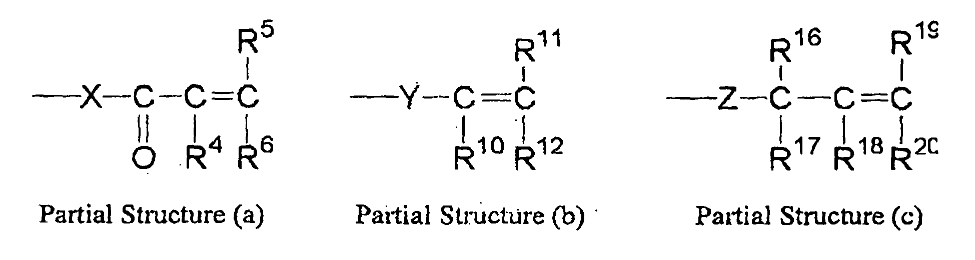

In the partial structures (a) to (c), R⁴ to R⁶, R¹⁰ to R¹², and R¹⁶ to R²⁰ each independently represent a hydrogen atom or a monovalent substituent. X and Z each independently represent an oxygen atom, a sulfur atom, or -N(R²²)-, and R²² represents a hydrogen atom or a monovalent organic group. Y represents an oxygen atom, a sulfur atom, a phenylene group which may have a substituent, or -N(R²³)- and R²³ represents a hydrogen atom or a monovalent organic group.

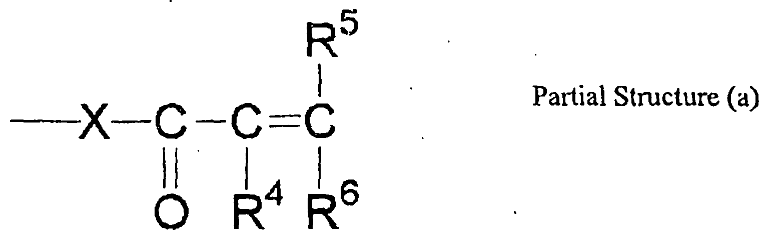

In the partial structure (a), R⁴ to R⁶ each independently represent a monovalent substituent. R⁴ is preferably a hydrogen atom or an alkyl group which may have a substituent and more preferably a hydrogen atom or a methyl group in terms of high radical reactivity. R⁵ and R⁶ each independently represent a hydrogen atom, a halogen atom, an amino group, a carboxyl group, an alkoxycarbonyl group, a sulfo group, a nitro group, a cyano group, an alkyl group which may have a substituent, an aryl group which may have a substituent, an alkoxy group which may have a substituent, an aryloxy group which may have a substituent, an alkylamino group which may have a substituent, an arylamino group which may have a substituent, an alkylsulfonyl group which may have a substituent, and an arylsulfonyl group which may have a substituent. Among the above, in terms of a high radical reactivity, a hydrogen atom, a carboxyl group, an alkoxycarbonyl group, an alkyl group which may have a substituent, and an aryl group which may have a substituent are preferable.

X represents an oxygen atom, a sulfur atom, or -N(R²²)-, and R²² represents a hydrogen atom or a monovalent organic group. R²² may be an alkyl group which may have a substituent. Especially, in terms of high radical reactivity, a hydrogen atom, a methyl group, an ethyl group, and an isopropyl group are preferable.

Here, examples of introducible substituents include an alkyl group, an alkenyl group, an alkynyl group, an aryl group, an alkoxy group, an aryloxy group, a halogen atom, an amino group, an alkylamino group, an arylamino group, a carboxyl group, an alkoxycarbonyl group, a sulfo group, a nitro group, a cyano group, an amide group, an alkylsulfonyl group, and an arylsulfonyl group.

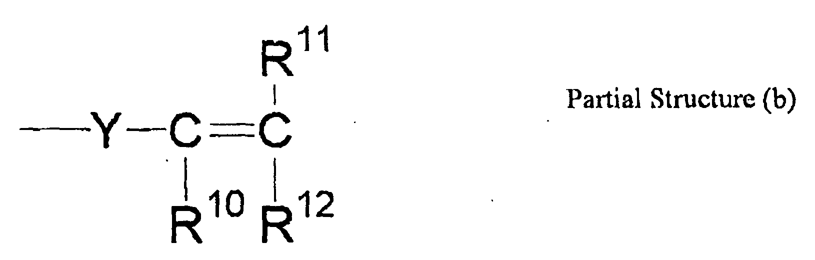

In the partial structure (b) above, R¹⁰ is preferably a hydrogen atom or an alkyl group which may have a substituent. Especially, in terms of high radical reactivity, a hydrogen atom and a methyl group are preferable. R¹¹ and R¹² each independently represent a hydrogen atom, a halogen atom, an amino group, a dialkylamino group, a carboxyl group, an alkoxycarbonyl group, a sulfo group, a nitro group, a cyano group, an alkyl group which may have a substituent, an aryl group which may have a substituent, an alkoxy group which may have a substituent, an aryloxy group which may have a substituent, an alkylamino group which may have a substituent, an arylamino group which may have a substituent, an alkylsulfonyl group which may have a substituent, or an arylsulfonyl group which may have a substituent. Among the above, in terms of high radical reactivity, a hydrogen atom, a carboxyl group, an alkoxycarbonyl group, an alkyl group which may have a substituent, and an aryl group which may have a substituent arc preferable.

Here, examples of introducible substituents include the groups mentioned as introducible substituents in the description of the partial structure (a). Y represents an oxygen atom, a sulfur atom, a phenylene group which may have a substituent, or -N(R²³)-. R²³ may be an alkyl group which may have a substituent. Especially, in terms of high radical reactivity, a hydrogen atom, a methyl group, an ethyl group, and an isopropyl group are preferable.

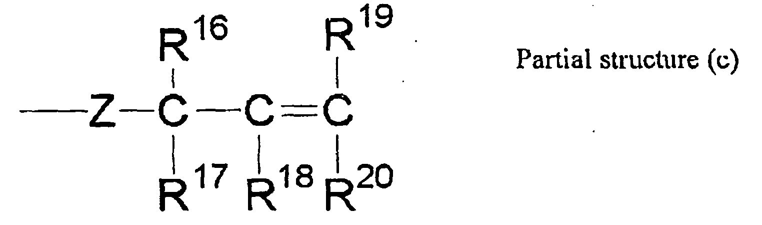

In the partial structure (c), R¹⁶ to R²⁰ each independently represent a hydrogen atom or a monovalent substituent. Preferable examples of R¹⁶ to R²⁰ include a hydrogen atom, a halogen atom, an amino group, a dialkylamino group, a carboxyl group, an alkoxycarbonyl group, a sulfo group, a nitro group, a cyano group, an alkyl group which may have a substituent, an aryl group which may have a substituent, an alkoxy group which may have a substituent, an aryloxy group which may have a substituent, an alkylamino group which may have a substituent, an arylamino group which may have a substituent, an alkylsulfonyl group which may have a substituent, and an arylsulfonyl group which may have a substituent. Among the above, a hydrogen atom, a carboxyl group, an alkoxycarbonyl group, an alkyl group which may have a substituent, and an aryl group which may have a substituent are preferable.

Examples of introducible substituents include the groups mentioned as introducible substituents in the description of the partial structure (a). Z represents an oxygen atom, a sulfur atom, or -N(R²²)-, R²² has the same definition and preferable range as those of R²² in the partial structure (a).

Moreover, the specific alkali-soluble resin used in the colored curable composition of the present invention has ,in its structure, an acid group so as to improve various properties such as removability of a non-image portion. It is preferable for the specific alkali-soluble resin to contain, as a copolymer component, a radical polymerizable compound having an acid group.

Examples of the acid group include a carboxylic acid group, a sulfonic acid group, a phosphoric acid group, and a phenolic hydroxyl group, with a carboxylic acid group being particularly preferable. The specific alkali-soluble resin may have one kind of, or two or more kinds of, the above-mentioned acid groups. The content of the copolymer components having acid groups is preferably from 5 to 50 mol%, and particularly preferably from 10 to 40 mol%, from the viewpoint of preventing the image strength from being damaged by development with alkaline water.

For the purpose of improving various properties such as image strength, the specific alkali-soluble resin of the present invention may preferably further contain one or more other radical polymerizable compounds as copolymer components in addition to the radical polymerizable compound having a specific functional group, insofar as the effects of the present invention are not impaired.

Examples of radical polymerizable compounds that can be copolymerized in the specific alkali-soluble resin of the present invention include radical polymerizable compounds selected from acrylic esters, methacrylic esters, styrenes, acrylonitriles, and methacrylonitriles.

Specific examples include acrylic esters, such as alkyl acrylates (preferably, the number of the carbon atoms of the alkyl group is from 1 to 20, and specific examples include benzyl acrylate, 4-biphenyl acrylate, butyl acrylate, sec-butyl acrylate, t-butyl acrylate, 4-t-butylphenyl acrylate, 4-chlorophenyl acrylate, pentachlorophenyl acrylate, 4-cyanobenzyl acrylate, cyano methyl acrylate, cyclohexyl acrylate, 2-ethoxyethyl acrylate, ethyl acrylate, 2-ethylhexyl acrylate, heptyl acrylate, hexyl acrylate, isoboronyl acrylate, isopropyl acrylate, methyl acrylate, 3,5-dimethyl adamanthyl acrylate, 2-naphthyl acrylate, neopentyl acrylate, octyl acrylate, phenethyl acrylate, phenyl acrylate, propylacrylate, tolyl acrylate, amyl acrylate, tetrahydrofurfuryl acrylate, 2-hydroxyethyl acrylate, 3-hydroxypropyl acrylate, 2-hydroxypropyl acrylate, 4-hydroxybutyl acrylate, 5-hydroxypentyl acrylate, allyl acrylate, 2-allyloxyethyl acrylate, and a propargyl acrylate);

methacrylic esters, such as alkyl methacrylates (preferably, the number of the carbon atoms of the alkyl group is from 1 to 20, and specific examples include benzyl methacrylate, 4-biphenyl methacrylate, butyl methacrylate, sec-butyl methacrylate, t-butyl methacrylate, 4-t-butylphenyl methacrylate, 4-chlorophenyl methacrylate, pentachlorophenyl methacrylate, 4-cyanophenyl methacrylate, cyanomethyl methacrylate, cyclohexyl methacrylate, 2-ethoxyethyl methacrylate, ethyl methacrylate, 2-ethylhexyl methacrylate, heptyl methacrylate, hexyl methacrylate, isoboronyl methacrylate, isopropyl methacrylate, methyl methacrylate, 3,5-dimethyl adamantyl methacrylate, 2-naphthyl methacrylate, neopentyl methacrylate, octyl methacrylate, phenethyl methacrylate, phenyl methacrylate, propyl methacrylate, tolyl methacrylate, amyl methacrylate, tetrahydrofurfuryl methacrylate, 2-hydroxyethyl methacrylate, 3-hydroxypropyl methacrylate, 2-hydroxypropyl methacrylate, 4-hydroxybutyl methacrylate, 5-hydroxypentyl methacrylate, allyl methacrylate, 2-allyloxyethyl methacrylate, and propargyl methacrylate);

styrenes, such as styrene and alkylstyrenes (e.g., methylstyrene, dimethylstyrene, trimethylstyrene, ethylstyrene, diethylstyrene, isopropylstyrene, butylstyrene, hexylstyrene, cyclohexylstyrene, decylstyrene, benzylstyrene, chloromethylstyrene, trifluoromethylstyrene, ethoxymethylstyrene, and acetoxymethylstyrene); alkoxystyrene (e.g., methoxystyrene, 4-methoxy-3-methyl styrene, and dimethoxystyrene); halogenstyrene (e.g., chlorostyrene, dichlorostyrene, trichlorostyrene, tetrachlorostyrene, pentachlorostyrene, bromestylene, dibromestylene, iodostyrene, fluorostyrene, trifluorostyrene, 2-brome-4-trifluoromethylstyrene, and 4-fluoro-3-trifluoromethylstyrene); acrylonitrile, and methacrylonitrile.

Among the above-mentioned radical polymerizable compounds, methacrylic esters, acrylamides, methacrylamides, and styrenes are preferably used. Paricularly preferable are benzyl methacrylate, t-butyl methacrylate, 4-t-butylphenyl methacrylate, pentachlorophenyl methacrylate, 4-cyanophenyl methacrylate, cyclohexyl methacrylate, ethyl methacrylate, 2-ethylhexyl methacrylate, isoboronyl methacrylate, isopropyl methacrylate, methyl methacrylate, 3,5-dimethyl adamantyl methacrylate, 2-naphthyl methacrylate, neopentyl methacrylate, phenyl methacrylate, tetrahydrofurfuryl methacrylate, 2-hydroxyethyl methacrylate, 3-hydroxypropyl methacrylate, 2-hydroxypropyl methacrylate, allyl methacrylate,

acrylamide, N-methyl acrylamide, N-isopropylacrylamide, morphoryl acrylamide, piperidyl acrylamide, N-t-butylacrylamide, N-cyclohexylacrylamide, N-phenylacrylamide, N-naphthyl acrylamide, N-hydroxymethyl acrylamide, N-hydroxyethyl acrylamide, N-allylacrylamide, 4-hydroxyphenyl acrylamide, 2-hydroxyphenyl acrylamide, N,N-dimethylacrylamide, N,N-diisopropylacrylamide, N,N-di-t-butylacrylamide, N,N-dicyclohexyl acrylamide, N,N-phenylacrylamide, N,N-dihydroxyethyl acrylamide, N,N-diallylacrylamide,

methacrylamide, N-methylmethacrylamide, N-isopropylmethacrylamide, morphoryl methacrylamide, piperidyl methacrylamide, N-t-butylmethacrylamide, N-cyclohexylmethaczylamide, N-phenylmethacrylamide, N-naphthylmethacrylamide, N-hydroxymethylmethacrylamide, N-hydroxyethylmethacrylamide, N-allylmethacrylamide, 4-hydroxyphenyl methacrylamide, 2-hydroxyphenyl methacrylamide, N,N-dimethylmethacrylamide, N,N-diisopropylmethacrylamide, N,N-di-t-butylmethacrylamide, N,N-dicyclohexylmethacrylamide, N,N-phenylmethacrylamide, N,N-dihydroxyethylmethacrylamide, N,N-diallylmethacrylamide,

styrene, methylstyrene, dimethylstyrene, trimethylstyrene, isopropylstyrene, butylstyrene, cyclohexylstyrene, chloromethylstyrene, trifluoromethylstyrene, ethoxymethylstyrene, acetoxymethylstyrene, methoxystyrene, 4-methoxy-3-methylstyrene, chlorostyrene, dichlorostyrene, trichlorostyrene, tetrachlorostyrene, pentachlorostyrene, bromostyrene, dibromostyrene, iodostyrene, fluorostyrene, trifluorostyrene, 2-bromo-4-trifluoromethylstyrene, and 4-fluoro-3-trifluoromethylstyrene.

One of, or two or more of, these additional radical polymerizable compounds may be used. The content of the additional copolymer component(s) in the specific alkali-soluble resin is preferably from 0 to 90 mol%, and particularly preferably from 0 to 60 mol%. When the content thereof is in the above-mentioned range, sufficient pattern forming property is obtained.

Examples of a solvent used when synthesizing such a high-molecular-weight compound include ethylene dichloride, cyclohexanone, methyl ethyl ketone, acetone, methanol, ethanol, propanol, butanol, ethyleneglycol monomethyl ether, ethyleneglycol monoethyl ether, 2-methoxyethyl acetate, 1-methoxy-2-propanol, 1-methoxy-2-propyl acetate, N,N-dimethylformamide, N,N-dimethylacetamide, dimethylsulfoxide, toluene, ethyl acetate, methyl lactate, and ethyl lactate. The solvent may be used singly, or a mixture of two or more thereof may be used.

Specific examples of the specific alkali-soluble resin include the following Exemplary Compounds 1 to 31. In the following Tables, "Ex. Comp." represents "Exemplary Compound".

| Ex. Comp. | Composition (mol%) | Mw(×10⁴) | Tg (°C) | Acid Value (mgKOH/g) |
|---|---|---|---|---|
| 1 | 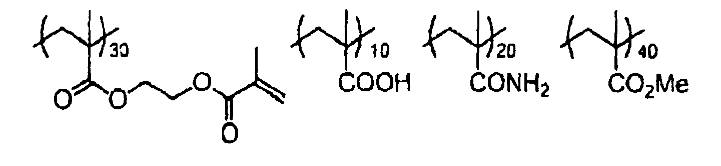 | 5 | 108 | 64 |
| 2 | 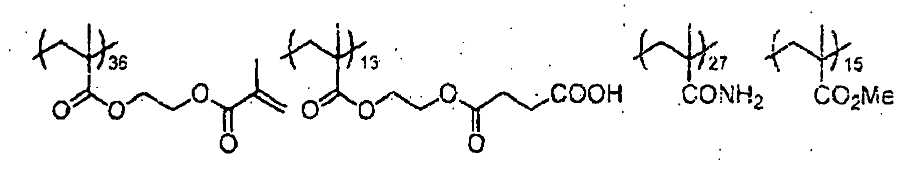 | 8.5 | 91 | 46 |
| 3 | 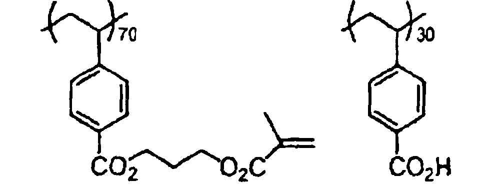 | 9.0 | 105 | 67 |
| 4 | 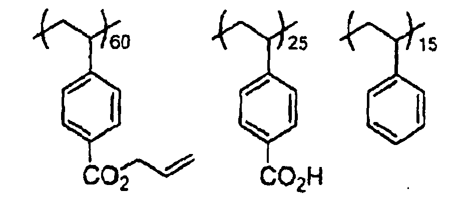 | 8.8 | 110 | 62 |
| 5 | 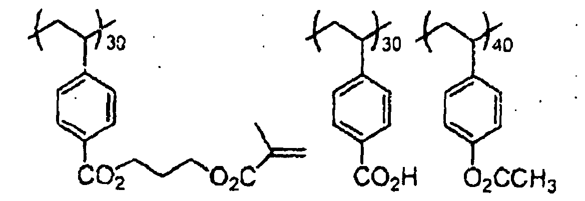 | 9.9 | 110 | 79 |
| 6 | 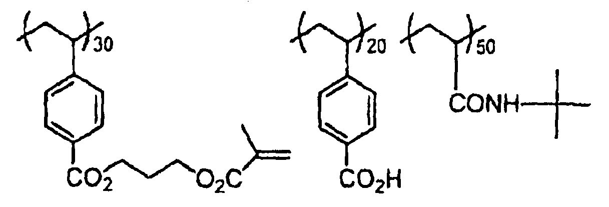 | 8.9 | 116 | 67 |
| 7 | 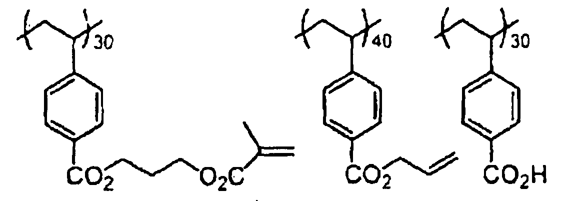 | 11.4 | 108 | 62 |
| 8 | 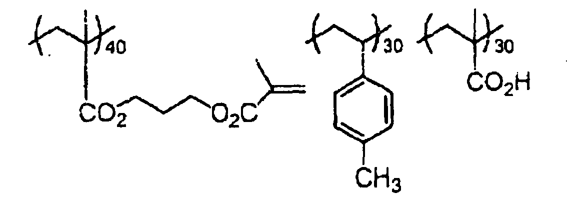 | 10.5 | 110 | 73 |
| 9 | 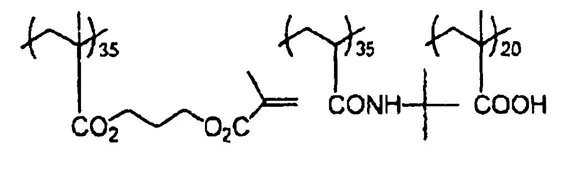 | 7.5 | 105 | 67 |
| 10 | 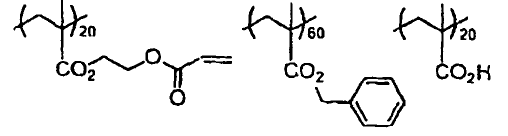 | 97000 | | 70 |
| 11 | 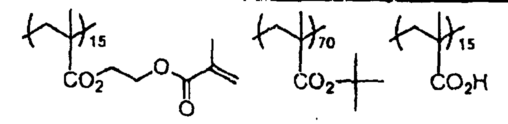 | 128000 | | 59 |
| 12 | 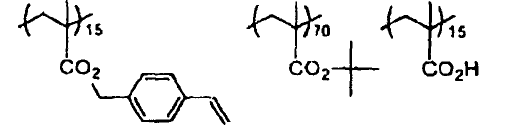 | 135000 | | 59 |
| 13 | 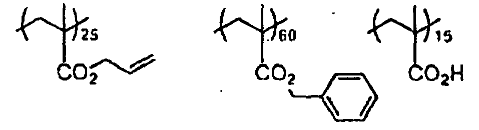 | 132000 | | 56 |
| 14 | 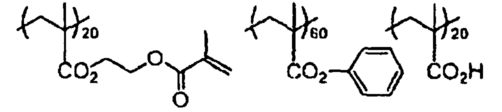 | 103000 | | 74 |
| 15 | 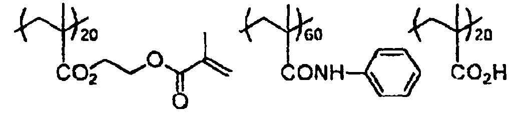 | 97000 | | 73 |
| 16 | 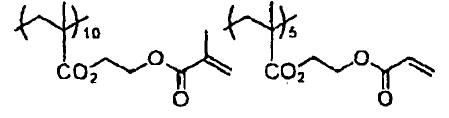 | 107000 | | 51 |
| | 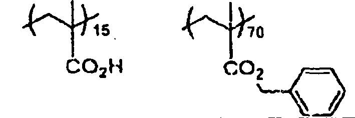 | | | |
| 17 | 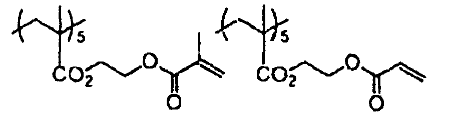 | 114000 | | 77 |
| | 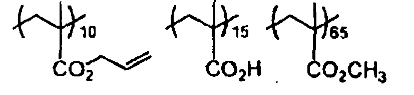 | | | |
| 18 | 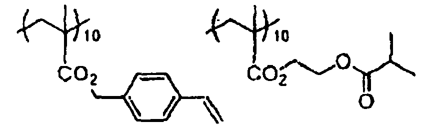 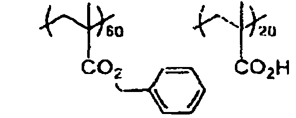 | 136000 | | 69 |
| 19 | 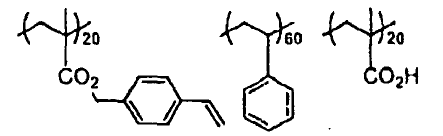 | 100000 | | 93 |
| 20 | 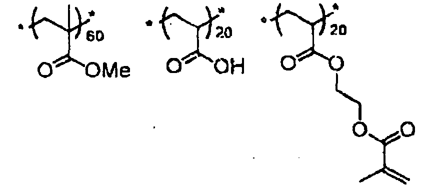 | 9000 | | 103 |
| 21 | 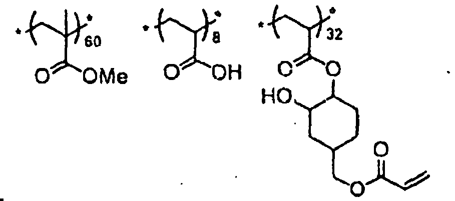 | 14000 | | 30 |
| 22 | 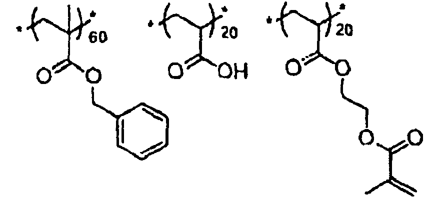 | 50000 | | 72 |
| 23 | 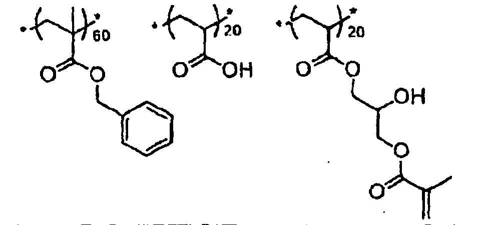 | 50000 | | 70 |
| 24 | 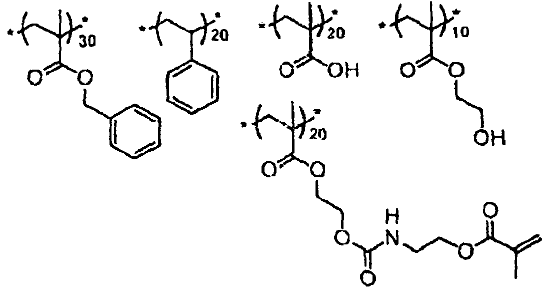 | 30000 | | 70 |
| 25 | 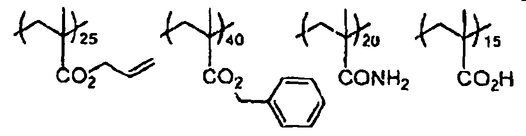 | 145000 | | 64 |
| 26 | 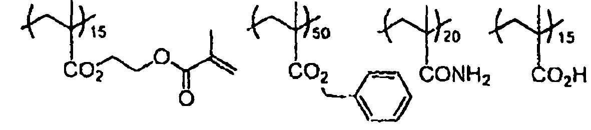 | 120000 | | 57 |
| 27 | 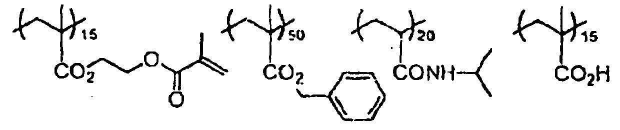 | 133000 | | 54 |
| 28 | 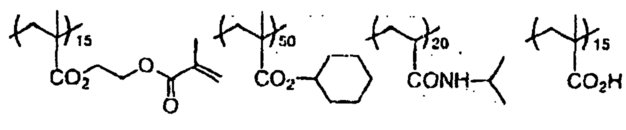 | 111000 | | 55 |
| 29 | 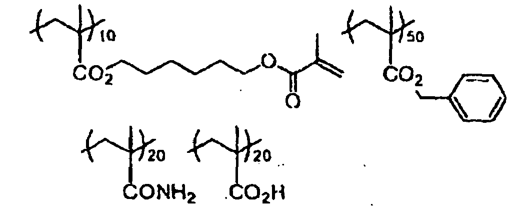 | 103000 | | 77 |
| 30 | 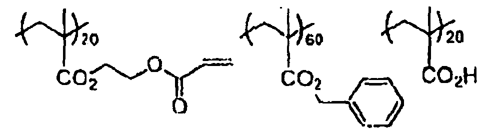 | 58000 | | 70 |
| 31 | 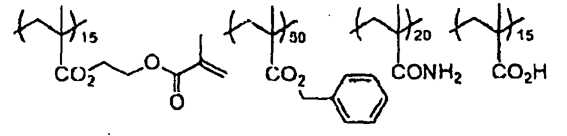 | 52000 | | 57 |

In terms of polymerizability and alkali-developability, the specific alkali-soluble resin is preferably a resin having a structural unit represented by the following Formula (4) and at least one structural unit selected from the group consisting of structural units represented by the following Formulae (1) to (3).

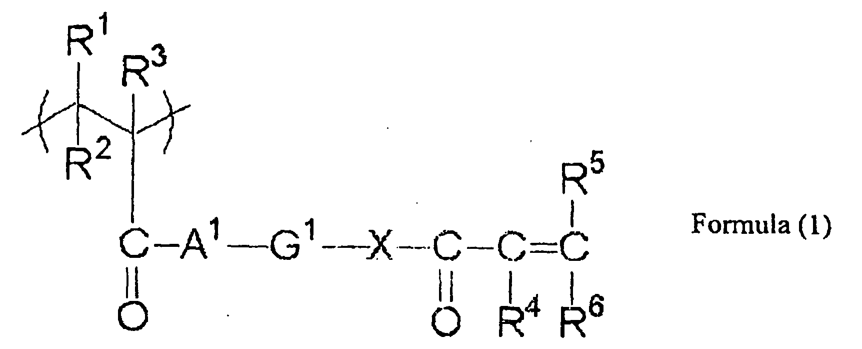

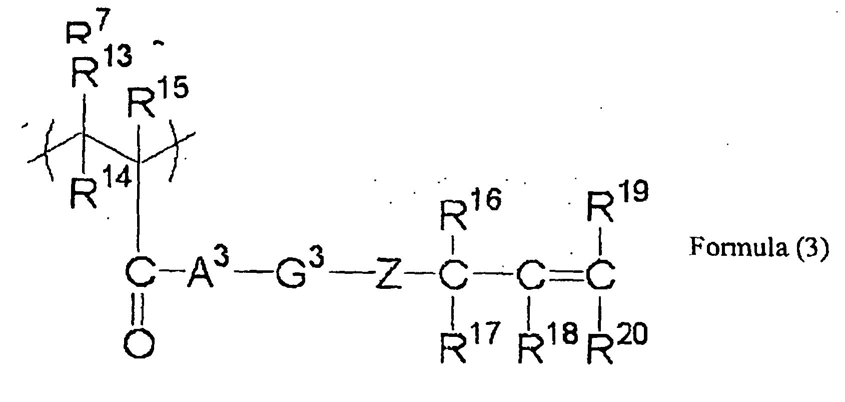

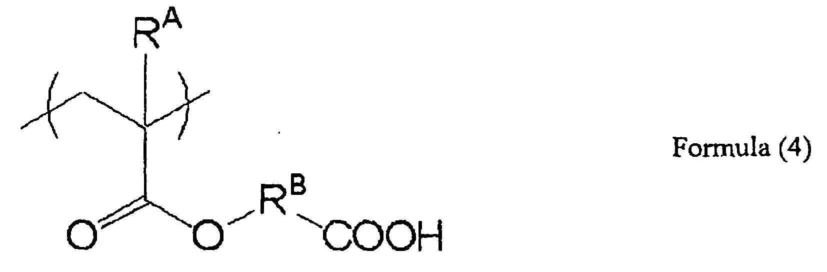

In Formulae (1) to (3), A¹, A², and A³ each independently represent an oxygen atom, a sulfur atom, or -N(R²¹)-, and R²¹ represents an alkyl group which may have a substituent, G¹, G², and G³ each independently represent a divalent organic group. X and Z each independently represent an oxygen atom, a sulfur atom, or -N(R²²)-, and R²² represents an alkyl group which may have a substituent. Y represents an oxygen atom, a sulfur atom, a phenylene group which may have a substituent, or -N(R²³)-, and R²³ represents an alkyl group which may have a substituent. R¹ to R²⁰ each independently represent a hydrogen atom or a monovalent substituent.

In Formula (1), R¹ to R³ each independently represent a hydrogen atom or a monovalent substituent, and may independently represent a hydrogen atom or an alkyl group which may itself has a substituent. Especially, R¹ and R² each preferably represent a hydrogen atom and R³ preferably represent a hydrogen atom or a methyl group.
R⁴ to R⁶ in Formula (1) each independently represent a hydrogen atom or a monovalent substituent. R⁴ preferably represent a hydrogen atom or an alkyl group which may itself have a substituent. Especially, a hydrogen atom, a methyl group, and an ethyl group are preferable. R⁵ and R⁶ in Formula (1) each independently represent a hydrogen atom, a halogen atom, an alkoxycarbonyl group, a sulfo group, a nitro group, a cyano group, an alkyl group which may itself have a substituent, an aryl group which may itself have a substituent, an alkoxy group which may itself have a substituent, an aryloxy group which may itself have a substituent, an alkylsulfonyl group which may itself have a substituent, or an arylsulfonyl group which may itself have a substituent. Among the above, a hydrogen atom, an alkoxycarbonyl group, and an alkyl group which may itself have a substituent, and an aryl group which may itself have a substituent are preferable.
Here, examples of the optional substituents in the above groups include a methoxycarbonyl group, an ethoxycarbonyl group, an isopropyloxycarbonyl group, a methyl group, an ethyl group, and a phenyl group.

In Formula (1), A¹ represents an oxygen atom, a sulfur atom, or -N(R²¹)-, and X represents an oxygen atom, a sulfur atom, or -N(R²²)-. Here, R²¹ and R²² each may be an alkyl group which may have a substituent.
G¹ in Formula (1) represents a divalent organic group, and an alkylene group which may have a substituent is preferable. More preferable examples include an alkylene group having 1 to 20 carbon atoms which may have a substituent, a cycloalkylene group having 3 to 20 carbon atoms which may have a substituent, and an aromatic group having 6 to 20 carbon atoms which may have a substituent. Especially, a straight or branched alkylene group having 1 to 10 carbon atoms which may have a substituent, a cycloalkylene group having 3 to 10 carbon atoms which may have a substituent, and an aromatic group having 6 to 12 carbon atoms which may have a substituent are preferable in terms of properties such as resin strength and developability.

Here, preferable examples of a substituent in G¹ include a hydroxyl group and a substituent other than substituents having a hetero atom to which a hydrogen atom is bonded (e.g., an amino group, a thiol group, and a carboxy group).

It is preferable that, in the structural unit represented by Formula (1) in the present invention, A¹ represent an oxygen atom, a sulfur atom, or -N(R²¹)-; X represent an oxygen atom, a sulfur atom, or -N(R²²)-; G¹ represent an alkylene group which may have a substituent; R¹ and R² each represent a hydrogen atom; R³ represent a hydrogen atom or a methyl group; R⁴ represent a hydrogen atom or an alkyl group; R⁵ and R⁶ each independently represent a hydrogen atom, an alkoxycarbonyl group, an alkyl group, or an aryl group; and R²¹ and R²² each independently represent an alkyl group.

In Formula (2), R⁷ to R⁹ each independently represent a hydrogen atom or a monovalent substituent, and each may represent a hydrogen atom or an alkyl group which may itself have a substituent. Especially, R⁷ and R⁸ each preferably represent a hydrogen atom, and R⁹ preferably represents a hydrogen atom or a methyl group.
R¹⁰ to R¹² in Formula (2) each independently represent a hydrogen atom or a monovalent substituent. Specific examples of the substituent include a hydrogen atom, a halogen atom, a dialkylamino group, an alkoxycarbonyl group, a sulfo group, a nitro group, a cyano group, an alkyl group which may itself have a substituent, an aryl group which may itself have a substituent, an alkoxy group which may itself have a substituent, an aryloxy group which may itself have a substituent, an alkylsulfonyl group which may itself have a substituent, and an arylsulfonyl group which may itself have a substituent. Among the above, a hydrogen atom, an alkoxycarbonyl group, an alkyl group which may itself have a substituent, and an aryl group which may itself have a substituent are preferable.
Here, examples of the optional substituents in the above groups include those mentioned as examples of the optional substituents in the description of Formula (1).

A² in Formula (2) represents an oxygen atom, a sulfur atom, or -N(R²¹)-. Here, R²¹ may be a hydrogen atom or an alkyl group which may have a substituent.
G² in Formula (2) represents a divalent organic group, and preferably represents an alkylene group which may have a substituent. Preferable examples include an alkylene group having 1 to 20 carbon atoms which may have a substituent, a cycloalkylene group having 3 to 20 carbon atoms which may have a substituent, and an aromatic group having 6 to 20 carbon atoms which may have a substituent. Especially, a straight or branched alkylene group having 1 to 10 carbon atoms which may have a substituent, a cycloalkylene group having 3 to 10 carbon atoms which may have a substituent, and an aromatic group having 6 to 12 carbon atoms which may have a substituent are preferable in terms of properties such as resin strength and developability.
Here, preferable examples of a substituent in G² include a hydroxyl group and a substituent other than substituents having a hetero atom to which a hydrogen atom is bonded (e.g., an amino group, a thiol group, and a carboxy group).
When G² in Formula (2) has a substituent that has a hetero atom to which a hydrogen atom is bonded and that is not a hydroxyl group, storage stability may decrease when used in combination with an onium salt compound as the initiator described below.
Y in Formula (2) represents an oxygen atom, a sulfur atom, -N(R²³)-, or a phenylene group which may have a substituent. Here, R²³ may represent a hydrogen atom or an alkyl group which may have a substituent.

It is preferable that, in the structural unit represented by Formula (2) in the present invention, R¹⁰ represent a hydrogen atom or an alkyl group; R¹¹ and R¹² each independently represent a hydrogen atom, an alkaxycarbonyl group, an alkyl group, or an aryl group; R⁷ and R⁸ each represent a hydrogen atom; R⁹ represent a hydrogen atom or a methyl group; A² represent an oxygen atom, a sulfur atom, or -N(R²¹)-; G² represent a straight or branched alkylene group having 1 to 10 carbon atoms which may have a substituent, a cycloalkylene group having 3 to 10 carbon atoms which may have a substituent, or an aromatic group having 6 to 12 carbon atoms which may have a substituent; Y represent an oxygen atom, a sulfur atom, -N(R²³)-, or a phenylene group which may have a substituent; and R²¹ and R²³ each independently represent a hydrogen atom or an alkyl group which may have a substituent.

In Formula (3), R¹³ to R¹⁵ each independently represent a hydrogen atom or a monovalent substituent, and may independently represent a hydrogen atom or an alkyl group which may itself have a substituent. Especially, as R¹³ and R¹⁴, a hydrogen atom is preferable, and, as R¹⁵, a hydrogen atom or a methyl group is preferable.
R¹⁶ to R²⁰ in Formula (3) each independently represent a hydrogen atom or a monovalent substituent. Examples of R¹⁶ to R²⁰ include a hydrogen atom, a halogen atom, a dialkylamino group, an alkoxycarbonyl group, a sulfo group, a nitro group, a cyano group, an alkyl group which may itself have a substituent, an aryl group which may itself have a substituent, an alkoxy group which may itself have a substituent, an aryloxy group which may itself have a substituent, an alkylsulfonyl group which may itself have a substituent, and an arylsulfonyl group which may itself have a substituent. Especially, a hydrogen atom, an alkoxycarbonyl group, an alkyl group which may itself have a substituent, and an aryl group which may itself have a substituent are preferable. Examples of the optional substituents in the above groups include those mentioned as optional substituents in the description of Formulae (1).
In Formulae (3), A³ represents an oxygen atom, a sulfur atom, or -N(R²¹)-, and Z represents an oxygen atom, a sulfur atom, or -N(R²²)-. Examples of R²¹ and R²² include those mentioned in the description of Formula (1).

G³ in Formula (3) represents a divalent organic group, and an alkylene group which may have a substituent is preferable. Preferable examples include an alkylene group having 1 to 20 carbon atoms which may have a substituent, a cycloalkylene group having 3 to 20 carbon atoms which may have a substituent, and an aromatic group having 6 to 20 carbon atoms which may have a substituent. Especially, a straight or branched alkylene group having 1 to 10 carbon atoms which may have a substituent, a cycloalkylene group having 3 to 10 carbon atoms which may have a substituent, and an aromatic group having 6 to 12 carbon atoms which may have a substituent are preferable in terms of properties such as resin strength and developability.
Here, Examples of a substituent in G³ include a hydroxyl group and a substituent other than substituents having a hetero atom to which a hydrogen atom is bonded (e.g., an amino group, a thiol group, and a carboxy group).

It is preferable that, in the structural unit represented by Formula (3) in the present invention, R¹³ and R¹⁴ each represent a hydrogen atom; R¹⁵ represent a hydrogen atom or a methyl group; R¹⁶ to R²⁰ each represent a hydrogen atom, an alkoxycarbonyl group, an alkyl group which may have a substituent, or an aryl group which may have a substituent; A³ represent an oxygen atom, a sulfur atom, or -N(R²¹)-; Z represent an oxygen atom, a sulfur atom, or -N(R²²)-; R²¹ and R²² each independently be selected from those mentioned in the description af R²¹ and R²² in Formula (1); and G³ represent a straight or branched alkylene group having 1 to 10 carbon atoms which may have a substituent, a cycloalkylene group having 3 to 10 carbon atoms which may have a substituent, or an aromatic group having 6 to 12 carbon atoms which may have a substituent.

The specific alkali-soluble resin in the present invention preferably contains at least one structural unit selected from the structural units represented by Formulae (1) to (3) in an amount that is at least 1.5 times (in terms of a molar ratio) the content of the structural unit represented by Formula (4) for the purpose of suppressing heat sagging in postbaking. From the viewpoint of curability, the content of the at least one structural unit selected from the structural units represented by Formulae (1) to (3) is more preferably at least 2.0 times (in terms of a molar ratio) the content of the structural unit represented by Formula (4), and most preferably at least 3.0 times (in terms of a molar ratio) the content of the structural unit represented by Formula (4).
Moreover, from the viewpoint of improving the curing properties and reducing the post-development residue, the specific alkali-soluble resin preferably contains, in a molecule, at least one structural unit selected from the structural units represented by Formulae (1) to (3) in a ratio of not less than 35 mol% but less than 95 mol%. The ratio is more preferably from 37 to 90 mol%, still more preferably not less than 40 mol% but less than 85 mol%.
Especially, from the viewpoint of curability, a resin containing a structural unit represented by Formula (1) in a ratio of not less than 40 mol% but less than 85 mol% is most preferable.

Synthesis of a polymer compound having at least one structural unit selected from the structural units represented by Formulae (1) to (3) above can be performed according to a synthesis method described in Paragraphs [0027] to [0057] of JP-A No. 2003-262958. Especially, it is preferable to perform the synthesis by the synthesis method 1) in JP-A No. 2003-262958.

The specific alkali-soluble resin is preferably a resin obtained by the following synthesis method (1) or (2).

Synthesis method (1)
This synthesis method include extracting, by an action of a base, a proton from a polymer synthesized using a compound represented by the following Formula (5) as a copolymer component, so as to eliminate L and so as to obtain a desired polymer compound having a structure represented by Formula (1) described above.

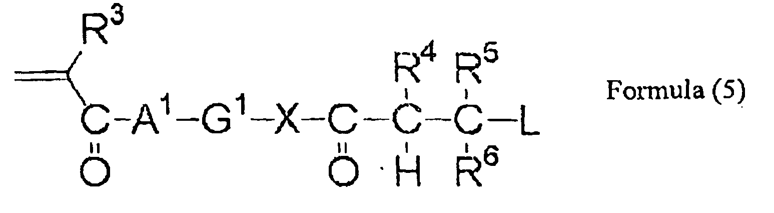

In Formula (5), L represents an anionic elimination group, and preferably represents a halogen atom, an alkyl group, or an arylsulfonyloxy group. R³ to R⁶, A¹, G¹, and X have the same definitions and preferable ranges as in Formula (1).
As the base used for causing an elimination reaction, either of an inorganic compound or an organic compound may be used. The details and preferable examples of the method are disclosed in Paragraphs [0028] to [0033] of JP-A No. 2003-262958.

Preferable examples of an inorganic compound base include sodium hydroxide, potassium hydroxide, sodium carbonate, sodium hydrogen carbonate, potassium carbonate, and potassium hydrogen carbonate. Examples of an organic compound base include metal alkoxides, such as sodium methoxide, sodium ethoxide, and potassium t-butoxide; and organic amine compounds, such as triethylamine, pyridine, and diisopropylethylamine.

Synthesis method (2)
The synthesis method (2) includes performing base treatment on a polymer synthesized using a compound represented by the following Formula (6) as a copolymer component so as to cause an elimination reaction at a specific functional group and so as to remove X¹, whereby a radical reactive group is obtained.

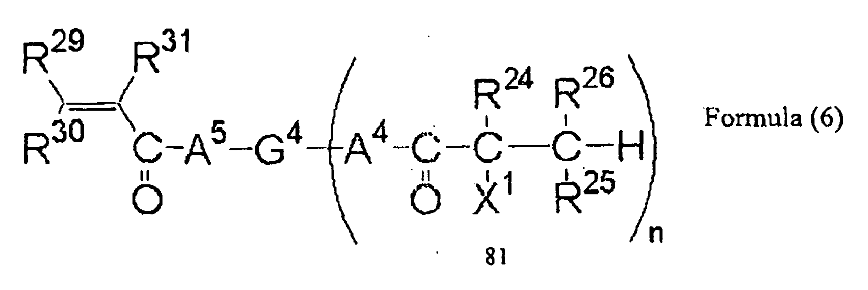

In Formula (6), A¹ represents an oxygen atom, a sulfur atom, or -N(R²⁷)-; A⁵ represents an oxygen atom, a sulfur atom, or -NR²⁸-; R²⁴, R²⁵, R²⁶, R²⁹, R³⁰, and _{R}³¹ each independently represent hydrogen or a monovalent organic group; X¹ represents a group to be removed by an elimination reaction; G⁴ represents an organic connecting group; and n represents an integer of from 1 to 10.

Especially, A⁴ preferably represent an oxygen atom in the present invention. It is preferable that R²⁴ represent a methyl group; R²⁵, R²⁶, R²⁹, and R³⁰ each represent a hydrogen atom, and R³¹ represent a methyl group or a hydrogen atom. X¹ preferably represents a bromine atom and G⁴ preferably represents methylene.

The details and preferable examples of the method are disclosed in JP-A No. 2003-335814.

The resin obtained by the synthesis method (2) may be a high-molecular-weight compound disclosed in JP-A No, 2003-335814. Specific preferable examples include (i) a high-molecular-weight polyvinyl compound, (ii) a high-molecular-weight polyurethane compound, (iii) a high-molecular-weight polyurea compound, (iv) a high-molecular-weight poly (urethane-urea) compound, (v) a high-molecular-weight polyester compound, (vi) a high-molecular-weight polyamide compound. (vii) a high-molecular-weight acetal-modified polyvinyl alcohol compound, and specific compounds thereof disclosed in the above document.

Specific examples of the compound represented by Formula (5) include, but are not limited to, the following compounds (M-1) to (M-12).

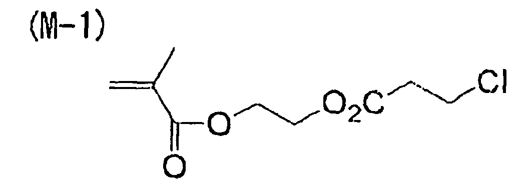

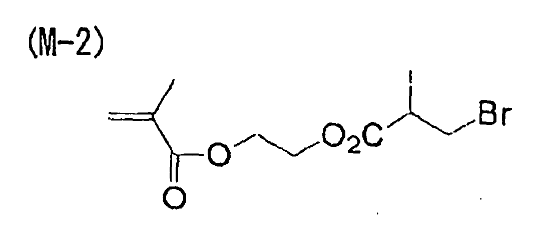

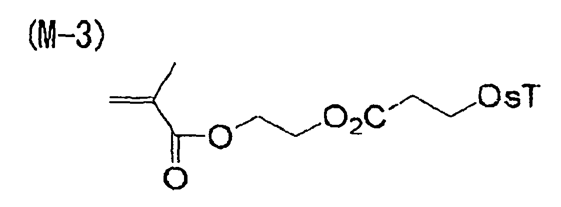

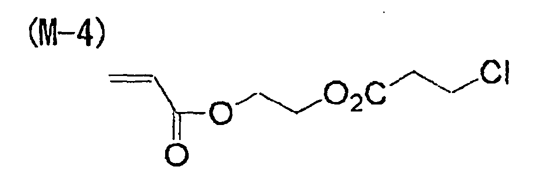

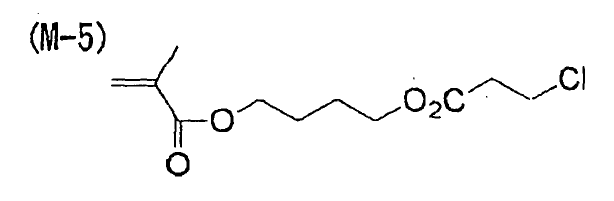

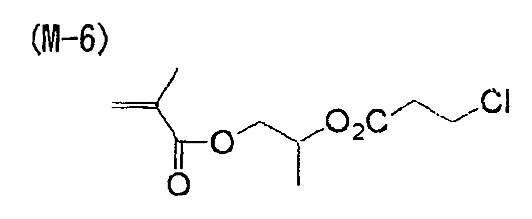

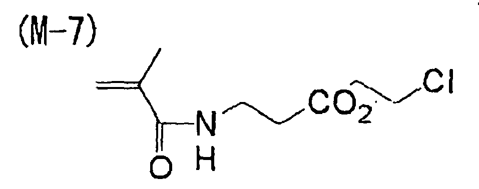

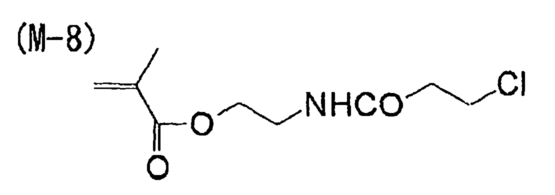

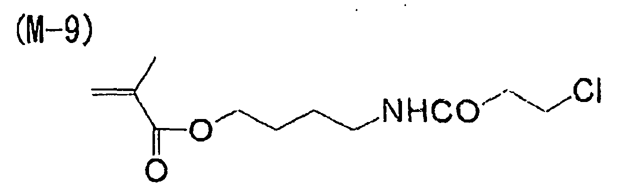

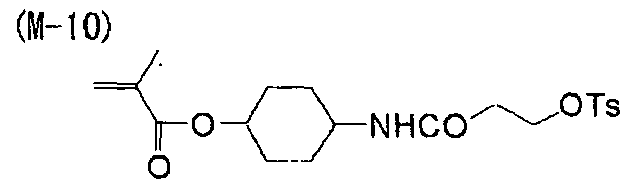

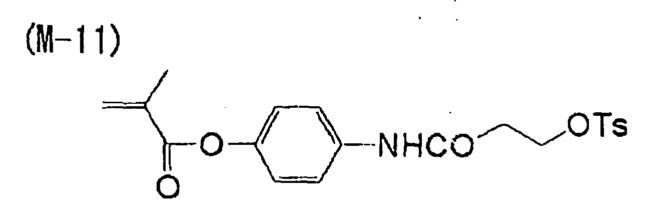

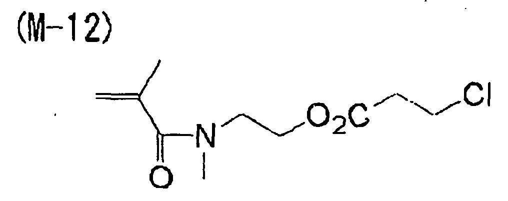

Examples of the compound represented by Formula (6) include, but are not limited to, the following compounds (i-1) to (i-50).

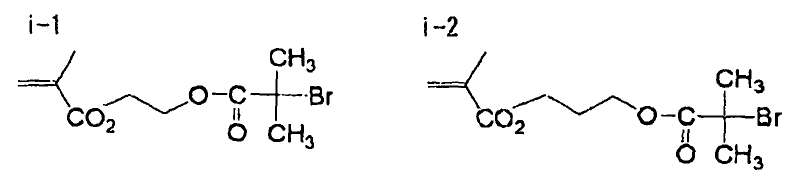

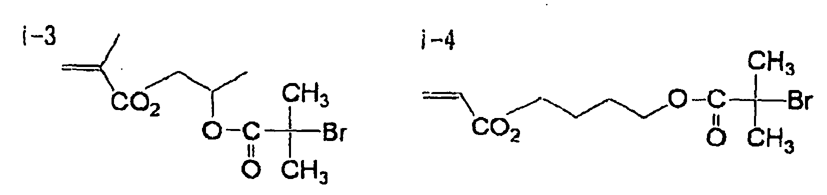

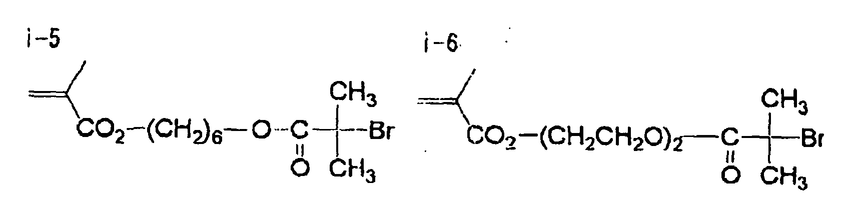

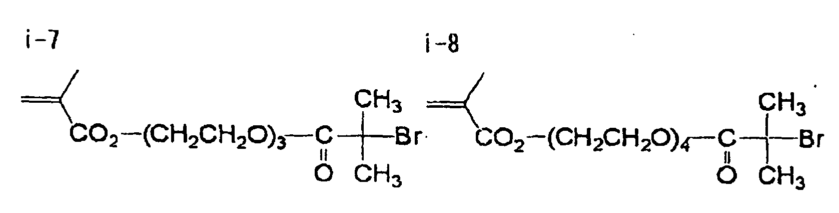

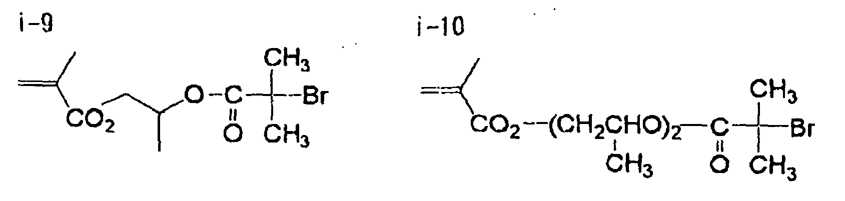

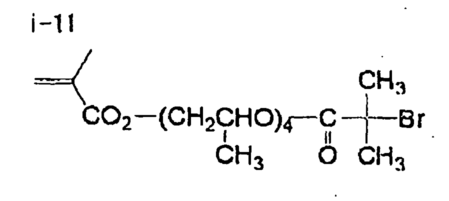

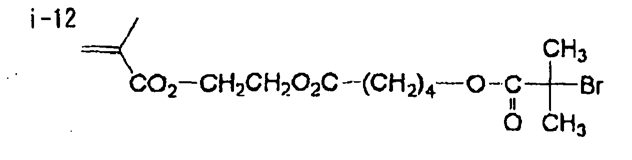

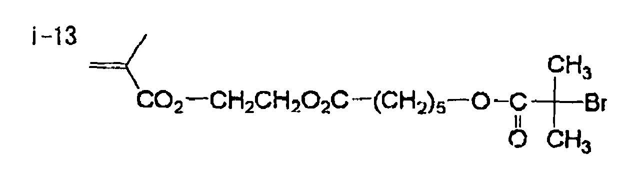

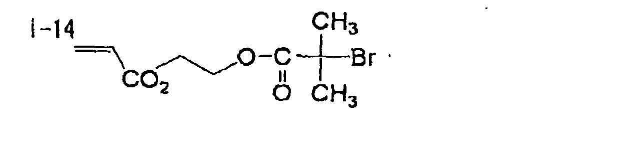

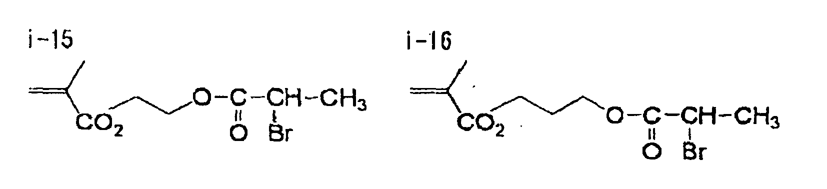

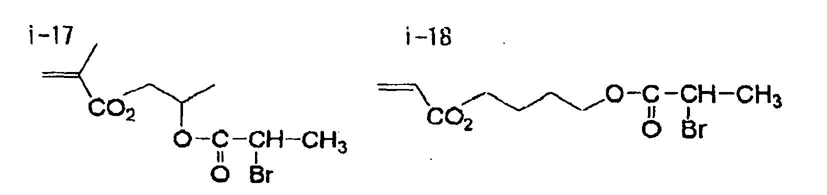

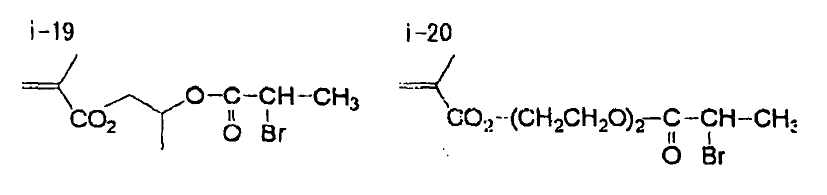

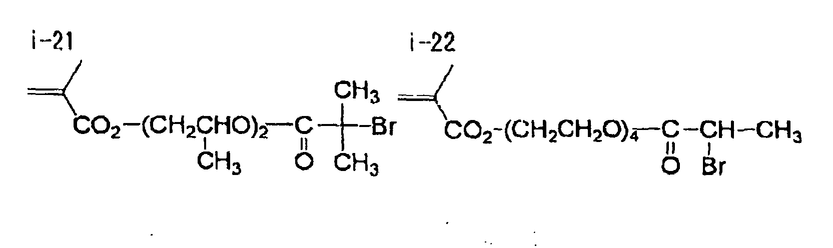

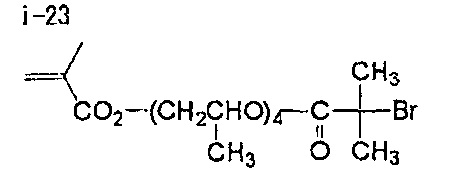

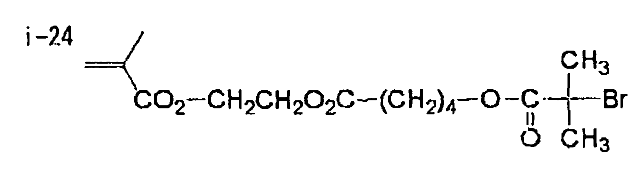

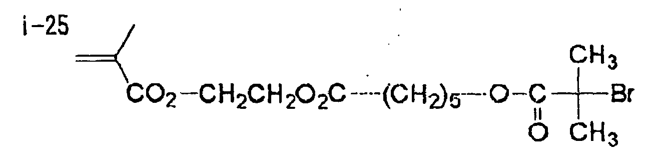

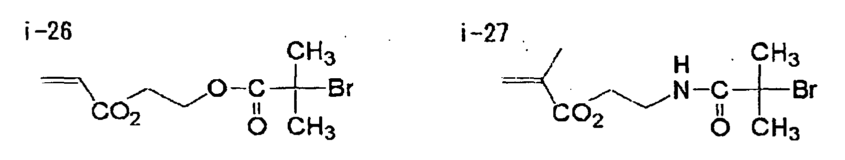

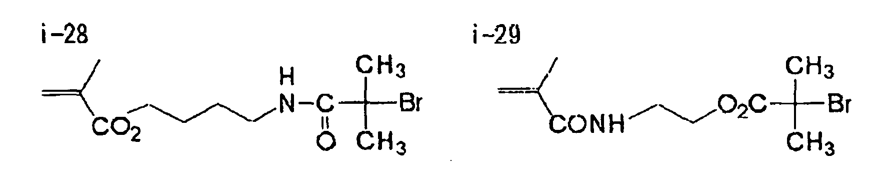

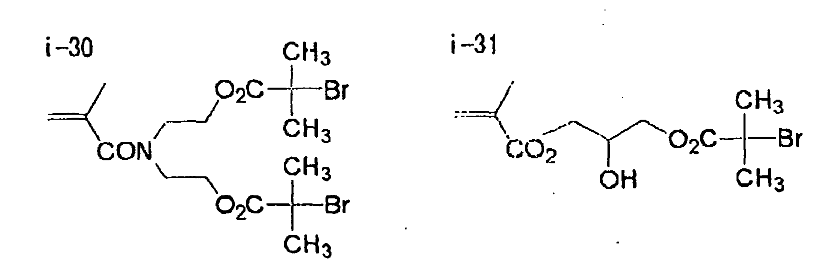

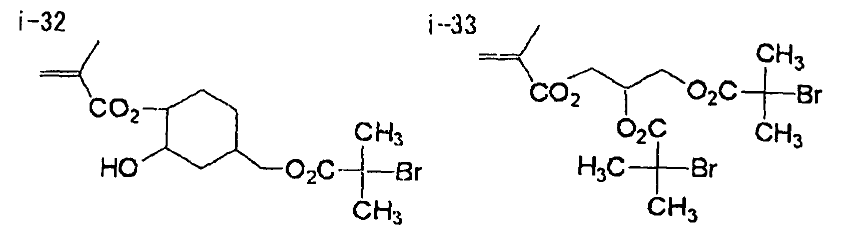

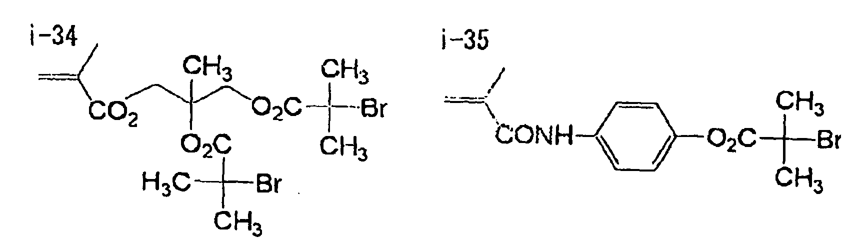

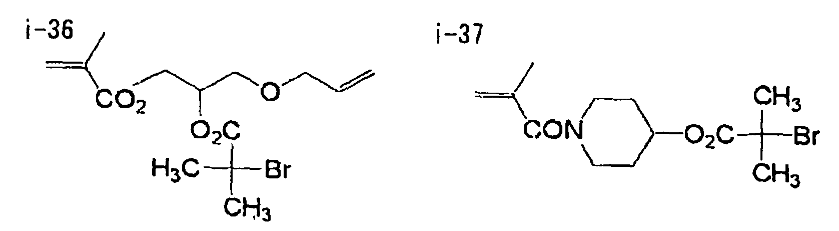

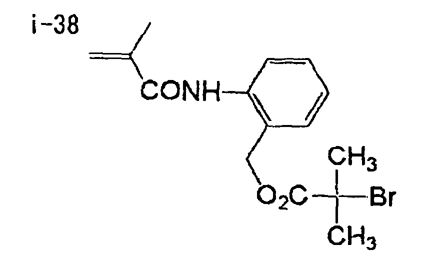

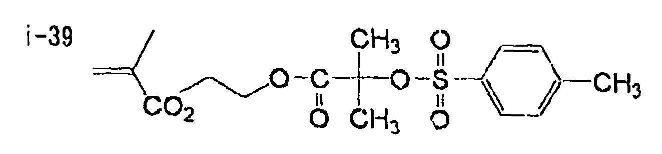

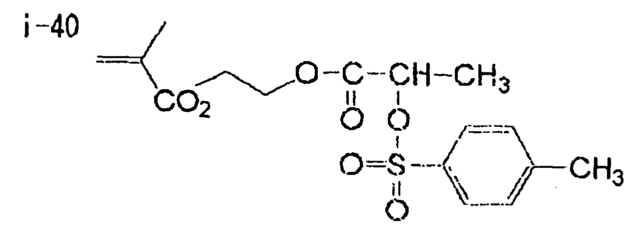

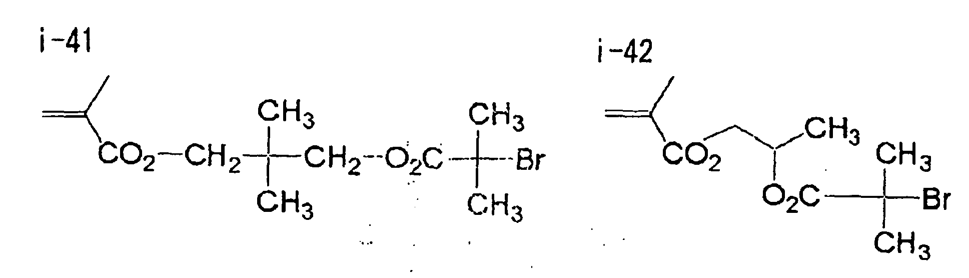

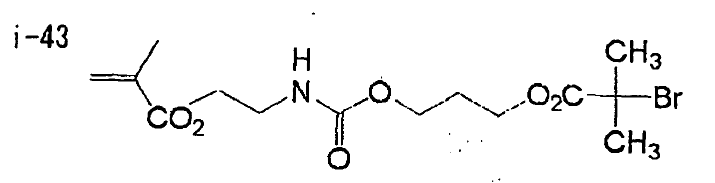

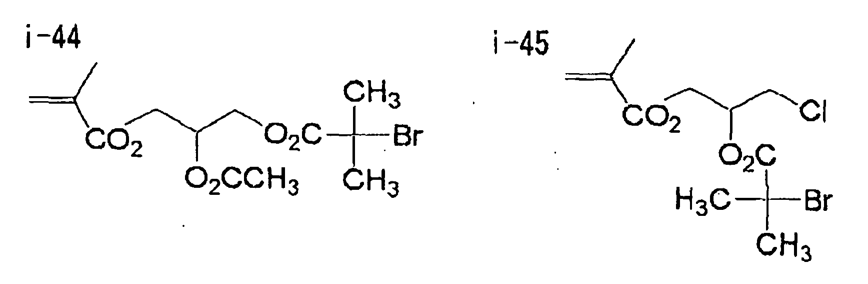

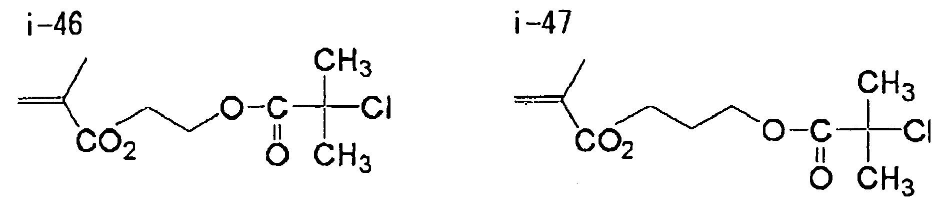

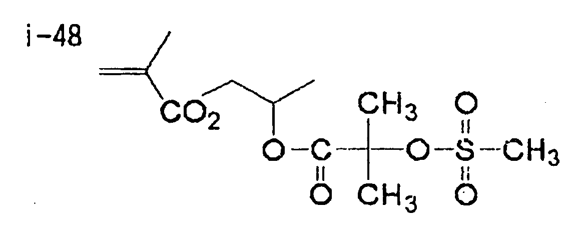

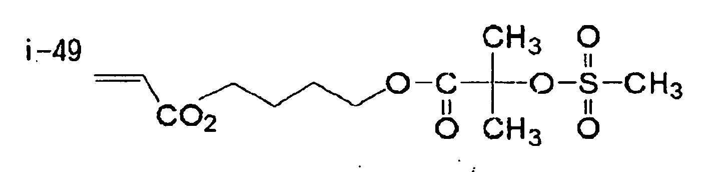

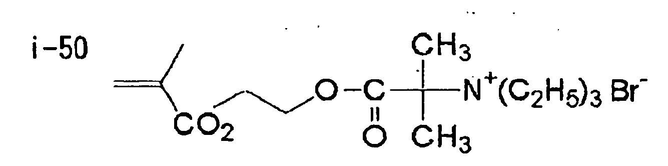

The specific alkali-soluble resin in the present invention preferably contains a structural unit represented by the following Formula (4).

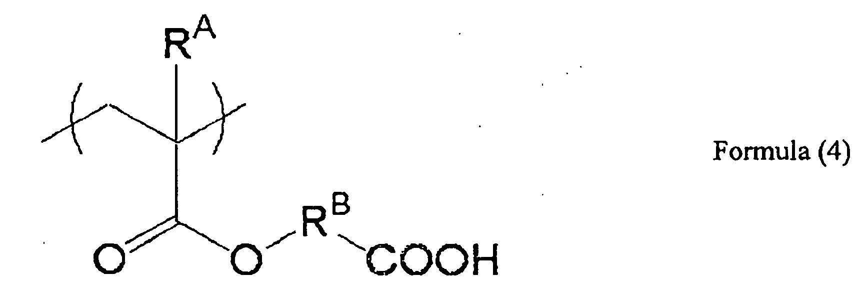

In Formula (4), R^{A} represents hydrogen or an alkyl group having 1 to 6 carbon atoms, and R^{B} represents a divalent connecting group.
R^{A} represents preferably a hydrogen atom or a methyl group.
R^{B} may represent a divalent connecting group, examples of which include an alkylene group having 1 to 12 carbon atoms which may be substituted; - U-R^{C}-V- (in which U and V each independently represent a direct bond or an alkylene group having 1 to 3 carbon atoms and R^{C} represents a cyclohexyl ring, a benzene ring, or a naphthalene ring, each of which may be substituted.); and -R^{D}-X-R^{E}- (in which, R^{D} and R^{E} each independently represents an alkylene group having 1 to 10 carbon atoms which may be substituted, or a benzene or naphthalene ring which may be substituted, and X represents an ester bond, an amide bond, a urethane bond, an ether bond, a thioether bond, a carbonate bond, a urea bond, or an imide bond). Especially, R^{B} represents preferably a divalent connecting group having 1 to 6 carbon atoms.

Among the alkali-soluble resins according to the present invention, specific compound examples of a resin having a structural unit represented by Formula (4) and at least one structural unit selected from the group consisting of structural units represented by Formulae (1) to (3) include Exemplary Compounds 101 to 121 shown in the following tables. In the following Tables, "Ex. Comp." represents "Exemplary Compound".

| Ex. Comp. | Composition (mol%) | Acid Value (mgKOH/g) | Mw |
|---|---|---|---|
| 101 | 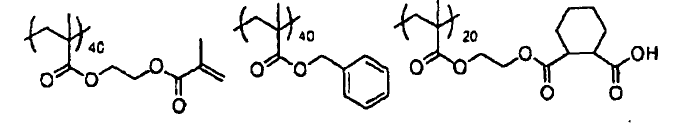 | 54 | 85000 |
| 102 | 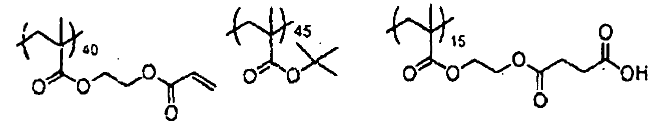 | 49 | 36000 |
| 103 | 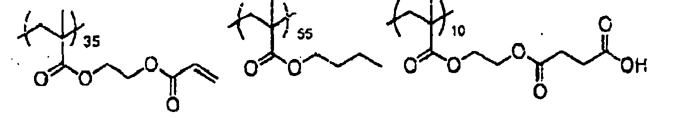 | 34 | 62000 |
| 104 | 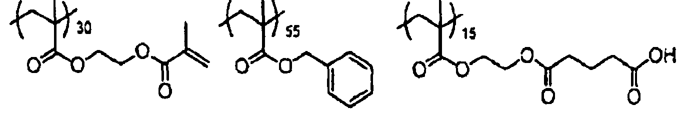 | 44 | 30000 |
| 105 | 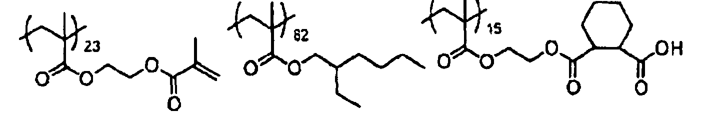 | 43 | 31000 |
| 106 | 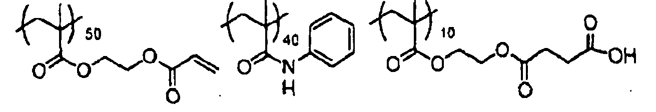 | 31 | 23000 |
| 107 | 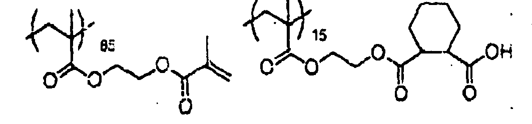 | 40 | 100000 |
| 108 | 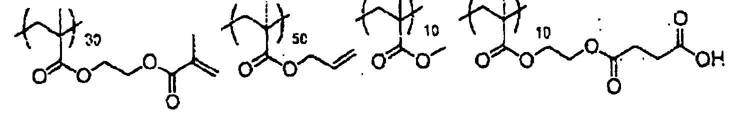 | 36 | 63000 |
| 109 | 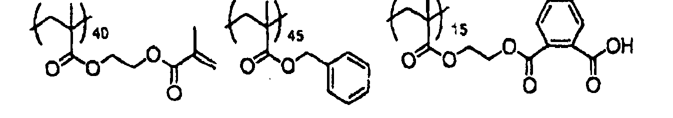 | 42 | 55000 |
| 110 | 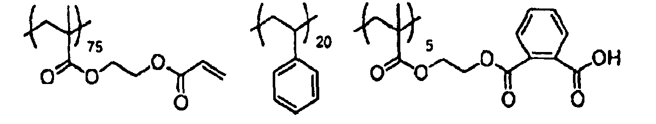 | 16 | 36000 |
| 111 | 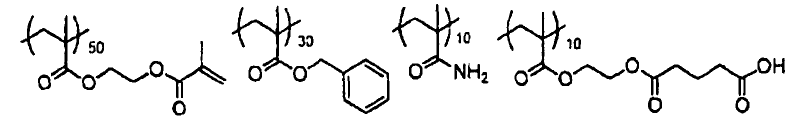 | 30 | 22000 |
| 112 | 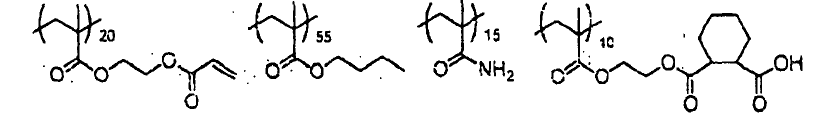 | 47 | 28000 |
| 113 | 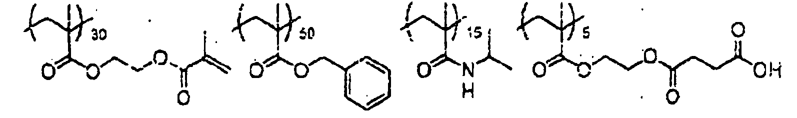 | 16 | 53000 |
| 114 | 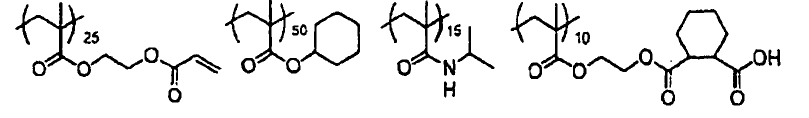 | 32 | 33000 |
| 115 | 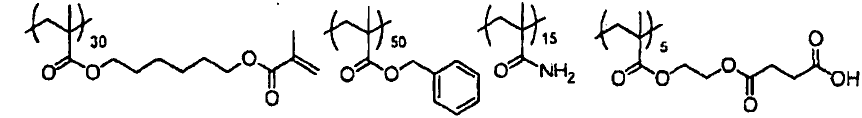 | 15 | 30000 |
| 116 | 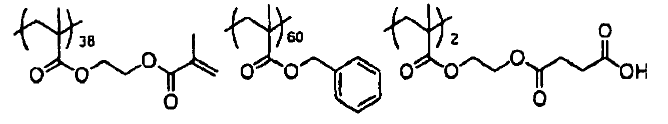 | 6.0 | 61000 |
| 117 | 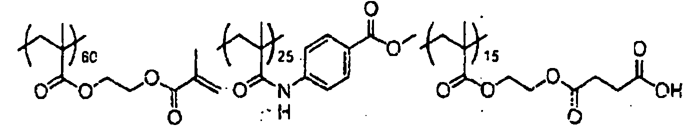 | 45 | 48000 |
| 118 | 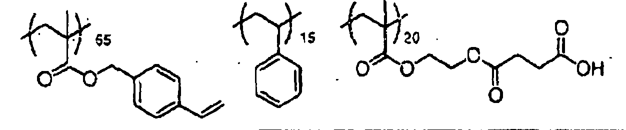 | 58 | 27000 |
| 119 | 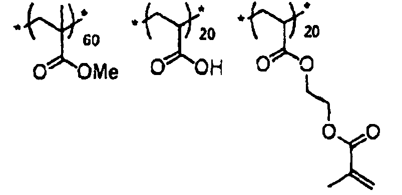 | 47 | 90000 |
| 120 | 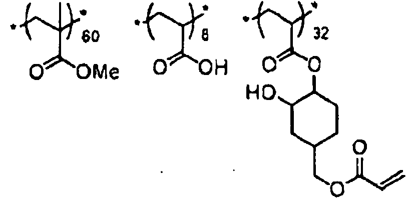 | 30 | 14000 |
| 121 | 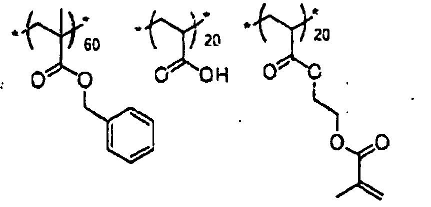 | 34 | 50000 |

The acid value of the specific alkali-soluble resin in the present invention is preferably in the range of from 5.0 to 110 mgKOH/g, more preferably in the range of from 5.5 to 75 mgKOH/g, and still more preferably in the range of from 6.0 to 70 mgKOH/g. When the acid value is 110 mgKOH/g or lower, peeling off of a pattern at the time of development is prevented. When the acid value is 5.0 mgKOH/g or more, alkaline developability is excellent.

In the present invention, the acid value of the specific alkali-soluble resin (D) can be calculated from the average content of an acid group in a resin molecule, for example. A resin having a desired acid value can be obtained by changing the content of a monomer unit containing an acid group in the specific alkali-soluble resin.

The weight average molecular weight of the specific alkali-soluble resin (D) in the present invention is preferably from 30,000 to 300,000, more preferably from 35,000 to 250,000, still more preferably from 40,000 to 200,000, and particularly preferably from 45,000 to 100,000 from the viewpoint of preventing peeling of a pattern at the time of development and obtaining excellent developability.
It should be noted that the weight average molecular weight of the specific alkali-soluble resin can be measured by GPC, for example.

The content of the specific alkali-soluble resin with respect to the total solid content of the colored curable composition of the present invention is preferably from 0.1 to 7.0 mass% in terms of polymerizability and alkali developability. From the viewpoint of achieving both the prevention of pattern peeling and the prevention of a development residue, the content of the specific alkali-soluble resin with respect to the total solid content of the colored curable composition is more preferably from 0.3 to 6.0 mass%, and still more preferably from 1.0 to 5.0 mass%.

The colored curable composition of the present invention may further contain, as required, optional components described below in detail.
Hereinafter, the optional components which may be contained in the colored curable composition of the present invention will be described.
- Binder polymer-
   In the colored curable composition of the present invention, a common binder polymer may be used, as required, in addition to the specific alkali-soluble resin for the purpose of improving film properties and the like. It is preferable to use a linear organic polymer as the binder. The linear organic polymer may be known linear organic polymer. In order to realize development with water or weakly alkaline water, the linear organic polymer is preferably soluble or swellable in water or weakly alkaline water. The linear organic polymer may be selected and used in consideration of the function as a film forming agent as well as the developer to be used (a water developer, an weakly alkaline water developer, or an organic solvent developer, for example). For example, use of a water-soluble organic polymer realizes development with water. Such a linear organic polymer may be a radical polymer that has a carboxylic acid group at a side chain, and examples there of include those disclosed in, for example, JP-A No. 59-44615, JP-B Nos. 54-34327, 58-12577, and 54-25957, and JP-A Nos. 54-92723, 59-53836, and 59-71048. More specifically, the following polymers are usable: a resin that is a homopolymer of a monomer having a carboxyl group or copolymer formed using a monomer having a carboxyl group as a copolymer component; a resin obtained by preparing a homopolymer of a monomer having an acid anhydride or a copolymer formed using a monomer having an acid anhydride as a copolymer and then subjecting an acid anhydride unit to hydrolysis, half-esterification, or half-amidation; and an epoxy acrylate in which an epoxy resin has been modified with an unsaturated monocarboxylic acid and an acid anhydride. Examples of the monomer having a carboxyl group include acrylic acid, methacrylic acid, itaconic acid, crotonic acid, maleic acid, fumaric acid, and 4-carboxystyrene. Examples of the monomer having acid anhydride include maleic anhydride. Moreover, an acid cellulose derivative having a carboxyl group at a side chain is also usable. Further, a compound obtained by adding a cyclic acid anhydride to a polymer having a hydroxyl group is useful.

Moreover, urethane binder polymers containing acid groups disclosed in JP-B Nos. 7-12004, 7-120041, 7-120042, and 8-12424, JP-A Nos. 63-287944, 63-287947, and 1-271741 and Japanese Patent Application No. 10-116232 and urethane binder polymers having acid groups and double bonds at side chains disclosed in JP-A No. 2002-107918 are excellent in strength, and thus are advantageous in respect of low exposure suitability.
Moreover, acetal-modified polyvinyl alcohol binder polymers having acid groups disclosed, for example, in European Patent Nos. 993966 and 1204000, JP-A No. 2001-318463 are excellent in the balance between film strength and developability, and thus are preferable.
Further, polyvinyl pyrrolidone and polyethylene oxide, for example, are also useful as water-soluble linear organic polymers. In view of increasing the strength of a cured film, alcoholic soluble nylon and polyether of 2,2-bis-(4-hydroxyphenyl)-propane and epichlorohydrin, for example, are useful.

The weight average molecular weight of a binder polymer which can be used in the colored curable composition of the present invention is preferably 5,000 or more, and more preferably in the range of from 10,000 to 300,000. The number average molecular weight thereof is preferably 1,000 or more, and more preferably in the range of from 2, 000 to 250,000. The degree of polydispersity (weight average molecular weight/number average molecular weight) is preferably 1 or more, and more preferably in the range of from 1.1 to 10.
The binder polymer may be any one of a random polymer, a block polymer, and a graft polymer.

Binder polymers usable in the present invention can be synthesized by conventional methods. Examples of a solvent used in the synthesis include tetrahydrofuran, ethylene dichloride, cyclohexanone, methyl ethyl ketone, acetone, methanol, ethanol, ethyleneglycol monoethyl ether, ethyleneglycol monoethyl ether, 2-methoxyethyl acetate, diethyleneglycol dimethyl ether, 1-methoxy-2-propanol, l-methoxy-2-propyl acetate, N,N-dimethylformamide, N,N-dimethylacetamide, toluene, ethyl acetate, methyl lactate, ethyl lactate, dimethyl sulfoxide, and water. The solvent may be used singly or a mixture of two or more thereof may be used.
Examples of a radical polymerization initiator used when the binder polymer which can be used in the colored curable composition of the present invention is synthesized include known compounds, such as an azo initiator and a peroxide initiator.
- Sensitizer -
   The colored curable composition of the present invention may contain a sensitizer for the purpose of improving the radical generation efficiency of a radical initiator and making the composition sensitive to a longer wavelength.
   As a sensitizer which can be used in the present invention, a substance which sensitizes the specific photopolymerization initiator through an electronic transition mechanism or an energy transfer mechanism.

Examples of the sensitizer used for the colored curable composition of the present invention include substances belonging to any of the classes of compounds described below and having an absorption wavelength in a wavelength region of from 300 nm to 450 nm.
Specifically, examples thereof include polynuclear aromatic compounds (e.g., phenanthrene, anthracene, pyrene, perylene, triphenylene, and 9,10-dialkoxy anthracene), xanthenes (e.g., fluorescein, eosine, erythrosine, rhodamine B, and rose bengal), thioxanthones (isopropylthioxanthone, diethyithioxanthone, chlorothioxanthone), cyanines (e.g., thiacarbocyanine and oxacarbocyanine), merocyanines (e.g., merocyanine and carbomerocyanine), phthalocyanines, thiazines (e.g., thionine, methylene blue, and toluidine blue), acridines (e.g., acridine orange, chloroflavin, and acriflavine), anthraquinones (e.g., anthraquinone), squaryliums (e.g., squarylium), acridine orange, coumarins (e.g., 7-diethylamino-4-methylcoumarin), ketocoumarin, phenothiazins, phenazines, styryl benzens, azo compounds, diphenylmethane, triphenylmethane, distyryl benzens, carbazoles, porphyrin, spiro compounds, quinacridone, indigo, styryl, pyrylium compounds, pyrromethene compounds, pyrazolotriazole compounds, benzothiazole compounds, barbituric acid derivatives, thiobarbituric acid derivatives, acetophenone, benzophenone, thioxanthone, aromatic ketone compounds such as Michler's ketone, and heterocyclic compounds such as N-aryl oxazolidinone.

More preferable examples of the sensitizer in the colored curable composition of the present invention include compounds represented by the following Formulae (e-1) to (e-4).

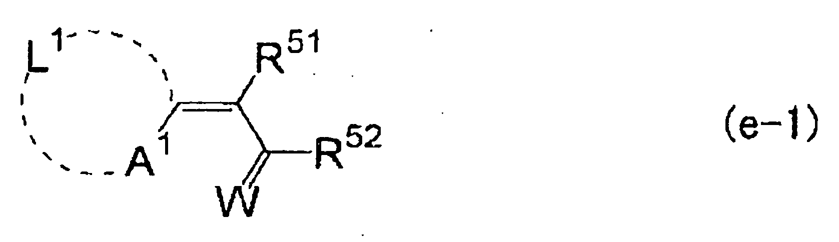

In Formula (e-1), A¹ represents a sulfur atom or NR⁵⁰; R⁵⁰ represents an alkyl group or an aryl group; L¹ represents a non-metallic atomic group forming, together with A¹ adjacent to L¹ and the adjacent carbon atom, a basic nucleus of a dye; R⁵¹ and R⁵² each independently represent a hydrogen atom or a monovalent non-metallic atomic group; R⁵¹ and R⁵² may be combined with each other to form an acidic nucleus of a dye; and W represents an oxygen atom or a sulfur atom.

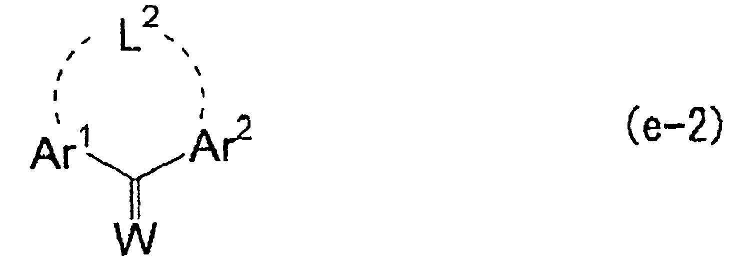

In Formula (e-2), Ar¹ and Ar² each independently represent an aryl group, and Ar¹ and Ar² are connected by -L²-; L² represents -O- or -S-; and W has the same definition as in Formula (e-1).

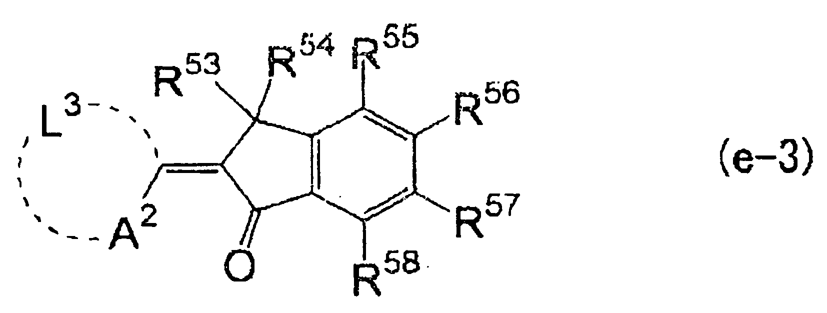

In Fomula (e-3), A² represents a sulfur atom or NR⁵⁹; L³ represents a non-metallic atomic group forming, together with A² adjacent to L³ and the adjacent carbon atom, a basic nucleus of a dye; R⁵³, R⁵⁴, R⁵⁵, R⁵⁶, R⁵⁷, and R⁵⁸ each independently represent a monovalent group of a non-metallic atomic group; and R⁵⁹ represents an alkyl group or an aryl group.

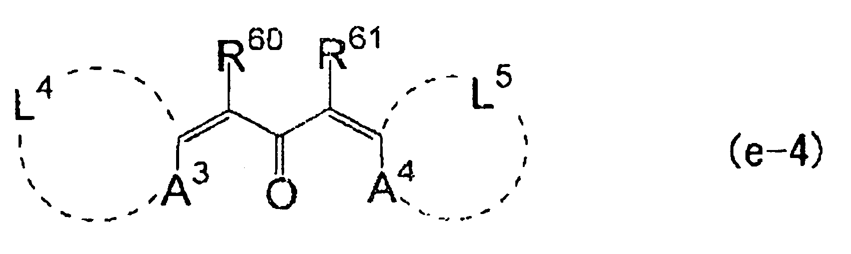

In Formula (e-4), A³ and A⁴ each independently represent -S- or -NR⁶² ; R⁶² represents a substituted or unsubstituted alkyl group or a substituted or unsubstituted aryl group; L⁴ represents a non-metallic atomic group forming, together with A³ adjacent to L⁴ and the adjacent carbon atom, a basic nucleus of a dye; L⁵ represents a non-metallic atomic group forming, together with A⁴ adjacent to L⁵ and the adjacent carbon atom, a basic nucleus of a dye; and R⁶⁰ and R⁶¹ each independently represent a monovalent non-metallic atomic group or can be combined with each other to form an aliphatic ring or an aromatic ring.

Moreover, examples of a preferable sensitizer which can be contained in the colored curable composition of the present invention include, in addition to the above-mentioned sensitizers, at least one selected from a compound represented by Formula (12) shown below and a compound represented by Formula (13) shown below.

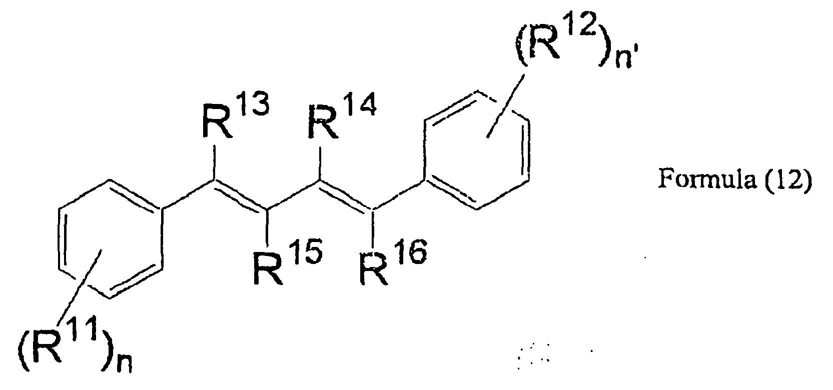

In Formula (12), R¹¹ and R¹² each independently represent a monovalent substituent; R¹³, R¹⁴, R¹⁵, and R¹⁶, each independently represent a hydrogen atom or a monovalent substituent; n represents an integer of from 0 to 5; n' represents an integer of from 0 to 5 with the proviso that both n and n' are not 0 simultaneously; when n is 2 or more, two or more R¹¹s may represent the same substituent as each other or may represent different substituents from each other; when n' is 2 or more, two or more R¹²s may represent the same substituent as each other or may represent different substituents from each other; and in the compound represented by Formula (12), the geometry at each double bond is not limited to either geometry, and the scope of the compound represented by Formula (12) includes geometric isomers thereof.

The molar extinction coefficient ε of the compound represented by Formula (12) at a wavelength of 365 nm is preferably 500 mol⁻¹·L·cm⁻¹ or higher, more preferably 3,000 mol⁻¹·L· cm⁻¹ or higher; and most preferably 20,000 mol⁻¹·L·cm⁻¹ or higher. When the value of the molar extinction coefficient ε at the wavelength is in the above-mentioned range, the sensitivity is significantly improved, which is preferable from the viewpoint of the light absorption efficiency.

Preferable specific examples of the compound represented by Formula (12) include, but are not limited to, those shown below.
It should be noted that, in this specification, chemical formulae are shown as simple structural formulae in some cases, and the solid lines represent hydrocarbon groups unless elements or substituents are indicated. In the following specific examples, Me represents a methyl group, Et represents an ethyl group, Bu represents a butyl group, n-Bu represents an n-butyl group, and Ph represents a phenyl group.

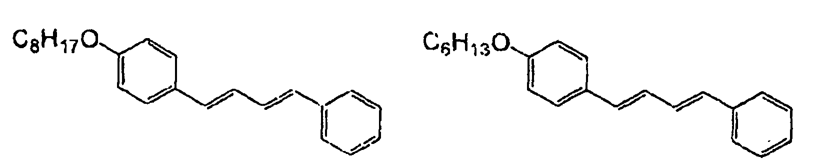

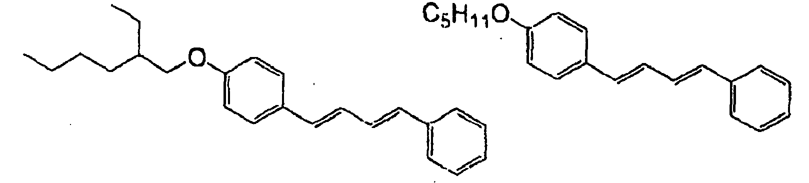

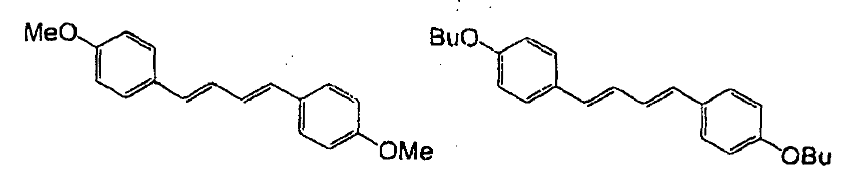

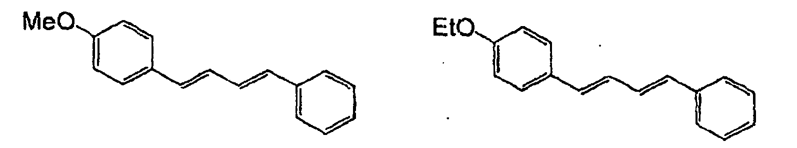

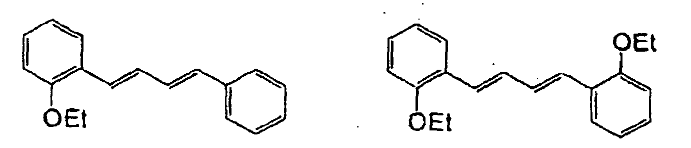

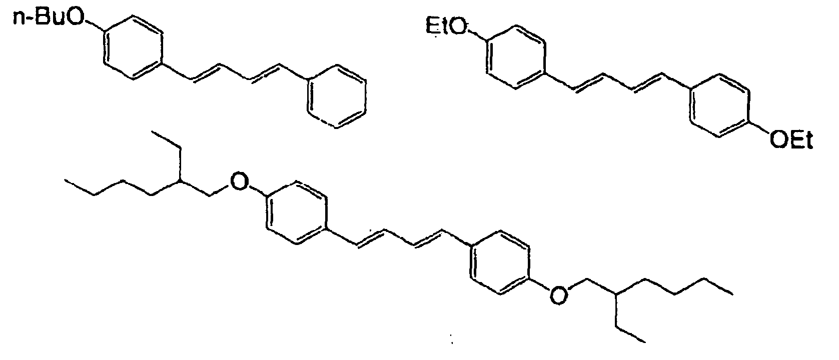

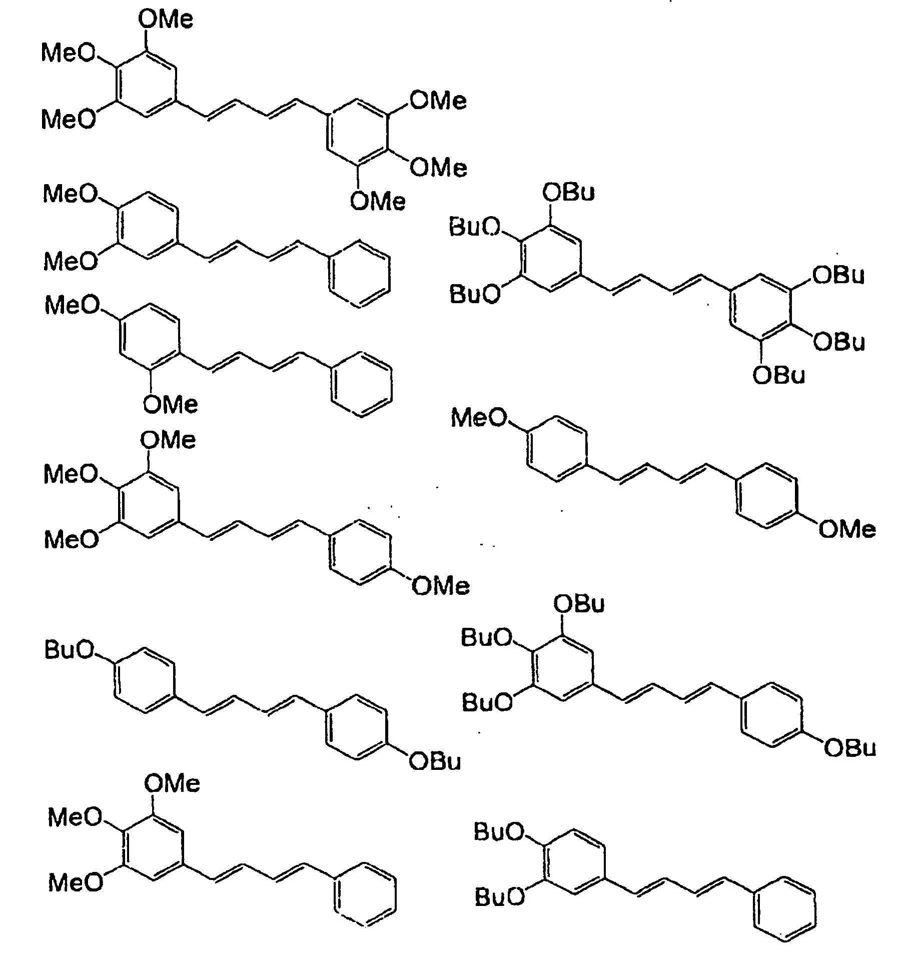

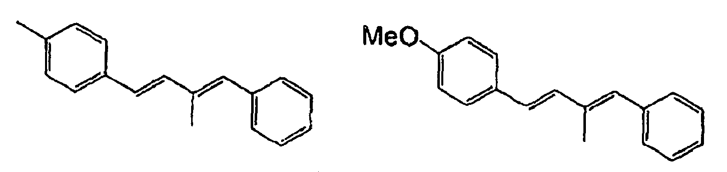

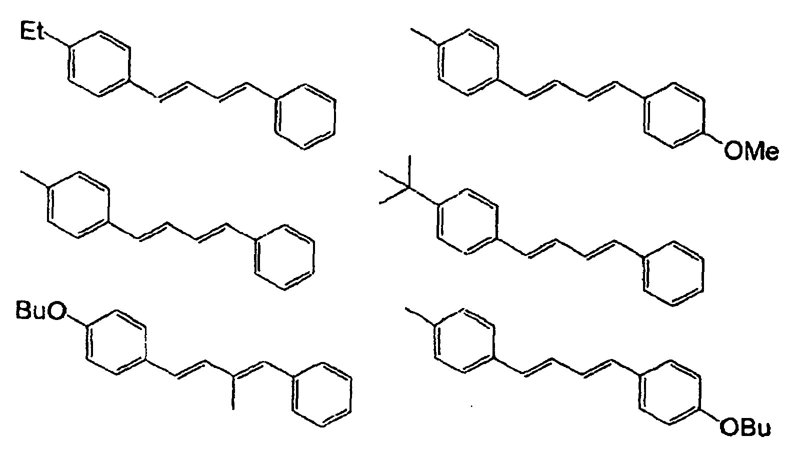

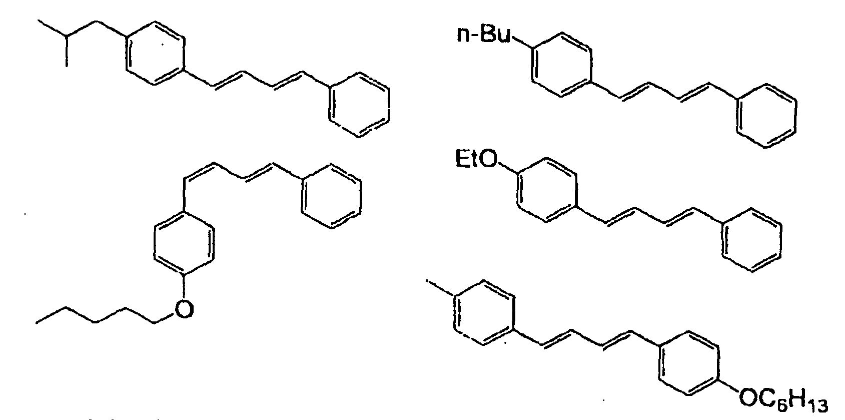

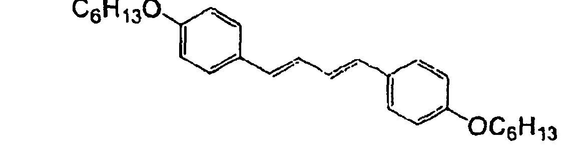

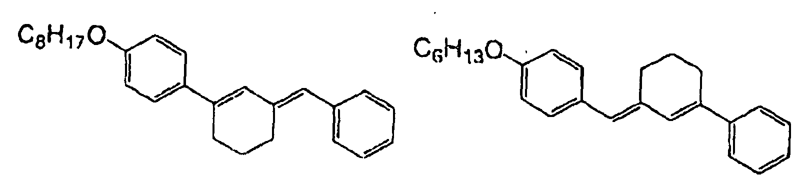

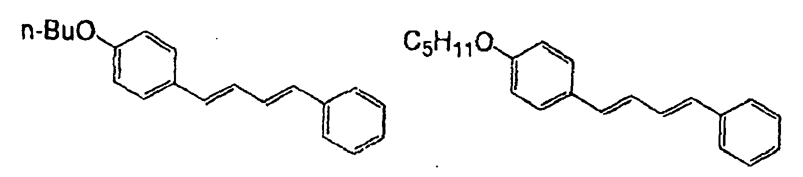

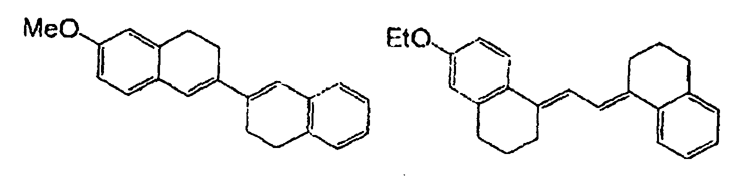

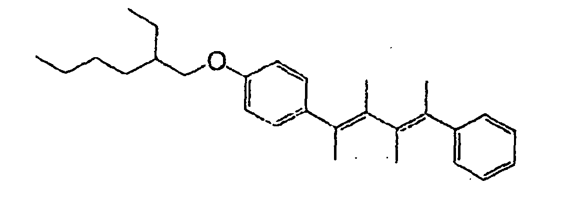

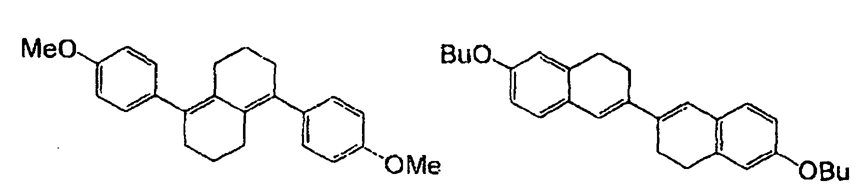

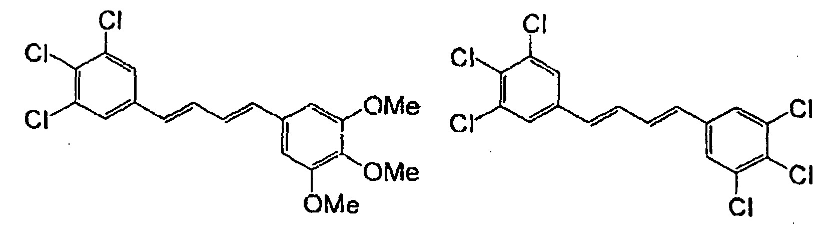

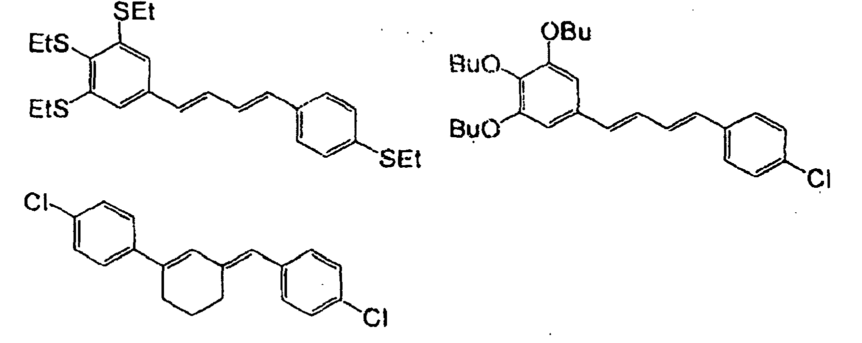

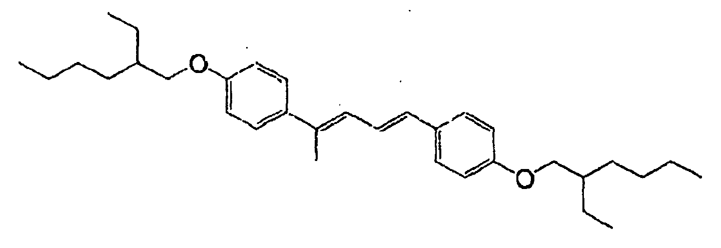

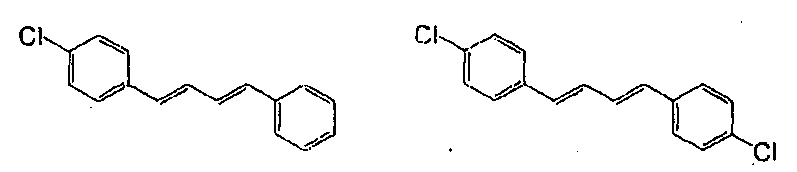

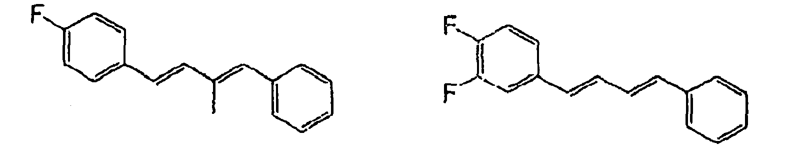

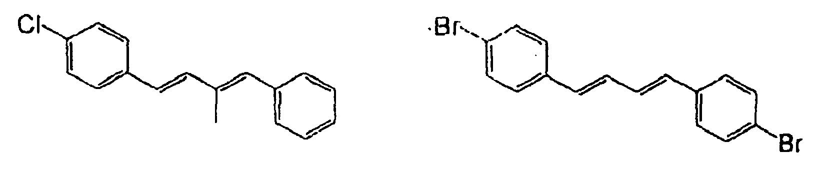

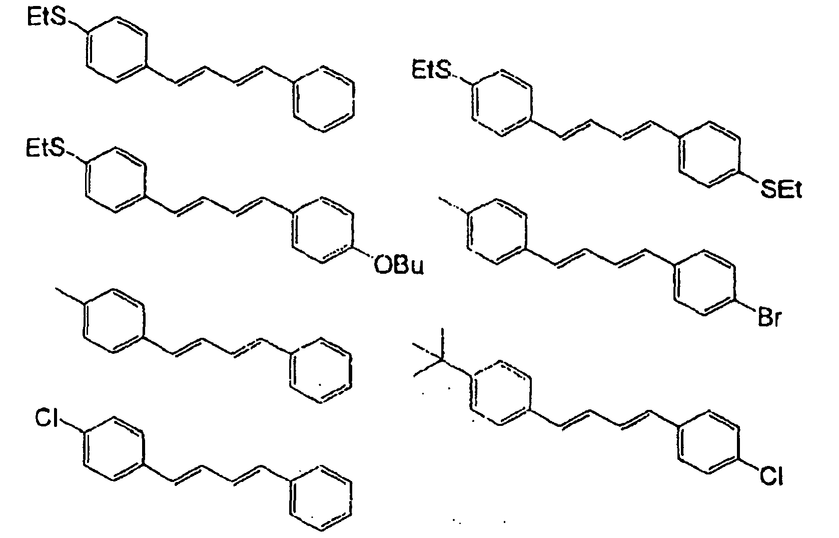

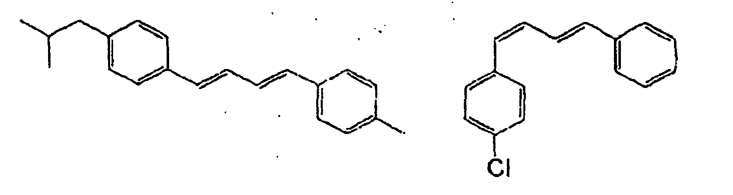

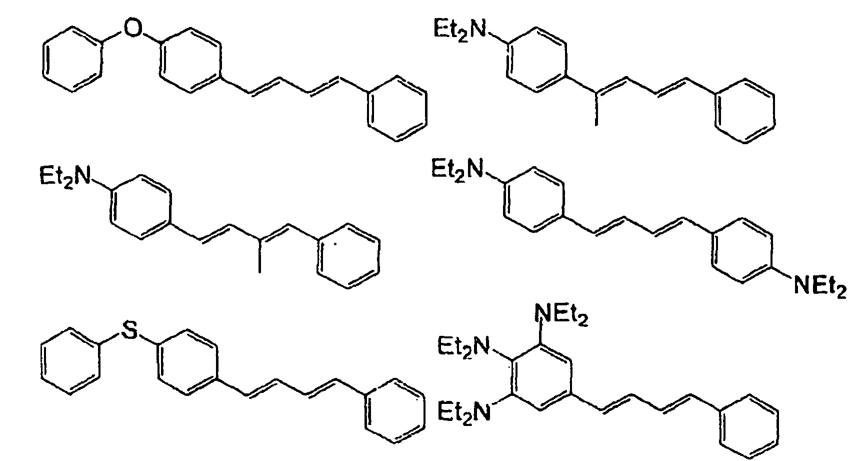

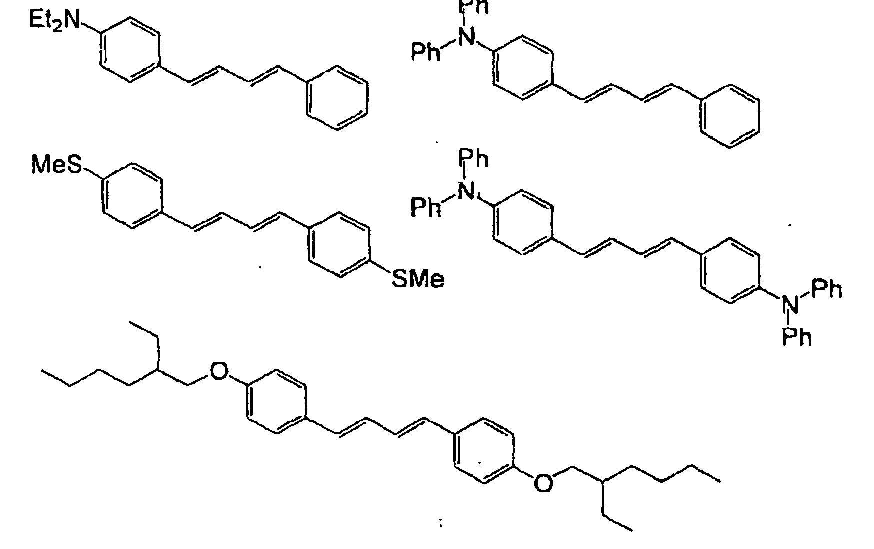

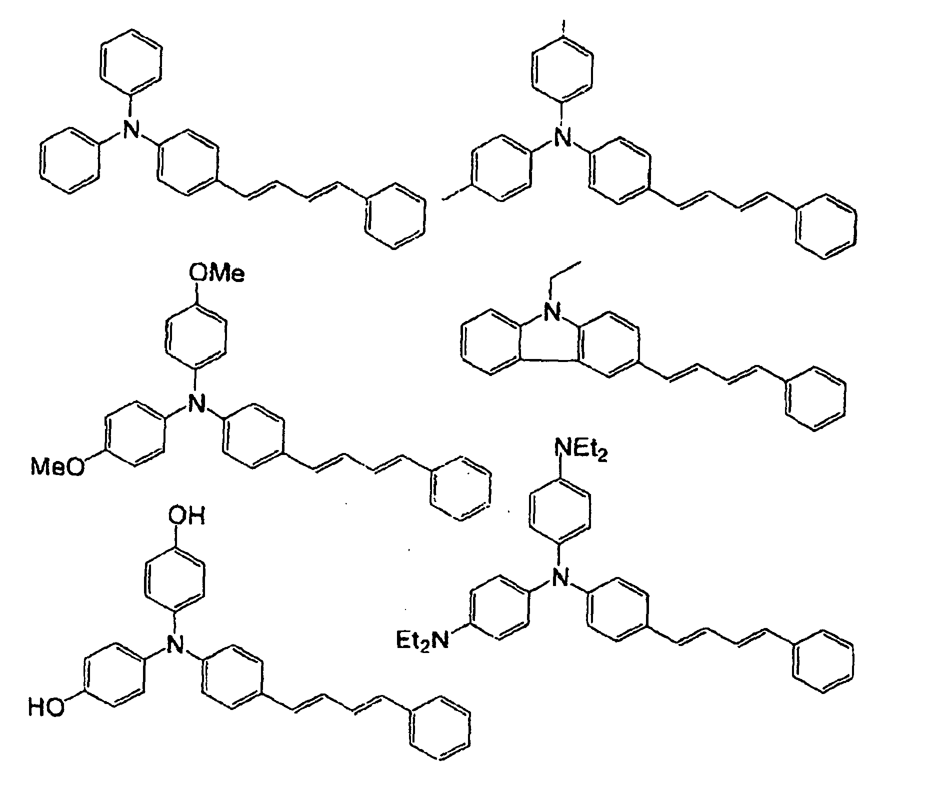

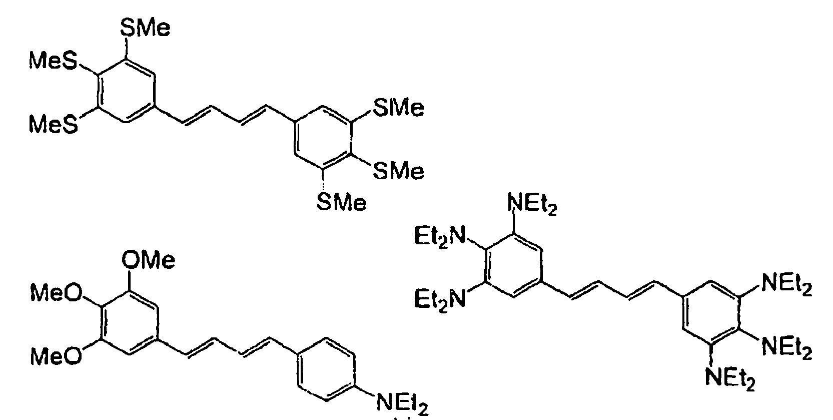

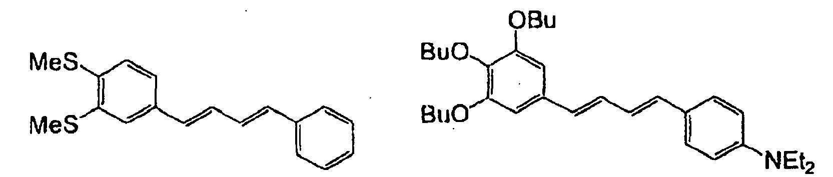

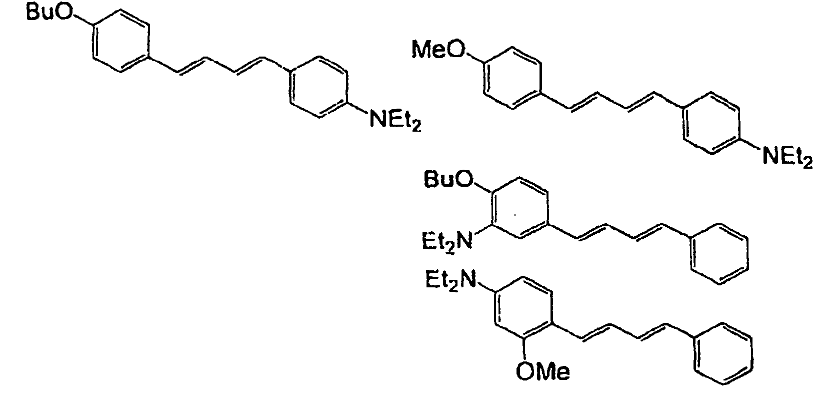

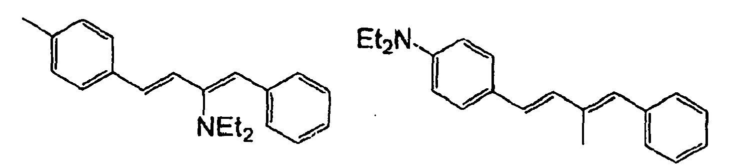

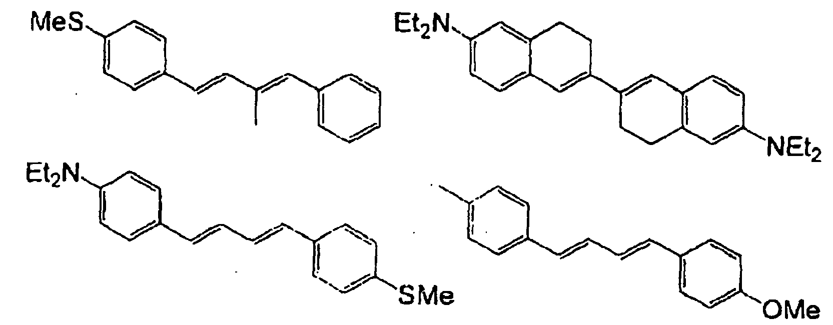

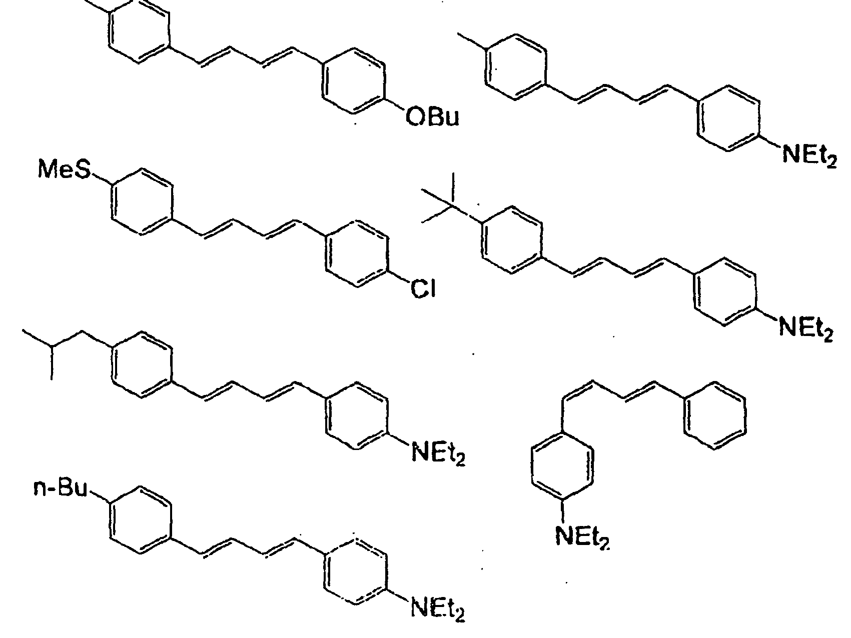

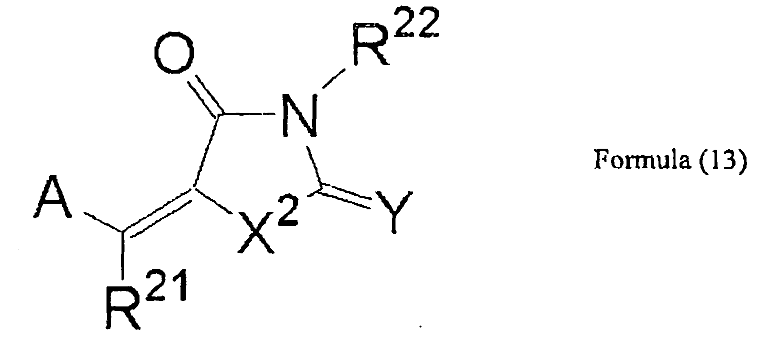

In Formula (13), A represents an aromatic ring or a heterocycle, each of which may have a substituent; X² represents an oxygen atom, a sulfur atom, or -N(R²³)-; and Y represents an oxygen atom, a sulfur atom, or -N(R²³)-. R²¹, R²² , and R²³ each independently represent a hydrogen atom or a monovalent non-metallic atomic group, and two or more of A, R²¹, R²², and R²³ may be combined, in any combination, with each other to form an aliphatic ring or an aromatic ring.

In Formula (13), R²¹, R²², and R²³ each independently represent a hydrogen atom or a monovalent non-metallic atomic group. When R²¹, R²², or R²³ represents a monovalent non-metallic atomic group, the monovalent non-metallic atomic group is preferably a substituted or unsubstituted alkyl group, a substituted or unsubstituted aryl group, a substituted or unsubstituted alkenyl group, a substituted or unsubstituted aromatic heterocyclic residue, a substituted or unsubstituted alkoxy group, a substituted or unsubstituted alkylthio group, a hydroxyl, or a halogen atom.

In the compound represented by Formula (13), Y is preferably an oxygen atom or -N(R²³)- from the viewpoint of improving the decomposition efficiency of a photopolymerization initiator. R²³ represents a hydrogen atom or a monovalent non-metallic atomic group. When there are plural R²³s, each of them may independently represent a hydrogen atom or a monovalent non-metallic atomic group. Y is most preferably -N(R²³)-.

Preferable of the compound represented by Formula (13) include, but are not limited to, specific examples (VI1) to (VI124) shown below. Moreover, the geometry at the double bond connecting the acidic nucleus and the basic nucleus is not limited to either geometry, and the scope of the compound represented by Formula (13) includes geometric isomers with respect to the double bond.

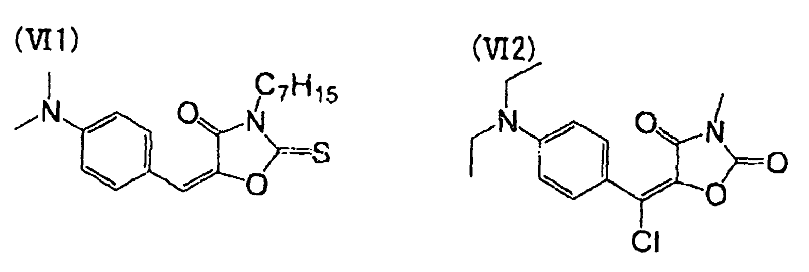

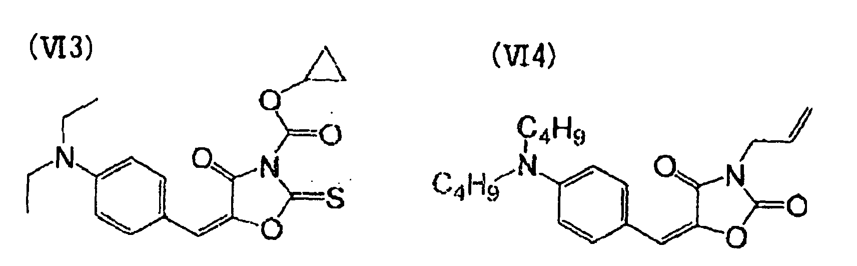

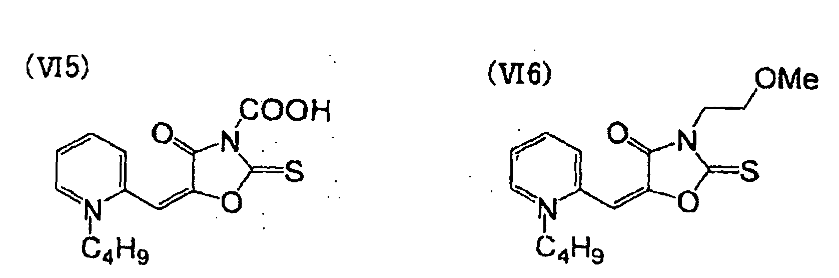

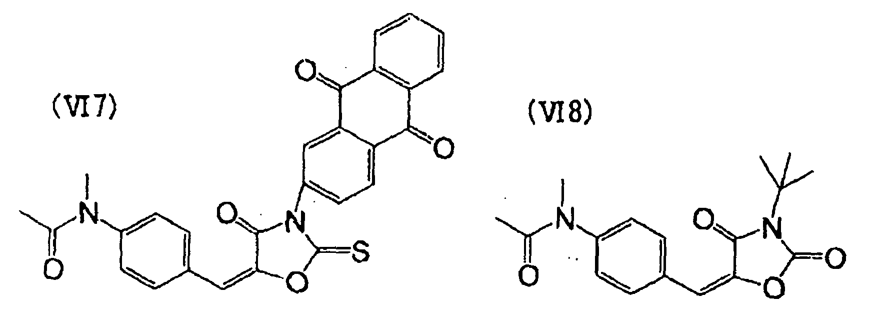

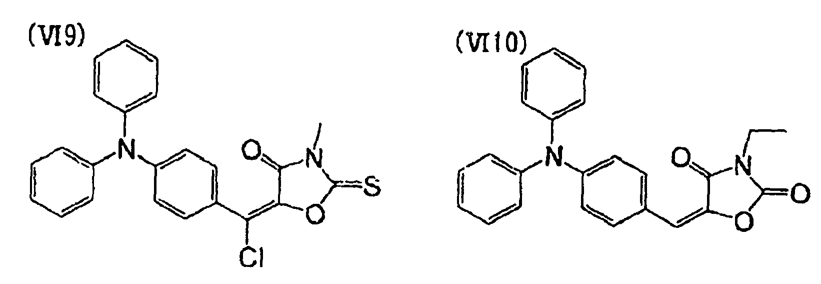

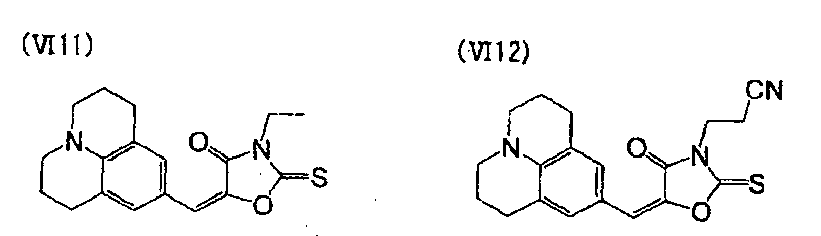

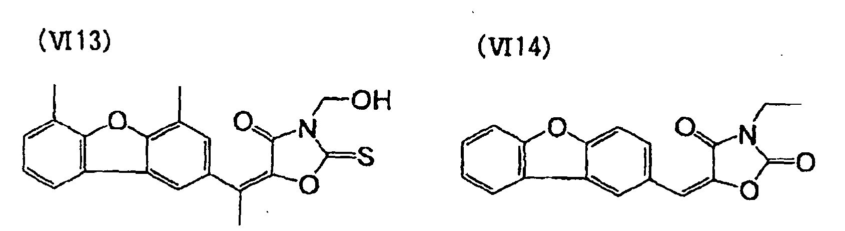

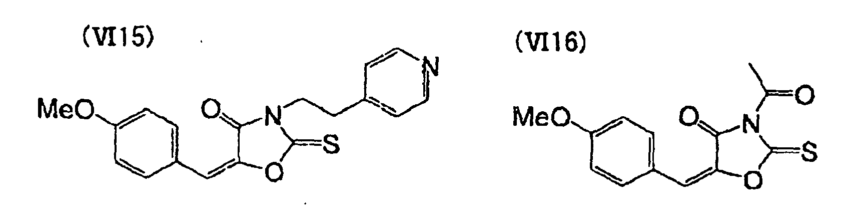

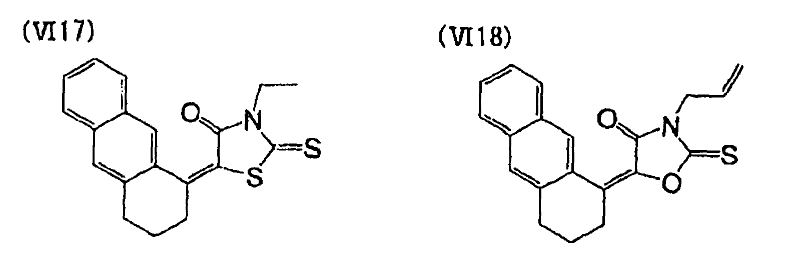

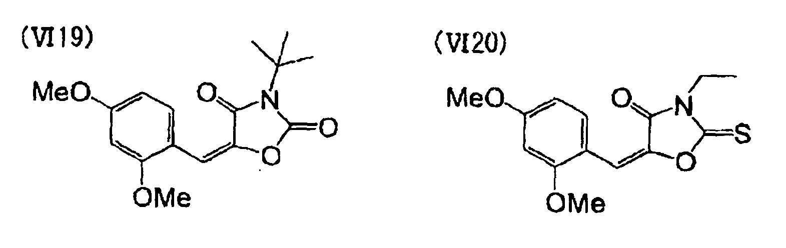

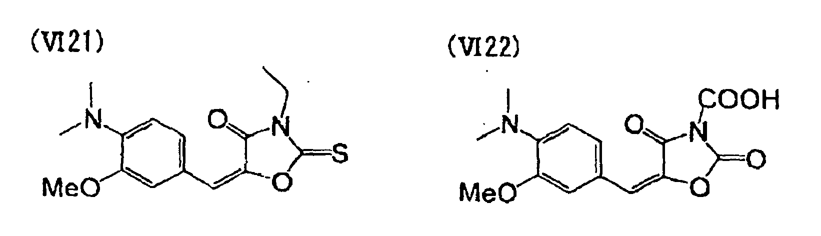

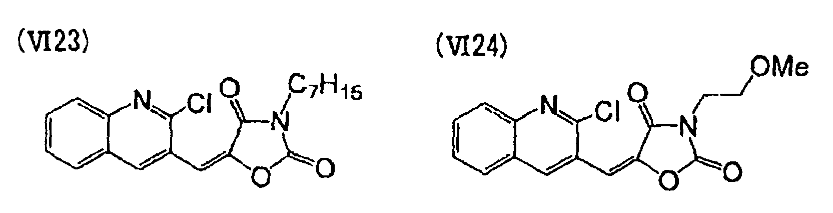

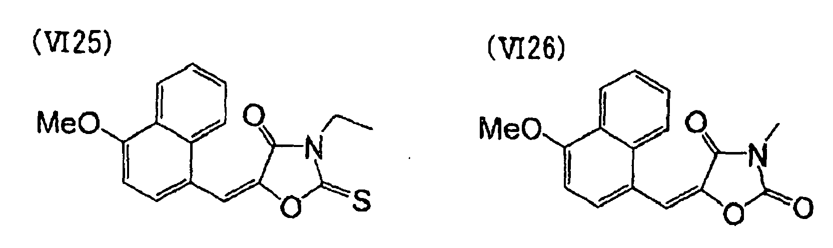

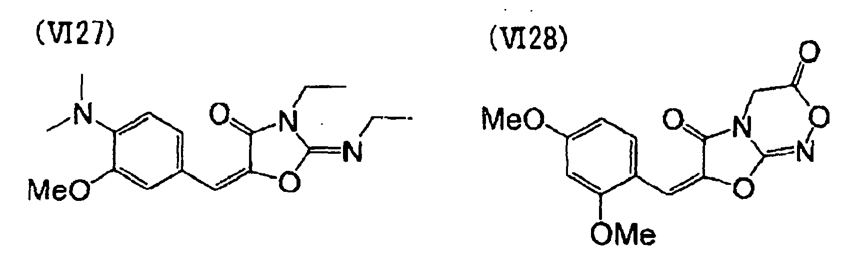

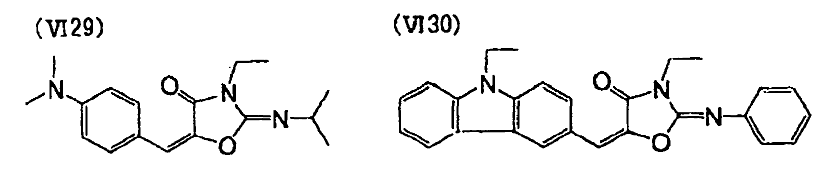

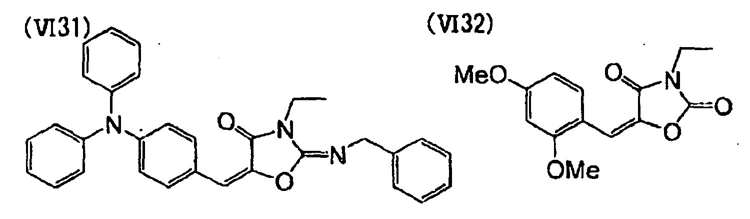

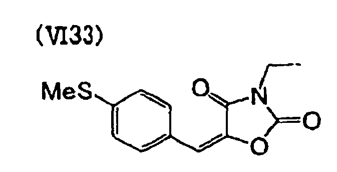

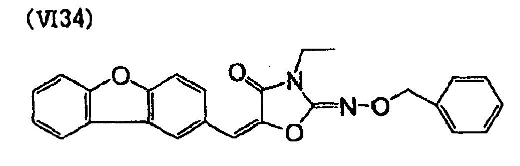

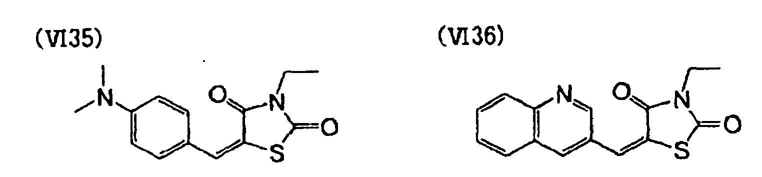

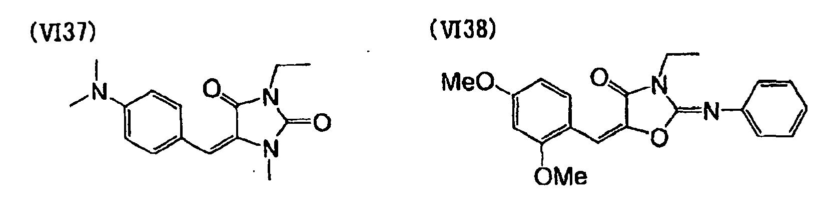

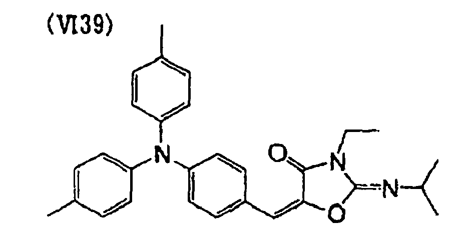

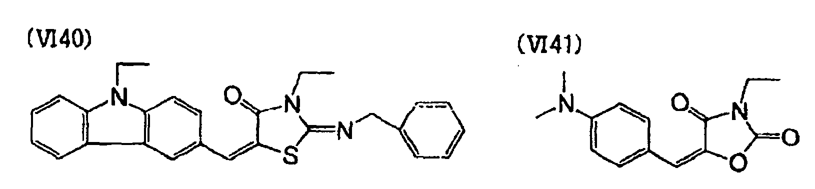

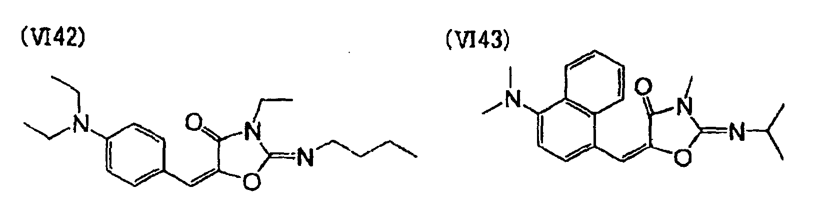

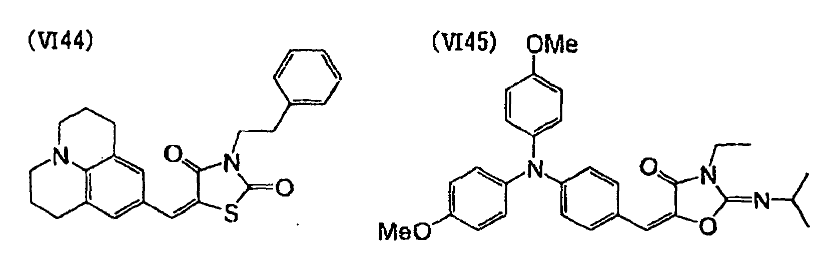

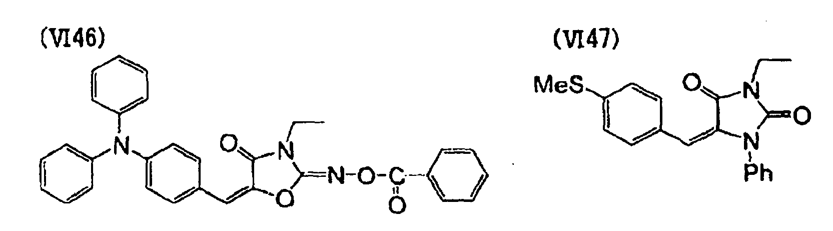

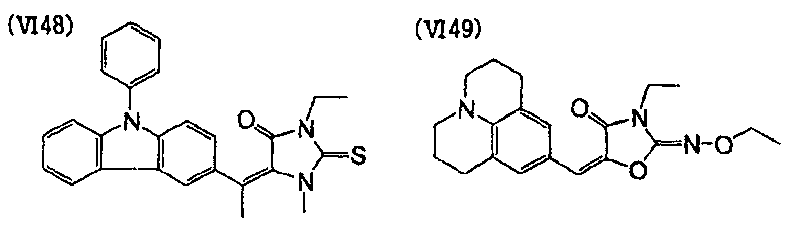

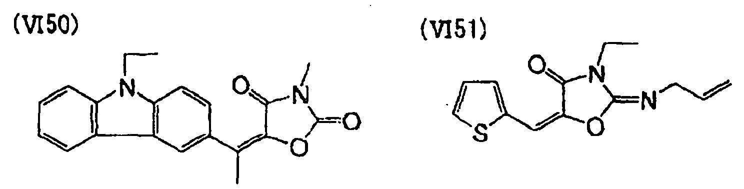

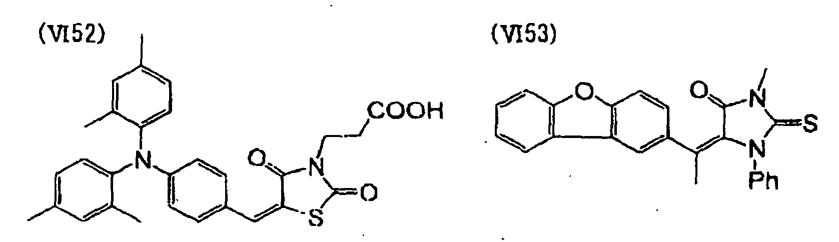

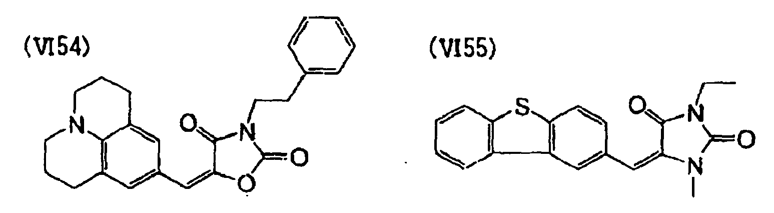

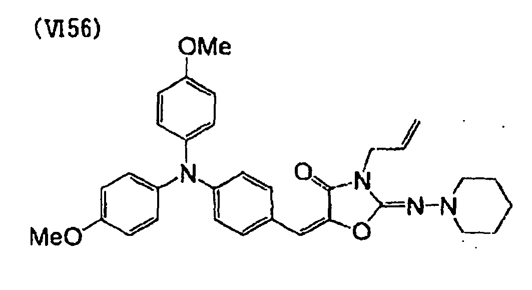

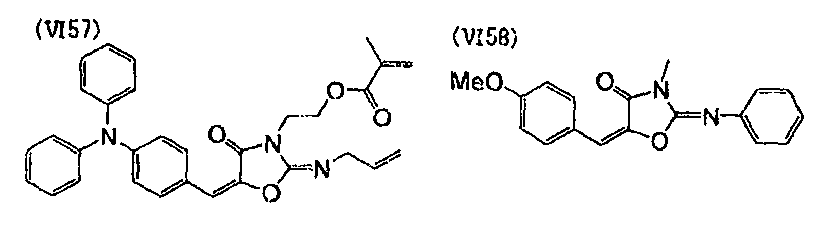

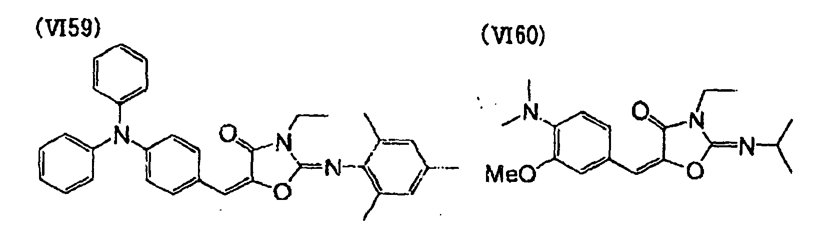

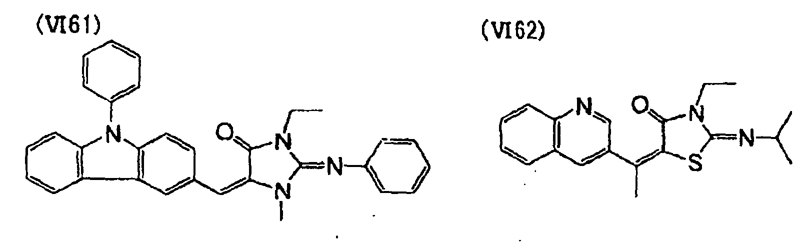

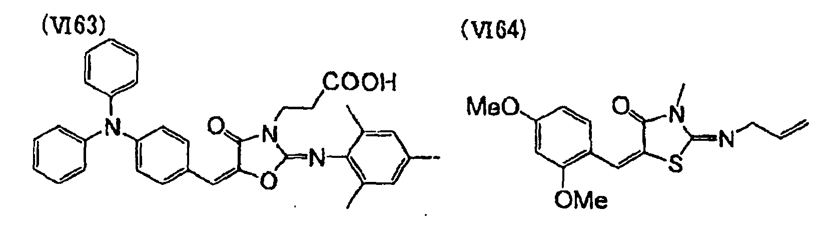

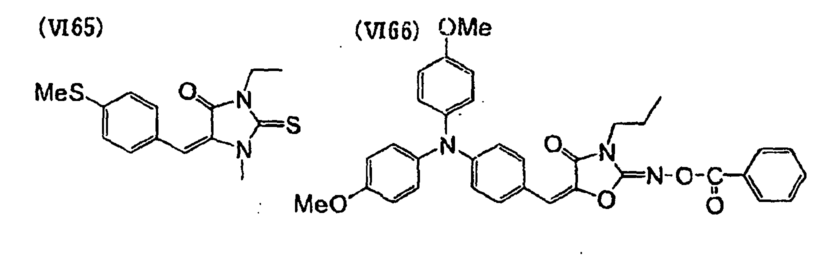

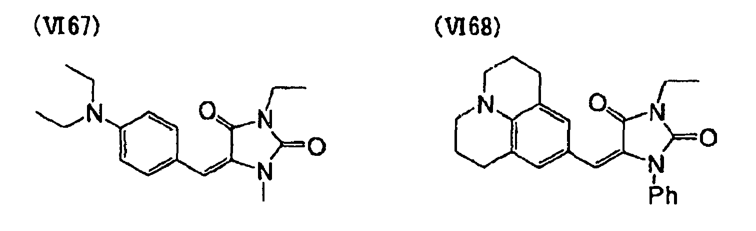

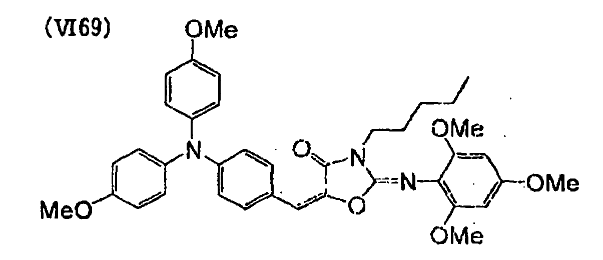

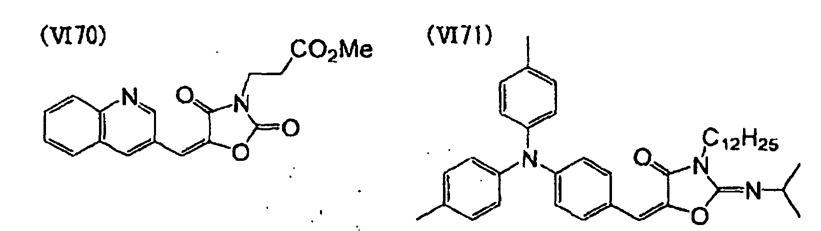

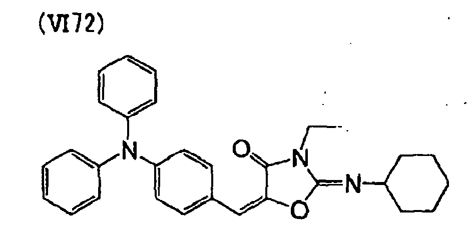

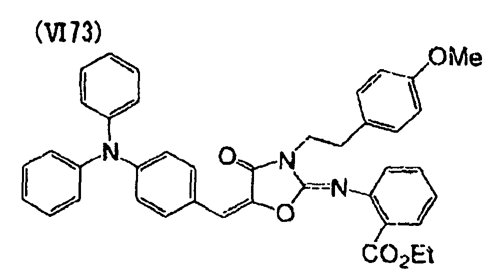

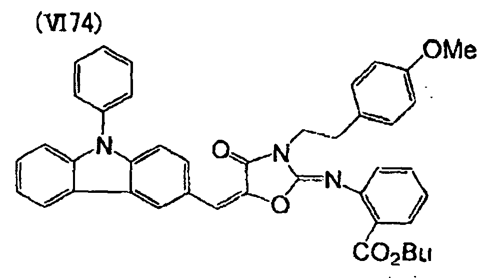

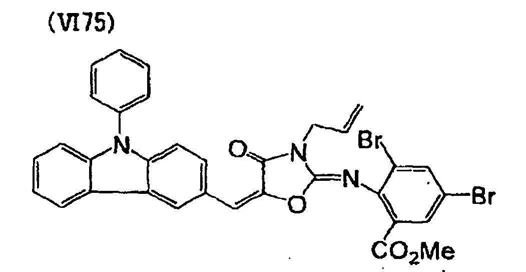

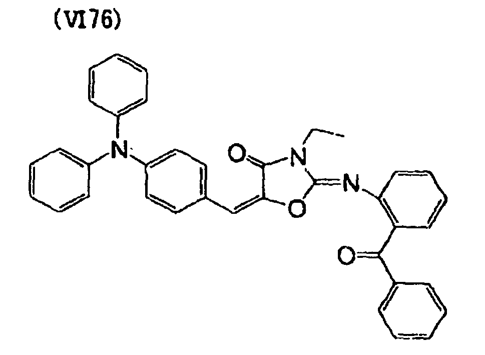

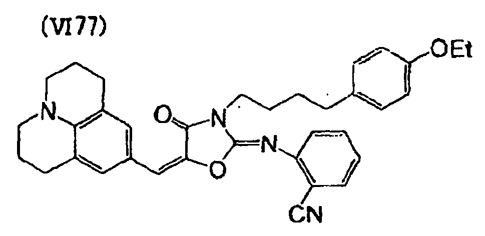

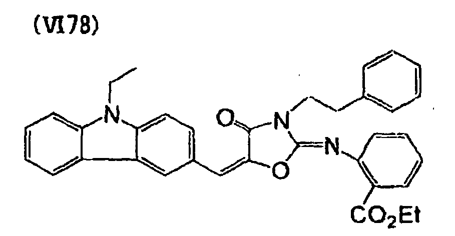

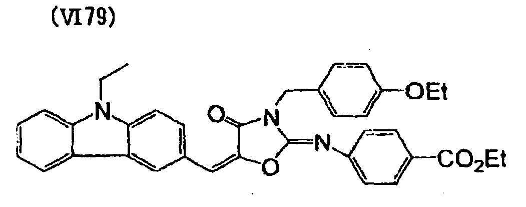

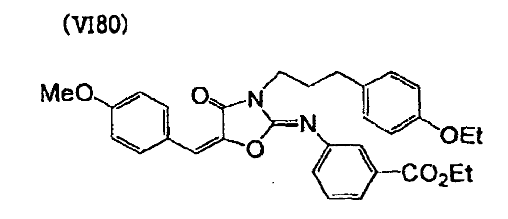

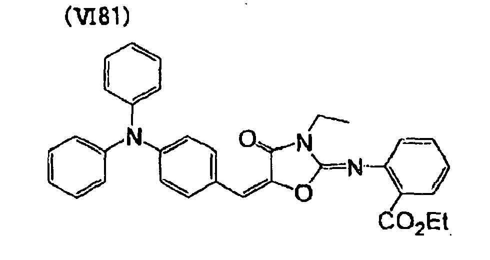

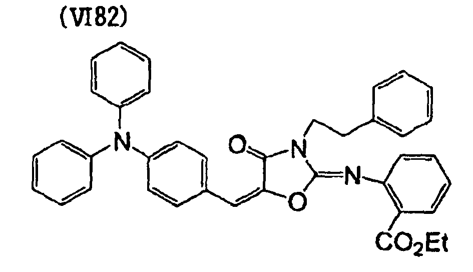

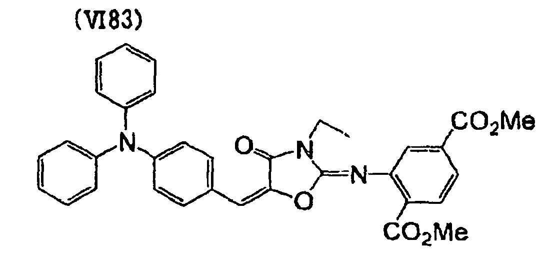

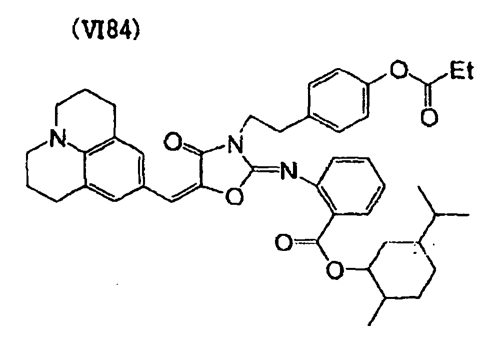

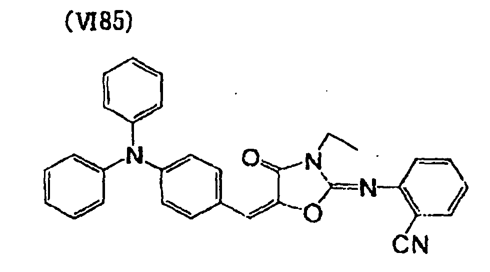

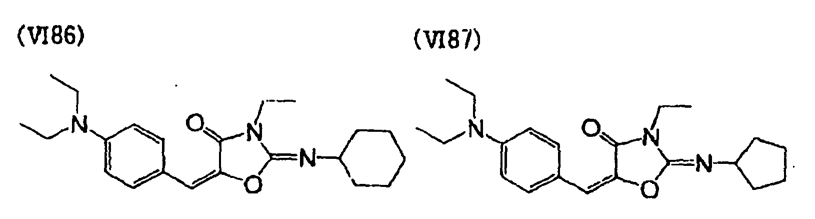

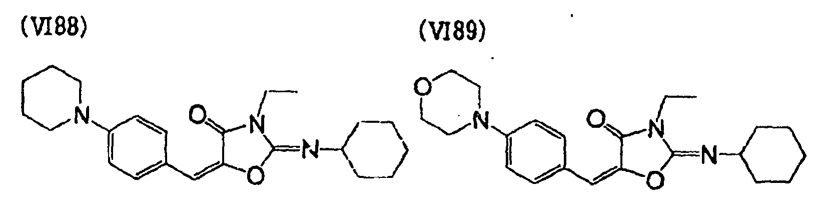

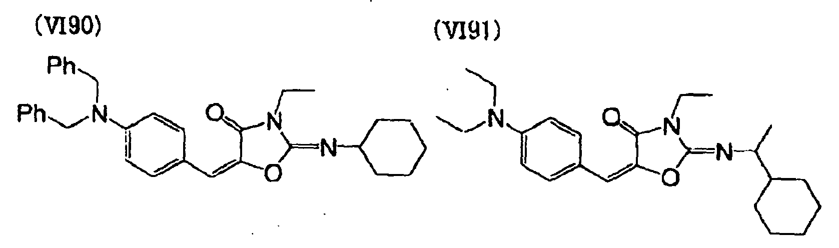

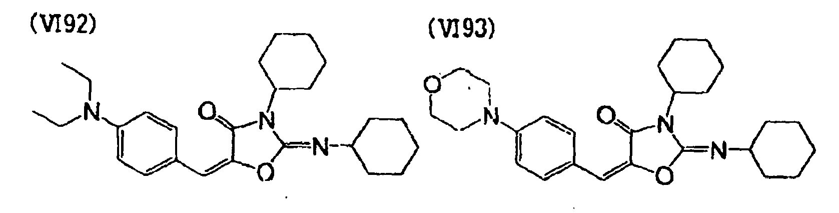

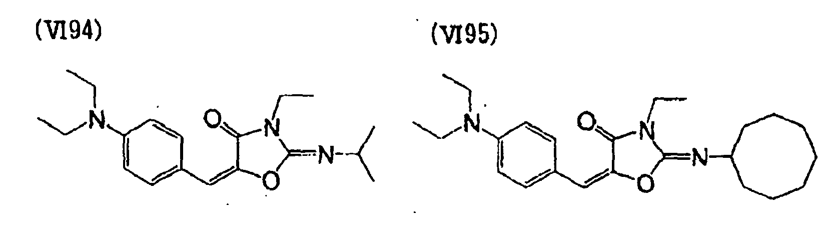

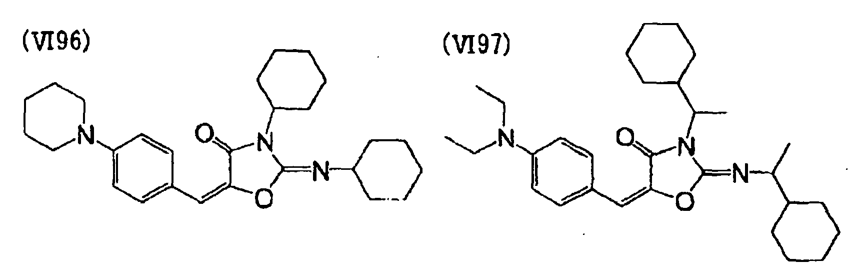

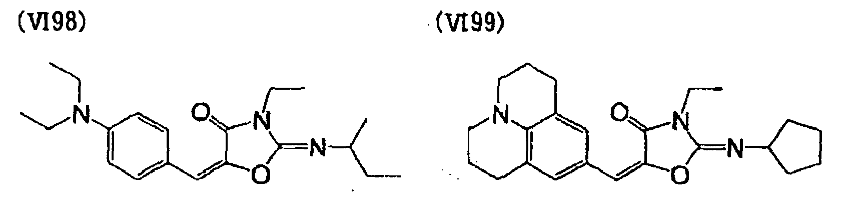

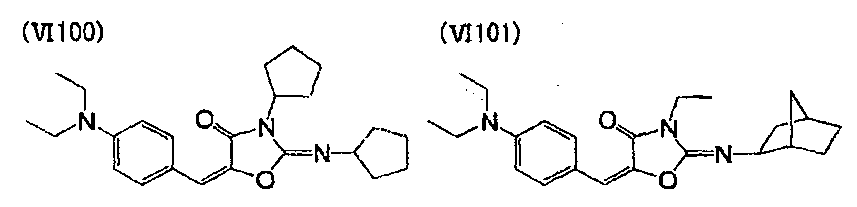

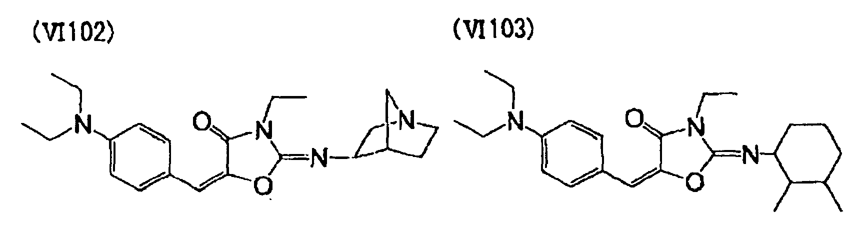

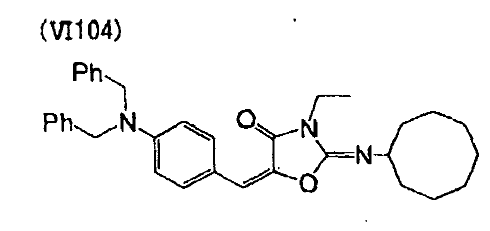

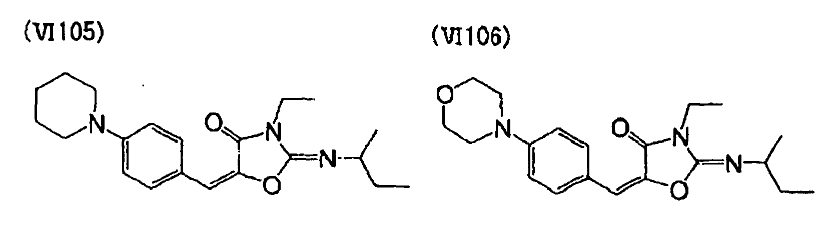

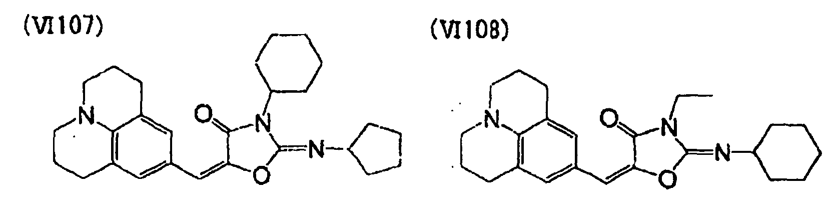

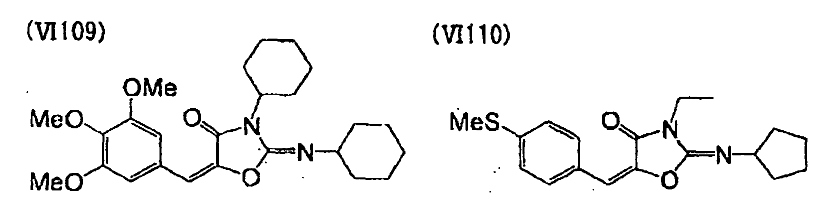

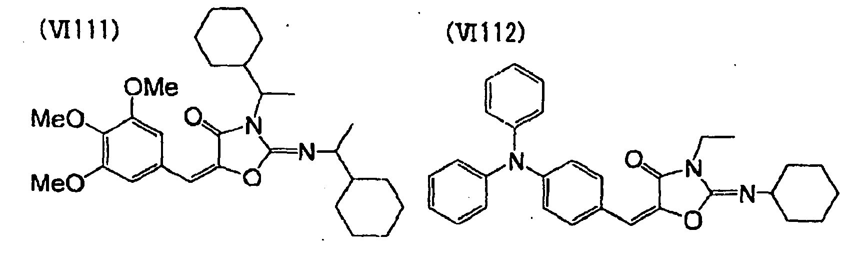

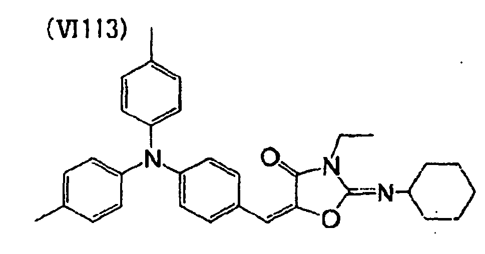

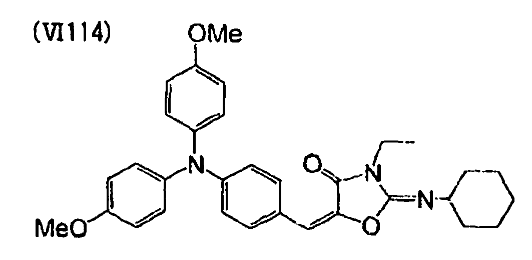

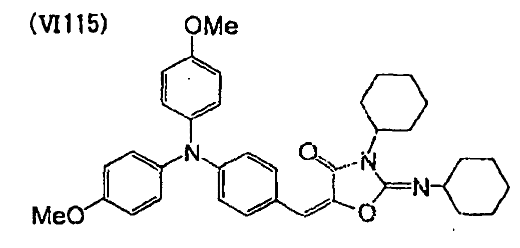

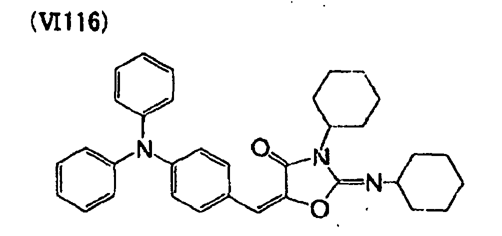

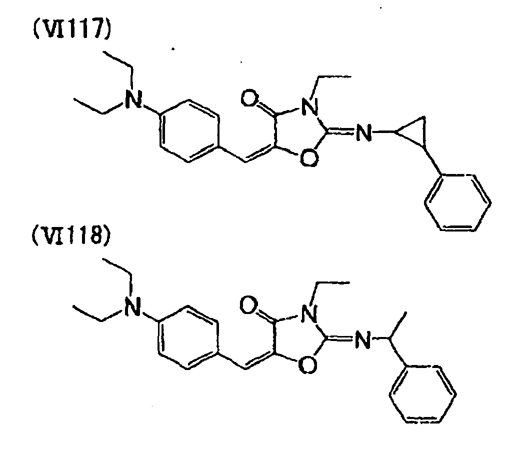

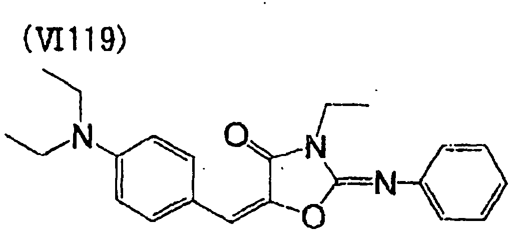

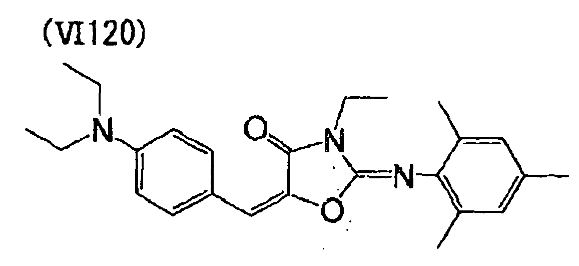

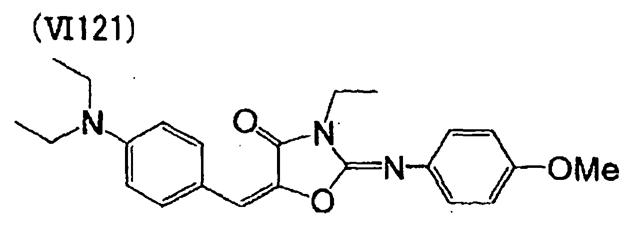

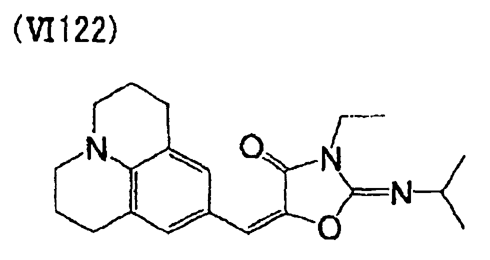

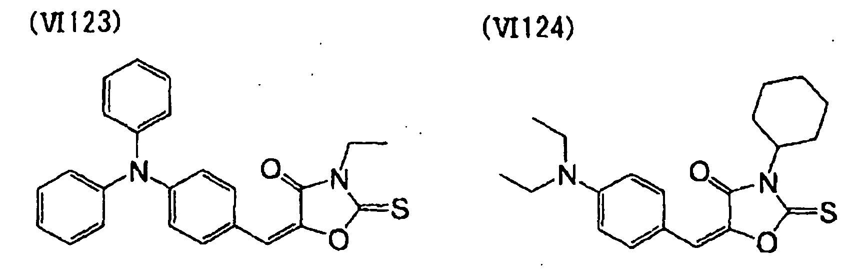

From the viewpoint of the light absorption efficiency to a deep portion and initiation decomposition efficiency, the content of the sensitizer in the colored curable composition of the present invention is preferably from 0.1 to 20 mass%, and more preferably from 0.5 to 15 mass%, in terms of the solid content.
The sensitizer may be used singly or in combination of two or more thereof.
The colored curable composition may contain one compound selected from a compound represented by Formula (12) and a compound represented by Formula (13), or may contain two or more thereof in combination.
- Co-sensitizer-
   The colored curable composition of the present invention preferably further contain a co-sensitizer.
   In the present invention, the co-sensitizer has, for example, a function of further improving the sensitivity of the specific photopolymerization initiator or sensitizer to active radiation and/or a function of preventing inhibition of the polymerization of the polymerizable compound due to oxygen.

Examples of such a co-sensitizer include amines, e.g., compounds disclosed in M. R. Sander et al., Journal of Polymer Society Vol. 10, pp. 3173 (1972), JP-B No. 44-20189 and JP-A Nos. 51-82102, 52-134692, 59-138205, 60-84305, 62-18537, and 64-33104, and *Research Disclosure* No. 33825. Specific examples include triethanolamine, ethyl p-dimethylaminobenzoate, p-formyldimethylaniline, and p-methylthiodimethylaniline.

Other examples of co-sensitizers include thiols and sulfides, such as thiol compounds disclosed in JP-A No. 53-702, JP-B No. 55-500806, and JP-A No. 5-142772, and disulfide compounds disclosed in JP-A No. 56-75643. Specific examples include 2-mercaptobenzothiazole, 2-mercaptobenzoxazole, 2-mercaptobenzimidazole, 2-mercapto-4(3H)-quinazoline, and β-mercaptonaphthalene.

Moreover, other examples of the co-sensitizer include amino acid compounds (e.g., N-phenylglycine), organometallic compounds disclosed in JP-B No. 48-42965 (e.g., tributyltin acetate), a hydrogen donor disclosed in JP-B No. 55-34414, sulfur compounds (e.g., trithiane) disclosed in JP-A No. 6-308727.

The content of the co-sensitize is preferably in the range of from 0.1 to 30 mass%, more preferably in the range of from 1 to 25 mass%, and still more preferably in the range of from 0.5 to 20 mass%, with respect to the mass of the total solid content of the colored curable composition of the present invention from the viewpoint of increasing the curing rate by improving the balance between the polymerization growth rate and the chain transfer.

Moreover, the colored curable composition of the present invention preferably contains a thiol compound as a co-sensitizer.
The thiol compound which can be contained in the colored curable composition of the present invention is preferably a compound represented by the following Formula (14).

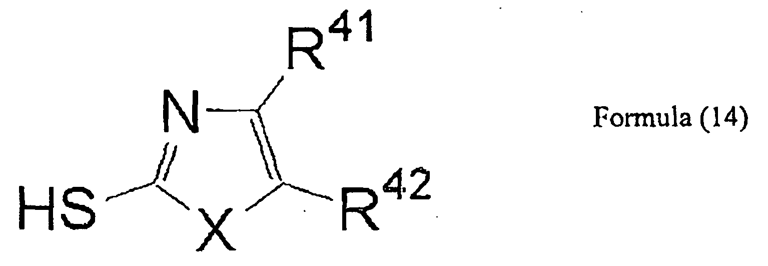

In Formula (14), X represents a sulfur atom, an oxygen atom, or -N(R⁴³)-, and R⁴³ represents a hydrogen atom, an alkyl group having 1 to 5 carbon atoms, or an aryl group having 6 to 13 carbon atoms. R⁴¹ and R⁴² each independently represent a hydrogen atom, an alkyl group having 1 to 5 carbon atoms, a hydroxyalkyl group having 1 to 3 carbon atoms, a phenyl group which may be substituted by an alkoxy group having 1 to 8 carbon atoms, a nitro group, an alkoxycarbonyl group having an alkyl group having 1 to 8 carbon atoms, a phenoxy carbonyl group, an acetyl group, or a carboxy group. Moreover, R⁴¹, R⁴², and the carbon atoms adjacent thereto that form a double bond therebetween may together form a benzene ring, and the double bond that the carbon atoms adjacent to R⁴¹ and R⁴² form may be hydrogenated.

Examples of thiol compounds include compounds disclosed as thiol compounds in, for example, JP-A No. 53-702, JP-B No. 55-500806, and JP-A No. 5-142772.

Furthermore, the thiol compounds suitable for the colored curable composition of the present invention are preferably represented by the following Formula (15).

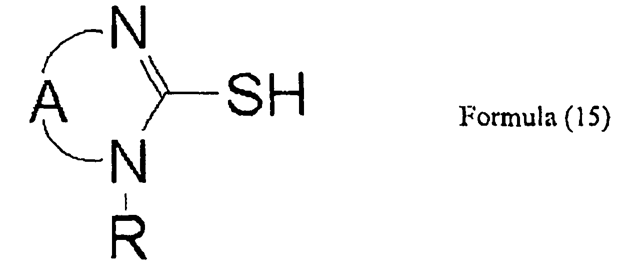

In Formula (15), R represents an alkyl group or an aryl group; and A represents an atomic group forming a heterocycle with N=C-N.

In Formula (15), R represents an alkyl group or an aryl group.
The alkyl group may be a linear, branched or cyclic alkyl group having 1 to 20 carbon atoms, more preferably a linear alkyl group having 1 to 12 carbon atoms, a branched alkyl group having 3 to 12 carbon atoms or a cyclic alkyl group having 5 to 10 carbon atoms.
Examples of the alkyl group include a methyl group, an ethyl group, a propyl group, a butyl group, a pentyl group, a hexyl group, a heptyl group, an octyl group, a nonyl group, a decyl group, an undecyl group, a dodecyl group, a tridecyl group, a hexadecyl group, an octadecyl group, an eicocyl group, an isopropyl group, an isobutyl group, a sec-butyl group, a tert-butyl group, an isopentyl group, a neopentyl group, a 1-methylbutyl group, an isohexyl group, a 2-ethylhexyl group, a 2-methylhexyl group, a cyclohexyl group, a cyclopentyl group, and a 2-norbomyl group.

The aryl group may have a monocyclic structure, structure having a condensed ring formed by condensation of 1 to 3 benzene rings, or a structure having a condensed ring formed by condensation of at least one benzene ring and at least one five-membered unsaturated ring, Examples thereof include a phenyl group, a naphthyl group, an anthryl group, a phenanthryl group, an indenyl group, an acenaphthenyl group, and a fluorenyl group. In particular, a phenyl group or a naphthyl group is more preferred.

The alkyl group or aryl group may further have at least one substituent. Examples of the substituent that may be introduced include a linear, branched or cyclic alkyl group having 1 to 20 carbon atoms, a linear, branched or cyclic alkenyl group having 2 to 20 carbon atoms, an alkynyl group having 2 to 20 carbon atoms, an aryl group having 6 to 20 carbon atoms, an acyloxy group having 1 to 20 carbon atoms, an alkoxycarbonyloxy group having 2 to 20 carbon atoms, an aryloxycarbonyloxy group having 7 to 20 carbon atoms, a carbamoyloxy group having 1 to 20 carbon atoms, a carbonamide group having 1 to 20 carbon atoms, a sulfonamide group having 1 to 20 carbon atoms, a carbamoyl group having 1 to 20 carbon atoms, a sulfamoyl group, a substituted sulfamoyl group having 1 to 20 carbon atoms, an alkoxy group having 1 to 20 carbon atoms, an aryloxy group having 6 to 20 carbon atoms, an aryloxycarbonyl group having 7 to 20 carbon atoms, an alkoxycarbonyl group having 2 to 20 carbon atoms, an N-acylsulfamoyl group having 1 to 20 carbon atoms, an N-sulfamoylcarbamoyl group having 1 to 20 carbon atoms, an alkylsulfonyl group having 1 to 20 carbon atoms, an arylsulfonyl group having 6 to 20 carbon atoms, an alkoxycarbonylamino group having 2 to 20 carbon atoms, an aryloxycarbonylamino group having 7 to 20 carbon atoms, an amino group, a substituted amino group having 1 to 20 carbon atoms, an imino group having 1 to 20 carbon atoms, an ammonio group having 3 to 20 carbon atoms, a carboxyl group, a sulfo group, an oxy group, a mercapto group, an alkylsulfinyl group having 1 to 20 carbon atoms, an arylsulfinyl group having 6 to 20 carbon atoms, an alkylthio group having 1 to 20 carbon atoms, an arylthio group having 6 to 20 carbon atoms, a ureide group having 1 to 20 carbon atoms, a heterocyclic group having 2 to 20 carbon atoms, an acyl group having 1 to 20 carbon atoms, a sulfamoylamino group, a substituted sulfamoylamino group having 1 to 2 carbon atoms, a silyl group having 2 to 20 carbon atoms, an isocyanate group, an isocyanide group, a halogen atom (such as a fluorine, chlorine or bromine atom), a cyano group, a nitro group, and an onium group.

In Formula (15), A represents an atomic group that forms a heterocycle together with N=C-N.
The at least one atom that forms the atomic group may include atoms selected from carbon, nitrogen, hydrogen, sulfur, and selenium atoms.
The heterocycle formed by A and N=C-N may further have at least one substituent. Examples of introducible substituents include those described above as substituents introducible into the alkyl group or aryl group.

A thiol compound suitable for the colored curable composition of the invention is more preferably a compound represented by Formula (16) or (17) below.

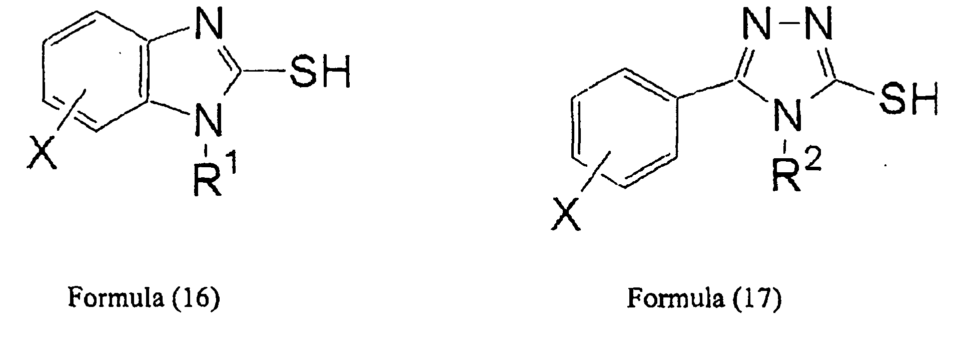

In Formula (16), R¹ represents an aryl group, and X represents a hydrogen atom, a halogen atom, an alkoxy group, an alkyl group, or an aryl group.

In Formula (17), R² represents an alkyl group or an aryl group, and X represents a hydrogen atom, a halogen atom, an alkoxy group, an alkyl group, or an aryl group.

In Formulae (16) and (17), the halogen atom is preferably a fluorine, chlorine, bromine, or iodine atom.

In Formulae (16) and (17), the alkoxy group may be a methoxy group, an ethoxy group, a propyloxy group, an isopropyloxy group, a butyloxy group, a pentyloxy group, a hexyloxy group, a dodecyloxy group, a benzyloxy group, an allyloxy group, a phenethyloxy group, a carboxyethyloxy group, a methoxycarbonylethyloxy group, an ethoxycarbonylethyloxy group, a methoxyethoxy group, a phenoxyethoxy group, a methoxyethoxyethoxy group, an ethoxyethoxyethoxy group, a morpholinoethoxy group, a morpholinopropyloxy group, an allyloxyethoxyethoxy group, a phenoxy group, a tolyloxy group, a xylyloxy group, a mesityloxy group, a methoxyphenyloxy group, an ethoxyphenyloxy group, a chlorophenyloxy group, a bromophenyloxy group, an acetyloxy group, a benzoyloxy group, or a naphthyloxy group.

Examples and preferable range of the alkyl group in Formulae (16) and (17) are the same as the examples and preferable range of the alkyl group represented by R of Formula (15).
Moreover, examples and preferable range of the aryl group in Formulae (16) and (17) are the same as the examples and preferable range of the aryl group represented by R of Formulae (15).

Each group in Formulae (16) and (17) may further have a substituent. The substituent may be selected from those described above as substituents introducible to the alkyl group or aryl group represented by R of Formula (15).

In Formulae (16) and (17), X represents more preferably a hydrogen atom from the viewpoint of PGMEA solubility.
In Formula (16), R¹ represents most preferably a phenyl group in terms of the sensitivity and PGMEA solubility.
In Formula (17), R² represents more preferably a methyl group, an ethyl group, a phenyl group, or a benzyl group in terms of the sensitivity and PGMEA solubility.

Among Formulae (16) and (17), compounds represented by Formula (17) are more preferable in terms of PGMEA solubility.

Hereinafter, preferable specific examples of thiol compounds which can be used in the present invention include, but are not limited to, those shown below.
It should be noted that, in this specification, chemical formulae are shown as simple structural formulae in some cases, and the solid lines represent hydrocarbon groups unless elements or substituents are indicated. In the following specific examples, Me represents a methyl group.

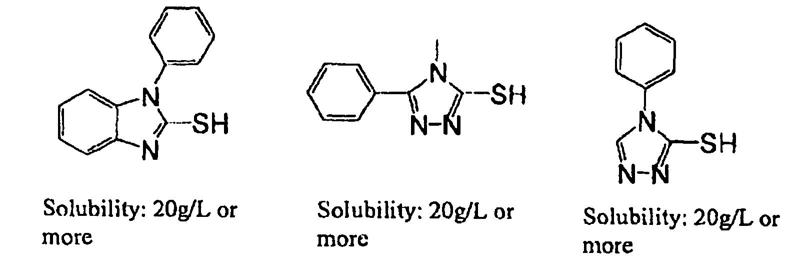

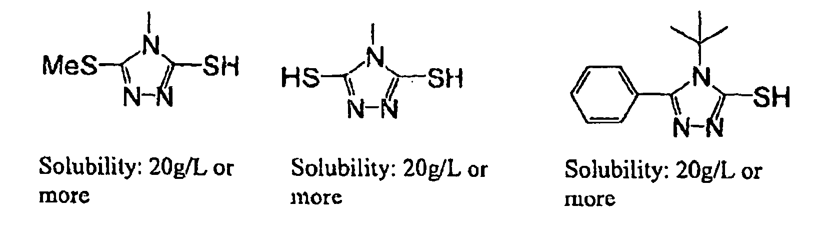

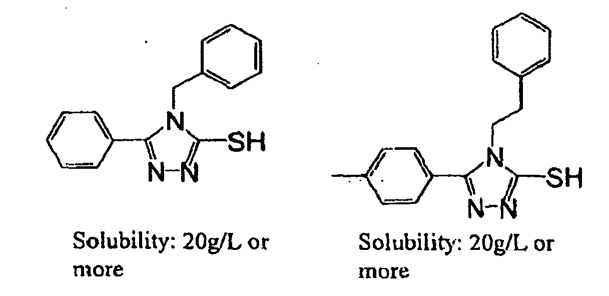

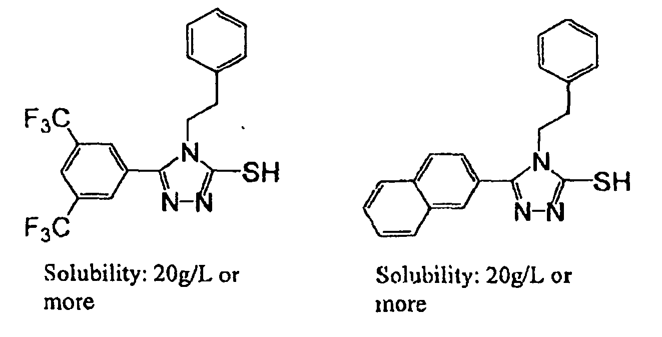

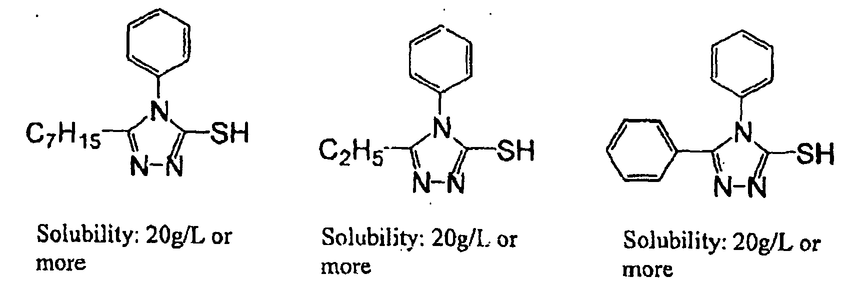

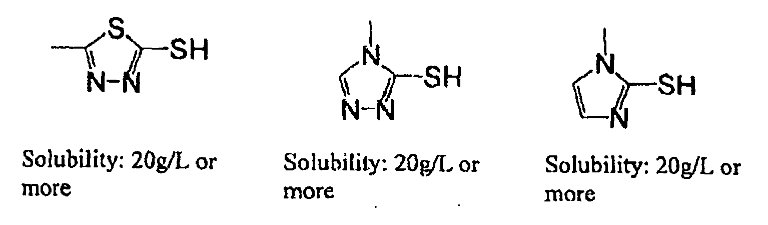

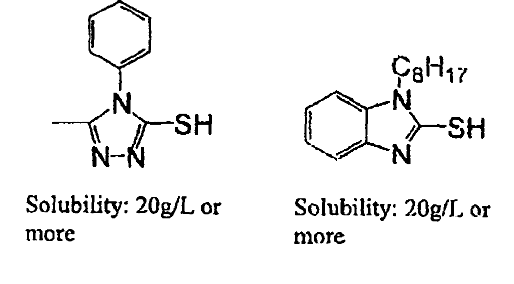

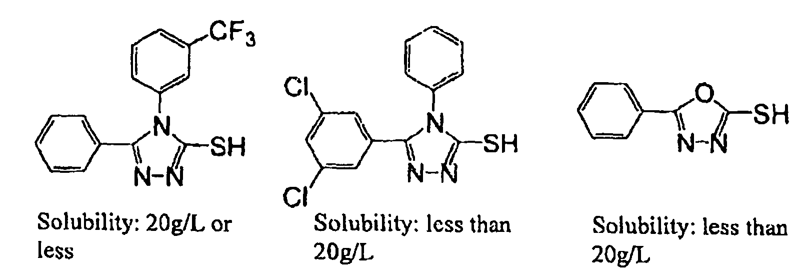

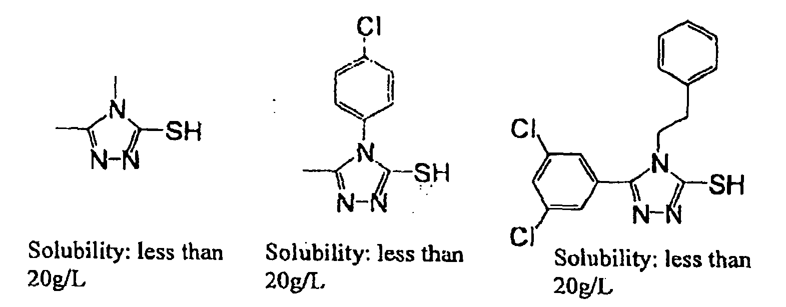

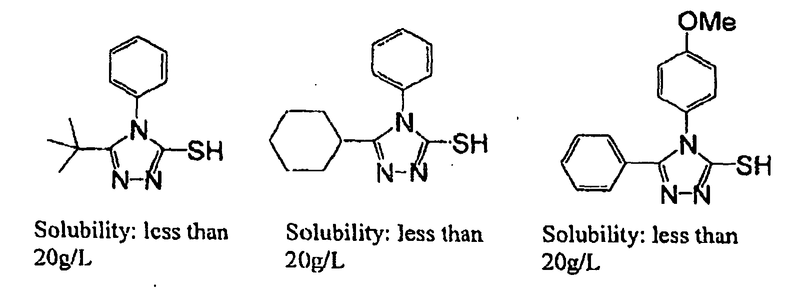

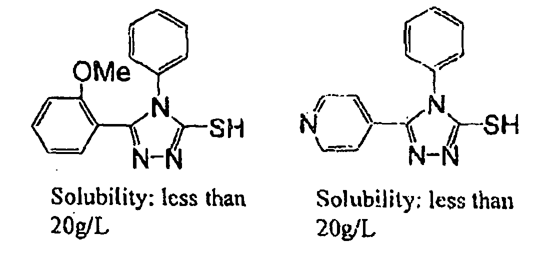

The solubility of these thiol compounds in PGMEA solvent is preferably 20g/L or more, more preferably from 20g/L to 50g/L, and still more preferably from 20g/L to 40g/L from the viewpoint of uniformity of the formed film.
- Solubility measurement method-
   In this specification, the solubility of a thiol compound is defined as follows.
   A thiol compound to be measured is added to 5 mL of propyleneglycol monomethyl ether acetate (PGMEA) solvent, and stirred at 25°C for 1 hour. The maximum amount of the thiol compound that completely dissolves after the stirring is defined as solubility.

The thiol compounds can be synthesized according to the method described in J. Appl. Chem., 34, 2203-2207 (1961).

The thiol compound may be used singly or in combination of two or more thereof.
When two or more thiol compounds are used in combination, the two or more thiol compounds may be all represented by any one of Formulae described above or may be a combination of thiol compounds represented by different Formulae (e.g., a compound represented by Formula (16) and a compound represented by Formula (17) may be used in combination).

When the colored curable composition of the present invention contains a thiol compound, the content thereof is preferably in the range of from 0.5 to 30 mass%, more preferably in the range of from 1 to 25 mass%, and still more preferably in the range of from 3 to 20 mass%, with respect to the mass of the total solid content of the colored curable composition from the viewpoint of increasing the curing rate by improving the balance between the polymerization growth rate and the chain transfer.
- Polymerization inhibitor-
   The colored curable composition of the present invention preferably contains a small amount of thermal polymerization inhibitor so as to prevent unnecessary thermal polymerization of the polymerizable compound during the production or storage of a photopolymerizable composition.
   Examples of thermal polymerization inhibitors that can be used in the present invention include hydroquinone, p-methoxyphenol, di-t-butyl-p-cresol, pyrogallol, t-butylcatechol, benzoquinone, 4,4'-thiobis(3-methyl-6-t-butylphenol), 2,2'-methylenebis(4-methyl-6-t-butylphenol), and N-nitrosophenylhydroxyamine cerous salt.

The addition amount of the thermal polymerization inhibitor is preferably from about 0.01 to about 5 mass% with respect to the total solid content of the colored curable composition of the present invention.
Further, in order to prevent the polymerization inhibition due to oxygen, a higher fatty acid derivative, such as behenic acid or behenic acid amide, may be optionally added such that the higher fatty acid derivative is unevenly distributed at the surface of the coating film during a drying process after coating. The addition amount of the higher fatty acid derivative is preferably from about 0.5 to about 10 mass% with respect to the total composition.
- Adhesion improver-
   The colored curable composition of the present invention may contain an adhesion improver so as to improve the adhesion to a hard surface, such as a surface of a support. Examples of the adhesion improver include a silane coupling agent and a titanium coupling agent.

Examples of the silane coupling agent include γ-(2-aminoethyl)aminopropyltrimethoxysilane, γ-(2-aminoethyl)aminopropyldimethoxysilane, β-(3,4-epoxycyclohexyl)ethyltrimethoxysilane, γ-aminopropyltrimethoxysilane, γ-aminopropyltriethoxysilane, γ-methacryloxypropyltrimethoxysilane, γ-methacryloxypropyltriethoxysilane, γ-acryloxypropyltrimethoxysilane, γ-acryloxypropyltriethoxysilane, γ-isoryanatepropyltimethoxysilane, γ-isocyanatepropyltriethoxysilane, N-β-(N-vinylbenzylaminoethyl)-y-aminopropyltrimethoxysilane · hydrochloride, γ-glycidoxypropyltrimetoxysilane, γ-glycidoxypropyltriethoxysilane, aminosilane, γ-mercaptopropyltrimethoxysilane, γ-mercaptopropyltriethoxysilane, methyltrimethoxysilane, methyltriethoxysilane, vinyltriacetoxysilane, γ-chloropropyltrimetoxysilane, hexamethyldisilazane, γ-anilinopropyltrimethoxysilane, vinyltrimelhoxysilane, vinyltriethoxysilane, vinyltris(β-methoxyethoxy)silane, octadecyldimethyl[3-(trimethoxysilyl)propyl]ammonium chloride, γ-chloropropylmethyldimethoxysilane, γ-mercaptopropylmethyl dimethoxysilane, methyltrichlorosilane, dimethyldichlorosilane, trimethylchlorosilane, 2-(3,4-epoxycyclohexyl)ethyltrimethoxysilane, bisallyltrimethoxysilane, tetraethoxysilane, bis(trimethoxysilyl)hexane, phenyltrimethoxysilane, N-(3-acryloxy-2-hydroxypropyl)-3-aminopropyltriethoxysilane, N-(3-methacryloxy-2-hydroxypropyl)-3-aminopropyltriethoxysilane, (methacryloxymethyl)methyldiethoxysilane, and (acryloxymethyl)methyl dimethoxysilane.
Among the above, γ-methacryloxypropyltrimethoxysilane, γ-inethacryloxypropyltriethoxysilane, γ-acryloxypropyltrimethoxysilane, γ-acryloxypropyltriethoxysilane, γ-mercapropropyltrimethoxysilane, γ-aminopropyltriethoxysilane, and phenyltrimethoxysilane are preferable, and γ-methacryloxypropyl trimethoxysilane is most preferable.

The addition amount of the adhesion improver is preferably from 0.5 to 30 mass%, and more preferably from 0.7 to 20 mass%, with respect to the total solid content of the colored curable composition of the present invention.
- Diluent-
   In the colored curable composition of the present invention, various organic solvents may be used as diluents.
   Examples of the organic solvents include acetone, methyl ethyl ketone, cyclohexane, ethyl acetate, ethylene dichloride, tetrahydrofuran, toluene, ethyleneglycol monomethyl ether, ethyleneglycol monoethyl ether, ethyleneglycol dimethyl ether, propyleneglycol monomethyl ether, propyleneglycol monoethyl ether, acetylacetone, cyclohexanone, diacetone alcohol, ethyleneglycol monomethyl ether acetate, ethyleneglycol ethyl ether acetate, ethyleneglycol monoisopropyl ether, ethyleneglycol monobutyl ether acetate, 3-methoxypropanol, methoxymethoxyethanol, diethylene glycol monomethyl ether, diethyleneglycol monoethyl ether, diethyleneglycol dimethyl ether, diethyleneglycol diethyl ether, propyleneglycol monomethyl ether acetate, propyleneglycol monoethyl ether acetate, 3-methoxypropyl acetate, N,N dimethylformamide, dimethyl sulfoxide, γ-butyrolactone, methyl lactate, and ethyl lactate.
   The solvent may be used singly or a mixture of two or more thereof may be used. The concentration of the solid content relative to the organic solvent is preferably from 2 to 60 mass%.

- Other additives-
   Furthermore, to the colored curable composition of the present invention, known additives, such as an inorganic filler, a plasticizer, and a lypophilizing agent, may be added so as to improve the physical properties of the cured film.
   Examples of the plasticizer include dioctyl phthalate, didodecyl phthalate, triethylene glycol dicaprylate, dimethylglycol phthalate, tricresyl phosphate, dioctyl adipate, dibutyl sebacate, and triacetyl glycerol. When a binder is used, the plasticizer may be added in a ratio of 10 mass% or lower relative to the total mass of the polymerizable compound and the binder polymer.

### <Color filter and Method of producing the same>

Next, a color filter of the present invention and a method of producing the same will be described.
The color filter of the present invention has, on a support, a colored pattern formed from the colored curable composition of the present invention.
Hereinafter, the color filter of the present invention will be described in detail with reference to a method of producing the same (method of the present invention for producing a color filter).

The method of the present invention for producing a color filter includes a step of applying the colored curable composition of the present invention onto a support to form a colored curable composition layer (hereinafter, sometimes referred to as a "colored curable composition layer formation step"); a step of exposing the colored curable composition layer to radiation through a mask (hereinafter sometimes referred to as an "exposure step"), and a step of developing the exposed colored curable composition layer to form a colored pattern (hereinafter sometimes referred to as a "developing step").

Specifically, the colored curable composition of the present invention is applied directly onto a support (substrate) or onto another layer provided on the support (substrate) to form a colored curable composition layer (colored curable composition layer formation step); the colored curable composition layer is exposed to radiation through a given mask pattern to cure only an irradiated portion of the coating film (colored curable composition layer) (exposure step); and the coating film is developed with a developer (developing step) to thereby form a patterned film having pixels of the respective colors (three colors or four colors), whereby the color filter of the present invention can be produced.
Hereinafter, each step in the method of the present invention for producing a color filter will be described.

### [Colored curable composition layer formation step]

In the colored curable composition layer formation step, the colored curable composition of the present invention is applied onto a support to form a colored curable composition layer.

Examples of the support that can be used in this step include soda glass substrates, PYREX (registered trademark) glass substrates, quartz glass substrates, and a substrate obtained by attaching a transparent electrically-conductive film onto any of the above glass substrates, which are for use in liquid crystal displays and the like, and photoelectric converting substrates for use in image-pickup devices, such as silicon substrates and complementary metal oxide film semiconductors (CMOS). In some cases, these substrates may have black stripes that separate pixels from one another.
If necessary, an undercoat layer may be formed on the support in order to improve adhesion to the upper layer, prevent the substance diffusion or flatten the substrate surface.

A photopolymerizable composition of the present invention for a color filter can be applied onto the support by various coating methods, such as slit coating, an ink-jet method, spin coating, cast coating, roll coating, and screen printing.

The coating thickness of the colored curable composition of the present invention is preferably from 0.1 µm to 10 µm, more preferably from 0.2 µm to 5 µm, and still more preferably from 0.2 µm to 3 µm.
When a color filter for a solid state image pickup device is produced, the coating thickness of the colored curable composition of the present invention is preferably from 0.35 µm to 1.5 µm, and more preferably from 0.40 µm to 1.0 µm, from the viewpoint of resolution and developability.

The colored curable composition applied onto the support may be dried generally at a temperature of from 70°C to 110°C for 2 to 4 minutes to form a colored curable composition layer.

[Exposure step]
In an exposure step, the colored curable composition layer formed in the colored curable composition layer formation step is exposed to radiation through a mask to cure only an irradiated portion of the coating film. It is preferable to perform exposure by emitting radiation. As the radiation for exposure, ultraviolet rays, particularly g line or i line, are preferable, and a high pressure mercury lamp is more preferable. The irradiation intensity is preferably from 5 mJ/cm² to 1,500 mJ/cm², more preferably from 10 mJ/cm² to 1,000 mJ/cm², and most preferably from 10 mJ/cm² to 300 mJ/cm².

[Development step]
Following the exposure step, alkali development treatment (developing step) is performed to dissolve, in an alkaline water solution, only a region that has not been irradiated with radiation in the exposure step, whereby only the photo-cured portion remains.
The developer is preferably an organic alkali developer is preferable which does not damage an underlying circuit or the like. The development temperature is generally from 20°C to 30°C and the development time is generally from 20 to 90 seconds.

The alkali used in the developer may be an organic alkaline compound, such as aqueous ammonia, ethylamine, diethylamine, dimethylethanolamine, tetramethylammonium hydroxide, tetraethylammonium hydroxide, choline, pyrrole, piperidine, or 1,8-diazabicyclo-[5,4,0]-7-undecene, each of which may be diluted with pure water to form an aqueous alkaline solution having a concentration of from 0.001 to 10 mass%, preferably from 0.01 to 1 mass%. It should be noted that when a developer containing such an alkaline aqueous solution is used, cleaning (rinsing) with pure water may be generally performed after development.

It should be noted that, in the method of the present invention for producing a color filter, after performing the colored curable composition layer formation step, exposure step, and development step, a curing step of curing the formed colored pattern by heating and/or exposure to radiation may be optionally performed.

A color filter having a desired colors may be produced by repeating the colored curable composition layer formation step, exposure step, and development step (and, optionally, the curing step) for the number of times corresponding to the number of the desired colors.

Since the color filter of the present invention uses the colored curable composition of the present invention, the formed colored pattern exhibits a strong adhesion to a support substrate and the cured composition is excellent in development resistance. Therefore a high-resolution pattern can be formed with excellent exposure sensitivity, the pattern showing favorable adhesion to the substrate at an exposed portion and providing a desired cross-sectional shape. Accordingly the color filter of the present invention can be preferably used for solid state image pickup devices, such as a liquid crystal display element and CCD, and is suitable particularly for CCD elements, CMOS, or the like that have a high resolution having, for example, over 1 million pixels. More specifically, the color filter of the present invention is preferably applied to solid state image pickup devices.
The color filter of the present invention can be used, for example, as a color filter disposed between the light receiving portions of the respective pixels of a CCD and a micro lens for condensing light.

<Solid state image pickup device>
The color filter of the present invention can be used for solid state image pickup devices, such as liquid crystal display elements and CCD, and is suitable particularly for CCD elements, CMOS, or the like that have a high resolution having, for example, over 1 million pixels. More specifically, the color filter of the present invention is preferably applied to solid state image pickup devices.
The color filter of the present invention can be used, for example, as a color filter disposed between the light receiving portions of the respective pixels of a CCD and a micro lens for condensing light.

### EXAMPLES

Hereinafter, the present invention will be described more specifically with reference to examples. However the examples should not be construed as limiting the invention, and the invention is capable of numerous rearrangements, modifications and substitution of parts and elements without departing from the spirit of the invention. Unless otherwise specified, "part", "%", and "wt%" are based on mass.

<Synthesis of specific photopolymerization initiator>
(Synthesis Example 1: Synthesis of specific compound 1, which is a specific photopolymerization initiator)
Ethylcarbazole (100.0 g, 0.512 mol) was dissolved in 260 ml of chlorobenzene. The mixture was cooled to 0°C, and then aluminum chloride (70.3 g, 0.527 mol) was added thereto. Subsequently, o-tolyl chloride (81.5 g, 0.527 mol) was added dropwise over 40 minutes, the temperature of the reaction solution was increased to room temperature, and then the reaction solution was stirred for 3 hours. Next, after the reaction solution was cooled to 0°C, aluminum chloride (75.1 g, 0.563 mol) was added thereto. 4-chlorobutyryl chloride (79.4 g, 0.563 mol) was added dropwise over 40 minutes, the temperature of the reaction solution was increased to room temperature, and the reaction solution was stirred for 3 hours. A mixed solution of 156 ml of an aqueous 35wt% hydrochloric acid solution and 392 ml of distilled water was cooled to 0°C, and then the reaction solution was added dropwise. The precipitated solid was subjected to suction filtration, washed with distilled water and methanol, and recrystallized from acetonitrile to thereby obtain Compound A having the following structure (Obtained amount: 164.4 g, Yield: 77%).

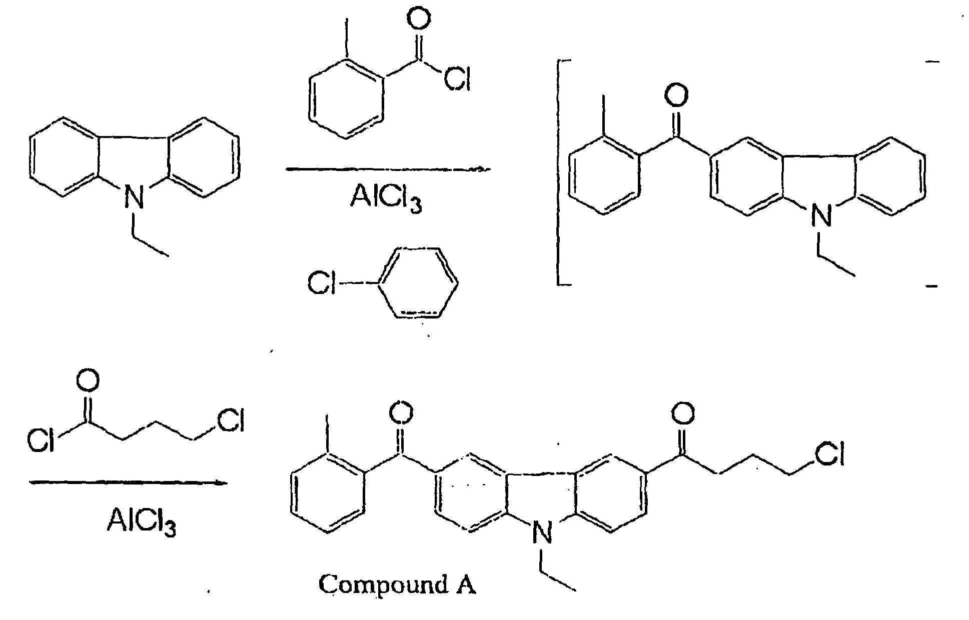

Compound A (20.0 g, 47.9 mmol) was dissolved in 64 ml of THF, and 4-chlorobenzene thiol (7.27 g, 50.2 mmol) and sodium iodide (0.7 g, 4.79 mmol) were added thereto. Subsequently, sodium hydroxide (2.0 g, 50.2 mmol) was added to the reaction solution, and the reaction solution was refluxed for 2 hours. After the reaction solution was cooled to 0°C, SM-28 (11.1 g, 57.4 mmol) was added dropwise over 20 minutes, the temperature of the reaction solution was increased to room temperature, and then the reaction solution was stirred for 2 hours. After the reaction solution was cooled to 0°C, isopentyl nitrite (6.73 g, 57.4 mmol) was added dropwise over 20 minutes, the temperature of the reaction solution was increased to room temperature, and then the reaction solution was stirred for 3 hours. The reaction solution was diluted in 120 ml of acetone, and was added dropwise to an aqueous 0.1N hydrochloric acid solution that had been cooled to 0°C. The precipitated solid was collected by to suction filtration, and washed with distilled water. Subsequently, recrystallization from acetonitrile was conducted to thereby obtain Compound B having the following structure (Obtained amount: 17.0 g, Yield: 64%).

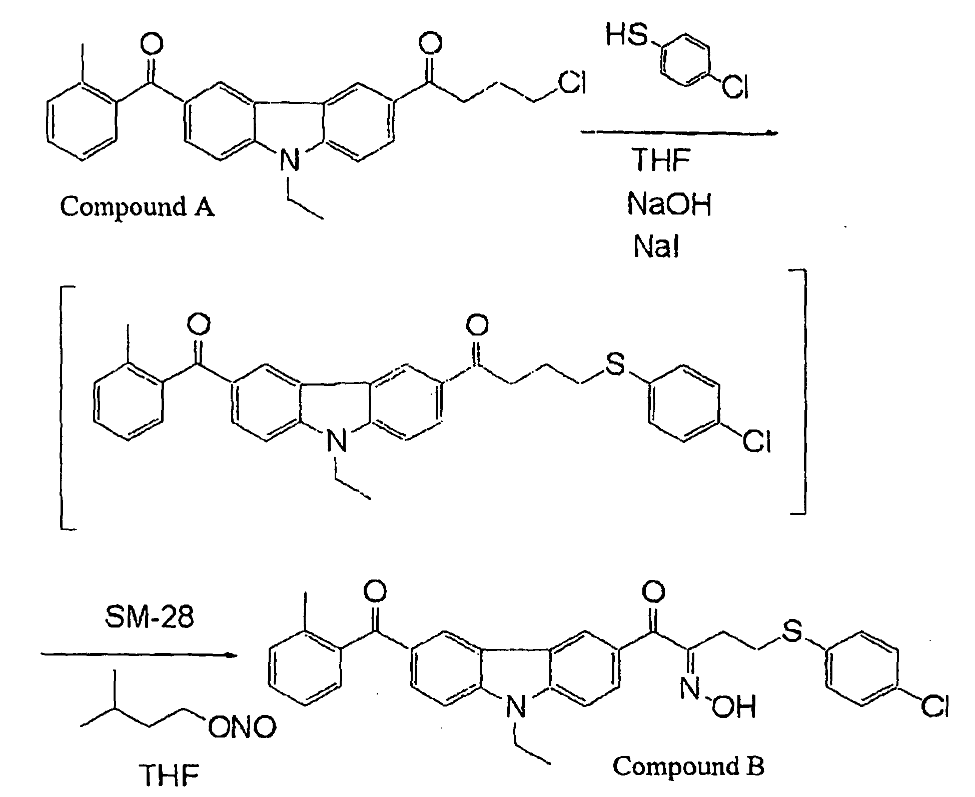

Compound B (18.0 g, 32.4 mmol) was dissolved in 90 ml of N-methylpyrrolidone, and then triethylamine (3.94 g, 38.9 mmol) was added thereto. After the reaction solution was cooled to 0°C, acetyl chloride (3.05 g, 38.9 mmol) was added dropwise over 20 minutes, the temperature of the reaction solution was increased to room temperature, and the reaction solution was stirred for 2 hours. The reaction solution was added dropwise to 150 ml of distilled water which had been cooled to 0°C. The precipitated solid was collected by suction filtration, washed with 200 ml of isopropyl alcohol which had been cooled to 0°C, and dried to thereby obtain Specific Compound 1 (Obtained amount: 19.5g, Yield: 99%).

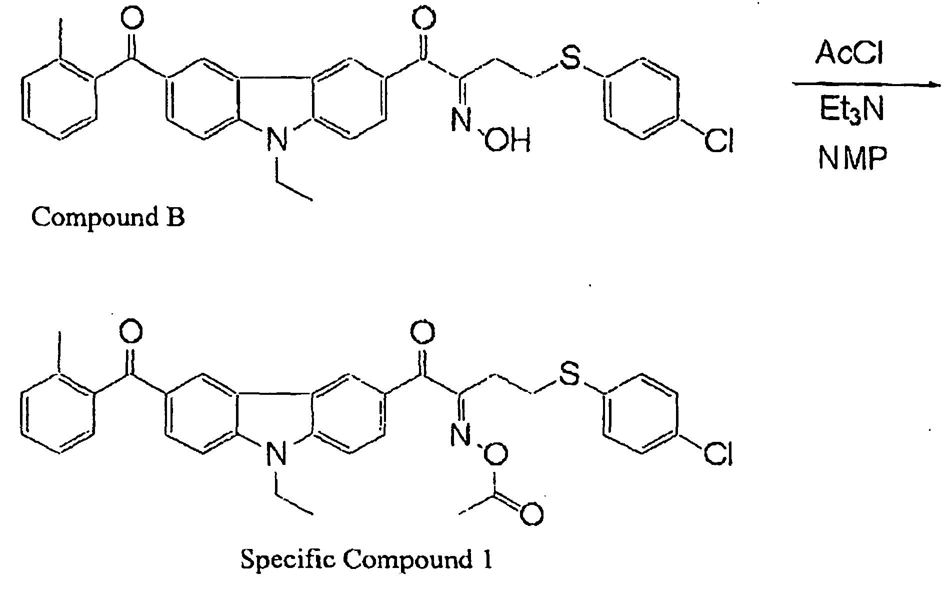

The structure of the obtained Specific Compound 1 was identified by NMR. (¹H-NMR 400MHz CDCl3): 8.86 (s, 1H), 8.60 (s, 1H), 8.31 (d, 1H, J= 8.0Hz), 8.81 (d, 1H, J= 8.0Hz), 7.51-7.24 (m. 10H), 7.36 (q, 2H, 7.4Hz), 3.24-3.13 (m, 4H), 2.36 (s, 3H), 2.21 (s, 3H), 1.50 (t, 3H, 7.4Hz).

(Synthesis Example 2: Synthesis of a specific compound 2, which is a specific photopolymerization initiator)
An oxime compound (17.6 g, 32.4 mmol) was dissolved in 90 ml of N-methylpyrrolidone, and triethylamine (3.94 g, 38.9 mmol) was added thereto. After the reaction solution was cooled to 0°C, acetyl chloride (3.05 g, 38.9 mmol) was added dropwise over 20 minutes, the temperature of the reaction solution was increased to room temperature, and the reaction solution was stirred for 2 hours. The reaction solution was added dropwise to 150 ml of distilled water which had been cooled to 0°C. The precipitated solid was collected by suction filtration, washed with 200 ml of isopropyl alcohol which had been cooled to 0°C, and dried to thereby obtain Specific Compound 2 (Obtained amount: 17.5 g, Yield: 92%).

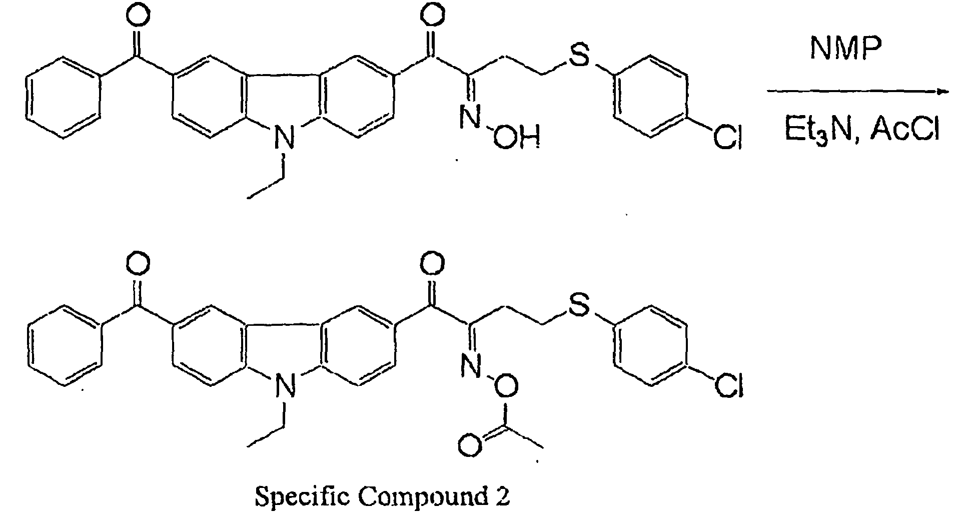

### (Synthesis Example 3: Synthesis of a specific compound 3, which is a specific photopolymerization initiator)

Compound C (18.0 g, 41.2 mmol) was dissolved in 90 ml of N-methylpyrrolidone, and triethylamine (4.59 g, 45.3 mmol) was added thereto. After the reaction solution was cooled to 0°C, acetyl chloride (3.56 g, 45.3 mmol) was added dropwise over 20 minutes, the temperature of the reaction solution was increased to room temperature, and the reaction solution was stirred for 2 hours. The reaction solution was added dropwise to 150 ml of distilled water which had been cooled to 0°C. The precipitated solid was collected by suction filtration, washed with 200 ml of isopropyl alcohol which had been cooled to 0°C, and dried to thereby obtain Specific Compound 3 (Obtained amount: 18.7 g, Yield: 95%).

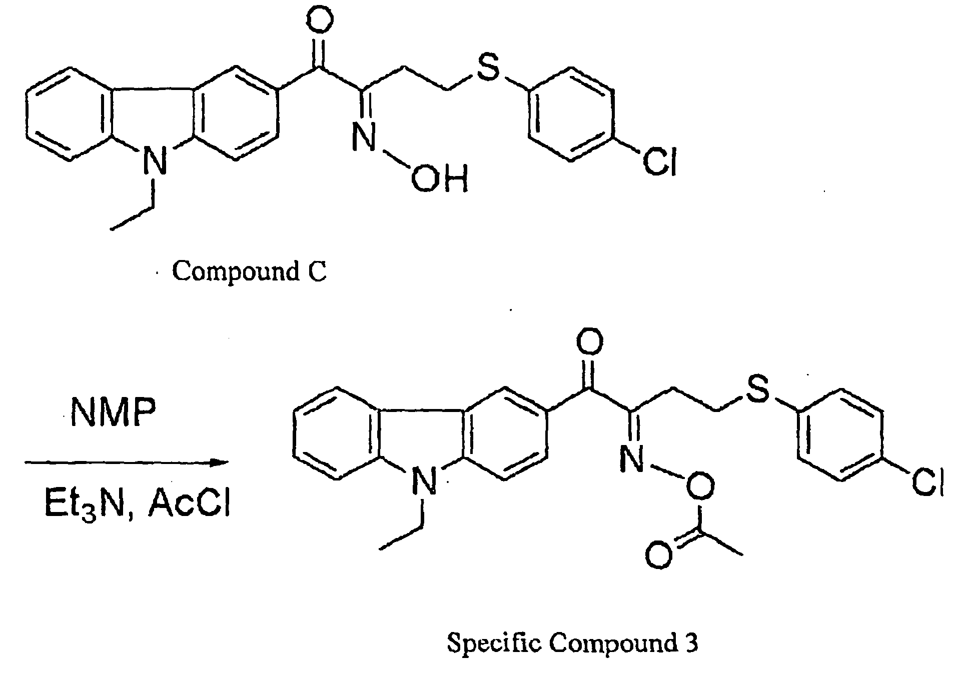

(Synthesis Example 4: Synthesis of Comparative Compound 4)
An oxime compound E (17.7 g, 32.4 mmol) having the following structure was dissolved in 90 ml of N-methylpyrrolidone, and then triethylamine (3.94 g, 38.9 mmol) was added thereto. After the reaction solution was cooled to 0°C, acetyl chloride (3.05 g, 38.9 mmol) was added dropwise over 20 minutes, the temperature of the reaction solution was increased to room temperature, and the reaction solution was stirred for 2 hours. The reaction solution was added dropwise to 150 ml of distilled water which had been cooled to

### 0°C. The precipitated solid was collected by suction filtration, washed with 200 ml of isopropyl alcohol which had been cooled to 0°C, and dried to thereby obtain Comparative

Compound 4 (Obtained amount: 17.5 g, Yield: 92%).

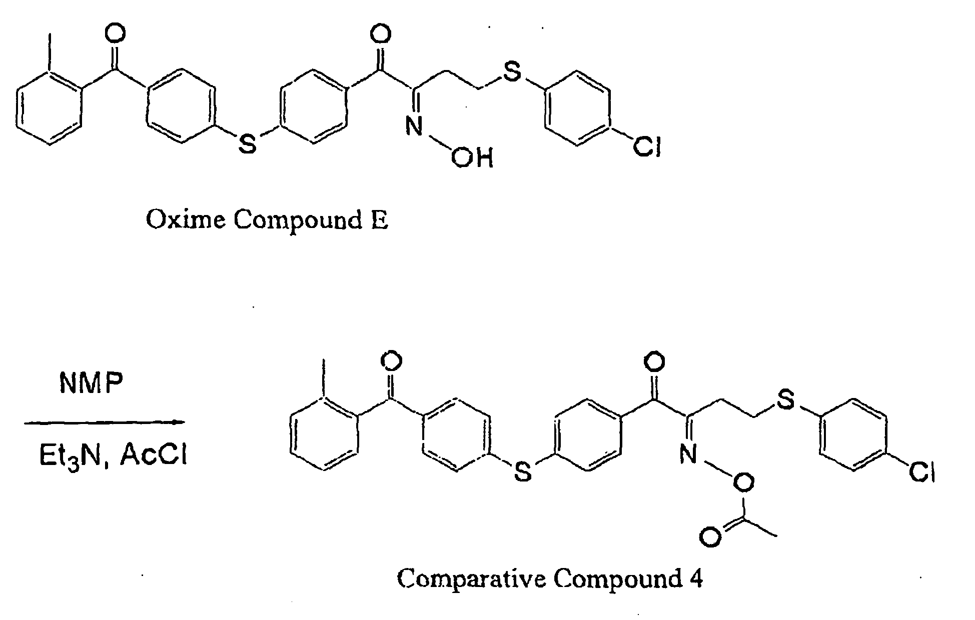

The structure of the obtained Comparative Compound 4 was identified by NMR. (¹H-NMR 400MHz CDCl₃): 8.05 (d, 1H, J=8.8Hz), 7.78(d, 1H, J=8.8Hz), 7.47 (d, 1H, J=8.0Hz), 7.42-7.26(m, 10H), 3.19-3.08 (m, 4H), 2.35 (s, 3H), 2.17(s,3H)

The thus obtained specific photopolymerization initiators (Specific Compounds 1 to 3) and Comparative Compounds 1 to 4, and the molar absorption coefficient at 365 nm of each compound are shown in the following.

| Initiator | Structure | Molar absorption coefficient at 365 nm |
|---|---|---|
| Specific compound 1 | 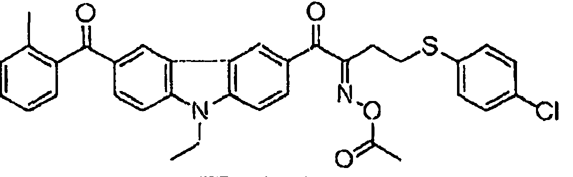 | 16658 |
| Specific compound 2 | 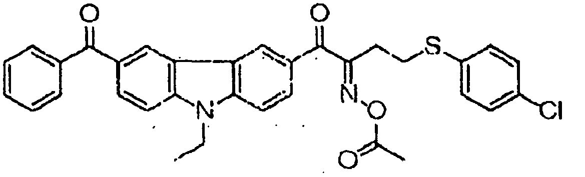 | 15348 |
| Specific compound 3 | 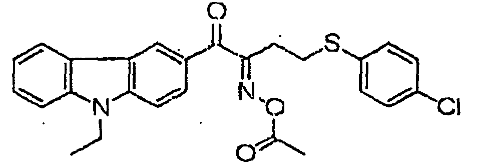 | 12530 |
| Comparative compound 1 | IRGACURE OXE 01 (manufactured by Ciba Specialty Chemicals Co., Ltd. | 5226 |
| Comparative compound 2 | IRGACURE OXE 02 (manufactured by Ciba Specialty Chemicals Co., Ltd. | 2140 |
| Comparative compound 3 | IRGACURE OXE 369 (manufactured by Ciba Specialty Chemicals Co., Ltd. | 982 |
| Comparative compound 4 | 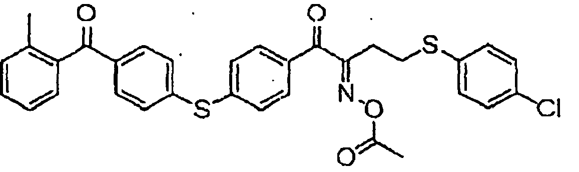 | 4813 |

The following Specific Compounds 4 to 6 were synthesized in a manner similar to the synthesis examples described above. 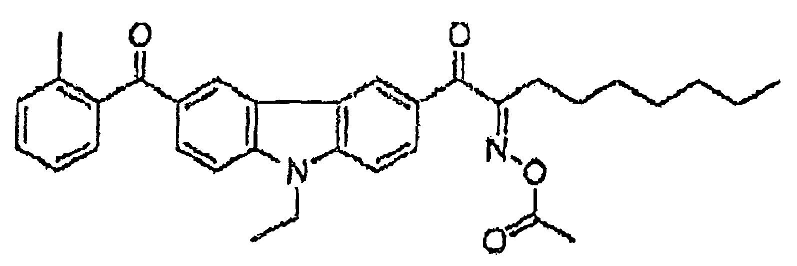 Specific Compound 4 having a molar absorption coefficient of 15,000 or more at 365 nm 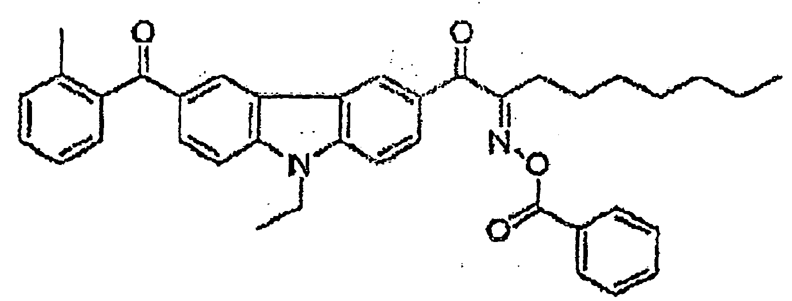 Specific Compound 5 having a molar absorption coefficient of 15,000 or more at 365 nm 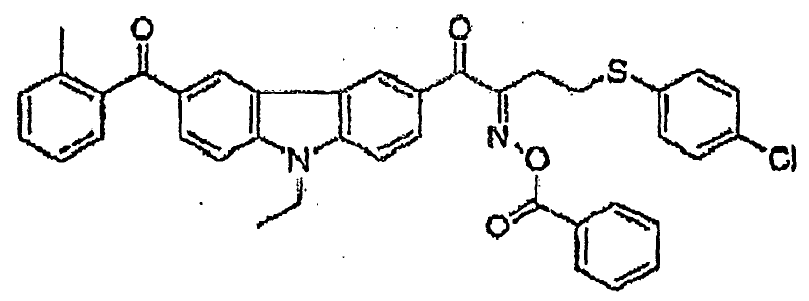 Specific Compound 6 having a molar absorption coefficient of 15,000 or more at 365 nm

The molar extinction coefficient at 365 nm of each of the obtained Specific Compounds 1 to 6 and Comparative Compounds 1 to 4 was measured at a concentration of 0.01 g/L using an ethyl acetate solvent for spectral analysis and Carry-5 spectrophotometer manufactured by Varian. The structure of each of Comparative Compounds 1 to 3 is as shown below.

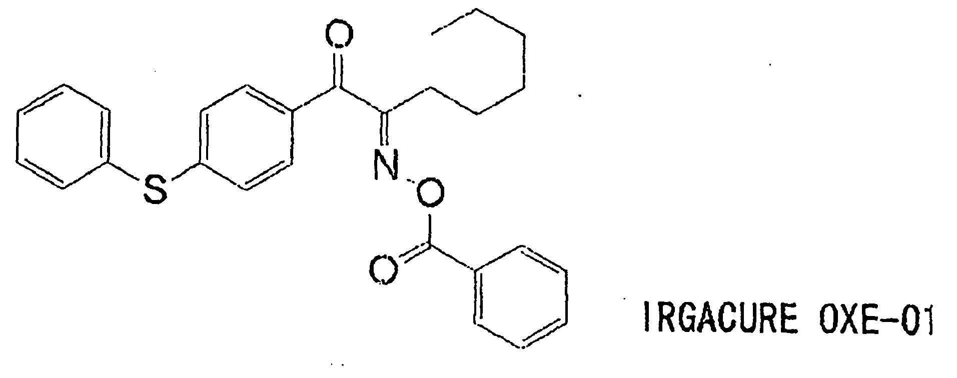

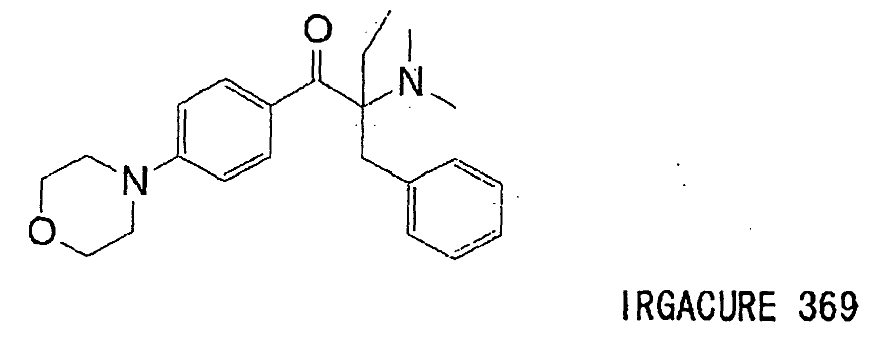

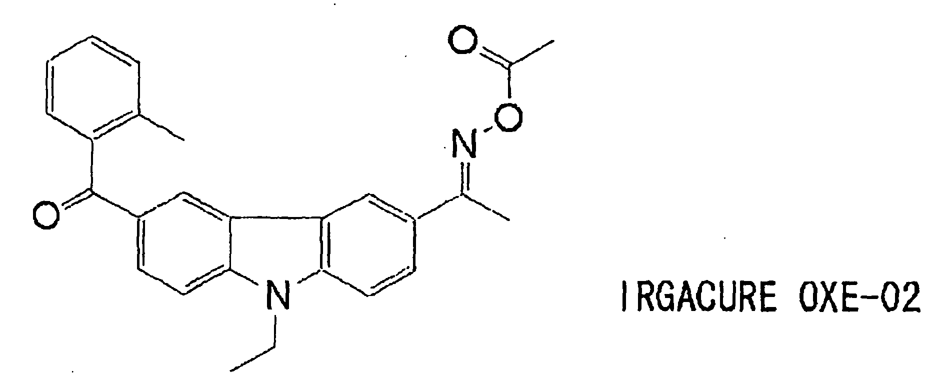

[Example 1-1]
<1. Preparation of colored curable composition A-1>
As a colored curable composition, a negative colored curable composition A-1 containing a colorant (pigment) was prepared, and a color filter of Example 1-1 was produced using the same.

1-1. Preparation of pigment dispersion liquid (P1)
40 parts by mass of a mixture of C.I. pigment Green 36 and C.I. pigment yellow 219 in a mass ratio of 30/70 as a pigment, 10 parts by mass (about 4.51 parts by mass in terms of the solid content) of BYK2001 (Disperbyk: tradename, manufactured by BYK-Chemie, Solid content of 45.1 mass%) as a dispersant; and 150 parts by mass of ethyl 3-ethoxypropionate as a solvent was mixed to form a mixed liquid, and dispersed for 15 hours by a bead mill to thereby prepare a pigment dispersion liquid (P1).
The average particle diameter of the pigment in the obtained pigment dispersion liquid (P1) was measured by a dynamic light scattering method, and was found to be 200 nm.

1-2. Preparation of Colored Curable Composition A-1 (Coating Liquid)
Components of the following composition A-1 were mixed and dissolved to thereby prepare a colored curable composition A-1.
- Composition A-1-
- Pigment dispersion liquid (P1) 700 parts by mass
- Alkali-soluble resin (Exemplary Compound (101)) 100 parts by mass
- Polyfunctional monomer [Mixture of pentaerythritol triacrylate and dipentaerythritol hexaacrylate (3:7)] 60 parts by mass
- Specific photopolymerization initiator (Specific compound 1) 60 parts by mass
- Solvent (propyleneglycol monomethylether acetate) 1,000 parts by mass
- Surfactant (Tradename: Tetranick 150R1, product of BASF A.G.) 1 part by mass
- γ-methacryloxypropyl triethoxysilane 5 parts by mass

<2. Production of color filter>
2-1. Formation of photosensitive composition layer
The colored curable composition A-1 containing the pigment obtained above was slit-coated, as a resist solution, on a 550 mm × 650 mm glass substrate under the following conditions. The resultant was held as was for 10 minutes, and subjected to vacuum drying and prebaking (100°C for 80 seconds) to form a photosensitive composition coating film (photosensitive composition layer).

(Slit coating conditions)

| | |
|---|---|
| Size of an opening at the top of the coating head: | 50 µm |
| Coating speed: | 100 mm/second |
| Clearance between the substrate and the coating head: | 150 µm |
| Coating thickness (dry thickness): | 2 µm |
| Coating temperature: | 23 °C |

2-2. Exposure, Development
Thereafter, the photosensitive composition layer was patternwise exposed to radiation using a 2.5 kW ultrahigh pressure mercury lamp. The entire surface of the photosensitive composition layer after exposure was coated with a 10% aqueous solution of an organic developer (Tradename: CD, manufactured by Fuji Photo Film Electronics Materials), and was allowed to stand still for 60 seconds.

2-3. Heat-treatment
Thereafter, pure water was sprayed in shower form to the photosensitive composition layer to wash away the developer, and the resultant was then heated in a 220°C oven for 1 hour (postbaking). Thus a color filter in which a colored pattern was formed on a glass substrate was obtained.

<3. Performance evaluation>
The storage stability and exposure sensitivity of the colored curable composition A-1, development properties when a colored pattern was formed on a glass substrate using the colored curable composition, adhesion of the obtained colored pattern to substrate and the cross-sectional shape of the pattern were evaluated as follows. The results are shown in Table 1.

3-1. Storage stability of colored curable composition
The colored curable composition A-1 was stored for one month at room temperature, and then the precipitation degree was visually evaluated according to the following criteria.
(Criteria)
A : No precipitation was observed.
B : Precipitation was slightly observed.
C : Precipitation was observed.

3-2. Exposure sensitivity of colored curable composition
The colored curable composition A-1 was spin coated on a glass substrate, and dried to form a coating film having a thicknesses of 1.0 µm. Specifically, the spin coating was performed at 300 rpm for 5 seconds, and then at 800 rpm for 20 seconds, and the drying was performed at 100°C for 80 seconds. Next, the obtained coating film was exposed at various exposure amounts in the range of from 10 mJ/cm² to 1,600 mJ/cm² using a photomask for a test having a line width of 2.0 µm and a proxymity exposure device having an ultrahigh pressure mercury lamp (manufactured by Hitachi High-tech Electronics Engineering Co., Ltd.). Then, using a 60% CD-2000 developer (tradename, manufactured by Fuji Photo Film Electronics Materials), the coating film after exposure was developed under the conditions of a temperature of 25°C and a development time of 60 seconds. Thereafter, the resultant was rinsed for 20 seconds with running water, and spray-dried to complete patterning.
Regarding the evaluation of exposure sensitivity, the minimum exposure amount at which the post-development thickness of the region that was irradiated with light in the exposure step became 95% or more of the thickness (100 %) of the film before the exposure was evaluated as the exposure requirement amount. A smaller exposure requirement amount indicates a higher sensitivity.

3-3. Developability and Pattern cross-sectional shape
The developability and pattern cross-sectional shape were evaluated by confirming the substrate surface and cross-sectional shape after postbaking was conducted in "2-3. Heat Treatment". The observation of the substrate surface and cross-sectional shape was performed according to a usual method through observation under an optical microscope and by observation of SEM photographs. The details of the evaluation method are as follows.
- Developability-
   In the exposure step, the presence or absence of a residue in a region (unexposed region) which had not been irradiated with light was observed to evaluate the developability. The results are shown in Table 1.
   (Criteria)
   A : No residue was observed in the unexposed region.
   B: Residues were slightly observed in the unexposed region, but was practically acceptable.
   C: Significant residues were observed in the unexposed part.

- Pattern cross-sectional shape-
   The cross-sectional shape of the formed pattern was observed and evaluated. As the cross-sectional shape of the pattern, a forward tapered shape is the most preferable and a rectangular shape is the next preferable shape. An inversely tapered shape is unfavorable. The results are shown in Table 1.

[Examples 1-2 to 1-23 and Comparative Examples 1-1 to 1-8]
Colored curable compositions A-2 to A-23 for Examples and colored curable compositions A'-1 to A'-8 for Comparative Examples were prepared and color filters of Examples 1-2 to 1-23 and Comparative Examples 1-1 to 1-8 were obtained in the same manner as in Example 1-1, except that (i) 60 paris by mass of the specific compound 1 (Specific photopolymerization initiator) in the composition A-1 used for the preparation of the colored curable composition A-1 in Example 1-1 was replaced by the respective compounds in the respective amounts shown in Tables 1 to 2, and, (ii) in each of Examples 1-12 to 1-20, a sensitizer and/or a co-sensitizer of the kinds and amounts shown in Tables 1 to 2 was further added. Furthermore, the same evaluation as in Example 1-1 was performed. The results are shown in Tables 1 to 2.

**Table 1**

| Example | Composition | Initiator | Sensitizer | Co-sensitizer | Alkali-soluble Resin | Storage Stability | Exposure Requirement Amount (mJ/cm²) | Developability | Pattern Cross-sectional Shape |
|---|---|---|---|---|---|---|---|---|---|
| Example 1-1 | A-1 | Specific compound 1 (60 parts by mass) | Not Added | Not Added | Exemplary Compound (101) | A | 220 | A | Rectangular |
| Example 1-2 | A-2 | Specific compound 1 (60 parts by mass) | Not Added | Not Added | Exemplary Compound (103) | A | 200 | A | Forward tapered |
| Example 1-3 | A-3 | Specific compound 1 (60 parts by mass) | Not Added | Not Added | Exemplary Compound (104) | A | 200 | A | Forward tapered |
| Example 1-4 | A-4 | Specific compound 1 (60 parts by mass) | Not Added | Not Added | Exemplary Compound (106) | A | 200 | A | Forward tapered |
| Example 1-5 | A-5 | Specific compound 1 (60 parts by mass) | Not Added | Not Added | Exemplary Compound (110) | A | 210 | A | Forward tapered |
| Example 1-6 | A-6 | Specific compound 1 (60 parts by mass) | Not Added | Not Added | Exemplary Compound (116) | A | 200 | B | Forward tapered |
| Example 1-7 | A-7 | Specific compound 1 (60 parts by mass) | Not Added | Not Added | Exemplary Compound (119) | A | 200 | B | Rectangular |
| Example 1-8 | A-8 | Specific compound 1 (60 parts by mass) | Not Added | Not Added | Exemplary Compound (120) | A | 200 | B | Rectangular |
| Example 1-9 | A-9 | Specific compound 1 (60 parts by mass) | Not Added | Not Added | Exemplary Compound (121) | A | 200 | B | Rectangular |
| Example 1-10 | A-10 | Specific compound 2 (60 parts by mass) | Not Added | Not Added | Exemplary Compound (104) | A | 200 | A | Forward tapered |
| Example 1-11 | A-11 | Specific compound 3 (60 parts by mass) | Not Added | Not Added | Exemplary Compound (104) | A | 250 | A | Rectangular |
| Example 1-12 | A-12 | Specific compound 1 (50 parts by mass) | A1 (10 parts by mass) | Not Added | Exemplary Compound (104) | A | 190 | A | Forward tapered |
| Example 1-13 | A-13 | Specific compound 1 (50 parts by mass) | A2 (10 parts by mass) | Not Added | Exemplary Compound (104) | A | 180 | A | Forward tapered |
| Example 1-14 | A-14 | Specific compound 1 (50 parts by mass) | A3 (10 parts by mass) | Not Added | Exemplary Compound (104) | A | 180 | A | Forward tapered |
| Example 1-15 | A-15 | Specific compound 1 (50 parts by mass) | Not Added | F1 (10 parts by mass) | Exemplary Compound (104) | A | 190 | A | Forward tapered |
| Example 1-16 | A-16 | Specific compound 1 (50 parts by mass) | Not Added | F2 (10 parts by mass) | Exemplary Compound (104) | A | 190 | A | Forward tapered |
| Example 1-17 | A-17 | Specific compound 1 (50 parts by mass) | Not Added | F3 (10 parts by mass) | Exemplary Compound (104) | A | 180 | A | Forward tapered |

**Table 2**

| Example | Composition | Initiator | Sensitizer | Co-sensitizer | Alkali-soluble Resin | Storage Stability | Exposure Requirement Amount (mJ/cm²) | Developability | Pattern Cross-sectional Shape |
|---|---|---|---|---|---|---|---|---|---|
| Example 1-17 | A-17 | Specific compound 1 (50 parts by mass) | Not Added | F3 (10 parts by mass) | Exemplary Compound (104) | A | 180 | A | Forward tapered |
| Example 1-18 | A-18 | Specific compound 1 (40 parts by mass) | A2 (10 parts by mass) | F1 (10 parts by mass) | Exemplary Compound (104) | A | 180 | A | Forward tapered |
| Example 1-19 | A-19 | Specific compound 1 (40 parts by mass) | A2 (10 parts by mass) | F2 (10 parts by mass) | Exemplary Compound (104) | A | 180 | A | Forward tapered |
| Example 1-20 | A-20 | Specific compound 1 (40 parts by mass) | A2 (10 parts by mass) | F3 (10 parts by mass) | Exemplary Compound (104) | A | 170 | A | Forward tapered |
| Example 1-21 | A-21 | Specific compound 4 (60 parts by mass) | Not Added | Not Added | Exemplary Compound (104) | A | 230 | A | Forward tapered |
| Example 1-22 | A-22 | Specific compound 5 (60 parts by mass) | Not Added | Not Added | Exemplary Compound (104) | A | 240 | A | Forward tapered |
| Example 1-23 | A-23 | Specific compound 6 (60 parts by mass) | Not Added | Not Added | Exemplary Compound (104) | A | 240 | A | Forward tapered |
| Comparative Example 1 | A-1 | Comparative compound 1 (60 parts by mass) | Not Added | Not Added | Benzyl methacrylate/methacrylic acid/ hydroxyethyl methacrylate copolymer (molar ratio: 80/10/10, Mw: 10000) | A | 500 | C | Inversely tapered |
| Comparative Example 2 | A'-2 | Comparative compound 1 (60 parts by mass) | Not Added | Not Added | Benzyl methacrylate/methacrylic acid copolymer (molar ratio: 70/30, Mw:10000) | A | 500 | B | Inversely tapered |
| Comparative Example 3 | A'-3 | Comparative compound 2 (60 parts by mass) | Not Added | Not Added | Benzyl methacrylate/methacrylic acid/ hydroxyethyl methacrylate copolymer (molar ratio: 80/10/10, Mw: 10000) | A | 500 | C | Inversely tapered |
| Comparative Example 4 | A'-4 | Comparative compound 3 (60 parts by mass) | Not Added | Not Added | Benzyl methacrylate/methacrylic acid/ hydroxyethyl methacrylate copolymer (molar ratio: 80/10/10, Mw: 10000) | A | 950 | B | Inversely tapered |
| Comparative Example 5 | A'-5 | Comparative compound 4 (60 parts by mass) | Not Added | Not Added | Benzyl methacrylate/methacrylic acid/ hydroxyethyl methacrylate copolymer (molar ratio: 80/10/10, Mw: 10000) | A | 500 | C | Rectangular |
| Comparative Example 6 | A'-6 | Comparative compound 1 (60 parts by mass) | Not Added | Not Added | Exemplary Compound (104) | A | 300 | A | Inversely tapered |
| Comparative Example 7 | A'-7 | Comparative Compound 2 (60 parts by mass) | Not Added | Not Added | Exemplary Compound (120) | A | 300 | B | Inversely tapered |
| Comparative Example 8 | A'-8 | Comparative compound 1 (60 parts by mass) | Not Added | Not Added | Exemplary Compound (119) | A | 300 | B | Inversely tapered |

Sensitizers A1 to A3 and co-sensitizer F1 to F3 shown in Tables 1 and Table 2 are compounds shown below. The same applies to Tables 4 to 9.
A1: 4,4-bisdiethylamino benzophene
A2: diethylthioxanthone
A3: 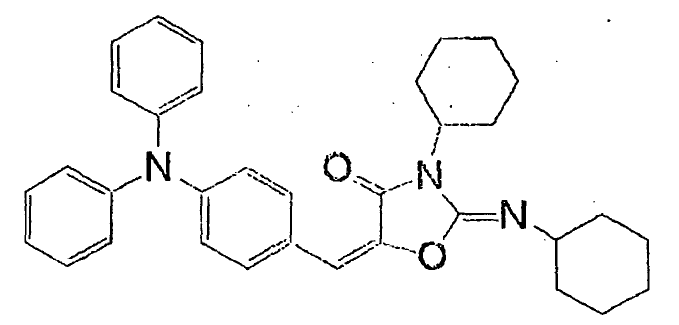
F1: 2-mercaptobenzimidazol
F2: 2-mercaptobenzothiazol
F3: N-phenyl-2-mercaptobenzimidazol

The results shown in Tables 1 and 2 demonstrate that the colored curable composition of each Example containing the specific photopolymerization initiator (specific compounds 1 to 6) has a high exposure sensitivity, excellent developability when it is used for forming a colored pattern of a color filter (prevention of a development residue), and provides a colored pattern having an excellent cross-sectional shape. Moreover, it is revealed that the colored curable composition of each Example has excellent storage stability (stability with time),

[Example 2-1]
<1. Preparation of resist liquid>
Components in the following composition were mixed and dissolved to prepare a
resist liquid.
- Composition of Resist Liquid-
- Propyleneglycol monomethyl ether acetate (PGMEA) 19.20 parts by mass
- Ethyl lactate 36.67 parts by mass
- Resin [40%PGMEA solution of benzyl methacrylate / methacrylic acid / 2-hydroxyethyl methacrylate copolymer (molar ratio = 60/22/18)] 30.51 parts by mass
- Dipentaerythritol hexaacrylate (polymerizable compound) 12.20 parts by mass
- Polymerization inhibitor (p-methoxyphenol) 0.0061 part by mass
- Fluorochemical surfactant [F-475 (tradename), manufactured by Dainippon Ink & Chemicals, Inc.] 0.83 part by mass
- Photoinitiator [TAZ-107 (tradename: trihalomethyltriazine-based photopolymerization initiator, manufactured by Midori Kagaku K.K.)] 0.586 part by mass

<2. Production of silicon wafer substrate having an undercoat layer>
A 6-inch silicon wafer was heat-treated in an oven at 200°C for 30 minutes. Subsequently, the resist liquid was applied onto the silicon wafer such that the dry film thickness became 2 µm, and heated in a 220°C oven for 1 hour to form an undercoat layer to thereby obtain a silicon wafer substrate having an undercoat layer.

<3. Preparation of colored curable composition B-1>
Compounds in the following composition B-1 were mixed and dissolved to prepare a colored curable composition B-1 containing a colorant (dye).

-Composition B-1-
Cyclohexanone 80 parts by mass
- Colorant (C.I. Acid Blue 108) 7.5 parts by mass
- Colorant (C.I. solvent Yellow 162) 2.5 parts by mass
- Polyfunctional monomer [Mixture of pentaerythritol triacrylate and dipentaerythritol hexaacrylate (3:7)] 3.0 parts by mass
- Alkali-soluble resin (Exemplary Compound (101)) 4,5 parts by mass
- Specific compound 1 [Specific photopolymerization initiator] 2.5 parts by mass

<4. Evaluation of storage stability of colored curable composition B-1 (coating liquid)>
The colored curable composition B-1 was stored at room temperature for one month, and then was visually evaluated for the precipitation degree according to the following criteria. The results are shown in Table 4.
(Criteria)
A : No precipitation was observed.
B : Precipitation was slightly observed.
C : Precipitation was observed.

<5. Production of color filter using colored curable composition B-1 and evaluation thereof>
The colored curable composition B-1 prepared in item 3-B above was applied onto the undercoat layer of the silicon wafer substrate obtained in item 2 above to form a photosensitive coating film. The coating film was heat-treated (prebaked) for 120 seconds using a 100°C hot plate in such that the dry film thickness of the coating film became 0.9 µm.
Subsequently, the coating film was irradiated by using an i-ray stepper exposure apparatus FPA-3000 i 5+ (tradename: manufactured by Canon Co.) at a wavelength of 365 nm through an Island pattern mask having a 2 µm square pattern at an exposure amount of from 10 to 1,600 mJ/cm².
Then the silicon wafer substrate having the irradiated coating film thereon was placed on a horizontal rotary table of a spin-shower developing machine (Model DW-30 (tradename); manufactured by Chemitronics Co.) and subjected to paddle development at 23°C for 60 seconds using a CD-2000 (tradename: manufactured by Fuji Film Materials Co., Ltd.) to thereby form a colored pattern on the silicon wafer substrate.

The silicon wafer substrate on which the colored pattern was formed was fixed to the horizontal rotary table by using a vacuum chuck system. While rotating the silicon wafer substrate by using a rotational device at a rotation speed of 50 rpm, rinsing treatment was performed by supplying purified water in shower form from above the rotational center thereof using an ejection nozzle, and then the substrate was spray-dried.
Thus a color filter in which a colored pattern was formed on a substrate was obtained.
- Exposure sensitivity-
   Regarding the evaluation of exposure sensitivity, the minimum exposure amount at which the post-development thickness of the region that was irradiated with light in the exposure step became 95% or more of the thickness (100 %) of the film before the exposure was evaluated as the exposure requirement amount. A smaller exposure requirement amount indicates a higher sensitivity. The size of the colored pattern was also measured using a length measurement SEM "S-9260A" (tradename: manufactured by Hitachi
   High-Technologies Corp.) at that time. A pattern size closer to 2 µm indicates a sufficient curing property and more favorable sensitivity.
   The measurement and evaluation results are shown in Table 4.

- Pattern cross-sectional shape-
   The evaluation of the pattern cross-sectional shape was performed according to the evaluation method and evaluation criteria employed in Example 1-1. The measurement and evaluation results are shown in Table 4.

- Confirmation of development residue-
   A 1.5 µm square pixel pattern was formed with an exposure amount of 7,000 J/cm² using a length measurement SEM (Hitachi S-9260S (tradename)). The periphery of pixels and a portion between pixels are observed to confirm the degree of generation of development residue such as adhering matter and undissolved residue.
   The observation results were classified, for evaluation, into three ranks of Type-A, Type-B, and Type-C in the order from better results to worse results (i.e., in the order from more prevention of development residue to less prevention of development residue). The classification method is shown in Table 3 and Fig. 1. Moreover the measurement and evaluation results are shown in Table 4.
   Among the above-mentioned ranks, Type-A, Type-B, and Type-C, the Type-A and Type-B are within a permissible range (practically acceptable), with Type-A being more preferable.

| | Type-A | Type-B | Type-C |
|---|---|---|---|
| Residual at pixel periphery | Not observed | Not observed | Significantly observed |
| Residual at a portion between pixels | Not observed | Slightly observed | Significantly observed |

[Examples 2-2 to 2-25 and Comparative Examples 2-1 to 2-4 and 2-6 to 2-8]
Colored curable compositions B-2 to B-25 for Examples and colored curable compositions B'3-1 to B'3-4 and B'3-6 to B'3-8 for Comparative Examples were prepared and color filters of Examples 2-2 to 2-25 and Comparative Examples 2-1 to 2-4 and 2-6 to 2-8 were obtained in the same manner as in Example 2-1, except that (i) 2.5 parts by mass of the specific compound 1 (Specific photopolymerization initiator) in the composition B-1 used for the preparation of the colored curable composition B-1 in Example 2-1 was replaced by the respective compounds in the respective amounts shown in Tables 4 and 5, and (ii) in each of Examples 2-12 to 2-22, a sensitizer and/or a co-sensitizer of the kind and amount shown in Tables 4 and 5 was further added. Furthermore the same evaluation as in Example 2-1 was performed. The results are shown in Tables 4 and 5.

[Example 3-1]
A compound having the following composition C-1 was mixed and dissolved to thereby prepare a colored curable composition C-1 containing a colorant (pigment).
- Composition C-1-
- Ethyl 3-ethoxypropionate [solvent] 17.9 parts by mass
- Colorant: Pigment dispersion liquid of C.I. Pigment Red 254 [Solid content: 15%, Pigment content in the solid content: 60%] 26.7 parts by mass
- Colorant: Pigment dispersion liquid of C.I. Pigment Yellow 139 [Solid content: 15%, Pigment content in the solid content: 60%] 1 7.8 parts by mass
- Polyfunctional monomer [Mixture of pentaerythritol triacrylate and dipentaerythritol hexaacrylate (3:7)] 3.5 parts by mass
- Specific compound 1 [Specific photopolymerization initiator] 0.5 part by mass
- Alkali-soluble resin (Exemplary Compound (101) 2.0 parts by mass

<Evaluation of Storage Stability of Colored Curable Composition C-1 (coating liquid)>
The storage stability of the colored curable composition C-1 (coating liquid) was evaluated in the same manner as in Example 2-1, except that the colored curable composition B-1 was replaced by the colored curable composition C-1. The results are shown in Table 6.

<Production of color filter using colored curable composition C-1 and evaluation thereof>
A color filter of Example 3-1 was produced in the same manner as in Example 2-1, except that the colored curable composition B-1 was replaced by the colored curable composition C-1. Then the same evaluation as in Example 2-1 was performed on the color filter of Example 3-1. The results are shown in Table 6.

[Examples 3-2 to 3-23 and Comparative Examples 3-1 to 3-4 and 3-6 to 3-8]
Colored curable compositions C-2 to C-23 for Examples and colored curable compositions C'3-1 to C'3-4 and C'3-6 to C'3-8 for Comparative Examples were prepared and color filters of Examples 3-2 to 3-23 and Comparative Examples 3-1 to 3-4 and 3-6 to 3-8 were obtained in the same manner as in Example 3-1, except that (i) 2.5 parts by mass of the specific compound 1 (Specific photopolymerization initiator) in the composition C-1 used for the preparation of the colored curable composition C-1 in Example 3-1 was replaced by the respective compounds in the respective amounts shown in Tables 6 and 7, and (ii) in each of Examples 3-12 to 3-20, a sensitizer and/or a co-sensitizer of the kind and amount shown in Tables 6 and 7 was further added. Furthermore the same evaluation as in Example 3-1 was performed. The results are shown in Tables 6 and 7.

[Example 4-1]
A compound having the following composition D-1 was mixed and dissolved to thereby prepare a colored curable composition D-1 containing a colorant (pigment).
- Composition D-1 (High pigment concentration)-
- Ethyl 3-ethoxypropionate [solvent] 17.9 parts by mass
- Colorant: Pigment dispersion liquid of C.I. Pigment Red 254 [Solid content: 15%, Pigment content in the solid content: 60%] 33.34 parts by mass
- Colorant: Pigment dispersion liquid of C.I. Pigment Yellow 139 [Solid content: 15%, Pigment content in the solid content: 60%] 22.23 parts by mass
- Polyfunctional monomer 2.5 parts by mass
- Specific compound 1 [Specific photopolymerization initiator] 0.5 part by mass
- Alkali-soluble resin (Exemplary Compound (101)) 2.0 parts by mass

<Evaluation of storage stability of colored curable composition D-1 (coating liquid)>
The storage stability of the colored curable composition D-1 (coating liquid) was evaluated in the same manner as in Example 2-1, except that the colored curable composition B-1 was replaced by the colored curable composition D-1. The results are shown in Table 8.

<Production of color filter using colored curable composition D-1 and evaluation thereof>
A color filter of Example 4-1 was produced in the same manner as in Example 2-1, except that the colored curable composition B-1 was replaced by the colored curable composition D-1. Then the same evaluation as in Example 2-1 was performed on the color filter of Example 4-1. The results are shown in Table 8.

[Examples 4-2 to 4-23 and Comparative Examples 4-1 to 4-4 and 4-6 to 4-8]
Colored curable compositions D-2 to D-23 for Examples and colored curable compositions D'3-1 to D'3-4 and D'3-6 to D'3-8 for Comparative Examples were prepared and color filters of Examples 4-2 to 4-23 and Comparative Examples 4-1 to 4-4 and 4-6 to 4-8 were obtained in the same manner as in Example 4-1, except that (i) 2.5 parts by mass of the specific compound 1 (Specific photopolymerization initiator) in the composition D-1 used for the preparation of the colored curable composition D-1 in Example 4-1 was replaced by the respective compounds in the respective amounts shown in Tables 8 and 9, and (ii) in each of Examples 4-12 to 4-20, a sensitizer and/or a co-sensitizer of the kind and amount shown in Tables 8 and 9 was further added. Furthermore, the same evaluation as in Example 4-1 was performed. The results are shown in Tables 8 and 9.

**Table 4**

| | Composition | Initiator | Sensitizer | Co-sensitizer | Alkali-soluble Resin | Exposure Requirement Amount (mJ/cm²) | Pattern size A (µm) | Stability with Time | Residue Geneartion |
|---|---|---|---|---|---|---|---|---|---|
| Example 2-1 | B-1 | Specific compound 1 (2.5 parts by mass) | Not Added | Not Added | Exemplary Compound (101) | 1000 | 1.95 | A | A |
| Example 2-2 | B-2 | Specific compound 1 (2.5 parts by mass) | Not Added | Not Added | Exemplary Compound (103) | 1000 | 1.95 | A | A |
| Example 2-3 | B-3 | Specific compound 1 (2.5 parts by mass) | Not Added | Not Added | Exemplary Compound (104) | 1000 | 1.95 | A | A |
| Example 2-4 | B-4 | Specific compound 1 (2.5 parts by mass) | Not Added | Not Added | Exemplary Compound (105) | 1000 | 1.95 | A | A |
| Example 2-5 | B-5 | Specific compound 1 (2.5 parts by mass) | Not Added | Not Added | Exemplary Compound (110) | 1100 | 1.95 | A | A |
| Example 2-6 | B-6 | Specific compound 1 (2.5 parts by mass) | Not Added | Not Added | Exemplary Compound (116) | 1100 | 1.95 | A | B |
| Example 2-7 | B-7 | Specific compound I (2.5 parts by mass) | Not Added | Not Added | Exemplary Compound (119) | 1000 | 1.94 | A | B |
| Example 2-8 | B-8 | Specific compound 1 (2.5 parts by mass) | Not Added | Not Added | Exemplary Compound (120) | 1000 | 1.94 | A | B |
| Example 2-9 | B-9 | Specific compound 1 (2.5 parts by mass) | Not Added | Not Added | Exemplary Compound (121) | 1000 | 1.94 | A. | B |
| Example 2-10 | B-10 | Specific compound 2 (2.5 parts by mass) | Not Added | Not Added | Exemplary Compound (104) | 1000 | 1.95 | A | A |
| Example 2-11 | B-11 | Specific compound 3 (2.5 parts by mass) | Not Added | Not Added | Exemplary Compound (104) | 1500 | 1.93 | A | A |
| Example 2-12 | B-12 | Specific compound 1 (2.0 parts by mass) | A1 (0.5 parts by mass) | Not Added | Exemplary Compound (104) | 900 | 1.96 | A | A |
| Example 2-13 | B-13 | Specific compound 1 (2.0 parts by mass) | A2 (0.5 parts by mass) | Not Added | Exemplary Compound (104) | 900 | 1.96 | A | A |
| Example 2-14 | B-14 | Specific compound 1 (2.0 parts by mass) | A3 (0.5 parts by mass) | Not Added | Exemplary Compound (104) | 800 | 1.96 | A | A |
| Example 2-15 | B-15 | Specific compound 1 (2.0 parts by mass) | Not Added | F1 (0.5 parts by mass) | Exemplary Compound (104) | 900 | 1.96 | A | A |
| Example 2-16 | B-16 | Specific compound 1 (2.0 parts by mass) | Not Added | F2 (0.5 parts by mass) | Exemplary Compound (104) | 900 | 1.96 | A | A |
| Example 2-17 | B-17 | Specific compound 1 (2.0 parts by mass) | Not Added | F3 (0.5 parts by mass) | Exemplary Compound (104) | 800 | 1.96 | A | A |

**Table 5**

| | Composition | Initiator | Sensitizer | Co-sensitizer | Alkali-soluble Resin | Exposure Requirement Amount (mJ/cm²) | Pattern size A (µm) | Stability with Time | Residue Geneartion |
|---|---|---|---|---|---|---|---|---|---|
| Example 2-18 | B-18 | Specific compound 1 (2.0 parts by mass) | Not Added | F3 (0.5 parts by mass) | Exemplary Compound (104) | 800 | 1.97 | A | A |
| Example 2-19 | B-19 | Specific compound 1 (2.0 parts by mass) | Not Added | F3 (0.5 parts by mass) | Exemplary Compound (104) | 700 | 1.97 | A | A |
| Example 2-20 | B-20 | Specific compound 1 (1.5 parts by mass) | A2 (0.5 parts by mass) | F1 (0.5 parts by mass) | Exemplary Compound (104) | 800 | 1.97 | A | A |
| Example 2-21 | B-21 | Specific compound 1 (1.0 parts by mass) | A2 (0.5 parts bypass) | F2 (0.5 parts by mass) | Exemplary Compound (104) | 800 | 1.97 | A | A |
| Example 2-22 | B-22 | Specific compound 1 (1.0 parts by mass) | A2 (0.5 parts by mass) | F3 (0.5 parts by mass) | Exemplary Compound (104) | 600 | 1.97 | A | A |
| Example 2-23 | B-23 | Specific compound 4 (2.0 parts by mass) | Not Added | Not Added | Exemplary Compound (104) | 1300 | 1.94 | A | A |
| Example 2-24 | B-24 | Specific compound 5 (2.0 parts by mass) | Not Added | Not Added | Exemplary Compound (104) | 1400 | 1.93 | A | A |
| Example 2-25 | B-25 | Specific compound 6 (2.0 parts by mass) | Not Added | Not Added | Exemplary Compound (104) | 1400 | 1.93 | A | A |
| Comparative Example 2-1 | B'-1 | Comparative compound 1 (2.5 parts by mass) | Not Added | Not Added | Benzyl methaerylate/methacrylic acid/ hydroxyethyl methacrylate copolymer (molar ratio: 80/10/10, Mw: 10000) | 2000 | 1.92 | A | C |
| Comparative Example 2-2 | B'-2 | Comparative compound 2 (2.5 parts by mass) | Not Added | Not Added | Benzyl methacrylate/methacrylic acid copolymer (molar ratio: 70/30, Mw:10000) | 2000 | 1.92 | A | C |
| Comparative Example 2-3 | B'-3 | Comparative compound 3 (2.5 parts by mass) | Not Added | Not Added | Benzyl methacrylate/methacrylic acid/ hydroxyethyl methacrylate copolymer (molar ratio: 80/10/10, Mw: 10000) | 2500 | 1.88 | A | C |
| Comparative Example 2-4 | B'-4 | Comparative compound 4 (2.5 parts by mass) | Not Added | Not Added | Benzyl methacrylate/methacrylic acid/ hydroxyethyl methacrylate copolymer (molar ratio: 80/10/10, Mw: 10000) | 2000 | 1.92 | A | C |
| Comparative Example 2-6 | B'-6 | Comparative compound 1 (2.5 parts by mass) | Not Added | Not Added | Exemplary Compound (104) | 1800 | 1.93 | A | A |
| Comparative Example 2-7 | B'-7 | Comparative compound 1 (2.5 parts by mass) | Not Added | Not Added | Exemplary Compound (120) | 1800 | 1.92 | A | B |
| Comparative Example 2-8 | B'-8 | Comparative compound 1(2.5 parts by mass) | Not Added | Not Added | Exemplary Compound (119) | 1800 | 1.92 | A | B |

**Table 6**

| | Composition | Initiator | Sensitizer | Co-sensitizer | Alkali-soluble Resin | Exposure Requirement Amount (mJ/cm²) | Pattern size A (µm) | Stability with Time | Residue Geneartion |
|---|---|---|---|---|---|---|---|---|---|
| Example 3-1 | C-1 | Specific compound I (0.5 parts by mass) | Not Added | Not Added | Exemplary Compound (101) | 1000 | 1.95 | A | A |
| Example 3-2 | C-2 | Specific compound 1 (0.5 parts by mass) | Not Added | Not Added | Exemplary Compound (103) | 1000 | 1.95 | A | A |
| Example 3-3 | C-3 | Specific compound 1 (0.5 parts by mass) | Net Added | Not Added | Exemplary Compound (104) | 1000 | 1.95 | A | A |
| Example 3-4 | C-4 | Specific compound 1 (0.5 parts by mass) | Not Added | Not Added | Exemplary Compound (106) | 1000 | 1.95 | A | A |
| Example 3-5 | C-5 | Specific compound I (0.5 parts by mass) | Not Added | Not Added | Exemplary Compound (110) | 1100 | 1.94 | A | A |
| Example 3-6 | C-6 | specific compound 1 (0.5 parts by mass) | Not Added | Not Added | Exemplary Compound (116) | 1100 | 1.94 | A | B |
| Example 3-7 | C-7 | Specific compound I (0.5 parts by mass) | Not Added | Not Added | Exemplary Compound (119) | 1100 | 1.95 | A | B |
| Example 3-8 | C-8 | Specific compound 1 (0.5 parts by mass) | Not Added | Not Added | Exemplary Compound (120) | 1100 | 1.95 | A | E |
| Example 3-9 | C-9 | Specific compound I (0.5 parts by mass) | Net Added | Not Added | Exemplary Compound (121) | 1100 | 1.95 | A | E |
| Example 3-10 | C-10 | Specific compound 2 (0.5 parts by mass) | Not Added | Not Added | Exemplary Compound (104) | 1000 | 1.95 | A | A |
| Example 3-11 | C-11 | Specific compound 3 (0.5 parts by mass) | Not Added | Not Added | Exemplary Compound (104) | 1500 | 1.92 | A | A |
| Example 3-12 | C-12 | Specific compound 1 (0.4 parts by mass) | A1 (0.1 parts by mass) | Not Added | Exemplary Compound (104) | 900 | 1.96 | A | A |
| Example 3-13 | C-13 | Specific compound 1 (0.4 parts by mass) | A2 (0.1 parts by mass) | Not Added | Exemplary Compound (104) | 900 | 1.96 | A | A |
| Example 3-14 | C-14 | Specific compound 1 (0.4 parts by mass) | A3 (0.1 parts by mass) | Not Added | Exemplary Compound (104) | 800 | 1.96 | A | A |
| Example 3-15 | C-15 | Specific compound 1 (0.4 parts by mass) | Not Added | F1 (0.1 parts by mass) | Exemplary Compound (104) | 900 | 1.96 | A | A |
| Example 3-16 | C-16 | Specific compound 1 (0.4 parts by mass) | Not Added | F2 (0.1 parts by mass) | Exemplary Compound (104) | 900 | 1.96 | A | A |
| Example 3-17 | C-17 | Specific compound 1 (0.4 parts by mass) | Not Added | F3 (0.1 parts by mass) | Exemplary Compound (104) | 800 | 1.96 | A | A |

**Table 7**

| | Composition | Initiator | Sensitizer | Co-sensitizer | Alkali-soluble Resin | Exposure Requirement Amount (mJ/cm²) | Pattern size A (µm) | Stability with Time | Residue Geneartion |
|---|---|---|---|---|---|---|---|---|---|
| Example 3-18 | C-18 | Specific compound 1 (0.3 parts by mass) | A2 (0.1 parts by mass) | F1 (0.1 parts by mass) | Exemplary Compound (104) | 800 | 1.97 | A | A |
| Example 3-19 | C-19 | Specific compound 1 (0.3 parts by mass) | A2 (0.1 parts by mass) | F2 (0.1 parts by mass) | Exemplary Compound (104) | 800 | 1.97 | A | A |
| Example 3-20 | C-20 | Specific compound 1 (0.3 parts by mass) | A2 (0.1 parts by mass) | F3 (0.1 parts by mass) | Exemplary Compound (104) | 700 | 1.97 | A | A |
| Example 3-21 | C-21 | Specific ccmpound 4 (0.5 parts by mass) | Not Added | Not Added | Exemplary Compound (104) | 1300 | 1.94 | A | A |
| Example 3-22 | C-22 | Specific compound 5 (0.5 parts by mass) | Not Added | Not Added | Exemplary Compound (104) | 1400 | 1.93 | A | A |
| Example 3-23 | C-23 | Specific compound 6 (0.5 parts by mass) | Not Added | Not Added | Exemplary Compound (104) | 1400 | 1.93 | A | A |
| Comparative Example 3-1 | C'-1 | Comparative compound 1 (0.5 parts by mass) | Not Added | Not Added | Benzyl methacrylate/methacrylic acid/ hydroxyethyl methacrylate copolymer (molar ratio: 80/10/10, Mw: 10000) | 2000 | 1.92 | A | C |
| Comparative Example 3-2 | C'-2 | Comparative compound 2 (0.5 parts by mass) | Not Added | Not Added | Benzyl methacrylate/methacrylic acid copolymer (molar ratio: 70/30, Mw:10000) | 2000 | 1.92 | A | C |
| Comparative Example 3-3 | C'-3 | Comparative compound 3 (0.5 parts by mass) | Not Added | Not Added | Benzyl methacrylate/methacrylic acid copolymer (molar ratio: 70/30, Mw:10000) | 2500 | 1.88 | A | C |
| Comparative Example 3-4 | C'-4 | Comparative compound 4 (0.5 parts by mass) | Not Added | Not Added | Benzyl methacrylate/methacrylic acid copolymer (molar ratio: 70/30, Mw:10000) | 2000 | 1.92 | A | C |
| Comparative Example 3-6 | C'-6 | Comparative compound 1 (0.5 parts by mass) | Not Added | Not Added | Exemplary Compound (104) | 1800 | 1.93 | A | A |
| Comparative Example 3-7 | C'-7 | Comparative compound 1 (0.5 parts by mass) | Not Added | Not Added | Exemplary Compound (120) | 1800 | 1.92 | A | B |
| Comparative Example 3-8 | C'-8 | Comparative compound 1 (0.5 parts by mass) | Not Added | Not Added | Exemplary Compound (119) | 1800 | 1.92 | A | B |

**Table 8**

| | Combosition | Initiator | Sensitizer | Co-sensitizer | Alkali-soluble Resin | Exposure Requirement Amount (mJ/cm²) | Pattern size A (µm) | Stability with Time | Residue Geneartion |
|---|---|---|---|---|---|---|---|---|---|
| Example 4-1 | D-1 | Specific compound 1 (0.5 parts by mass) | Not Added | Not Added | Exemplary Compound (101) | 1500 | 1.92 | A | A |
| Example 4-2 | D-2 | Specific compound 1 (0.5 parts by mass) | Not Added | Not Added | Exemplary Compound (103) | 1500 | 1.92 | A | A |
| Example 4-3 | D-3 | Specific compound I (0.5 parts by mass) | Not Added | Not Added | Exemplary Compound (104) | 1500 | 1.92 | A | A |
| Example 4-4 | D-4 | Specific compound 1 (0.5 parts by mass) | Not Added | Not Added | Exemplary Compound (106) | 1500 | 1.92 | A | A |
| Example 4-5 | D-5 | Specific compound 1 (0.5 parts by mass) | Not Added | Not Added | Exemplary Compound (110) | 1600 | 1.91 | A | A |
| Example 4-6 | D-6 | Specific compound 1 (0.5 parts by mass) I | Not Added | Not Added | Exemplary Compound (116) | 1500 | 1.92 | A | B |
| Example 4-7 | D-7 | Specific compound 1 (0.5 parts by mass) | Net Added | Not Added | Exemplary Compound (119) | 1600 | 1.92 | A | B |
| Example 4-8 | D-8 | Specific compound 1 (0.5 parts by mass) | Not Added | Not Added | Exemplary Compound (120) | 1600 | 1.92 | A | B |
| Example 4-9 | D-9 | Specific compound 1 (0.5 parts by mass) | Not Added | Not Added | Exemplary Compound (121) | 1600 | 1.92 | A | B |
| Example 4-10 | D-10 | Specific compound 2 (0.5 parts by mass) | Not Added | Not Added | Exemplary Compound (104) | 1500 | 1.92 | A | A |
| Example 4-11 | D-11 | Specific compound 3 (0.5 parts by mass) | Not Added | Not Added | Exemplary Compound (104) | 1700 | 1.90 | A | A |
| Example 4-12 | D-12 | Specific compound 1 (0.5 parts by mass) | A1 (0.5 parts by mass) | Not Added | Exemplary Compound (104) | 1400 | 1.93 | A | A |
| Example 4-13 | D-13 | Specific compound 1 (0.5 parts by mass) | A2 (0.5 parts by mass) | Not Added | Exemplary Compound (104) | 1400 | 1.93 | A | A |
| Example 4-14 | D-14 | Specific compound 1 (0.5 parts by mass) | A3 (0.5 parts by mass) | Not Added | Exemplary Compound (104) | 1300 | 1.94 | A | A |
| Example 4-15 | D-15 | Specific compound 1 (0.5 parts by mass) | Not Added | F1 (0.5 parts by mass) | Exemplary Compound (104) | 1400 | 1.93 | A | A |
| Example 4-16 | D-16 | Specific compound 1 (0.5 parts by mass) | Not Added | F2 (0.5 parts by mass) | Exemplary Compound (104) | 1400 | 1.93 | A | A |

**Table 9**

| | Composition | Initiator | Sensitizer | Co-sensitizer | Alkali-soluble Resin | Exposure Requirement Amount (mJ/cm²) | Pattern size A (µm) | Stability with Time | Residue Generation |
|---|---|---|---|---|---|---|---|---|---|
| Example 4-17 | D-17 | Specific compound 1 (0.5 parts by mass) | Not Added | F3 (0.5 parts by mass) | Exemplary Compound (104) | 1300 | 1.94 | A | A |
| Example 4-18 | D-18 | Specific compound 1 (0.3 parts by mass) | A2 (0.1 parts by mass) | F1 (0.1 parts by mass) | Exemplary Compound (104) | 1100 | 1.95 | A | A |
| Example 4-19 9 | D-19 | Specific compound 1 (0.3 parts by mass) | A2 (0.1 parts by mass) | F2 (0.1 parts by mass) | Exemplary Compound (104) | 1100 | 1.95 | A | A |
| Example 4-20 | D-20 | Specific compound 1 (0.3 parts by mass) | A2 (0.1 parts by mass) | F3 (0.1 parts by mass) | Exemplary Compound (104) | 1100 | 1.96 | A | A |
| Example 4-21 | D-21 | Specific compound 4 (0.5 parts by mass) | Not Added | Not Added | Exemplary Compound (104) | 1600 | 1.91 | A | A |
| Example 4-22 | D-22 | Specific compound 5 (0.5 parts by mass) | Not Added | Not Added | Exemplary Compound (104) | 1600 | 1.91 | A | A |
| Example 4-23 | D-23 | Specific compound 6 (0.5 parts by mass) | Not Added | Not Added | Exemplary Compound (104) | 1600 | 1.91 | A | A |
| Comparative Example 4-1 | D-1 | Comparative compound 1 (0.5 parts by mass) | Not Added | Not Added | Benzyl methacrylate/methacrylic acid/ hydroxyethyl methacrylate copolymer (molar ratio: 80/10110, Mw: 10000) | 2500 | 1.89 | A | C |
| Comparative Example 4-2 | D'-2 | Comparative compound 2 (0.5 parts by mass) | Not Added | Not Added | Benzyl methacrjlate/methacrylic acid copolymer (molar ratio: 70/30, Mw:10000) | 2500 | 1.89 | A | C |
| Comparative Example 4-3 | D'-3 | Comparative compound 3 (0.5 parts by mass) | Not Added | Not Added | Benzyl methacrylate/methacrylic acid copolymer (molar ratio: 70/30, Mw:10000) | 3000 | 1.87 | A | C |
| Comparative Example 4-4 | D'-4 | Comparative compound 4 (0.5 parts by mass) | Not Added | Not Added | Benzyl methacrylate/methacrylic acid copolymer (molar ratio: 70/30, Mw:10000) | 2500 | 1.89 | A | C |
| Comparative Example 4-6 | D'-6 | Comparative compound 1 (0.5 parts by mass) | Not Added | Not Added | Exemplary Compound (104) | 2000 | 1.90 | A | A |
| Comparative Example 4-7 | D'-7 | Comparative Compound 1 (0.5 parts by mass) | Not Added | Not Added | Exemplary Compound (120) | 2000 | 1.90 | A | C |
| Comparative Example 4-8 | D'-8 | Comparative compound 1 (0.5 parts by mass) | Not Added | Not Added | Exemplary Compound (119) | 2000 | 1.90 | A | C |

The results shown in Tables 4 to 9 demonstrate that the colored curable composition containing the specific photopolymerization initiator (Specific compound 1, 2, 3, 4, 5 or 6) of each Example has high exposure sensitivity, the generation of a development residue when the colored curable composition is used for forming a colored pattern of a color filter is suppressed, and the cross-sectional shape of the pattern of the obtained colored pattern is excellent. Moreover, it is also revealed that the colored curable compositions have excellent storage stability (stability with time).

## Claims

1. A colored curable composition, comprising:
a photopolymerization initiator represented by the following Formula (II) and having a molar extinction coefficient at a wavelength of 365 nm of from 12,000 to 500,000: 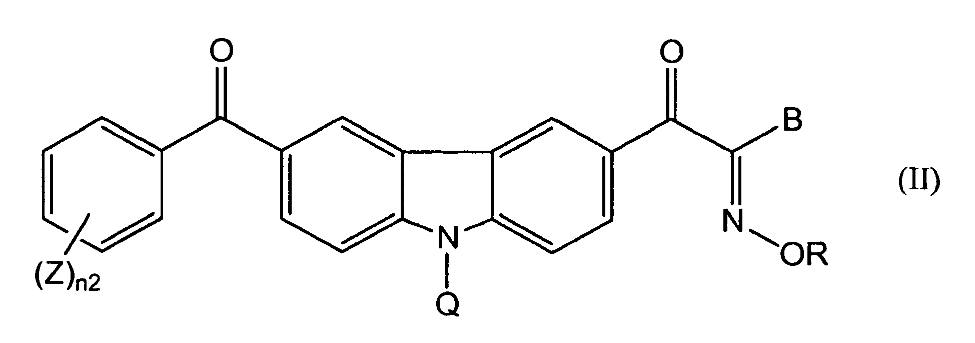 wherein, in Formula (II), R, B, and Q each independently represent a monovalent organic group; Z represents a monovalent substituent, and n₂ represents an integer of from 0 to 5;
a polymerizable compound;
a colorant; and
an alkali-soluble resin having at least one unsaturated double bond and including at least one structural unit represented by any one of the following Formulae (1) to (3) and a structural unit represented by the following Formula (4): 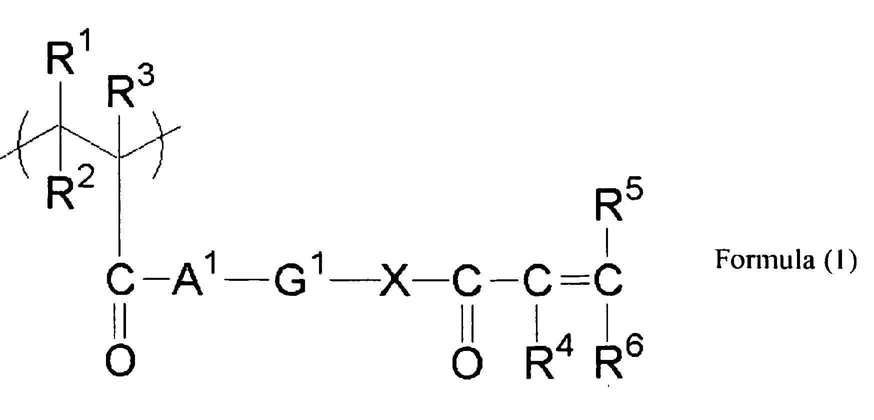 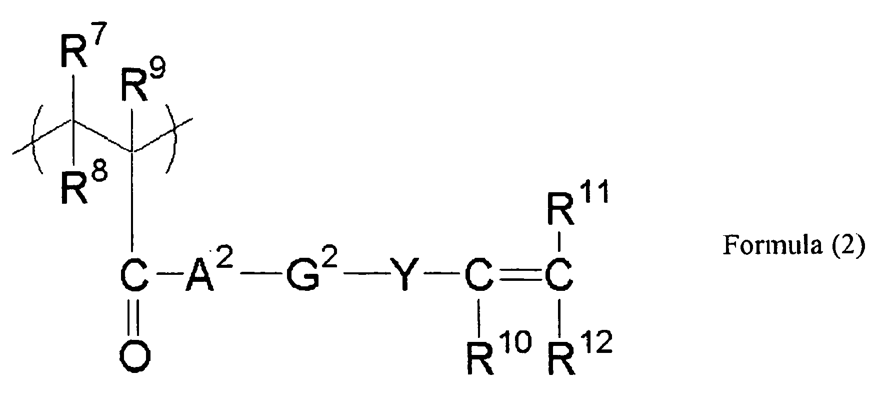 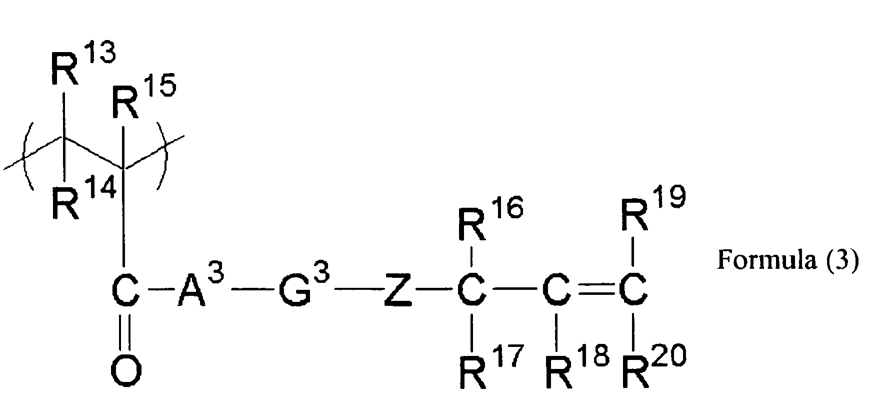 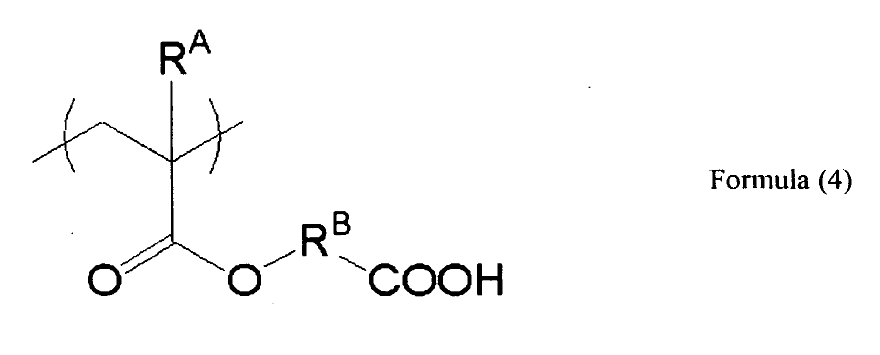
wherein, in Formulae (1) to (3), A¹, A² and A³ each independently represent an oxygen atom, a sulfur atom, or -N(R²¹)-; R²¹ represents an alkyl group which may have a substituent; G¹, G² and G³ each independently represent a divalent organic group; X and Z each independently represent an oxygen atom, a sulfur atom, or -N(R²²)-; R²² represents an alkyl group which may have a substituent; Y represents an oxygen atom, a sulfur atom, a phenylene group which may have a substituent, or -N(R²³)-; R²³ represents an alkyl group which may have a substituent; and R¹ to R²⁰ each independently represent a hydrogen atom or a monovalent substituent; and, in Formula (4), R^{A} represents a hydrogen atom or an alkyl group having 1 to 6 carbon atoms; and R^{B} represents a divalent connecting group.

2. The colored curable composition according to claim 1, wherein the content of the colorant is from 50 mass% to 90 mass% with respect to the total solid content of the colored curable composition.

3. A color filter, comprising a colored pattern formed from the colored curable composition according to claim 1 or claim 2.

4. A method of producing a color filter, comprising:
applying the colored curable composition according to claim 1 or claim 2 onto a support to form a colored curable composition layer;
exposing the colored curable composition layer through a mask; and
developing the colored curable composition layer after exposure to form a colored pattern.

5. A solid state image pickup device, comprising the color filter according to claim 3.

## Patentansprüche

1. Farbige härtbare Zusammensetzung, umfassend einen Fotopolymerisationsinitiator, der
durch die Formel (II) dargestellt ist 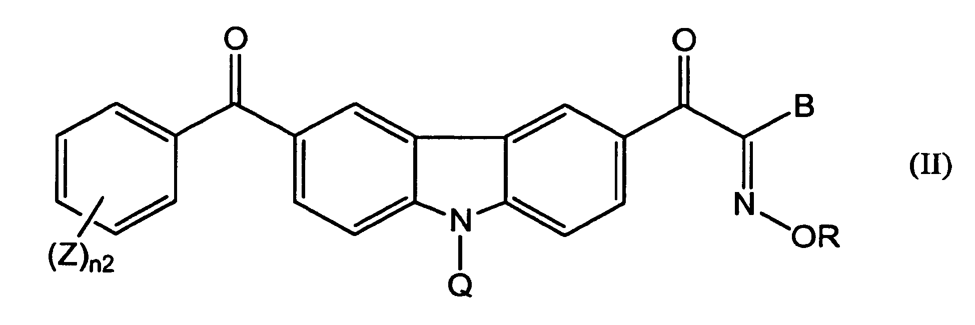 wobei in der Formel (II), R, B und Q jeweils unabhängig voneinander eine monovalente organische Gruppe; Z einen monovalenten Substituenten und n2 eine ganze Zahl von 0 bis 5 darstellen,
und einen molaren Extinktionskoeffizienten bei einer Wellenlänge von 365 nm, von 12.000 bis 500.000 aufweist;
eine polymerisierbare Verbindung;
einen Farbstoff; und
ein alkali-lösliches Harz, das wenigstens eine ungesättigte Doppelbindung und wenigstens eine durch eine der folgenden Formeln (1) bis (3) dargestellte Struktureinheit sowie eine Struktureinheit der Formel (4) aufweist 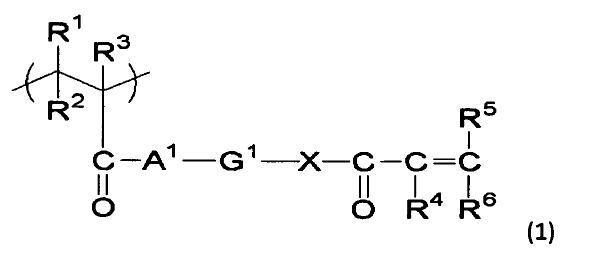 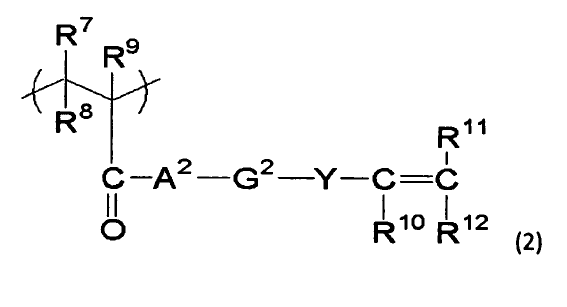 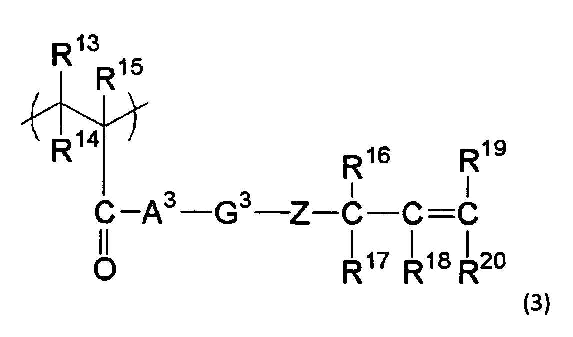 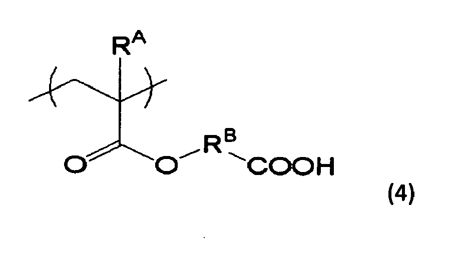 wobei, in den Formeln (1) bis (3), A¹, A² und A³ jeweils unabhänging voneinander ein Sauerstoffatom, ein Schwefelatom oder -N(R²¹)- darstellen; R²¹ eine möglicherweise substituierte Alkylgruppe darstellt; G¹, G² und G³ jeweils unabhänging voneinander eine divalente organische Gruppe darstellen; X und Z jeweils unabhänging voneinander ein Sauerstoffatom, ein Schwefelatom oder -N(R²²)- darstellen; R²² eine möglicherweise substituierte Alkylgruppe darstellt; Y ein Sauerstoffatom, ein Schwefelatom, eine möglicherweise substituierte Phenylengruppe oder -N(R²³)- darstellt; R²³ eine möglicherweise substituierte Alkylgruppe darstellt; und R¹ bis R²⁰ jeweils unabhängig voneinander ein Wasserstoffatom oder einen monovalenten Substituenten darstellen; und in Formel (4), R^{A} ein Wasserstoffatom oder eine Alkylgruppe mit von 1 bis zu 6 Kohlenstoffatomen darstellt; und R^{B} eine divalente Verknüpfungsgruppe darstellt.

2. Farbige härtbare Zusammensetzung nach Anspruch 1, wobei der Farbstoffgehalt von 50 bis zu 90 Massenprozent in Bezug auf den Gesamtfeststoffgehalt der farbigen härtbaren Zusammensetzung beträgt.

3. Farbfilter aufweisend ein farbiges Muster, das durch die härtbare Zusammensetzung nach Anspruch 1 oder 2 gebildet wird.

4. Verfahren zur Herstellung eines Farbfilters, aufweisend
Auftragen der farbigen härtbaren Zusammensetzung nach Anspruch 1 oder 2 auf einen Träger zur Bildung einer farbigen härtbaren Schicht jener Zusammensetzung;
Belichten der farbigen härtbaren Schicht durch eine Maske; und
Entwickeln der farbigen härtbaren Schicht nach Belichtung zur Bildung eines farbigen Musters.

5. Halbleiter-Bildaufnahmegerät, das einen Farbfilter nach Anspruch 3 aufweist.

## Revendications

1. Composition durcissable colorée comprenant :
un amorceur de photopolymérisation représenté par la formule (II) suivante et ayant un coefficient d'extinction molaire à une longueur d'onde de 365 nm de 12 000 à 500 000 : 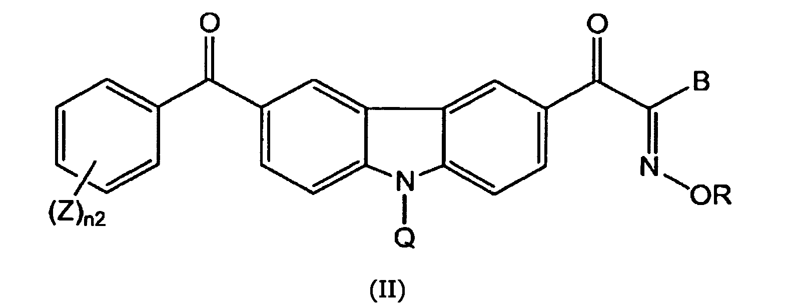 où, dans la formule (II), chacun de R, B et Q représente indépendamment un groupe organique monovalent ; Z représente un substituant monovalent, et n₂ représente un entier de 0 à 5 ;
un composé polymérisable ;
un colorant ; et
une résine soluble dans les alcalis ayant au moins une double liaison insaturée et contenant au moins un motif structurel représenté par l'une quelconque des formules (1) à (3) suivantes et un motif structurel représenté par la formule (4) suivante : 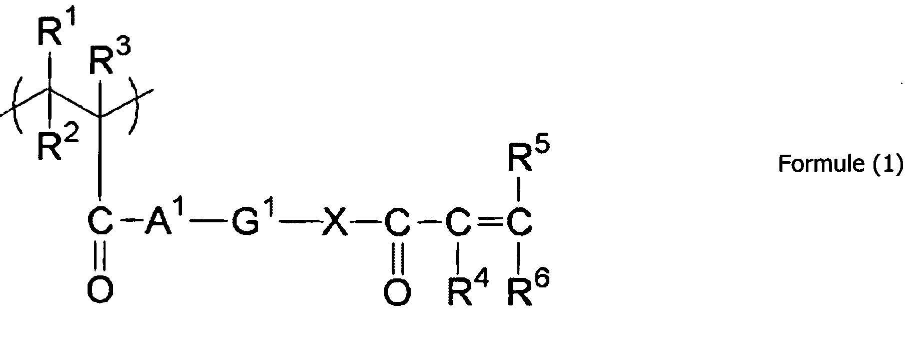 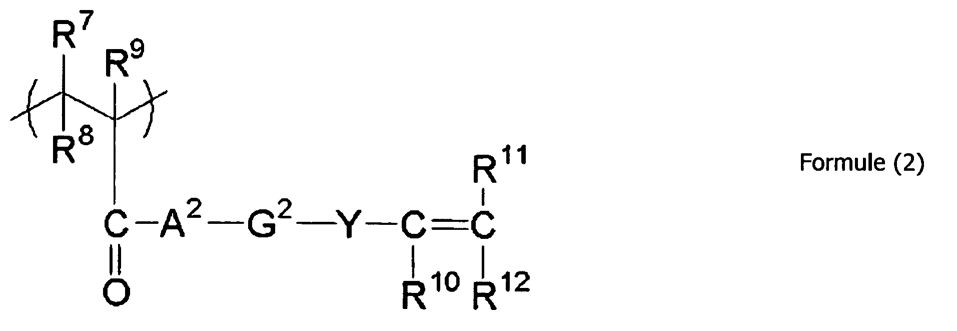 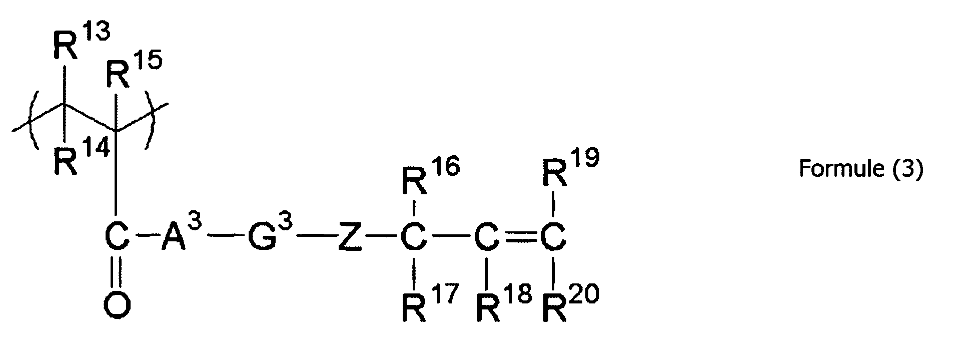 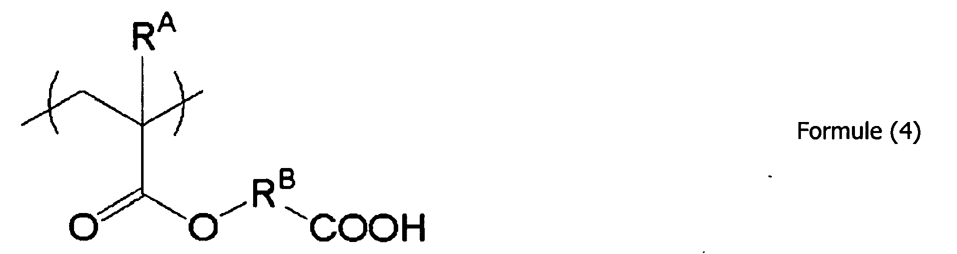 où, dans les formules (1) à (3), chacun de A¹, A² et A³ représente indépendamment un atome d'oxygène, un atome de soufre ou -N(R²¹)-; R²¹ représente un groupe alkyle qui peut porter un substituant ; chacun de G¹, G² et G³ représente indépendamment un groupe organique divalent ; chacun de X et Z représente indépendamment un atome d'oxygène, un atome de soufre, ou -N(R²²)-; R²² représente un groupe alkyle qui peut porter un substituant ; Y représente un atome d'oxygène, un atome de soufre, un groupe phénylène qui peut porter un substituant, ou -N(R²³)- ; R²³ représente un groupe alkyle qui peut porter un substituant ; et chacun de R¹ à R²⁰ représente indépendamment un atome d'hydrogène ou un substituant monovalent ; et, dans la formule (4), R^{A} représente un atome d'hydrogène ou un groupe alkyle ayant de 1 à 6 atomes de carbone ; et R^{B} représente un groupe de connexion divalent.

2. Composition durcissable colorée selon la revendication 1, dans laquelle la teneur en colorant est de 50 % en masse à 90 % en masse par rapport à la teneur totale en extrait sec de la composition durcissable colorée.

3. Filtre couleur comprenant un motif coloré formé de la composition durcissable colorée de la revendication 1 ou de la revendication 2.

4. Procédé de production d'un filtre couleur, comprenant :
l'application de la composition durcissable colorée de la revendication 1 ou de la revendication 2 sur un support pour former une couche de composition durcissable colorée ;
l'exposition de la couche de composition durcissable colorée à travers un masque ; et
le développement de la couche de composition durcissable colorée après exposition pour former un motif coloré.

5. Dispositif capteur d'image à semi-conducteur comprenant le filtre couleur de la revendication 3.
